# EUROPEAN PATENT SPECIFICATION

(11) **EP 3 261 146 B1**
(45) Date of publication and mention of the grant of the patent: **23.09.2020**
(21) Application number: 17176668.6
(22) Date of filing: 19.06.2017
(51) Int. Cl.: C09K 11/06, H01L 51/54

(54) **ORGANIC ELECTROLUMINESCENT MATERIALS AND DEVICES**
ORGANISCHE ELEKTROLUMINESZENTE MATERIALIEN UND VORRICHTUNGEN
MATÉRIAUX ET DISPOSITIFS ÉLECTROLUMINESCENTS ORGANIQUES

(30) Priority: 20.06.2016 US 201662352139 P; 26.01.2017 US 201762450848 P; 31.03.2017 US 201762479795 P; 03.04.2017 US 201762480746 P; 07.06.2017 US 201762516329 P; 09.06.2017 US 201715619190
(43) Date of publication of application: 27.12.2017
(60) Divisional application: 20190784.7
(73) Proprietor: Universal Display Corporation, Ewing, NJ 08618 (US)
(72) Inventor: TSAI, Jui-Yi, Ewing, NJ New Jersey 08618 (US); JI, Zhiqiang, Ewing, NJ New Jersey 08618 (US); DYATKIN, Alexey Borisovich, Ewing, NJ New Jersey 08618 (US); XIA, Chuanjun, Ewing, NJ New Jersey 08618 (US); LIN, Chun, Ewing, NJ New Jersey 08618 (US); ZENG, Lichang, Ewing, NJ New Jersey 08618 (US); YEAGER, Walter, Ewing, NJ New Jersey 08618 (US)
(74) Representative: Hansen, Norbert

(56) References cited:
- US-A1- 2014 197 386
- MARC LEPELTIER ET AL: "Tris-cyclometalated Iridium(III) Complexes with Three Different Ligands: a New Example with 2-(2,4-Difluorophenyl)pyridine-Based Complex", HELVETICA CHIMICA ACTA, vol. 97, no. 7, 1 July 2014 (2014-07-01), pages 939-956, XP055415325, CH ISSN: 0018-019X, DOI: 10.1002/hlca.201300339
- JIA-LING LIAO ET AL: "Ir(III)-Based Phosphors with Bipyrazolate Ancillaries; Rational Design, Photophysics, and Applications in Organic Light-Emitting Diodes", INORGANIC CHEMISTRY, vol. 54, no. 22, 16 November 2015 (2015-11-16), pages 10811-10821, XP055415785, EASTON, US ISSN: 0020-1669, DOI: 10.1021/acs.inorgchem.5b01835
- PARK GUI YOUN ET AL: "Iridium complexes containing three different ligands as white OLED dopants", MOLECULAR CRYSTALS AND LIQUID CRYS, TAYLOR & FRANCIS, UK, vol. 462, 1 January 2007 (2007-01-01), pages 179-188, XP008160706, ISSN: 1542-1406, DOI: 10.1080/07370650601013120

## Description

### FIELD

The present disclosure relates to compounds for use as phosphorescent emitters, and devices, such as organic light emitting diodes, including the same. More specifically, this disclosure relates to iridium complexes comprising three different bidentate ligands and their use in OLEDs to enhance the device efficiency and lifetime.

### BACKGROUND

Opto-electronic devices that make use of organic materials are becoming increasingly desirable for a number of reasons. Many of the materials used to make such devices are relatively inexpensive, so organic opto-electronic devices have the potential for cost advantages over inorganic devices. In addition, the inherent properties of organic materials, such as their flexibility, may make them well suited for particular applications such as fabrication on a flexible substrate. Examples of organic opto-electronic devices include organic light emitting diodes/devices (OLEDs), organic phototransistors, organic photovoltaic cells, and organic photodetectors. For OLEDs, the organic materials may have performance advantages over conventional materials. For example, the wavelength at which an organic emissive layer emits light may generally be readily tuned with appropriate dopants.

OLEDs make use of thin organic films that emit light when voltage is applied across the device. OLEDs are becoming an increasingly interesting technology for use in applications such as flat panel displays, illumination, and backlighting. Several OLED materials and configurations are described in U.S. Pat. Nos. 5,844,363, 6,303,238, and 5,707,745.

One application for phosphorescent emissive molecules is a full color display. Industry standards for such a display call for pixels adapted to emit particular colors, referred to as "saturated" colors. In particular, these standards call for saturated red, green, and blue pixels. Alternatively the OLED can be designed to emit white light. In conventional liquid crystal displays emission from a white backlight is filtered using absorption filters to produce red, green and blue emission. The same technique can also be used with OLEDs.The white OLED can be either a single EML device or a stack structure. Color may be measured using CIE coordinates, which are well known to the art.

One example of a green emissive molecule is tris(2-phenylpyridine) iridium, denoted Ir(ppy)₃, which has the following structure:

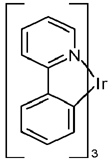

In this, and later figures herein, we depict the dative bond from nitrogen to metal (here, Ir) as a straight line.

As used herein, the term "organic" includes polymeric materials as well as small molecule organic materials that may be used to fabricate organic opto-electronic devices. "Small molecule" refers to any organic material that is not a polymer, and "small molecules" may actually be quite large. Small molecules may include repeat units in some circumstances. For example, using a long chain alkyl group as a substituent does not remove a molecule from the "small molecule" class. Small molecules may also be incorporated into polymers, for example as a pendent group on a polymer backbone or as a part of the backbone. Small molecules may also serve as the core moiety of a dendrimer, which consists of a series of chemical shells built on the core moiety. The core moiety of a dendrimer may be a fluorescent or phosphorescent small molecule emitter. A dendrimer may be a "small molecule," and it is believed that all dendrimers currently used in the field of OLEDs are small molecules.

As used herein, "top" means furthest away from the substrate, while "bottom" means closest to the substrate. Where a first layer is described as "disposed over" a second layer, the first layer is disposed further away from substrate. There may be other layers between the first and second layer, unless it is specified that the first layer is "in contact with" the second layer. For example, a cathode may be described as "disposed over" an anode, even though there are various organic layers in between.

As used herein, "solution processible" means capable of being dissolved, dispersed, or transported in and/or deposited from a liquid medium, either in solution or suspension form.

A ligand may be referred to as "photoactive" when it is believed that the ligand directly contributes to the photoactive properties of an emissive material. A ligand may be referred to as "ancillary" when it is believed that the ligand does not contribute to the photoactive properties of an emissive material, although an ancillary ligand may alter the properties of a photoactive ligand.

As used herein, and as would be generally understood by one skilled in the art, a first "Highest Occupied Molecular Orbital" (HOMO) or "Lowest Unoccupied Molecular Orbital" (LUMO) energy level is "greater than" or "higher than" a second HOMO or LUMO energy level if the first energy level is closer to the vacuum energy level. Since ionization potentials (IP) are measured as a negative energy relative to a vacuum level, a higher HOMO energy level corresponds to an IP having a smaller absolute value (an IP that is less negative). Similarly, a higher LUMO energy level corresponds to an electron affinity (EA) having a smaller absolute value (an EA that is less negative). On a conventional energy level diagram, with the vacuum level at the top, the LUMO energy level of a material is higher than the HOMO energy level of the same material. A "higher" HOMO or LUMO energy level appears closer to the top of such a diagram than a "lower" HOMO or LUMO energy level.

As used herein, and as would be generally understood by one skilled in the art, a first work function is "greater than" or "higher than" a second work function if the first work function has a higher absolute value. Because work functions are generally measured as negative numbers relative to vacuum level, this means that a "higher" work function is more negative. On a conventional energy level diagram, with the vacuum level at the top, a "higher" work function is illustrated as further away from the vacuum level in the downward direction. Thus, the definitions of HOMO and LUMO energy levels follow a different convention than work functions.

More details on OLEDs, and the definitions described above, can be found in US Pat. No. 7,279,704. MARC LEPELTIER ET AL: "Tris-cyclometalated iridium(III) Complexes with Three Different Ligands: a New Example with 2-(2,4-Difluorophenyl)pyridine-Based Complex", HELVETICA CHIMICA ACTA, vol. 97, no. 7, 2014, pages 939-956; JIA-LING LIAO ET AL: "Ir(III)-Based Phosphors with Bipyrazolate Ancillaries, Rational Design, Photophysics, and Applications in Organic Light-Emitting Diodes", INORGANIC CHEMISTRY, vol. 54, no. 22, 2015, pages 1081 1-10821; and PARK GUI YOUN ET AL: "Iridium complexes containing three different ligands as white OLED dopants", MOLECULAR CRYSTALS AND LIQUID CRYS, TAYLOR & FRANCIS, UK, vol. 462, 2007, pages 179-188, disclose similar complexes for use in OLEDs.

### SUMMARY

According to an aspect of the present disclosure, a compound having a formula Ir(L_{A})(L_{B})(L_{C}) is disclosed, wherein the ligand L_{A} is: 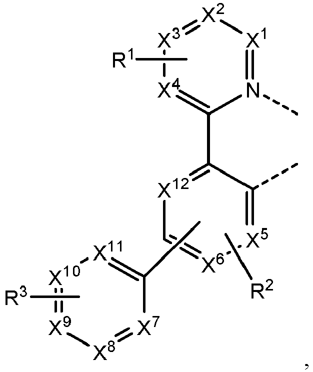
wherein the ligand L_{B} is 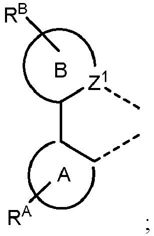 wherein the ligand L_{C} is 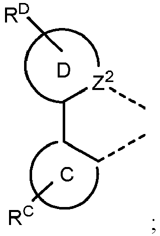
wherein rings A, B, C, and D are each independently a 5 or 6-membered carbocyclic or heterocyclic ring;
wherein R¹, R², R³, R^{A}, R^{B}, R^{C}, and R^{D} each independently represents mono, to a maximum possible number of substitution, or no substitution;
wherein X¹ to X¹², Z¹, and Z² are each independently C or N;
   wherein L_{A}, L_{B}, and L_{C} are different from each other, and can be connected to each other to form multidentate ligand;
wherein R¹, R², R³, R^{A}, R^{B}, R^{C}, and R^{D} are each independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof; and
wherein any two or more substituents among R¹, R², R³, R^{A}, R^{B}, R^{C}, and R^{D} are optionally joined or fused into a ring; and wherein at least one of R^{A}, R^{B}, R^{C}, and R^{D} is selected from the group consisting of alkyl, cycloalkyl, aryl, heteroaryl, partially or fully deuterated variants thereof, partially or fully fluorinated variants thereof, and combinations thereof.

According to an aspect of the present disclosure, an OLED is also disclosed. The OLED comprises: an anode; a cathode; and an organic layer, disposed between the anode and the cathode. The organic layer comprising a compound having the formula Ir(L_{A})(L_{B})(L_{C}) described herein.

A formulation comprising the compound described herein is also disclosed.

### BRIEF DESCRIPTION OF THE DRAWINGS

FIG. 1 shows an organic light emitting device.
FIG. 2 shows an inverted organic light emitting device that does not have a separate electron transport layer.

### DETAILED DESCRIPTION

Generally, an OLED comprises at least one organic layer disposed between and electrically connected to an anode and a cathode. When a current is applied, the anode injects holes and the cathode injects electrons into the organic layer(s). The injected holes and electrons each migrate toward the oppositely charged electrode. When an electron and hole localize on the same molecule, an "exciton," which is a localized electron-hole pair having an excited energy state, is formed. Light is emitted when the exciton relaxes via a photoemissive mechanism. In some cases, the exciton may be localized on an excimer or an exciplex. Non-radiative mechanisms, such as thermal relaxation, may also occur, but are generally considered undesirable.

The initial OLEDs used emissive molecules that emitted light from their singlet states ("fluorescence") as disclosed, for example, in U.S. Pat. No. 4,769,292. Fluorescent emission generally occurs in a time frame of less than 10 nanoseconds.

More recently, OLEDs having emissive materials that emit light from triplet states ("phosphorescence") have been demonstrated. Baldo et al., "Highly Efficient Phosphorescent Emission from Organic Electroluminescent Devices," Nature, vol. 395, 151-154, 1998; ("Baldo-I") and Baldo et al., "Very high-efficiency green organic light-emitting devices based on electrophosphorescence," Appl. Phys. Lett., vol. 75, No. 3, 4-6 (1999) ("Baldo-II"). Phosphorescence is described in more detail in US Pat. No. 7,279,704 at cols. 5-6.

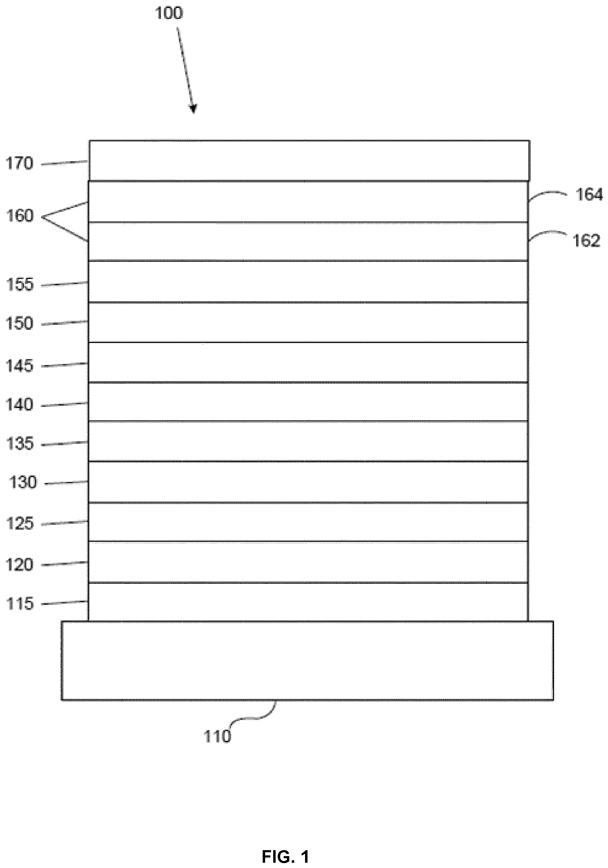

FIG. 1 shows an organic light emitting device 100. The figures are not necessarily drawn to scale. Device 100 may include a substrate 110, an anode 115, a hole injection layer 120, a hole transport layer 125, an electron blocking layer 130, an emissive layer 135, a hole blocking layer 140, an electron transport layer 145, an electron injection layer 150, a protective layer 155, a cathode 160, and a barrier layer 170. Cathode 160 is a compound cathode having a first conductive layer 162 and a second conductive layer 164. Device 100 may be fabricated by depositing the layers described, in order. The properties and functions of these various layers, as well as example materials, are described in more detail in US 7,279,704 at cols. 6-10.

More examples for each of these layers are available. For example, a flexible and transparent substrate-anode combination is disclosed in U.S. Pat. No. 5,844,363. An example of a p-doped hole transport layer is m-MTDATA doped with F₄-TCNQ at a molar ratio of 50:1, as disclosed in U.S. Patent Application Publication No. 2003/0230980. Examples of emissive and host materials are disclosed in U.S. Pat. No. 6,303,238 to Thompson et al. An example of an n-doped electron transport layer is BPhen doped with Li at a molar ratio of 1:1, as disclosed in U.S. Patent Application Publication No. 2003/0230980. U.S. Pat. Nos. 5,703,436 and 5,707,745 disclose examples of cathodes including compound cathodes having a thin layer of metal such as Mg:Ag with an overlying transparent, electrically-conductive, sputter-deposited ITO layer. The theory and use of blocking layers is described in more detail in U.S. Pat. No. 6,097,147 and U.S. Patent Application Publication No. 2003/0230980. Examples of injection layers are provided in U.S. Patent Application Publication No. 2004/0174116. A description of protective layers may be found in U.S. Patent Application Publication No. 2004/0174116.

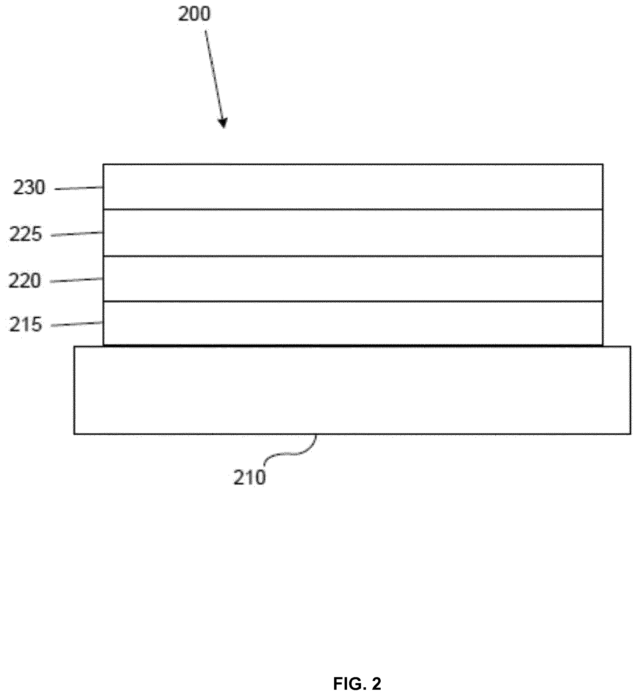

FIG. 2 shows an inverted OLED 200. The device includes a substrate 210, a cathode 215, an emissive layer 220, a hole transport layer 225, and an anode 230. Device 200 may be fabricated by depositing the layers described, in order. Because the most common OLED configuration has a cathode disposed over the anode, and device 200 has cathode 215 disposed under anode 230, device 200 may be referred to as an "inverted" OLED. Materials similar to those described with respect to device 100 may be used in the corresponding layers of device 200. FIG. 2 provides one example of how some layers may be omitted from the structure of device 100.

The simple layered structure illustrated in FIGS. 1 and 2 is provided by way of nonlimiting example, and it is understood that embodiments of the invention may be used in connection with a wide variety of other structures. The specific materials and structures described are exemplary in nature, and other materials and structures may be used. Functional OLEDs may be achieved by combining the various layers described in different ways, or layers may be omitted entirely, based on design, performance, and cost factors. Other layers not specifically described may also be included. Materials other than those specifically described may be used. Although many of the examples provided herein describe various layers as comprising a single material, it is understood that combinations of materials, such as a mixture of host and dopant, or more generally a mixture, may be used. Also, the layers may have various sublayers. The names given to the various layers herein are not intended to be strictly limiting. For example, in device 200, hole transport layer 225 transports holes and injects holes into emissive layer 220, and may be described as a hole transport layer or a hole injection layer. In one embodiment, an OLED may be described as having an "organic layer" disposed between a cathode and an anode. This organic layer may comprise a single layer, or may further comprise multiple layers of different organic materials as described, for example, with respect to FIGS. 1 and 2.

Structures and materials not specifically described may also be used, such as OLEDs comprised of polymeric materials (PLEDs) such as disclosed in U.S. Pat. No. 5,247,190 to Friend et al. By way of further example, OLEDs having a single organic layer may be used. OLEDs may be stacked, for example as described in U.S. Pat. No. 5,707,745 to Forrest et al. The OLED structure may deviate from the simple layered structure illustrated in FIGs. 1 and 2. For example, the substrate may include an angled reflective surface to improve out-coupling, such as a mesa structure as described in U.S. Pat. No. 6,091,195 to Forrest et al., and/or a pit structure as described in U.S. Pat. No. 5,834,893 to Bulovic et al.

Unless otherwise specified, any of the layers of the various embodiments may be deposited by any suitable method. For the organic layers, preferred methods include thermal evaporation, ink-jet, such as described in U.S. Pat. Nos. 6,013,982 and 6,087,196, organic vapor phase deposition (OVPD), such as described in U.S. Pat. No. 6,337,102 to Forrest et al., , and deposition by organic vapor jet printing (OVJP), such as described in U.S. Pat. No. 7,431,968. Other suitable deposition methods include spin coating and other solution based processes. Solution based processes are preferably carried out in nitrogen or an inert atmosphere. For the other layers, preferred methods include thermal evaporation. Preferred patterning methods include deposition through a mask, cold welding such as described in U.S. Pat. Nos. 6,294,398 and 6,468,819, and patterning associated with some of the deposition methods such as ink-jet and OVJP. Other methods may also be used. The materials to be deposited may be modified to make them compatible with a particular deposition method. For example, substituents such as alkyl and aryl groups, branched or unbranched, and preferably containing at least 3 carbons, may be used in small molecules to enhance their ability to undergo solution processing. Substituents having 20 carbons or more may be used, and 3-20 carbons is a preferred range. Materials with asymmetric structures may have better solution processibility than those having symmetric structures, because asymmetric materials may have a lower tendency to recrystallize. Dendrimer substituents may be used to enhance the ability of small molecules to undergo solution processing.

Devices fabricated in accordance with embodiments of the present invention may further optionally comprise a barrier layer. One purpose of the barrier layer is to protect the electrodes and organic layers from damaging exposure to harmful species in the environment including moisture, vapor and/or gases, etc. The barrier layer may be deposited over, under or next to a substrate, an electrode, or over any other parts of a device including an edge. The barrier layer may comprise a single layer, or multiple layers. The barrier layer may be formed by various known chemical vapor deposition techniques and may include compositions having a single phase as well as compositions having multiple phases. Any suitable material or combination of materials may be used for the barrier layer. The barrier layer may incorporate an inorganic or an organic compound or both. The preferred barrier layer comprises a mixture of a polymeric material and a non-polymeric material as described in U.S. Pat. No. 7,968,146, PCT Pat. Application Nos. PCT/US2007/023098 and PCT/US2009/042829. To be considered a "mixture", the aforesaid polymeric and non-polymeric materials comprising the barrier layer should be deposited under the same reaction conditions and/or at the same time. The weight ratio of polymeric to non-polymeric material may be in the range of 95:5 to 5:95. The polymeric material and the non-polymeric material may be created from the same precursor material. In one example, the mixture of a polymeric material and a non-polymeric material consists essentially of polymeric silicon and inorganic silicon.

OLEDs fabricated in accordance with embodiments of the invention can be incorporated into a wide variety of electronic component modules (or units) that can be incorporated into a variety of electronic products or intermediate components. Examples of such electronic products or intermediate components include display screens, lighting devices such as discrete light source devices or lighting panels, etc. that can be utilized by the end-user product manufacturers. Such electronic component modules can optionally include the driving electronics and/or power source(s). Devices fabricated in accordance with embodiments of the invention can be incorporated into a wide variety of consumer products that have one or more of the electronic component modules (or units) incorporated therein. Such consumer products would include any kind of products that include one or more light source(s) and/or one or more of some type of visual displays. Some examples of such consumer products include flat panel displays, computer monitors, medical monitors, televisions, billboards, lights for interior or exterior illumination and/or signaling, heads-up displays, fully or partially transparent displays, flexible displays, laser printers, telephones, cell phones, tablets, phablets, personal digital assistants (PDAs), wearable devices, laptop computers, digital cameras, camcorders, viewfinders, micro-displays (displays that are less than 2 inches diagonal), 3-D displays, virtual reality or augmented reality displays, vehicles, video walls comprising multiple displays tiled together, theater or stadium screen, and a sign. Various control mechanisms may be used to control devices fabricated in accordance with the present invention, including passive matrix and active matrix. Many of the devices are intended for use in a temperature range comfortable to humans, such as 18 degrees C. to 30 degrees C., and more preferably at room temperature (20-25 degrees C), but could be used outside this temperature range, for example, from -40 degree C to + 80 degree C.

The materials and structures described herein may have applications in devices other than OLEDs. For example, other optoelectronic devices such as organic solar cells and organic photodetectors may employ the materials and structures. More generally, organic devices, such as organic transistors, may employ the materials and structures.

The term "halo," "halogen," or "halide" as used herein includes fluorine, chlorine, bromine, and iodine.

The term "alkyl" as used herein contemplates both straight and branched chain alkyl radicals. Preferred alkyl groups are those containing from one to fifteen carbon atoms and includes methyl, ethyl, propyl, 1-methylethyl, butyl, 1-methylpropyl, 2-methylpropyl, pentyl, 1-methylbutyl, 2-methylbutyl, 3-methylbutyl, 1,1-dimethylpropyl, 1,2-dimethylpropyl, 2,2-dimethylpropyl,and the like. Additionally, the alkyl group may be optionally substituted.

The term "cycloalkyl" as used herein contemplates cyclic alkyl radicals. Preferred cycloalkyl groups are those containing 3 to 10 ring carbon atoms and includes cyclopropyl, cyclopentyl, cyclohexyl, adamantyl, and the like. Additionally, the cycloalkyl group may be optionally substituted.

The term "alkenyl" as used herein contemplates both straight and branched chain alkene radicals. Preferred alkenyl groups are those containing two to fifteen carbon atoms. Additionally, the alkenyl group may be optionally substituted.

The term "alkynyl" as used herein contemplates both straight and branched chain alkyne radicals. Preferred alkynyl groups are those containing two to fifteen carbon atoms. Additionally, the alkynyl group may be optionally substituted.

The terms "aralkyl" or "arylalkyl" as used herein are used interchangeably and contemplate an alkyl group that has as a substituent an aromatic group. Additionally, the aralkyl group may be optionally substituted.

The term "heterocyclic group" as used herein contemplates aromatic and non-aromatic cyclic radicals. Hetero-aromatic cyclic radicals also means heteroaryl. Preferred hetero-non-aromatic cyclic groups are those containing 3 to 7 ring atoms which includes at least one hetero atom, and includes cyclic amines such as morpholino, piperidino, pyrrolidino, and the like, and cyclic ethers, such as tetrahydrofuran, tetrahydropyran, and the like. Additionally, the heterocyclic group may be optionally substituted.

The term "aryl" or "aromatic group" as used herein contemplates single-ring groups and polycyclic ring systems. The polycyclic rings may have two or more rings in which two carbons are common to two adjoining rings (the rings are "fused") wherein at least one of the rings is aromatic, e.g., the other rings can be cycloalkyls, cycloalkenyls, aryl, heterocycles, and/or heteroaryls. Preferred aryl groups are those containing six to thirty carbon atoms, preferably six to twenty carbon atoms, more preferably six to twelve carbon atoms. Especially preferred is an aryl group having six carbons, ten carbons or twelve carbons. Suitable aryl groups include phenyl, biphenyl, triphenyl, triphenylene, tetraphenylene, naphthalene, anthracene, phenalene, phenanthrene, fluorene, pyrene, chrysene, perylene, and azulene, preferably phenyl, biphenyl, triphenyl, triphenylene, fluorene, and naphthalene. Additionally, the aryl group may be optionally substituted.

The term "heteroaryl" as used herein contemplates single-ring hetero-aromatic groups that may include from one to five heteroatoms. The term heteroaryl also includes polycyclic hetero-aromatic systems having two or more rings in which two atoms are common to two adjoining rings (the rings are "fused") wherein at least one of the rings is a heteroaryl, e.g., the other rings can be cycloalkyls, cycloalkenyls, aryl, heterocycles, and/or heteroaryls. Preferred heteroaryl groups are those containing three to thirty carbon atoms, preferably three to twenty carbon atoms, more preferably three to twelve carbon atoms. Suitable heteroaryl groups include dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine, preferably dibenzothiophene, dibenzofuran, dibenzoselenophene, carbazole, indolocarbazole, imidazole, pyridine, triazine, benzimidazole, 1,2-azaborine, 1,3-azaborine, 1,4-azaborine, borazine, and aza-analogs thereof. Additionally, the heteroaryl group may be optionally substituted.

The alkyl, cycloalkyl, alkenyl, alkynyl, aralkyl, heterocyclic group, aryl, and heteroaryl may be unsubstituted or may be substituted with one or more substituents selected from the group consisting of deuterium, halogen, alkyl, cycloalkyl, heteroalkyl, arylalkyl, alkoxy, aryloxy, amino, cyclic amino, silyl, alkenyl, cycloalkenyl, heteroalkenyl, alkynyl, aryl, heteroaryl, acyl, carbonyl, carboxylic acid, ether, ester, nitrile, isonitrile, sulfanyl, sulfinyl, sulfonyl, phosphino, and combinations thereof.

As used herein, "substituted" indicates that a substituent other than H is bonded to the relevant position, such as carbon. Thus, for example, where R¹ is mono-substituted, then one R¹ must be other than H. Similarly, where R¹ is di-substituted, then two of R¹ must be other than H. Similarly, where R¹ is unsubstituted, R¹ is hydrogen for all available positions.

The "aza" designation in the fragments described herein, i.e. aza-dibenzofuran, aza-dibenzothiophene, etc. means that one or more of the C-H groups in the respective fragment can be replaced by a nitrogen atom, for example, and without any limitation, azatriphenylene encompasses both dibenzo[*f,h*]quinoxaline and dibenzo[*f,h*]quinoline. One of ordinary skill in the art can readily envision other nitrogen analogs of the aza-derivatives described above, and all such analogs are intended to be encompassed by the terms as set forth herein.

It is to be understood that when a molecular fragment is described as being a substituent or otherwise attached to another moiety, its name may be written as if it were a fragment (e.g. phenyl, phenylene, naphthyl, dibenzofuryl) or as if it were the whole molecule (e.g. benzene, naphthalene, dibenzofuran). As used herein, these different ways of designating a substituent or attached fragment are considered to be equivalent.

According to an aspect of the present disclosure novel Iridium complexes comprising of three different bidenate ligands when incorporated in OLED devices provide better device efficiency and life time. The present disclosure discloses heterolyptic transition metal (Ir, Os, Rh, Ru, and Re) compounds used as emitters for PHOLED to improve the performance. The metal compounds disclosed herein have three different bidentate cyclometalated ligands coordinating to iridium metal center. The ligands were arranged in such a way that yield better device efficiency and stability.

According to an aspect, a compound having a formula Ir(L_{A})(L_{B})(L_{C}) is disclosed, wherein the ligand L_{A} is: 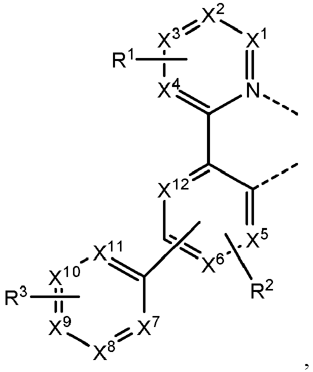
wherein the ligand L_{B} is 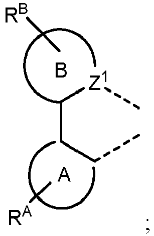 wherein the ligand L_{C} is 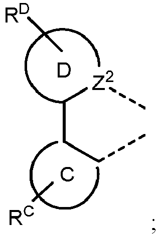
wherein rings A, B, C, and D are each independently a 5 or 6-membered carbocyclic or heterocyclic ring;
wherein R¹, R², R³, R^{A}, R^{B}, R^{C}, and R^{D} each independently represents mono, to a maximum possible number of substitution, or no substitution;
wherein X¹ to X¹², Z¹, and Z² are each independently C or N;
   wherein L_{A}, L_{B}, and L_{C} are different from each other, and can be connected to each other to form multidentate ligand;
wherein R¹, R², R³, R^{A}, R^{B}, R^{C}, and R^{D} are each independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof; and
wherein any two or more substituents among R¹, R², R³, R^{A}, R^{B}, R^{C}, and R^{D} are optionally joined or fused into a ring; and wherein at least one of R¹, R², R³, R^{A}, R^{B}, R^{C}, and R^{D} is selected from the group consisting of alkyl, cycloalkyl, aryl, heteroaryl, partially or fully deuterated variants thereof, partially or fully fluorinated variants thereof, and combinations thereof.

In some embodiments of the compound, any two substituents among R¹, R², R³, R^{A}, R^{B}, R^{C}, R^{D}, R', and R" are optionally joined or fused into a ring.

In some embodiments of the compound, the rings A and C are benzene, and the rings B and D are pyridine. In some embodiments, the rings A, B, C, and D are each independently selected from the group consisting of phenyl, pyridine, imidazole, and imidazole derived carbene.

In some embodiments of the compound, Z¹ and Z² are N.

In some embodiments of the compound, the ligand L_{A} is:

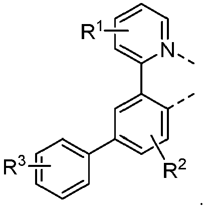

In some embodiments of the compound, the compound is selected from the group consisting of: 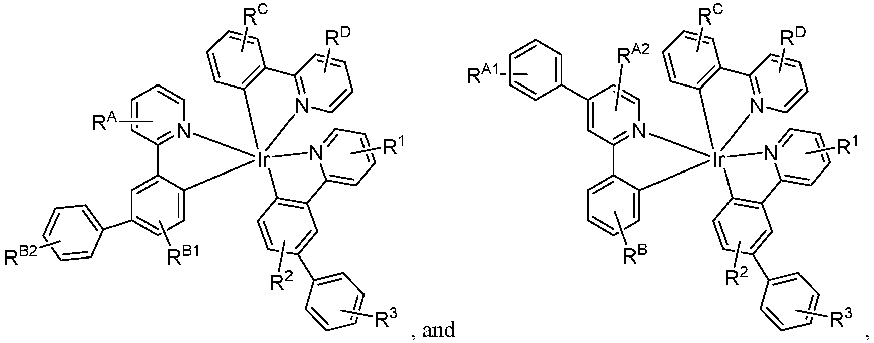
R^{A1} and R^{A2} have the same definition as R^{A}; and
R^{B1} and R^{B2} have the same definition as R^{B}.

In some embodiments of the compound, at least one of L_{B} and L_{C} is selected from the group consisting of:
L*ᵢ*, wherein L*ᵢ* is 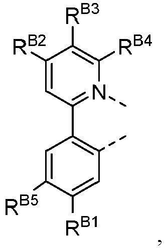 wherein for each i from 1 to 1462, R^{B1}, R^{B2}, R^{B3}, R^{B4} and R^{B5} are defined as follows for each *i*:

| ***i* in L*i*** | **R^{B1}** | **R^{B2}** | **R^{B3}** | **R^{B4}** | **R^{B5}** |
|---|---|---|---|---|---|
| 1. | H | H | H | H | H |
| 2. | CH₃ | H | H | H | H |
| 3. | H | CH₃ | H | H | H |
| 4. | H | H | CH₃ | H | H |
| 5. | CH₃ | CH₃ | H | CH₃ | H |
| 6. | CH₃ | H | CH₃ | H | H |
| 7. | CH₃ | H | H | CH₃ | H |
| 8. | H | CH₃ | CH₃ | H | H |
| 9. | H | CH₃ | H | CH₃ | H |
| 10. | H | H | CH₃ | CH₃ | H |
| 11. | CH₃ | CH₃ | CH₃ | H | H |
| 12. | CH₃ | CH₃ | H | CH₃ | H |
| 13. | CH₃ | H | CH₃ | CH₃ | H |
| 14. | H | CH₃ | CH₃ | CH₃ | H |
| 15. | CH₃ | CH₃ | CH₃ | CH₃ | H |
| 16. | CH₂CH₃ | H | H | H | H |
| 17. | CH₂CH₃ | CH₃ | H | CH₃ | H |
| 18. | CH₂CH₃ | H | CH₃ | H | H |
| 19. | CH₂CH₃ | H | H | CH₃ | H |
| 20. | CH₂CH₃ | CH₃ | CH₃ | H | H |
| 21. | CH₂CH₃ | CH₃ | H | CH₃ | H |
| 22. | CH₂CH₃ | H | CH₃ | CH₃ | H |
| 23. | CH₂CH₃ | CH₃ | CH₃ | CH₃ | H |
| 24. | H | CH₂CH₃ | H | H | H |
| 25. | CH₃ | CH₂CH₃ | H | CH₃ | H |
| 26. | H | CH₂CH₃ | CH₃ | H | H |
| 27. | H | CH₂CH₃ | H | CH₃ | H |
| 28. | CH₃ | CH₂CH₃ | CH₃ | H | H |
| 29. | CH₃ | CH₂CH₃ | H | CH₃ | H |
| 30. | H | CH₂CH₃ | CH₃ | CH₃ | H |
| 31. | CH₃ | CH₂CH₃ | CH₃ | CH₃ | H |
| 32. | H | H | CH₂CH₃ | H | H |
| 33. | CH₃ | H | CH₂CH₃ | H | H |
| 34. | H | CH₃ | CH₂CH₃ | H | H |
| 35. | H | H | CH₂CH₃ | CH₃ | H |
| 36. | CH₃ | CH₃ | CH₂CH₃ | H | H |
| 37. | CH₃ | H | CH₂CH₃ | CH₃ | H |
| 38. | H | CH₃ | CH₂CH₃ | CH₃ | H |
| 39. | CH₃ | CH₃ | CH₂CH₃ | CH₃ | H |
| 40. | CH(CH₃)₂ | H | H | H | H |
| 41. | CH(CH₃)₂ | CH₃ | H | CH₃ | H |
| 42. | CH(CH₃)₂ | H | CH₃ | H | H |
| 43. | CH(CH₃)₂ | H | H | CH₃ | H |
| 44. | CH(CH₃)₂ | CH₃ | CH₃ | H | H |
| 45. | CH(CH₃)₂ | CH₃ | H | CH₃ | H |
| 46. | CH(CH₃)₂ | H | CH₃ | CH₃ | H |
| 47. | CH(CH₃)₂ | CH₃ | CH₃ | CH₃ | H |
| 48. | H | CH(CH₃)₂ | H | H | H |
| 49. | CH₃ | CH(CH₃)₂ | H | CH₃ | H |
| 50. | H | CH(CH₃)₂ | CH₃ | H | H |
| 51. | H | CH(CH₃)₂ | H | CH₃ | H |
| 52. | CH₃ | CH(CH₃)₂ | CH₃ | H | H |
| 53. | CH₃ | CH(CH₃)₂ | H | CH₃ | H |
| 54. | H | CH(CH₃)₂ | CH₃ | CH₃ | H |
| 55. | CH₃ | CH(CH₃)₂ | CH₃ | CH₃ | H |
| 56. | H | H | CH(CH₃)₂ | H | H |
| 57. | CH₃ | H | CH(CH₃)₂ | H | H |
| 58. | H | CH₃ | CH(CH₃)₂ | H | H |
| 59. | H | H | CH(CH₃)₂ | CH₃ | H |
| 60. | CH₃ | CH₃ | CH(CH₃)₂ | H | H |
| 61. | CH₃ | H | CH(CH₃)₂ | CH₃ | H |
| 62. | H | CH₃ | CH(CH₃)₂ | CH₃ | H |
| 63. | CH₃ | CH₃ | CH(CH₃)₂ | CH₃ | H |
| 64. | CH₂CH(CH₃)₂ | H | H | H | H |
| 65. | CH₂CH(CH₃)₂ | CH₃ | H | CH₃ | H |
| 66. | CH₂CH(CH₃)₂ | H | CH₃ | H | H |
| 67. | CH₂CH(CH₃)₂ | H | H | CH₃ | H |
| 68. | CH₂CH(CH₃)₂ | CH₃ | CH₃ | H | H |
| 69. | CH₂CH(CH₃)₂ | CH₃ | H | CH₃ | H |
| 70. | CH₂CH(CH₃)₂ | H | CH₃ | CH₃ | H |
| 71. | CH₂CH(CH₃)₂ | CH₃ | CH₃ | CH₃ | H |
| 72. | H | CH₂CH(CH₃)₂ | H | H | H |
| 73. | CH₃ | CH₂CH(CH₃)₂ | H | CH₃ | H |
| 74. | H | CH₂CH(CH₃)₂ | CH₃ | H | H |
| 75. | H | CH₂CH(CH₃)₂ | H | CH₃ | H |
| 76. | CH₃ | CH₂CH(CH₃)₂ | CH₃ | H | H |
| 77. | CH₃ | CH₂CH(CH₃)₂ | H | CH₃ | H |
| 78. | H | CH₂CH(CH₃)₂ | CH₃ | CH₃ | H |
| 79. | CH₃ | CH₂CH(CH₃)₂ | CH₃ | CH₃ | H |
| 80. | H | H | CH₂CH(CH₃)₂ | H | H |
| 81. | CH₃ | H | CH₂CH(CH₃)₂ | H | H |
| 82. | H | CH₃ | CH₂CH(CH₃)₂ | H | H |
| 83. | H | H | CH₂CH(CH₃)₂ | CH₃ | H |
| 84. | CH₃ | CH₃ | CH₂CH(CH₃)₂ | H | H |
| 85. | CH₃ | H | CH₂CH(CH₃)₂ | CH₃ | H |
| 86. | H | CH₃ | CH₂CH(CH₃)₂ | CH₃ | H |
| 87. | CH₃ | CH₃ | CH₂CH(CH₃)₂ | CH₃ | H |
| 88. | C(CH₃)₃ | H | H | H | H |
| 89. | C(CH₃)₃ | CH₃ | H | CH₃ | H |
| 90. | C(CH₃)₃ | H | CH₃ | H | H |
| 91. | C(CH₃)₃ | H | H | CH₃ | H |
| 92. | C(CH₃)₃ | CH₃ | CH₃ | H | H |
| 93. | C(CH₃)₃ | CH₃ | H | CH₃ | H |
| 94. | C(CH₃)₃ | H | CH₃ | CH₃ | H |
| 95. | C(CH₃)₃ | CH₃ | CH₃ | CH₃ | H |
| 96. | H | C(CH₃)₃ | H | H | H |
| 97. | CH₃ | C(CH₃)₃ | H | CH₃ | H |
| 98. | H | C(CH₃)₃ | CH₃ | H | H |
| 99. | H | C(CH₃)₃ | H | CH₃ | H |
| 100. | CH₃ | C(CH₃)₃ | CH₃ | H | H |
| 101. | CH₃ | C(CH₃)₃ | H | CH₃ | H |
| 102. | H | C(CH₃)₃ | CH₃ | CH₃ | H |
| 103. | CH₃ | C(CH₃)₃ | CH₃ | CH₃ | H |
| 104. | H | H | C(CH₃)₃ | H | H |
| 105. | CH₃ | H | C(CH₃)₃ | H | H |
| 106. | H | CH₃ | C(CH₃)₃ | H | H |
| 107. | H | H | C(CH₃)₃ | CH₃ | H |
| 108. | CH₃ | CH₃ | C(CH₃)₃ | H | H |
| 109. | CH₃ | H | C(CH₃)₃ | CH₃ | H |
| 110. | H | CH₃ | C(CH₃)₃ | CH₃ | H |
| 111. | CH₃ | CH₃ | C(CH₃)₃ | CH₃ | H |
| 112. | CH₂C(CH₃)₃ | H | H | H | H |
| 113. | CH₂C(CH₃)₃ | CH₃ | H | CH₃ | H |
| 114. | CH₂C(CH₃)₃ | H | CH₃ | H | H |
| 115. | CH₂C(CH₃)₃ | H | H | CH₃ | H |
| 116. | CH₂C(CH₃)₃ | CH₃ | CH₃ | H | H |
| 117. | CH₂C(CH₃)₃ | CH₃ | H | CH₃ | H |
| 118. | CH₂C(CH₃)₃ | H | CH₃ | CH₃ | H |
| 119. | CH₂C(CH₃)₃ | CH₃ | CH₃ | CH₃ | H |
| 120. | H | CH₂C(CH₃)₃ | H | H | H |
| 121. | CH₃ | CH₂C(CH₃)₃ | H | CH₃ | H |
| 122. | H | CH₂C(CH₃)₃ | CH₃ | H | H |
| 123. | H | CH₂C(CH₃)₃ | H | CH₃ | H |
| 124. | CH₃ | CH₂C(CH₃)₃ | CH₃ | H | H |
| 125. | CH₃ | CH₂C(CH₃)₃ | H | CH₃ | H |
| 126. | H | CH₂C(CH₃)₃ | CH₃ | CH₃ | H |
| 127. | CH₃ | CH₂C(CH₃)₃ | CH₃ | CH₃ | H |
| 128. | H | H | CH₂C(CH₃)₃ | H | H |
| 129. | CH₃ | H | CH₂C(CH₃)₃ | H | H |
| 130. | H | CH₃ | CH₂C(CH₃)₃ | H | H |
| 131. | H | H | CH₂C(CH₃)₃ | CH₃ | H |
| 132. | CH₃ | CH₃ | CH₂C(CH₃)₃ | H | H |
| 133. | CH₃ | H | CH₂C(CH₃)₃ | CH₃ | H |
| 134. | H | CH₃ | CH₂C(CH₃)₃ | CH₃ | H |
| 135. | CH₃ | CH₃ | CH₂C(CH₃)₃ | CH₃ | H |
| 136. | 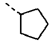 | H | H | H | H |
| 137. | 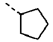 | CH₃ | H | CH₃ | H |
| 138. | 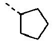 | H | CH₃ | H | H |
| 139. | 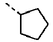 | H | H | CH₃ | H |
| 140. | 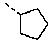 | CH₃ | CH₃ | H | H |
| 141. | 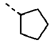 | CH₃ | H | CH₃ | H |
| 142. | 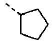 | H | CH₃ | CH₃ | H |
| 143. | 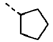 | CH₃ | CH₃ | CH₃ | H |
| 144. | H | 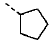 | H | H | H |
| 145. | CH₃ | 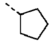 | H | CH₃ | H |
| 146. | H | 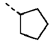 | CH₃ | H | H |
| 147. | H | 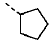 | H | CH₃ | H |
| 148. | CH₃ | 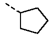 | CH₃ | H | H |
| 149. | CH₃ | 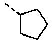 | H | CH₃ | H |
| 150. | H | 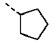 | CH₃ | CH₃ | H |
| 151. | CH₃ | 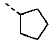 | CH₃ | CH₃ | H |
| 152. | H | H | 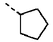 | H | H |
| 153. | CH₃ | H | 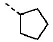 | H | H |
| 154. | H | CH₃ | 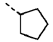 | H | H |
| 155. | H | H | 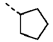 | CH₃ | H |
| 156. | CH₃ | CH₃ | 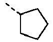 | H | H |
| 157. | CH₃ | H | 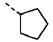 | CH₃ | H |
| 158. | H | CH₃ | 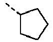 | CH₃ | H |
| 159. | CH₃ | CH₃ | 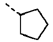 | CH₃ | H |
| 160. | 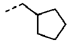 | H | H | H | H |
| 161. | 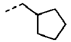 | CH₃ | H | CH₃ | H |
| 162. | 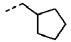 | H | CH₃ | H | H |
| 163. | 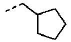 | H | H | CH₃ | H |
| 164. | 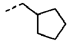 | CH₃ | CH₃ | H | H |
| 165. | 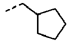 | CH₃ | H | CH₃ | H |
| 166. | 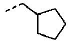 | H | CH₃ | CH₃ | H |
| 167. | 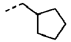 | CH₃ | CH₃ | CH₃ | H |
| 168. | H | 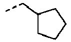 | H | H | H |
| 169. | CH₃ | 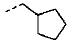 | H | CH₃ | H |
| 170. | H | 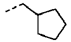 | CH₃ | H | H |
| 171. | H | 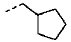 | H | CH₃ | H |
| 172. | CH₃ | 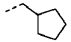 | CH₃ | H | H |
| 173. | CH₃ | 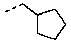 | H | CH₃ | H |
| 174. | H | 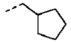 | CH₃ | CH₃ | H |
| 175. | CH₃ | 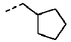 | CH₃ | CH₃ | H |
| 176. | H | H | 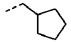 | H | H |
| 177. | CH₃ | H | 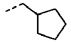 | H | H |
| 178. | H | CH₃ | 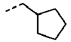 | H | H |
| 179. | H | H | 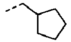 | CH₃ | H |
| 180. | CH₃ | CH₃ | 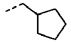 | H | H |
| 181. | CH₃ | H | 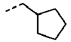 | CH₃ | H |
| 182. | H | CH₃ | 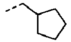 | CH₃ | H |
| 183. | CH₃ | CH₃ | 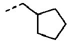 | CH₃ | H |
| 184. | 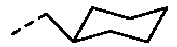 | H | H | H | H |
| 185. | 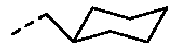 | CH₃ | H | CH₃ | H |
| 186. | 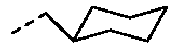 | H | CH₃ | H | H |
| 187. | 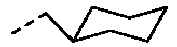 | H | H | CH₃ | H |
| 188. | 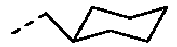 | CH₃ | CH₃ | H | H |
| 189. | 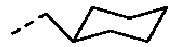 | CH₃ | H | CH₃ | H |
| 190. | 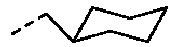 | H | CH₃ | CH₃ | H |
| 191. | 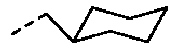 | CH₃ | CH₃ | CH₃ | H |
| 192. | H | 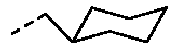 | H | H | H |
| 193. | CH₃ | 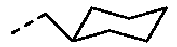 | H | CH₃ | H |
| 194. | H | 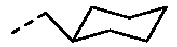 | CH₃ | H | H |
| 195. | H | 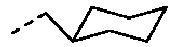 | H | CH₃ | H |
| 196. | CH₃ | 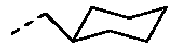 | CH₃ | H | H |
| 197. | CH₃ | 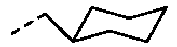 | H | CH₃ | H |
| 198. | H | 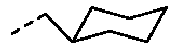 | CH₃ | CH₃ | H |
| 199. | CH₃ | 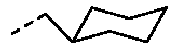 | CH₃ | CH₃ | H |
| 200. | H | H | 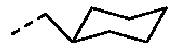 | H | H |
| 201. | CH₃ | H | 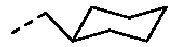 | H | H |
| 202. | H | CH₃ | 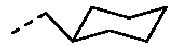 | H | H |
| 203. | H | H | 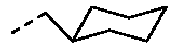 | CH₃ | H |
| 204. | CH₃ | CH₃ | 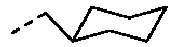 | H | H |
| 205. | CH₃ | H | 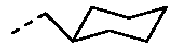 | CH₃ | H |
| 206. | H | CH₃ | 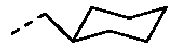 | CH₃ | H |
| 207. | CH₃ | CH₃ | 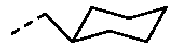 | CH₃ | H |
| 208. | 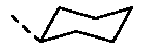 | H | H | H | H |
| 209. | 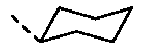 | CH₃ | H | CH₃ | H |
| 210. | 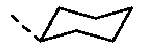 | H | CH₃ | H | H |
| 211. | 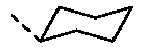 | H | H | CH₃ | H |
| 212. | 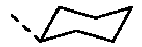 | CH₃ | CH₃ | H | H |
| 213. | 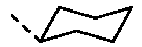 | CH₃ | H | CH₃ | H |
| 214. | 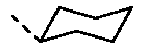 | H | CH₃ | CH₃ | H |
| 215. | 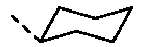 | CH₃ | CH₃ | CH₃ | H |
| 216. | H | 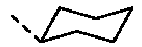 | H | H | H |
| 217. | CH₃ | 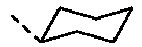 | H | CH₃ | H |
| 218. | H | 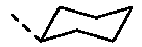 | CH₃ | H | H |
| 219. | H | 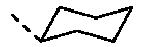 | H | CH₃ | H |
| 220. | CH₃ | 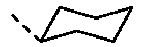 | CH₃ | H | H |
| 221. | CH₃ | 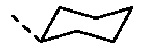 | H | CH₃ | H |
| 222. | H | 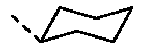 | CH₃ | CH₃ | H |
| 223. | CH₃ | 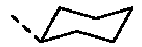 | CH₃ | CH₃ | H |
| 224. | H | H | 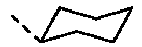 | H | H |
| 225. | CH₃ | H | 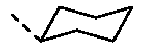 | H | H |
| 226. | H | CH₃ | 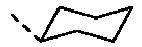 | H | H |
| 227. | H | H | 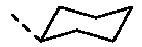 | CH₃ | H |
| 228. | CH₃ | CH₃ | 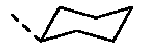 | H | H |
| 229. | CH₃ | H | 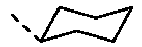 | CH₃ | H |
| 230. | H | CH₃ | 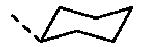 | CH₃ | H |
| 231. | CH₃ | CH₃ | 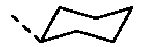 | CH₃ | H |
| 232. | 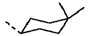 | H | H | H | H |
| 233. | 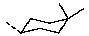 | CH₃ | H | CH₃ | H |
| 234. | 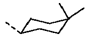 | H | CH₃ | H | H |
| 235. | 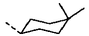 | H | H | CH₃ | H |
| 236. | 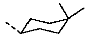 | CH₃ | CH₃ | H | H |
| 237. | 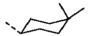 | CH₃ | H | CH₃ | H |
| 238. | 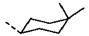 | H | CH₃ | CH₃ | H |
| 239. | 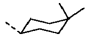 | CH₃ | CH₃ | CH₃ | H |
| 240. | H | 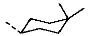 | H | H | H |
| 241. | CH₃ | 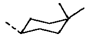 | H | CH₃ | H |
| 242. | H | 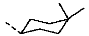 | CH₃ | H | H |
| 243. | H | 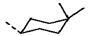 | H | CH₃ | H |
| 244. | CH₃ | 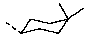 | CH₃ | H | H |
| 245. | CH₃ | 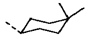 | H | CH₃ | H |
| 246. | H | 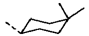 | CH₃ | CH₃ | H |
| 247. | CH₃ | 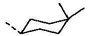 | CH₃ | CH₃ | H |
| 248. | H | H | 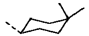 | H | H |
| 249. | CH₃ | H | 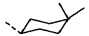 | H | H |
| 250. | H | CH₃ | 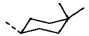 | H | H |
| 251. | H | H | 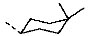 | CH₃ | H |
| 252. | CH₃ | CH₃ | 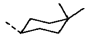 | H | H |
| 253. | CH₃ | H | 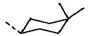 | CH₃ | H |
| 254. | H | CH₃ | 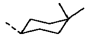 | CH₃ | H |
| 255. | CH₃ | CH₃ | 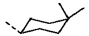 | CH₃ | H |
| 256. | 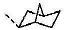 | H | H | H | H |
| 257. | 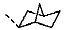 | CH₃ | H | CH₃ | H |
| 258. | 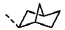 | H | CH₃ | H | H |
| 259. | 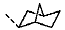 | H | H | CH₃ | H |
| 260. | 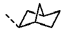 | CH₃ | CH₃ | H | H |
| 261. | 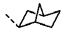 | CH₃ | H | CH₃ | H |
| 262. | 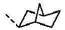 | H | CH₃ | CH₃ | H |
| 263. | 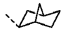 | CH₃ | CH₃ | CH₃ | H |
| 264. | H | 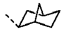 | H | H | H |
| 265. | CH₃ | 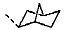 | H | CH₃ | H |
| 266. | H | 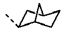 | CH₃ | H | H |
| 267. | H | 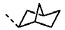 | H | CH₃ | H |
| 268. | CH₃ | 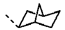 | CH₃ | H | H |
| 269. | CH₃ | 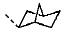 | H | CH₃ | H |
| 270. | H | 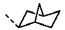 | CH₃ | CH₃ | H |
| 271. | CH₃ | 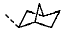 | CH₃ | CH₃ | H |
| 272. | H | H | 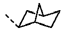 | H | H |
| 273. | CH₃ | H | 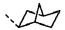 | H | H |
| 274. | H | CH₃ | 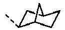 | H | H |
| 275. | H | H | 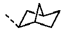 | CH₃ | H |
| 276. | CH₃ | CH₃ | 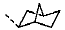 | H | H |
| 277. | CH₃ | H | 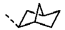 | CH₃ | H |
| 278. | H | CH₃ | 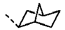 | CH₃ | H |
| 279. | CH₃ | CH₃ | 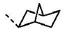 | CH₃ | H |
| 280. | CH(CH₃)₂ | H | CH₂CH₃ | H | H |
| 281. | CH(CH₃)₂ | H | CH(CH₃)₂ | H | H |
| 282. | CH(CH₃)₂ | H | CH₂CH(CH₃)₂ | H | H |
| 283. | CH(CH₃)₂ | H | C(CH₃)₃ | H | H |
| 284. | CH(CH₃)₂ | H | CH₂C(CH₃)₃ | H | H |
| 285. | CH(CH₃)₂ | H | 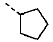 | H | H |
| 286. | CH(CH₃)₂ | H | 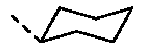 | H | H |
| 287. | CH(CH₃)₂ | H | 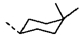 | H | H |
| 288. | CH(CH₃)₂ | H | 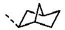 | H | H |
| 289. | CH(CH₃)₂ | H | 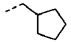 | H | H |
| 290. | CH(CH₃)₂ | H | 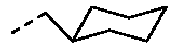 | H | H |
| 291. | C(CH₃)₃ | H | CH₂CH₃ | H | H |
| 292. | C(CH₃)₃ | H | CH(CH₃)₂ | H | H |
| 293. | C(CH₃)₃ | H | CH₂CH(CH₃)₂ | H | H |
| 294. | C(CH₃)₃ | H | C(CH₃)₃ | H | H |
| 295. | C(CH₃)₃ | H | CH₂C(CH₃)₃ | H | H |
| 296. | C(CH₃)₃ | H | 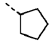 | H | H |
| 297. | C(CH₃)₃ | H | 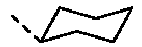 | H | H |
| 298. | C(CH₃)₃ | H | 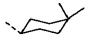 | H | H |
| 299. | C(CH₃)₃ | H | 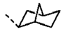 | H | H |
| 300. | C(CH₃)₃ | H | 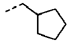 | H | H |
| 301. | C(CH₃)₃ | H | 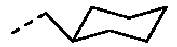 | H | H |
| 302. | CH₂C(CH₃)₃ | H | CH₂CH₃ | H | H |
| 303. | CH₂C(CH₃)₃ | H | CH(CH₃)₂ | H | H |
| 304. | CH₂C(CH₃)₃ | H | CH₂CH(CH₃)₂ | H | H |
| 305. | CH₂C(CH₃)₃ | H | C(CH₃)₃ | H | H |
| 306. | CH₂C(CH₃)₃ | H | CH₂C(CH₃)₃ | H | H |
| 307. | CH₂C(CH₃)₃ | H | CH₂CH₂CF₃ | H | H |
| 308. | CH₂C(CH₃)₃ | H | CH₂C(CH₃)₂CF₃ | H | H |
| 309. | CH₂C(CH₃)₃ | H | 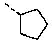 | H | H |
| 310. | CH₂C(CH₃)₃ | H | 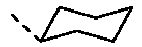 | H | H |
| 311. | CH₂C(CH₃)₃ | H | 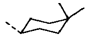 | H | H |
| 312. | CH₂C(CH₃)₃ | H | 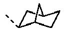 | H | H |
| 313. | CH₂C(CH₃)₃ | H | 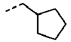 | H | H |
| 314. | CH₂C(CH₃)₃ | H | 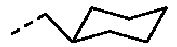 | H | H |
| 315. | 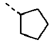 | H | CH₂CH₃ | H | H |
| 316. | 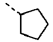 | H | CH(CH₃)₂ | H | H |
| 317. | 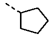 | H | CH₂CH(CH₃)₂ | H | H |
| 318. | 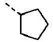 | H | C(CH₃)₃ | H | H |
| 319. | 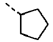 | H | CH₂C(CH₃)₃ | H | H |
| 320. | 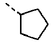 | H | 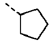 | H | H |
| 321. | 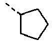 | H | 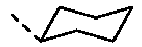 | H | H |
| 322. | 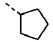 | H | 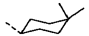 | H | H |
| 323. | 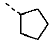 | H | 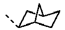 | H | H |
| 324. | 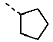 | H | 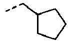 | H | H |
| 325. | 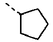 | H | 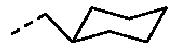 | H | H |
| 326. | 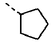 | H | CH₂CH₃ | H | H |
| 327. | 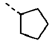 | H | CH(CH₃)₂ | H | H |
| 328. | 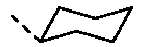 | H | CH₂CH(CH₃)₂ | H | H |
| 329. | 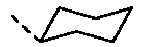 | H | C(CH₃)₃ | H | H |
| 330. | 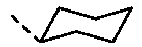 | H | CH₂C(CH₃)₃ | H | H |
| 331. | 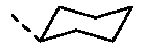 | H | 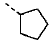 | H | H |
| 332. | 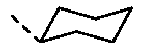 | H | 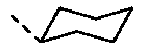 | H | H |
| 333. | 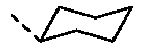 | H | 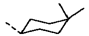 | H | H |
| 334. | 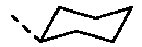 | H | 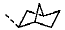 | H | H |
| 335. | 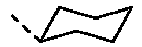 | H | 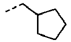 | H | H |
| 336. | 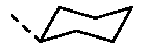 | H | 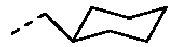 | H | H |
| 337. | 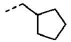 | H | CH₂CH(CH₃)₂ | H | H |
| 338. | 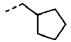 | H | C(CH₃)₃ | H | H |
| 339. | 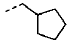 | H | CH₂C(CH₃)₃ | H | H |
| 340. | 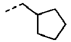 | H | 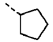 | H | H |
| 341. | 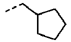 | H | 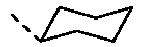 | H | H |
| 342. | 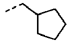 | H | 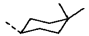 | H | H |
| 343. | 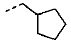 | H | 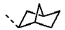 | H | H |
| 344. | 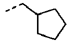 | H | 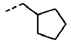 | H | H |
| 345. | 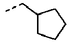 | H | 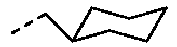 | H | H |
| 346. | 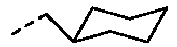 | H | CH₂CH(CH₃)₂ | H | H |
| 347. | 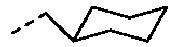 | H | C(CH₃)₃ | H | H |
| 348. | 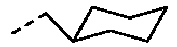 | H | CH₂C(CH₃)₃ | H | H |
| 349. | 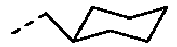 | H | 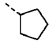 | H | H |
| 350. | 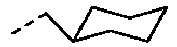 | H | 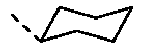 | H | H |
| 351. | 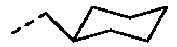 | H | 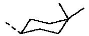 | H | H |
| 352. | 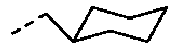 | H | 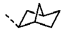 | H | H |
| 353. | 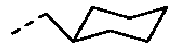 | H | 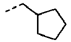 | H | H |
| 354. | 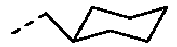 | H | 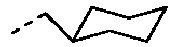 | H | H |
| 355. | 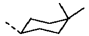 | H | CH₂CH(CH₃)₂ | H | H |
| 356. | 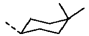 | H | C(CH₃)₃ | H | H |
| 357. | 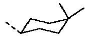 | H | CH₂C(CH₃)₃ | H | H |
| 358. | 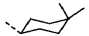 | H | 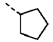 | H | H |
| 359. | 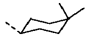 | H | 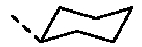 | H | H |
| 360. | 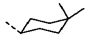 | H | 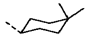 | H | H |
| 361. | 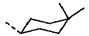 | H | 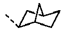 | H | H |
| 362. | 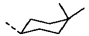 | H | 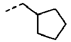 | H | H |
| 363. | 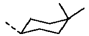 | H | 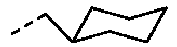 | H | H |
| 364. | H | H | H | H | H |
| 365. | CD₃ | H | H | H | H |
| 366. | H | CD₃ | H | H | H |
| 367. | H | H | CD₃ | H | H |
| 368. | CD₃ | CD₃ | H | CD₃ | H |
| 369. | CD₃ | H | CD₃ | H | H |
| 370. | CD₃ | H | H | CD₃ | H |
| 371. | H | CD₃ | CD₃ | H | H |
| 372. | H | CD₃ | H | CD₃ | H |
| 373. | H | H | CD₃ | CD₃ | H |
| 374. | CD₃ | CD₃ | CD₃ | H | H |
| 375. | CD₃ | CD₃ | H | CD₃ | H |
| 376. | CD₃ | H | CD₃ | CD₃ | H |
| 377. | H | CD₃ | CD₃ | CD₃ | H |
| 378. | CD₃ | CD₃ | CD₃ | CD₃ | H |
| 379. | CD₂CH₃ | H | H | H | H |
| 380. | CD₂CH₃ | CD₃ | H | CD₃ | H |
| 381. | CD₂CH₃ | H | CD₃ | H | H |
| 382. | CD₂CH₃ | H | H | CD₃ | H |
| 383. | CD₂CH₃ | CD₃ | CD₃ | H | H |
| 384. | CD₂CH₃ | CD₃ | H | CD₃ | H |
| 385. | CD₂CH₃ | H | CD₃ | CD₃ | H |
| 386. | CD₂CH₃ | CD₃ | CD₃ | CD₃ | H |
| 387. | H | CD₂CH₃ | H | H | H |
| 388. | CH₃ | CD₂CH₃ | H | CD₃ | H |
| 389. | H | CD₂CH₃ | CD₃ | H | H |
| 390. | H | CD₂CH₃ | H | CD₃ | H |
| 391. | CD₃ | CD₂CH₃ | CD₃ | H | H |
| 392. | CD₃ | CD₂CH₃ | H | CD₃ | H |
| 393. | H | CD₂CH₃ | CD₃ | CD₃ | H |
| 394. | CD₃ | CD₂CH₃ | CD₃ | CD₃ | H |
| 395. | H | H | CD₂CH₃ | H | H |
| 396. | CD₃ | H | CD₂CH₃ | H | H |
| 397. | H | CD₃ | CD₂CH₃ | H | H |
| 398. | H | H | CD₂CH₃ | CD₃ | H |
| 399. | CD₃ | CD₃ | CD₂CH₃ | H | H |
| 400. | CD₃ | H | CD₂CH₃ | CD₃ | H |
| 401. | H | CD₃ | CD₂CH₃ | CD₃ | H |
| 402. | CD₃ | CD₃ | CD₂CH₃ | CD₃ | H |
| 403. | CD(CH₃)₂ | H | H | H | H |
| 404. | CD(CH₃)₂ | CD₃ | H | CD₃ | H |
| 405. | CD(CH₃)₂ | H | CD₃ | H | H |
| 406. | CD(CH₃)₂ | H | H | CD₃ | H |
| 407. | CD(CH₃)₂ | CD₃ | CD₃ | H | H |
| 408. | CD(CH₃)₂ | CD₃ | H | CD₃ | H |
| 409. | CD(CH₃)₂ | H | CD₃ | CD₃ | H |
| 410. | CD(CH₃)₂ | CD₃ | CD₃ | CD₃ | H |
| 411. | H | CD(CH₃)₂ | H | H | H |
| 412. | CD₃ | CD(CH₃)₂ | H | CD₃ | H |
| 413. | H | CD(CH₃)₂ | CD₃ | H | H |
| 414. | H | CD(CH₃)₂ | H | CD₃ | H |
| 415. | CD₃ | CD(CH₃)₂ | CD₃ | H | H |
| 416. | CD₃ | CD(CH₃)₂ | H | CD₃ | H |
| 417. | H | CD(CH₃)₂ | CD₃ | CD₃ | H |
| 418. | CD₃ | CD(CH₃)₂ | CD₃ | CD₃ | H |
| 419. | H | H | CD(CH₃)₂ | H | H |
| 420. | CD₃ | H | CD(CH₃)₂ | H | H |
| 421. | H | CD₃ | CD(CH₃)₂ | H | H |
| 422. | H | H | CD(CH₃)₂ | CD₃ | H |
| 423. | CD₃ | CD₃ | CD(CH₃)₂ | H | H |
| 424. | CD₃ | H | CD(CH₃)₂ | CD₃ | H |
| 425. | H | CD₃ | CD(CH₃)₂ | CD₃ | H |
| 426. | CD₃ | CD₃ | CD(CH₃)₂ | CD₃ | H |
| 427. | CD(CD₃)₂ | H | H | H | H |
| 428. | CD(CD₃)₂ | CD₃ | H | CD₃ | H |
| 429. | CD(CD₃)₂ | H | CD₃ | H | H |
| 430. | CD(CD₃)₂ | H | H | CD₃ | H |
| 431. | CD(CD₃)₂ | CD₃ | CD₃ | H | H |
| 432. | CD(CD₃)₂ | CD₃ | H | CD₃ | H |
| 433. | CD(CD₃)₂ | H | CD₃ | CD₃ | H |
| 434. | CD(CD₃)₂ | CD₃ | CD₃ | CD₃ | H |
| 435. | H | CD(CD₃)₂ | H | H | H |
| 436. | CH₃ | CD(CD₃)₂ | H | CD₃ | H |
| 437. | H | CD(CD₃)₂ | CD₃ | H | H |
| 438. | H | CD(CD₃)₂ | H | CD₃ | H |
| 439. | CD₃ | CD(CD₃)₂ | CD₃ | H | H |
| 440. | CD₃ | CD(CD₃)₂ | H | CD₃ | H |
| 441. | H | CD(CD₃)₂ | CD₃ | CD₃ | H |
| 442. | CD₃ | CD(CD₃)₂ | CD₃ | CD₃ | H |
| 443. | H | H | CD(CD₃)₂ | H | H |
| 444. | CD₃ | H | CD(CD₃)₂ | H | H |
| 445. | H | CD₃ | CD(CD₃)₂ | H | H |
| 446. | H | H | CD(CD₃)₂ | CD₃ | H |
| 447. | CD₃ | CD₃ | CD(CD₃)₂ | H | H |
| 448. | CD₃ | H | CD(CD₃)₂ | CD₃ | H |
| 449. | H | CD₃ | CD(CD₃)₂ | CD₃ | H |
| 450. | CD₃ | CD₃ | CD(CD₃)₂ | CD₃ | H |
| 451. | CD₂CH(CH₃)₂ | H | H | H | H |
| 452. | CD₂CH(CH₃)₂ | CD₃ | H | CD₃ | H |
| 453. | CD₂CH(CH₃)₂ | H | CD₃ | H | H |
| 454. | CD₂CH(CH₃)₂ | H | H | CD₃ | H |
| 455. | CD₂CH(CH₃)₂ | CD₃ | CD₃ | H | H |
| 456. | CD₂CH(CH₃)₂ | CD₃ | H | CD₃ | H |
| 457. | CD₂CH(CH₃)₂ | H | CD₃ | CD₃ | H |
| 458. | CD₂CH(CH₃)₂ | CD₃ | CD₃ | CD₃ | H |
| 459. | H | CD₂CH(CH₃)₂ | H | H | H |
| 460. | CD₃ | CD₂CH(CH₃)₂ | H | CD₃ | H |
| 461. | H | CD₂CH(CH₃)₂ | CD₃ | H | H |
| 462. | H | CD₂CH(CH₃)₂ | H | CD₃ | H |
| 463. | CD₃ | CD₂CH(CH₃)₂ | CD₃ | H | H |
| 464. | CD₃ | CD₂CH(CH₃)₂ | H | CD₃ | H |
| 465. | H | CD₂CH(CH₃)₂ | CD₃ | CD₃ | H |
| 466. | CD₃ | CD₂CH(CH₃)₂ | CD₃ | CD₃ | H |
| 467. | H | H | CD₂CH(CH₃)₂ | H | H |
| 468. | CD₃ | H | CD₂CH(CH₃)₂ | H | H |
| 469. | H | CD₃ | CD₂CH(CH₃)₂ | H | H |
| 470. | H | H | CD₂CH(CH₃)₂ | CD₃ | H |
| 471. | CD₃ | CD₃ | CD₂CH(CH₃)₂ | H | H |
| 472. | CD₃ | H | CD₂CH(CH₃)₂ | CD₃ | H |
| 473. | H | CD₃ | CD₂CH(CH₃)₂ | CD₃ | H |
| 474. | CD₃ | CD₃ | CD₂CH(CH₃)₂ | CD₃ | H |
| 475. | CD₂C(CH₃)₃ | H | H | H | H |
| 476. | CD₂C(CH₃)₃ | CD₃ | H | CD₃ | H |
| 477. | CD₂C(CH₃)₃ | H | CD₃ | H | H |
| 478. | CD₂C(CH₃)₃ | H | H | CD₃ | H |
| 479. | CD₂C(CH₃)₃ | CD₃ | CD₃ | H | H |
| 480. | CD₂C(CH₃)₃ | CD₃ | H | CD₃ | H |
| 481. | CD₂C(CH₃)₃ | H | CD₃ | CD₃ | H |
| 482. | CD₂C(CH₃)₃ | CH₃ | CD₃ | CD₃ | H |
| 483. | H | CD₂C(CH₃)₃ | H | H | H |
| 484. | CD₃ | CD₂C(CH₃)₃ | H | CD₃ | H |
| 485. | H | CD₂C(CH₃)₃ | CD₃ | H | H |
| 486. | H | CD₂C(CH₃)₃ | H | CD₃ | H |
| 487. | CD₃ | CD₂C(CH₃)₃ | CD₃ | H | H |
| 488. | CD₃ | CD₂C(CH₃)₃ | H | CD₃ | H |
| 489. | H | CD₂C(CH₃)₃ | CD₃ | CD₃ | H |
| 490. | CD₃ | CD₂C(CH₃)₃ | CD₃ | CD₃ | H |
| 491. | H | H | CD₂C(CH₃)₃ | H | H |
| 492. | CD₃ | H | CD₂C(CH₃)₃ | H | H |
| 493. | H | CD₃ | CD₂C(CH₃)₃ | H | H |
| 494. | H | H | CD₂C(CH₃)₃ | CD₃ | H |
| 495. | CD₃ | CD₃ | CD₂C(CH₃)₃ | H | H |
| 496. | CD₃ | H | CD₂C(CH₃)₃ | CD₃ | H |
| 497. | H | CD₃ | CD₂C(CH₃)₃ | CD₃ | H |
| 498. | CD₃ | CD₃ | CD₂C(CH₃)₃ | CD₃ | H |
| 499. | 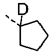 | H | H | H | H |
| 500. | 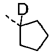 | CD₃ | H | CD₃ | H |
| 501. | 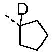 | H | CD₃ | H | H |
| 502. | 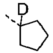 | H | H | CD₃ | H |
| 503. | 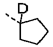 | CD₃ | CD₃ | H | H |
| 504. | 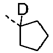 | CD₃ | H | CD₃ | H |
| 505. | 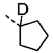 | H | CD₃ | CD₃ | H |
| 506. | 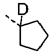 | CD₃ | CD₃ | CD₃ | H |
| 507. | H | 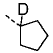 | H | H | H |
| 508. | CD₃ | 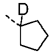 | H | CD₃ | H |
| 509. | H | 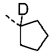 | CD₃ | H | H |
| 510. | H | 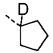 | H | CD₃ | H |
| 511. | CD₃ | 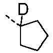 | CD₃ | H | H |
| 512. | CD₃ | 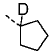 | H | CD₃ | H |
| 513. | H | 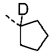 | CD₃ | CD₃ | H |
| 514. | CD₃ | 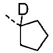 | CD₃ | CD₃ | H |
| 515. | H | H | 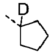 | H | H |
| 516. | CD₃ | H | 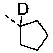 | H | H |
| 517. | H | CD₃ | 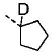 | H | H |
| 518. | H | H | 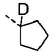 | CD₃ | H |
| 519. | CD₃ | CD₃ | 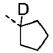 | H | H |
| 520. | CD₃ | H | 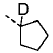 | CD₃ | H |
| 521. | H | CD₃ | 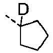 | CD₃ | H |
| 522. | CD₃ | CD₃ | 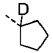 | CD₃ | H |
| 523. | 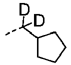 | H | H | H | H |
| 524. | 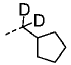 | CD₃ | H | CD₃ | H |
| 525. | 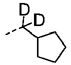 | H | CD₃ | H | H |
| 526. | 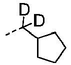 | H | H | CD₃ | H |
| 527. | 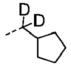 | CD₃ | CD₃ | H | H |
| 528. | 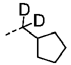 | CD₃ | H | CD₃ | H |
| 529. | 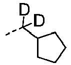 | H | CD₃ | CD₃ | H |
| 530. | 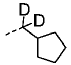 | CD₃ | CD₃ | CD₃ | H |
| 531. | H | 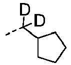 | H | H | H |
| 532. | CH₃ | 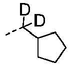 | H | CD₃ | H |
| 533. | H | 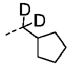 | CD₃ | H | H |
| 534. | H | 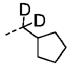 | H | CD₃ | H |
| 535. | CD₃ | 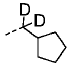 | CD₃ | H | H |
| 536. | CD₃ | 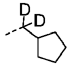 | H | CD₃ | H |
| 537. | H | 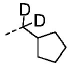 | CD₃ | CD₃ | H |
| 538. | CH₃ | 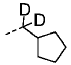 | CD₃ | CD₃ | H |
| 539. | H | H | 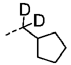 | H | H |
| 540. | CD₃ | H | 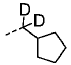 | H | H |
| 541. | H | CD₃ | 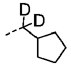 | H | H |
| 542. | H | H | 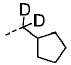 | CD₃ | H |
| 543. | CD₃ | CD₃ | 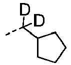 | H | H |
| 544. | CD₃ | H | 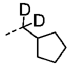 | CD₃ | H |
| 545. | H | CD₃ | 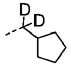 | CD₃ | H |
| 546. | CD₃ | CD₃ | 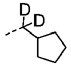 | CD₃ | H |
| 547. | 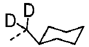 | H | H | H | H |
| 548. | 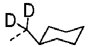 | CD₃ | H | CD₃ | H |
| 549. | 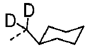 | H | CD₃ | H | H |
| 550. | 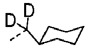 | H | H | CD₃ | H |
| 551. | 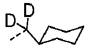 | CD₃ | CD₃ | H | H |
| 552. | 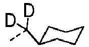 | CD₃ | H | CD₃ | H |
| 553. | 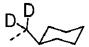 | H | CD₃ | CD₃ | H |
| 554. | 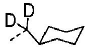 | CD₃ | CD₃ | CD₃ | H |
| 555. | H | 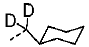 | H | H | H |
| 556. | CD₃ | 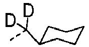 | H | CD₃ | H |
| 557. | H | 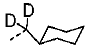 | CD₃ | H | H |
| 558. | H | 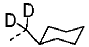 | H | CD₃ | H |
| 559. | CD₃ | 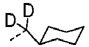 | CD₃ | H | H |
| 560. | CD₃ | 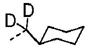 | H | CD₃ | H |
| 561. | H | 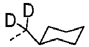 | CD₃ | CD₃ | H |
| 562. | CD₃ | 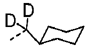 | CD₃ | CD₃ | H |
| 563. | H | H | 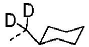 | H | H |
| 564. | CD₃ | H | 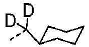 | H | H |
| 565. | H | CD₃ | 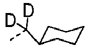 | H | H |
| 566. | H | H | 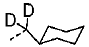 | CD₃ | H |
| 567. | CD₃ | CD₃ | 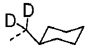 | H | H |
| 568. | CD₃ | H | 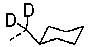 | CD₃ | H |
| 569. | H | CD₃ | 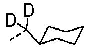 | CD₃ | H |
| 570. | CD₃ | CD₃ | 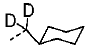 | CD₃ | H |
| 571. | 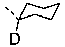 | H | H | H | H |
| 572. | 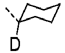 | CD₃ | H | CD₃ | H |
| 573. | 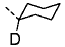 | H | CD₃ | H | H |
| 574. | 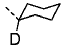 | H | H | CD₃ | H |
| 575. | 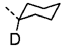 | CD₃ | CD₃ | H | H |
| 576. | 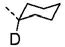 | CD₃ | H | CD₃ | H |
| 577. | 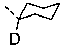 | H | CD₃ | CD₃ | H |
| 578. | 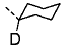 | CD₃ | CD₃ | CD₃ | H |
| 579. | H | 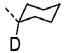 | H | H | H |
| 580. | CD₃ | 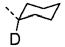 | H | CD₃ | H |
| 581. | H | 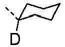 | CD₃ | H | H |
| 582. | H | 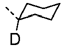 | H | CD₃ | H |
| 583. | CD₃ | 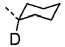 | CD₃ | H | H |
| 584. | CD₃ | 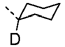 | H | CD₃ | H |
| 585. | H | 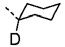 | CD₃ | CD₃ | H |
| 586. | CD₃ | 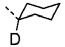 | CD₃ | CD₃ | H |
| 587. | H | H | 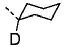 | H | H |
| 588. | CD₃ | H | 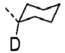 | H | H |
| 589. | H | CD₃ | 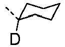 | H | H |
| 590. | H | H | 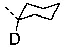 | CD₃ | H |
| 591. | CD₃ | CD₃ | 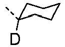 | H | H |
| 592. | CD₃ | H | 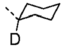 | CD₃ | H |
| 593. | H | CD₃ | 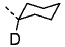 | CD₃ | H |
| 594. | CD₃ | CD₃ | 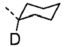 | CD₃ | H |
| 595. | 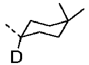 | H | H | H | H |
| 596. | 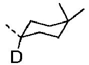 | CD₃ | H | CD₃ | H |
| 597. | 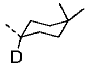 | H | CD₃ | H | H |
| 598. | 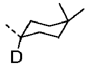 | H | H | CD₃ | H |
| 599. | 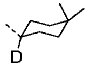 | CD₃ | CD₃ | H | H |
| 600. | 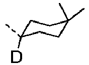 | CD₃ | H | CD₃ | H |
| 601. | 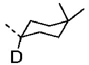 | H | CD₃ | CD₃ | H |
| 602. | 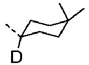 | CD₃ | CD₃ | CD₃ | H |
| 603. | H | 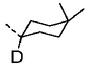 | H | H | H |
| 604. | CD₃ | 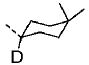 | H | CD₃ | H |
| 605. | H | 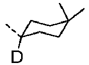 | CD₃ | H | H |
| 606. | H | 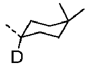 | H | CD₃ | H |
| 607. | CD₃ | 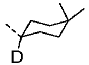 | CD₃ | H | H |
| 608. | CD₃ | 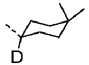 | H | CD₃ | H |
| 609. | H | 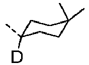 | CD₃ | CD₃ | H |
| 610. | CD₃ | 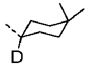 | CD₃ | CD₃ | H |
| 611. | H | H | 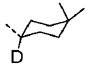 | H | H |
| 612. | CD₃ | H | 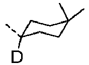 | H | H |
| 613. | H | CD₃ | 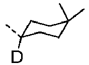 | H | H |
| 614. | H | H | 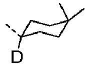 | CD₃ | H |
| 615. | CD₃ | CD₃ | 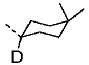 | H | H |
| 616. | CD₃ | H | 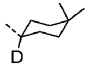 | CD₃ | H |
| 617. | H | CD₃ | 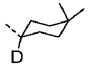 | CD₃ | H |
| 618. | CD₃ | CD₃ | 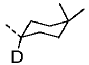 | CD₃ | H |
| 619. | 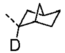 | H | H | H | H |
| 620. | 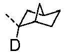 | CD₃ | H | CD₃ | H |
| 621. | 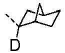 | H | CD₃ | H | H |
| 622. | 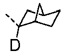 | H | H | CD₃ | H |
| 623. | 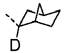 | CH₃ | CH₃ | H | H |
| 624. | 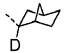 | CD₃ | H | CD₃ | H |
| 625. | 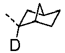 | H | CD₃ | CD₃ | H |
| 626. | 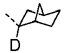 | CD₃ | CD₃ | CD₃ | H |
| 627. | 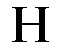 | 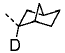 | H | H | H |
| 628. | 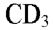 | 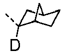 | H | CD₃ | H |
| 629. | H | 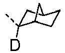 | CD₃ | H | H |
| 630. | H | 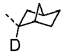 | H | CD₃ | H |
| 631. | CD₃ | 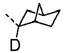 | CD₃ | H | H |
| 632. | CD₃ | 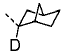 | H | CD₃ | H |
| 633. | H | 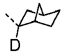 | CD₃ | CD₃ | H |
| 634. | CD₃ | 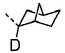 | CD₃ | CD₃ | H |
| 635. | H | H | 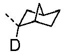 | H | H |
| 636. | CD₃ | H | 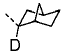 | H | H |
| 637. | H | CD₃ | 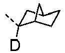 | H | H |
| 638. | H | H | 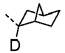 | CH₃ | H |
| 639. | CD₃ | CD₃ | 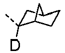 | H | H |
| 640. | CD₃ | H | 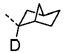 | CD₃ | H |
| 641. | H | CD₃ | 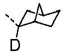 | CD₃ | H |
| 642. | CD₃ | CD₃ | 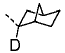 | CD₃ | H |
| 643. | CD(CH₃)₂ | H | CD₂CH₃ | H | H |
| 644. | CD(CH₃)₂ | H | CD(CH₃)₂ | H | H |
| 645. | CD(CH₃)₂ | H | CD₂CH(CH₃)₂ | H | H |
| 646. | CD(CH₃)₂ | H | C(CH₃)₃ | H | H |
| 647. | CD(CH₃)₂ | H | CD₂C(CH₃)₃ | H | H |
| 648. | CD(CH₃)₂ | H | 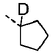 | H | H |
| 649. | CD(CH₃)₂ | H | 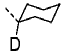 | H | H |
| 650. | CD(CH₃)₂ | H | 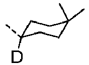 | H | H |
| 651. | CD(CH₃)₂ | H | 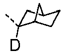 | H | H |
| 652. | CD(CH₃)₂ | H | 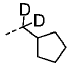 | H | H |
| 653. | CD(CH₃)₂ | H | 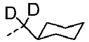 | H | H |
| 654. | C(CH₃)₃ | H | CD₂CH₃ | H | H |
| 655. | C(CH₃)₃ | H | CD(CH₃)₂ | H | H |
| 656. | C(CH₃)₃ | H | CD₂CH(CH₃)₂ | H | H |
| 657. | C(CH₃)₃ | H | C(CH₃)₃ | H | H |
| 658. | C(CH₃)₃ | H | CD₂C(CH₃)₃ | H | H |
| 659. | C(CH₃)₃ | H | 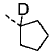 | H | H |
| 660. | C(CH₃)₃ | H | 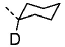 | H | H |
| 661. | C(CH₃)₃ | H | 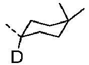 | H | H |
| 662. | C(CH₃)₃ | H | 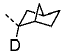 | H | H |
| 663. | C(CH₃)₃ | H | 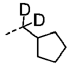 | H | H |
| 664. | C(CH₃)₃ | H | 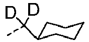 | H | H |
| 665. | CD₂C(CH₃)₃ | H | CD₂CH₃ | H | H |
| 666. | CD₂C(CH₃)₃ | H | CD(CH₃)₂ | H | H |
| 667. | CD₂C(CH₃)₃ | H | CD₂CH(CH₃)₂ | H | H |
| 668. | CD₂C(CH₃)₃ | H | C(CH₃)₃ | H | H |
| 669. | CD₂C(CH₃)₃ | H | CD₂C(CH₃)₃ | H | H |
| 670. | CD₂C(CH₃)₃ | H | 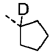 | H | H |
| 671. | CD₂C(CH₃)₃ | H | 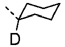 | H | H |
| 672. | CD₂C(CH₃)₃ | H | 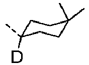 | H | H |
| 673. | CD₂C(CH₃)₃ | H | 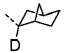 | H | H |
| 674. | CD₂C(CH₃)₃ | H | 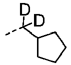 | H | H |
| 675. | CD₂C(CH₃)₃ | H | 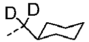 | H | H |
| 676. | 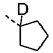 | H | CD₂CH₃ | H | H |
| 677. | 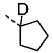 | H | CD(CH₃)₂ | H | H |
| 678. | 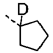 | H | CD₂CH(CH₃)₂ | H | H |
| 679. | 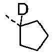 | H | C(CH₃)₃ | H | H |
| 680. | 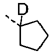 | H | CD₂C(CH₃)₃ | H | H |
| 681. | 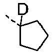 | H | 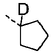 | H | H |
| 682. | 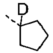 | H | 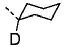 | H | H |
| 683. | 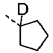 | H | 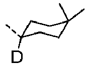 | H | H |
| 684. | 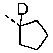 | H | 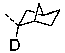 | H | H |
| 685. | 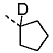 | H | 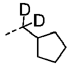 | H | H |
| 686. | 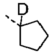 | H | 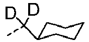 | H | H |
| 687. | 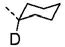 | H | CD₂CH₃ | H | H |
| 688. | 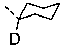 | H | CD(CH₃)₂ | H | H |
| 689. | 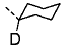 | H | CD₂CH(CH₃)₂ | H | H |
| 690. | 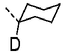 | H | C(CH₃)₃ | H | H |
| 691. | 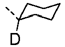 | H | CD₂C(CH₃)₃ | H | H |
| 692. | 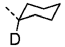 | H | 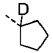 | H | H |
| 693. | 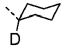 | H | 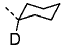 | H | H |
| 694. | 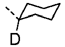 | H | 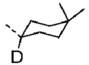 | H | H |
| 695. | 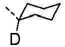 | H | 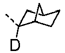 | H | H |
| 696. | 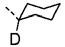 | H | 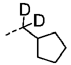 | H | H |
| 697. | 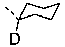 | H | 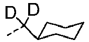 | H | H |
| 698. | 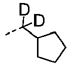 | H | CD₂CH₃ | H | H |
| 699. | 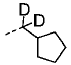 | H | CD(CH₃)₂ | H | H |
| 700. | 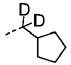 | H | CD₂CH(CH₃)₂ | H | H |
| 701. | 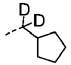 | H | C(CH₃)₃ | H | H |
| 702. | 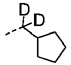 | H | CD₂C(CH₃)₃ | H | H |
| 703. | 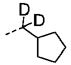 | H | 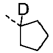 | H | H |
| 704. | 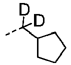 | H | 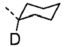 | H | H |
| 705. | 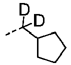 | H | 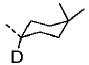 | H | H |
| 706. | 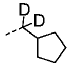 | H | 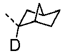 | H | H |
| 707. | 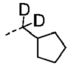 | H | 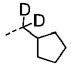 | H | H |
| 708. | 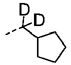 | H | 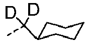 | H | H |
| 709. | 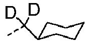 | H | CD₂CH₃ | H | H |
| 710. | 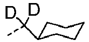 | H | CD(CH₃)₂ | H | H |
| 711. | 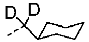 | H | CD₂CH(CH₃)₂ | H | H |
| 712. | 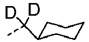 | H | C(CH₃)₃ | H | H |
| 713. | 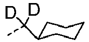 | H | CD₂C(CH₃)₃ | H | H |
| 714. | 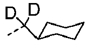 | H | 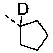 | H | H |
| 715. | 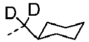 | H | 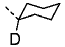 | H | H |
| 716. | 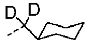 | H | 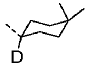 | H | H |
| 717. | 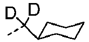 | H | 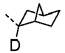 | H | H |
| 718. | 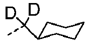 | H | 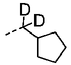 | H | H |
| 719. | 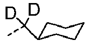 | H | 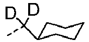 | H | H |
| 720. | 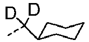 | H | CD₂CH₃ | H | H |
| 721. | 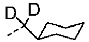 | H | CD(CH₃)₂ | H | H |
| 722. | 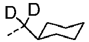 | H | CD₂CH(CH₃)₂ | H | H |
| 723. | 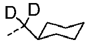 | H | C(CH₃)₃ | H | H |
| 724. | 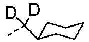 | H | CD₂C(CH₃)₃ | H | H |
| 725. | 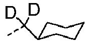 | H | 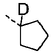 | H | H |
| 726. | 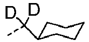 | H | 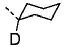 | H | H |
| 727. | 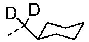 | H | 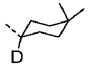 | H | H |
| 728. | 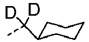 | H | 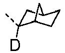 | H | H |
| 729. | 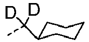 | H | 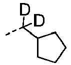 | H | H |
| 730. | 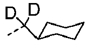 | H | 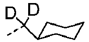 | H | H |
| 731. | H | H | H | H | Ph |
| 732. | CH₃ | H | H | H | Ph |
| 733. | H | CH₃ | H | H | Ph |
| 734. | H | H | CH₃ | H | Ph |
| 735. | CH₃ | CH₃ | H | CH₃ | Ph |
| 736. | CH₃ | H | CH₃ | H | Ph |
| 737. | CH₃ | H | H | CH₃ | Ph |
| 738. | H | CH₃ | CH₃ | H | Ph |
| 739. | H | CH₃ | H | CH₃ | Ph |
| 740. | H | H | CH₃ | CH₃ | Ph |
| 741. | CH₃ | CH₃ | CH₃ | H | Ph |
| 742. | CH₃ | CH₃ | H | CH₃ | Ph |
| 743. | CH₃ | H | CH₃ | CH₃ | Ph |
| 744. | H | CH₃ | CH₃ | CH₃ | Ph |
| 745. | CH₃ | CH₃ | CH₃ | CH₃ | Ph |
| 746. | CH₂CH₃ | H | H | H | Ph |
| 747. | CH₂CH₃ | CH₃ | H | CH₃ | Ph |
| 748. | CH₂CH₃ | H | CH₃ | H | Ph |
| 749. | CH₂CH₃ | H | H | CH₃ | Ph |
| 750. | CH₂CH₃ | CH₃ | CH₃ | H | Ph |
| 751. | CH₂CH₃ | CH₃ | H | CH₃ | Ph |
| 752. | CH₂CH₃ | H | CH₃ | CH₃ | Ph |
| 753. | CH₂CH₃ | CH₃ | CH₃ | CH₃ | Ph |
| 754. | H | CH₂CH₃ | H | H | Ph |
| 755. | CH₃ | CH₂CH₃ | H | CH₃ | Ph |
| 756. | H | CH₂CH₃ | CH₃ | H | Ph |
| 757. | H | CH₂CH₃ | H | CH₃ | Ph |
| 758. | CH₃ | CH₂CH₃ | CH₃ | H | Ph |
| 759. | CH₃ | CH₂CH₃ | H | CH₃ | Ph |
| 760. | H | CH₂CH₃ | CH₃ | CH₃ | Ph |
| 761. | CH₃ | CH₂CH₃ | CH₃ | CH₃ | Ph |
| 762. | H | H | CH₂CH₃ | H | Ph |
| 763. | CH₃ | H | CH₂CH₃ | H | Ph |
| 764. | H | CH₃ | CH₂CH₃ | H | Ph |
| 765. | H | H | CH₂CH₃ | CH₃ | Ph |
| 766. | CH₃ | CH₃ | CH₂CH₃ | H | Ph |
| 767. | CH₃ | H | CH₂CH₃ | CH₃ | Ph |
| 768. | H | CH₃ | CH₂CH₃ | CH₃ | Ph |
| 769. | CH₃ | CH₃ | CH₂CH₃ | CH₃ | Ph |
| 770. | CH(CH₃)₂ | H | H | H | Ph |
| 771. | CH(CH₃)₂ | CH₃ | H | CH₃ | Ph |
| 772. | CH(CH₃)₂ | H | CH₃ | H | Ph |
| 773. | CH(CH₃)₂ | H | H | CH₃ | Ph |
| 774. | CH(CH₃)₂ | CH₃ | CH₃ | H | Ph |
| 775. | CH(CH₃)₂ | CH₃ | H | CH₃ | Ph |
| 776. | CH(CH₃)₂ | H | CH₃ | CH₃ | Ph |
| 777. | CH(CH₃)₂ | CH₃ | CH₃ | CH₃ | Ph |
| 778. | H | CH(CH₃)₂ | H | H | Ph |
| 779. | CH₃ | CH(CH₃)₂ | H | CH₃ | Ph |
| 780. | H | CH(CH₃)₂ | CH₃ | H | Ph |
| 781. | H | CH(CH₃)₂ | H | CH₃ | Ph |
| 782. | CH₃ | CH(CH₃)₂ | CH₃ | H | Ph |
| 783. | CH₃ | CH(CH₃)₂ | H | CH₃ | Ph |
| 784. | H | CH(CH₃)₂ | CH₃ | CH₃ | Ph |
| 785. | CH₃ | CH(CH₃)₂ | CH₃ | CH₃ | Ph |
| 786. | H | H | CH(CH₃)₂ | H | Ph |
| 787. | CH₃ | H | CH(CH₃)₂ | H | Ph |
| 788. | H | CH₃ | CH(CH₃)₂ | H | Ph |
| 789. | H | H | CH(CH₃)₂ | CH₃ | Ph |
| 790. | CH₃ | CH₃ | CH(CH₃)₂ | H | Ph |
| 791. | CH₃ | H | CH(CH₃)₂ | CH₃ | Ph |
| 792. | H | CH₃ | CH(CH₃)₂ | CH₃ | Ph |
| 793. | CH₃ | CH₃ | CH(CH₃)₂ | CH₃ | Ph |
| 794. | CH₂CH(CH₃)₂ | H | H | H | Ph |
| 795. | CH₂CH(CH₃)₂ | CH₃ | H | CH₃ | Ph |
| 796. | CH₂CH(CH₃)₂ | H | CH₃ | H | Ph |
| 797. | CH₂CH(CH₃)₂ | H | H | CH₃ | Ph |
| 798. | CH₂CH(CH₃)₂ | CH₃ | CH₃ | H | Ph |
| 799. | CH₂CH(CH₃)₂ | CH₃ | H | CH₃ | Ph |
| 800. | CH₂CH(CH₃)₂ | H | CH₃ | CH₃ | Ph |
| 801. | CH₂CH(CH₃)₂ | CH₃ | CH₃ | CH₃ | Ph |
| 802. | H | CH₂CH(CH₃)₂ | H | H | Ph |
| 803. | CH₃ | CH₂CH(CH₃)₂ | H | CH₃ | Ph |
| 804. | H | CH₂CH(CH₃)₂ | CH₃ | H | Ph |
| 805. | H | CH₂CH(CH₃)₂ | H | CH₃ | Ph |
| 806. | CH₃ | CH₂CH(CH₃)₂ | CH₃ | H | Ph |
| 807. | CH₃ | CH₂CH(CH₃)₂ | H | CH₃ | Ph |
| 808. | H | CH₂CH(CH₃)₂ | CH₃ | CH₃ | Ph |
| 809. | CH₃ | CH₂CH(CH₃)₂ | CH₃ | CH₃ | Ph |
| 810. | H | H | CH₂CH(CH₃)₂ | H | Ph |
| 811. | CH₃ | H | CH₂CH(CH₃)₂ | H | Ph |
| 812. | H | CH₃ | CH₂CH(CH₃)₂ | H | Ph |
| 813. | H | H | CH₂CH(CH₃)₂ | CH₃ | Ph |
| 814. | CH₃ | CH₃ | CH₂CH(CH₃)₂ | H | Ph |
| 815. | CH₃ | H | CH₂CH(CH₃)₂ | CH₃ | Ph |
| 816. | H | CH₃ | CH₂CH(CH₃)₂ | CH₃ | Ph |
| 817. | CH₃ | CH₃ | CH₂CH(CH₃)₂ | CH₃ | Ph |
| 818. | C(CH₃)₃ | H | H | H | Ph |
| 819. | C(CH₃)₃ | CH₃ | H | CH₃ | Ph |
| 820. | C(CH₃)₃ | H | CH₃ | H | Ph |
| 821. | C(CH₃)₃ | H | H | CH₃ | Ph |
| 822. | C(CH₃)₃ | CH₃ | CH₃ | H | Ph |
| 823. | C(CH₃)₃ | CH₃ | H | CH₃ | Ph |
| 824. | C(CH₃)₃ | H | CH₃ | CH₃ | Ph |
| 825. | C(CH₃)₃ | CH₃ | CH₃ | CH₃ | Ph |
| 826. | H | C(CH₃)₃ | H | H | Ph |
| 827. | CH₃ | C(CH₃)₃ | H | CH₃ | Ph |
| 828. | H | C(CH₃)₃ | CH₃ | H | Ph |
| 829. | H | C(CH₃)₃ | H | CH₃ | Ph |
| 830. | CH₃ | C(CH₃)₃ | CH₃ | H | Ph |
| 831. | CH₃ | C(CH₃)₃ | H | CH₃ | Ph |
| 832. | H | C(CH₃)₃ | CH₃ | CH₃ | Ph |
| 833. | CH₃ | C(CH₃)₃ | CH₃ | CH₃ | Ph |
| 834. | H | H | C(CH₃)₃ | H | Ph |
| 835. | CH₃ | H | C(CH₃)₃ | H | Ph |
| 836. | H | CH₃ | C(CH₃)₃ | H | Ph |
| 837. | H | H | C(CH₃)₃ | CH₃ | Ph |
| 838. | CH₃ | CH₃ | C(CH₃)₃ | H | Ph |
| 839. | CH₃ | H | C(CH₃)₃ | CH₃ | Ph |
| 840. | H | CH₃ | C(CH₃)₃ | CH₃ | Ph |
| 841. | CH₃ | CH₃ | C(CH₃)₃ | CH₃ | Ph |
| 842. | CH₂C(CH₃)₃ | H | H | H | Ph |
| 843. | CH₂C(CH₃)₃ | CH₃ | H | CH₃ | Ph |
| 844. | CH₂C(CH₃)₃ | H | CH₃ | H | Ph |
| 845. | CH₂C(CH₃)₃ | H | H | CH₃ | Ph |
| 846. | CH₂C(CH₃)₃ | CH₃ | CH₃ | H | Ph |
| 847. | CH₂C(CH₃)₃ | CH₃ | H | CH₃ | Ph |
| 848. | CH₂C(CH₃)₃ | H | CH₃ | CH₃ | Ph |
| 849. | CH₂C(CH₃)₃ | CH₃ | CH₃ | CH₃ | Ph |
| 850. | H | CH₂C(CH₃)₃ | H | H | Ph |
| 851. | CH₃ | CH₂C(CH₃)₃ | H | CH₃ | Ph |
| 852. | H | CH₂C(CH₃)₃ | CH₃ | H | Ph |
| 853. | H | CH₂C(CH₃)₃ | H | CH₃ | Ph |
| 854. | CH₃ | CH₂C(CH₃)₃ | CH₃ | H | Ph |
| 855. | CH₃ | CH₂C(CH₃)₃ | H | CH₃ | Ph |
| 856. | H | CH₂C(CH₃)₃ | CH₃ | CH₃ | Ph |
| 857. | CH₃ | CH₂C(CH₃)₃ | CH₃ | CH₃ | Ph |
| 858. | H | H | CH₂C(CH₃)₃ | H | Ph |
| 859. | CH₃ | H | CH₂C(CH₃)₃ | H | Ph |
| 860. | H | CH₃ | CH₂C(CH₃)₃ | H | Ph |
| 861. | H | H | CH₂C(CH₃)₃ | CH₃ | Ph |
| 862. | CH₃ | CH₃ | CH₂C(CH₃)₃ | H | Ph |
| 863. | CH₃ | H | CH₂C(CH₃)₃ | CH₃ | Ph |
| 864. | H | CH₃ | CH₂C(CH₃)₃ | CH₃ | Ph |
| 865. | CH₃ | CH₃ | CH₂C(CH₃)₃ | CH₃ | Ph |
| 866. | 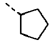 | H | H | H | Ph |
| 867. | 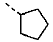 | CH₃ | H | CH₃ | Ph |
| 868. | 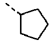 | H | CH₃ | H | Ph |
| 869. | 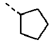 | H | H | CH₃ | Ph |
| 870. | 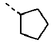 | CH₃ | CH₃ | H | Ph |
| 871. | 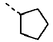 | CH₃ | H | CH₃ | Ph |
| 872. | 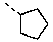 | H | CH₃ | CH₃ | Ph |
| 873. | 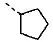 | CH₃ | CH₃ | CH₃ | Ph |
| 874. | H | 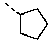 | H | H | Ph |
| 875. | CH₃ | 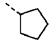 | H | CH₃ | Ph |
| 876. | H | 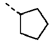 | CH₃ | H | Ph |
| 877. | H | 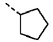 | H | CH₃ | Ph |
| 878. | CH₃ | 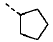 | CH₃ | H | Ph |
| 879. | CH₃ | 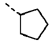 | H | CH₃ | Ph |
| 880. | H | 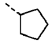 | CH₃ | CH₃ | Ph |
| 881. | CH₃ | 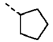 | CH₃ | CH₃ | Ph |
| 882. | H | H | 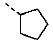 | H | Ph |
| 883. | CH₃ | H | 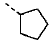 | H | Ph |
| 884. | H | CH₃ | 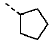 | H | Ph |
| 885. | H | H | 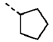 | CH₃ | Ph |
| 886. | CH₃ | CH₃ | 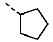 | H | Ph |
| 887. | CH₃ | H | 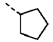 | CH₃ | Ph |
| 888. | H | CH₃ | 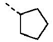 | CH₃ | Ph |
| 889. | CH₃ | CH₃ | 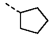 | CH₃ | Ph |
| 890. | 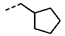 | H | H | H | Ph |
| 891. | 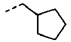 | CH₃ | H | CH₃ | Ph |
| 892. | 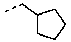 | H | CH₃ | H | Ph |
| 893. | 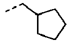 | H | H | CH₃ | Ph |
| 894. | 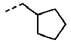 | CH₃ | CH₃ | H | Ph |
| 895. | 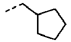 | CH₃ | H | CH₃ | Ph |
| 896. | 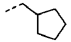 | H | CH₃ | CH₃ | Ph |
| 897. | 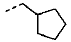 | CH₃ | CH₃ | CH₃ | Ph |
| 898. | H | 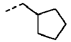 | H | H | Ph |
| 899. | CH₃ | 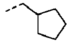 | H | CH₃ | Ph |
| 900. | H | 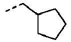 | CH₃ | H | Ph |
| 901. | H | 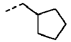 | H | CH₃ | Ph |
| 902. | CH₃ | 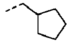 | CH₃ | H | Ph |
| 903. | CH₃ | 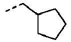 | H | CH₃ | Ph |
| 904. | H | 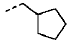 | CH₃ | CH₃ | Ph |
| 905. | CH₃ | 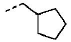 | CH₃ | CH₃ | Ph |
| 906. | H | H | 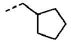 | H | Ph |
| 907. | CH₃ | H | 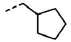 | H | Ph |
| 908. | H | CH₃ | 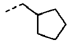 | H | Ph |
| 909. | H | H | 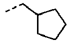 | CH₃ | Ph |
| 910. | CH₃ | CH₃ | 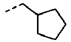 | H | Ph |
| 911. | CH₃ | H | 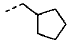 | CH₃ | Ph |
| 912. | H | CH₃ | 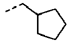 | CH₃ | Ph |
| 913. | CH₃ | CH₃ | 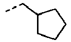 | CH₃ | Ph |
| 914. | 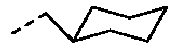 | H | H | H | Ph |
| 915. | 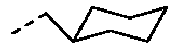 | CH₃ | H | CH₃ | Ph |
| 916. | 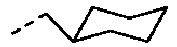 | H | CH₃ | H | Ph |
| 917. | 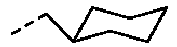 | H | H | CH₃ | Ph |
| 918. | 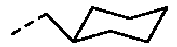 | CH₃ | CH₃ | H | Ph |
| 919. | 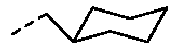 | CH₃ | H | CH₃ | Ph |
| 920. | 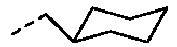 | H | CH₃ | CH₃ | Ph |
| 921. | 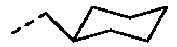 | CH₃ | CH₃ | CH₃ | Ph |
| 922. | H | 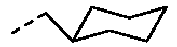 | H | H | Ph |
| 923. | CH₃ | 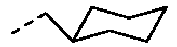 | H | CH₃ | Ph |
| 924. | H | 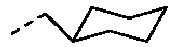 | CH₃ | H | Ph |
| 925. | H | 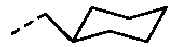 | H | CH₃ | Ph |
| 926. | CH₃ | 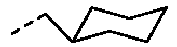 | CH₃ | H | Ph |
| 927. | CH₃ | 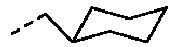 | H | CH₃ | Ph |
| 928. | H | 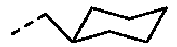 | CH₃ | CH₃ | Ph |
| 929. | CH₃ | 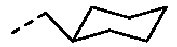 | CH₃ | CH₃ | Ph |
| 930. | H | H | 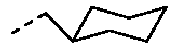 | H | Ph |
| 931. | CH₃ | H | 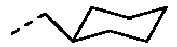 | H | Ph |
| 932. | H | CH₃ | 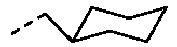 | H | Ph |
| 933. | H | H | 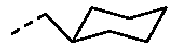 | CH₃ | Ph |
| 934. | CH₃ | CH₃ | 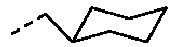 | H | Ph |
| 935. | CH₃ | H | 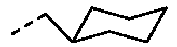 | CH₃ | Ph |
| 936. | H | CH₃ | 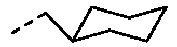 | CH₃ | Ph |
| 937. | CH₃ | CH₃ | 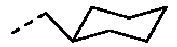 | CH₃ | Ph |
| 938. | 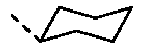 | H | H | H | Ph |
| 939. | 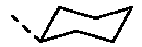 | CH₃ | H | CH₃ | Ph |
| 940. | 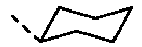 | H | CH₃ | H | Ph |
| 941. | 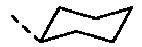 | H | H | CH₃ | Ph |
| 942. | 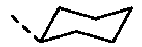 | CH₃ | CH₃ | H | Ph |
| 943. | 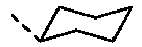 | CH₃ | H | CH₃ | Ph |
| 944. | 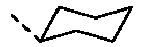 | H | CH₃ | CH₃ | Ph |
| 945. | 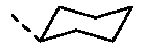 | CH₃ | CH₃ | CH₃ | Ph |
| 946. | H | 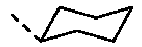 | H | H | Ph |
| 947. | CH₃ | 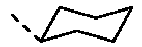 | H | CH₃ | Ph |
| 948. | H | 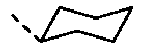 | CH₃ | H | Ph |
| 949. | H | 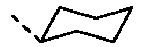 | H | CH₃ | Ph |
| 950. | CH₃ | 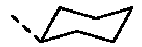 | CH₃ | H | Ph |
| 951. | CH₃ | 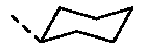 | H | CH₃ | Ph |
| 952. | H | 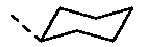 | CH₃ | CH₃ | Ph |
| 953. | CH₃ | 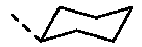 | CH₃ | CH₃ | Ph |
| 954. | H | H | 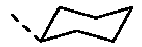 | H | Ph |
| 955. | CH₃ | H | 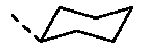 | H | Ph |
| 956. | H | CH₃ | 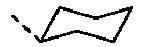 | H | Ph |
| 957. | H | H | 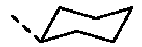 | CH₃ | Ph |
| 958. | CH₃ | CH₃ | 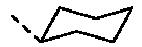 | H | Ph |
| 959. | CH₃ | H | 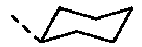 | CH₃ | Ph |
| 960. | H | CH₃ | 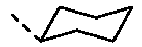 | CH₃ | Ph |
| 961. | CH₃ | CH₃ | 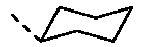 | CH₃ | Ph |
| 962. | 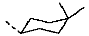 | H | H | H | Ph |
| 963. | 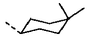 | CH₃ | H | CH₃ | Ph |
| 964. | 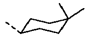 | H | CH₃ | H | Ph |
| 965. | 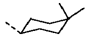 | H | H | CH₃ | Ph |
| 966. | 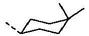 | CH₃ | CH₃ | H | Ph |
| 967. | 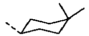 | 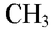 | H | CH₃ | Ph |
| 968. | 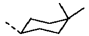 | 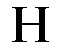 | CH₃ | CH₃ | Ph |
| 969. | 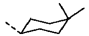 | 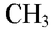 | CH₃ | CH₃ | Ph |
| 970. | H | 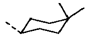 | H | H | Ph |
| 971. | CH₃ | 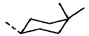 | H | CH₃ | Ph |
| 972. | H | 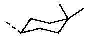 | CH₃ | H | Ph |
| 973. | H | 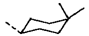 | H | CH₃ | Ph |
| 974. | CH₃ | 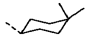 | CH₃ | H | Ph |
| 975. | CH₃ | 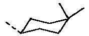 | H | CH₃ | Ph |
| 976. | H | 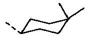 | CH₃ | CH₃ | Ph |
| 977. | CH₃ | 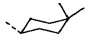 | CH₃ | CH₃ | Ph |
| 978. | H | H | 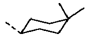 | H | Ph |
| 979. | CH₃ | H | 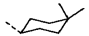 | H | Ph |
| 980. | H | CH₃ | 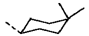 | H | Ph |
| 981. | H | H | 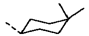 | CH₃ | Ph |
| 982. | CH₃ | CH₃ | 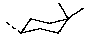 | H | Ph |
| 983. | CH₃ | H | 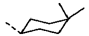 | CH₃ | Ph |
| 984. | H | CH₃ | 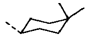 | CH₃ | Ph |
| 985. | CH₃ | CH₃ | 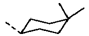 | CH₃ | Ph |
| 986. | 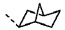 | H | H | H | Ph |
| 987. | 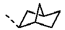 | CH₃ | H | CH₃ | Ph |
| 988. | 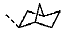 | H | CH₃ | H | Ph |
| 989. | 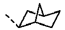 | H | H | CH₃ | Ph |
| 990. | 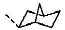 | CH₃ | CH₃ | H | Ph |
| 991. | 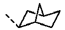 | CH₃ | H | CH₃ | Ph |
| 992. | 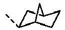 | H | CH₃ | CH₃ | Ph |
| 993. | 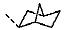 | CH₃ | CH₃ | CH₃ | Ph |
| 994. | H | 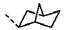 | H | H | Ph |
| 995. | CH₃ | 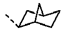 | H | CH₃ | Ph |
| 996. | H | 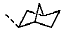 | CH₃ | H | Ph |
| 997. | H | 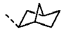 | H | CH₃ | Ph |
| 998. | CH₃ | 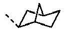 | CH₃ | H | Ph |
| 999. | CH₃ | 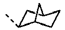 | H | CH₃ | Ph |
| 1000. | H | 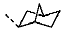 | CH₃ | CH₃ | Ph |
| 1001. | CH₃ | 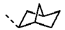 | CH₃ | CH₃ | Ph |
| 1002. | H | H | 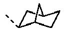 | H | Ph |
| 1003. | CH₃ | H | 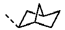 | H | Ph |
| 1004. | H | CH₃ | 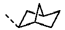 | H | Ph |
| 1005. | H | H | 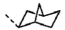 | CH₃ | Ph |
| 1006. | CH₃ | CH₃ | 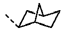 | H | Ph |
| 1007. | CH₃ | H | 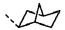 | CH₃ | Ph |
| 1008. | H | CH₃ | 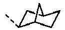 | CH₃ | Ph |
| 1009. | CH₃ | CH₃ | 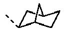 | CH₃ | Ph |
| 1010. | CH(CH₃)₂ | H | CH₂CH₃ | H | Ph |
| 1011. | CH(CH₃)₂ | H | CH(CH₃)₂ | H | Ph |
| 1012. | CH(CH₃)₂ | H | CH₂CH(CH₃)₂ | H | Ph |
| 1013. | CH(CH₃)₂ | H | C(CH₃)₃ | H | Ph |
| 1014. | CH(CH₃)₂ | H | CH₂C(CH₃)₃ | H | Ph |
| 1015. | CH(CH₃)₂ | H | 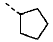 | H | Ph |
| 1016. | CH(CH₃)₂ | H | 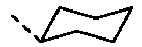 | H | Ph |
| 1017. | CH(CH₃)₂ | H | 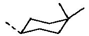 | H | Ph |
| 1018. | CH(CH₃)₂ | H | 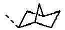 | H | Ph |
| 1019. | CH(CH₃)₂ | H | 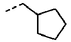 | H | Ph |
| 1020. | CH(CH₃)₂ | H | 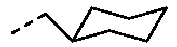 | H | Ph |
| 1021. | C(CH₃)₃ | H | CH₂CH₃ | H | Ph |
| 1022. | C(CH₃)₃ | H | CH(CH₃)₂ | H | Ph |
| 1023. | C(CH₃)₃ | H | CH₂CH(CH₃)₂ | H | Ph |
| 1024. | C(CH₃)₃ | H | C(CH₃)₃ | H | Ph |
| 1025. | C(CH₃)₃ | H | CH₂C(CH₃)₃ | H | Ph |
| 1026. | C(CH₃)₃ | H | 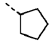 | H | Ph |
| 1027. | C(CH₃)₃ | H | 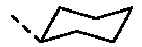 | H | Ph |
| 1028. | C(CH₃)₃ | H | 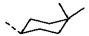 | H | Ph |
| 1029. | C(CH₃)₃ | H | 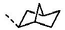 | H | Ph |
| 1030. | C(CH₃)₃ | H | 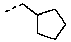 | H | Ph |
| 1031. | C(CH₃)₃ | H | 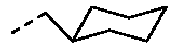 | H | Ph |
| 1032. | CH₂C(CH₃)₃ | H | CH₂CH₃ | H | Ph |
| 1033. | CH₂C(CH₃)₃ | H | CH(CH₃)₂ | H | Ph |
| 1034. | CH₂C(CH₃)₃ | H | CH₂CH(CH₃)₂ | H | Ph |
| 1035. | CH₂C(CH₃)₃ | H | C(CH₃)₃ | H | Ph |
| 1036. | CH₂C(CH₃)₃ | H | CH₂C(CH₃)₃ | H | Ph |
| 1037. | CH₂C(CH₃)₃ | H | 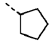 | H | Ph |
| 1038. | CH₂C(CH₃)₃ | H | 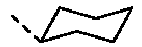 | H | Ph |
| 1039. | CH₂C(CH₃)₃ | H | 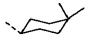 | H | Ph |
| 1040. | CH₂C(CH₃)₃ | H | 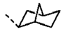 | H | Ph |
| 1041. | CH₂C(CH₃)₃ | H | 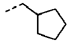 | H | Ph |
| 1042. | CH₂C(CH₃)₃ | H | 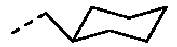 | H | Ph |
| 1043. | 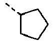 | H | CH₂CH₃ | H | Ph |
| 1044. | 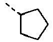 | H | CH(CH₃)₂ | H | Ph |
| 1045. | 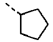 | H | CH₂CH(CH₃)₂ | H | Ph |
| 1046. | 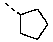 | H | C(CH₃)₃ | H | Ph |
| 1047. | 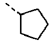 | H | CH₂C(CH₃)₃ | H | Ph |
| 1048. | 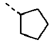 | H | 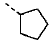 | H | Ph |
| 1049. | 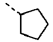 | H | 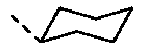 | H | Ph |
| 1050. | 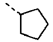 | H | 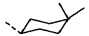 | H | Ph |
| 1051. | 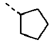 | H | 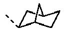 | H | Ph |
| 1052. | 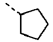 | H | 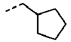 | H | Ph |
| 1053. | 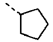 | H | 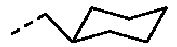 | H | Ph |
| 1054. | 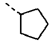 | H | CH₂CH₃ | H | Ph |
| 1055. | 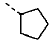 | H | CH(CH₃)₂ | H | Ph |
| 1056. | 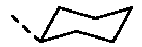 | H | CH₂CH(CH₃)₂ | H | Ph |
| 1057. | 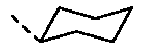 | H | C(CH₃)₃ | H | Ph |
| 1058. | 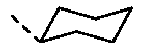 | H | CH₂C(CH₃)₃ | H | Ph |
| 1059. | 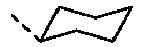 | H | 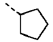 | H | Ph |
| 1060. | 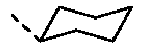 | H | 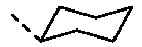 | H | Ph |
| 1061. | 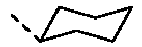 | H | 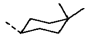 | H | Ph |
| 1062. | 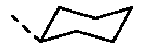 | H | 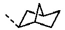 | H | Ph |
| 1063. | 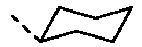 | H | 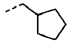 | H | Ph |
| 1064. | 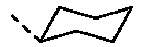 | H | 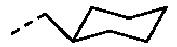 | H | Ph |
| 1065. | 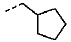 | H | CH₂CH(CH₃)₂ | H | Ph |
| 1066. | 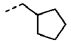 | H | C(CH₃)₃ | H | Ph |
| 1067. | 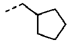 | H | CH₂C(CH₃)₃ | H | Ph |
| 1068. | 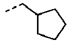 | H | 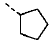 | H | Ph |
| 1069. | 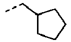 | H | 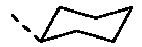 | H | Ph |
| 1070. | 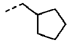 | H | 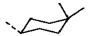 | H | Ph |
| 1071. | 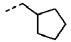 | H | 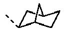 | H | Ph |
| 1072. | 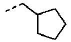 | H | 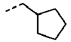 | H | Ph |
| 1073. | 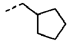 | H | 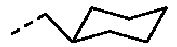 | H | Ph |
| 1074. | 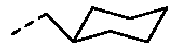 | H | CH₂CH(CH₃)₂ | H | Ph |
| 1075. | 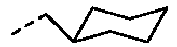 | H | C(CH₃)₃ | H | Ph |
| 1076. | 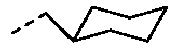 | H | CH₂C(CH₃)₃ | H | Ph |
| 1077. | 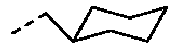 | H | 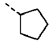 | H | Ph |
| 1078. | 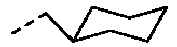 | H | 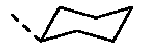 | H | Ph |
| 1079. | 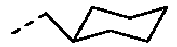 | H | 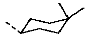 | H | Ph |
| 1080. | 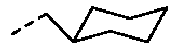 | H | 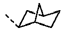 | H | Ph |
| 1081. | 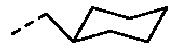 | H | 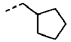 | H | Ph |
| 1082. | 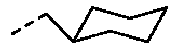 | H | 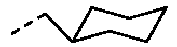 | H | Ph |
| 1083. | 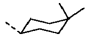 | H | CH₂CH(CH₃)₂ | H | Ph |
| 1084. | 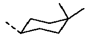 | H | C(CH₃)₃ | H | Ph |
| 1085. | 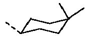 | H | CH₂C(CH₃)₃ | H | Ph |
| 1086. | 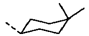 | H | 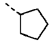 | H | Ph |
| 1087. | 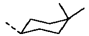 | H | 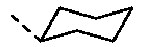 | H | Ph |
| 1088. | 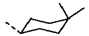 | H | 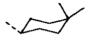 | H | Ph |
| 1089. | 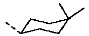 | H | 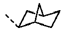 | H | Ph |
| 1090. | 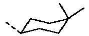 | H | 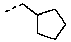 | H | Ph |
| 1091. | 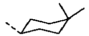 | H | 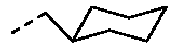 | H | Ph |
| 1092. | H | H | H | H | Ph |
| 1093. | CD₃ | H | H | H | Ph |
| 1094. | H | CD₃ | H | H | Ph |
| 1095. | H | H | CD₃ | H | Ph |
| 1096. | CD₃ | CD₃ | H | CD₃ | Ph |
| 1097. | CD₃ | H | CD₃ | H | Ph |
| 1098. | CD₃ | H | H | CD₃ | Ph |
| 1099. | H | CD₃ | CD₃ | H | Ph |
| 1100. | H | CD₃ | H | CD₃ | Ph |
| 1101. | H | H | CD₃ | CD₃ | Ph |
| 1102. | CD₃ | CD₃ | CD₃ | H | Ph |
| 1103. | CD₃ | CD₃ | H | CD₃ | Ph |
| 1104. | CD₃ | H | CD₃ | CD₃ | Ph |
| 1105. | H | CD₃ | CD₃ | CD₃ | Ph |
| 1106. | CD₃ | CD₃ | CD₃ | CD₃ | Ph |
| 1107. | CD₂CH₃ | H | H | H | Ph |
| 1108. | CD₂CH₃ | CD₃ | H | CD₃ | Ph |
| 1109. | CD₂CH₃ | H | CD₃ | H | Ph |
| 1110. | CD₂CH₃ | H | H | CD₃ | Ph |
| 1111. | CD₂CH₃ | CD₃ | CD₃ | H | Ph |
| 1112. | CD₂CH₃ | CD₃ | H | CD₃ | Ph |
| 1113. | CD₂CH₃ | H | CD₃ | CD₃ | Ph |
| 1114. | CD₂CH₃ | CD₃ | CD₃ | CD₃ | Ph |
| 1115. | H | CD₂CH₃ | H | H | Ph |
| 1116. | CH₃ | CD₂CH₃ | H | CD₃ | Ph |
| 1117. | H | CD₂CH₃ | CD₃ | H | Ph |
| 1118. | H | CD₂CH₃ | H | CD₃ | Ph |
| 1119. | CD₃ | CD₂CH₃ | CD₃ | H | Ph |
| 1120. | CD₃ | CD₂CH₃ | H | CD₃ | Ph |
| 1121. | H | CD₂CH₃ | CD₃ | CD₃ | Ph |
| 1122. | CD₃ | CD₂CH₃ | CD₃ | CD₃ | Ph |
| 1123. | H | H | CD₂CH₃ | H | Ph |
| 1124. | CD₃ | H | CD₂CH₃ | H | Ph |
| 1125. | H | CD₃ | CD₂CH₃ | H | Ph |
| 1126. | H | H | CD₂CH₃ | CD₃ | Ph |
| 1127. | CD₃ | CD₃ | CD₂CH₃ | H | Ph |
| 1128. | CD₃ | H | CD₂CH₃ | CD₃ | Ph |
| 1129. | H | CD₃ | CD₂CH₃ | CD₃ | Ph |
| 1130. | CD₃ | CD₃ | CD₂CH₃ | CD₃ | Ph |
| 1131. | CD(CH₃)₂ | H | H | H | Ph |
| 1132. | CD(CH₃)₂ | CD₃ | H | CD₃ | Ph |
| 1133. | CD(CH₃)₂ | H | CD₃ | H | Ph |
| 1134. | CD(CH₃)₂ | H | H | CD₃ | Ph |
| 1135. | CD(CH₃)₂ | CD₃ | CD₃ | H | Ph |
| 1136. | CD(CH₃)₂ | CD₃ | H | CD₃ | Ph |
| 1137. | CD(CH₃)₂ | H | CD₃ | CD₃ | Ph |
| 1138. | CD(CH₃)₂ | CD₃ | CD₃ | CD₃ | Ph |
| 1139. | H | CD(CH₃)₂ | H | H | Ph |
| 1140. | CD₃ | CD(CH₃)₂ | H | CD₃ | Ph |
| 1141. | H | CD(CH₃)₂ | CD₃ | H | Ph |
| 1142. | H | CD(CH₃)₂ | H | CD₃ | Ph |
| 1143. | CD₃ | CD(CH₃)₂ | CD₃ | H | Ph |
| 1144. | CD₃ | CD(CH₃)₂ | H | CD₃ | Ph |
| 1145. | H | CD(CH₃)₂ | CD₃ | CD₃ | Ph |
| 1146. | CD₃ | CD(CH₃)₂ | CD₃ | CD₃ | Ph |
| 1147. | H | H | CD(CH₃)₂ | H | Ph |
| 1148. | CD₃ | H | CD(CH₃)₂ | H | Ph |
| 1149. | H | CD₃ | CD(CH₃)₂ | H | Ph |
| 1150. | H | H | CD(CH₃)₂ | CD₃ | Ph |
| 1151. | CD₃ | CD₃ | CD(CH₃)₂ | H | Ph |
| 1152. | CD₃ | H | CD(CH₃)₂ | CD₃ | Ph |
| 1153. | H | CD₃ | CD(CH₃)₂ | CD₃ | Ph |
| 1154. | CD₃ | CD₃ | CD(CH₃)₂ | CD₃ | Ph |
| 1155. | CD(CD₃)₂ | H | H | H | Ph |
| 1156. | CD(CD₃)₂ | CD₃ | H | CD₃ | Ph |
| 1157. | CD(CD₃)₂ | H | CD₃ | H | Ph |
| 1158. | CD(CD₃)₂ | H | H | CD₃ | Ph |
| 1159. | CD(CD₃)₂ | CD₃ | CD₃ | H | Ph |
| 1160. | CD(CD₃)₂ | CD₃ | H | CD₃ | Ph |
| 1161. | CD(CD₃)₂ | H | CD₃ | CD₃ | Ph |
| 1162. | CD(CD₃)₂ | CD₃ | CD₃ | CD₃ | Ph |
| 1163. | H | CD(CD₃)₂ | H | H | Ph |
| 1164. | CH₃ | CD(CD₃)₂ | H | CD₃ | Ph |
| 1165. | H | CD(CD₃)₂ | CD₃ | H | Ph |
| 1166. | H | CD(CD₃)₂ | H | CD₃ | Ph |
| 1167. | CD₃ | CD(CD₃)₂ | CD₃ | H | Ph |
| 1168. | CD₃ | CD(CD₃)₂ | H | CD₃ | Ph |
| 1169. | H | CD(CD₃)₂ | CD₃ | CD₃ | Ph |
| 1170. | CD₃ | CD(CD₃)₂ | CD₃ | CD₃ | Ph |
| 1171. | H | H | CD(CD₃)₂ | H | Ph |
| 1172. | CD₃ | H | CD(CD₃)₂ | H | Ph |
| 1173. | H | CD₃ | CD(CD₃)₂ | H | Ph |
| 1174. | H | H | CD(CD₃)₂ | CD₃ | Ph |
| 1175. | CD₃ | CD₃ | CD(CD₃)₂ | H | Ph |
| 1176. | CD₃ | H | CD(CD₃)₂ | CD₃ | Ph |
| 1177. | H | CD₃ | CD(CD₃)₂ | CD₃ | Ph |
| 1178. | CD₃ | CD₃ | CD(CD₃)₂ | CD₃ | Ph |
| 1179. | CD₂CH(CH₃)₂ | H | H | H | Ph |
| 1180. | CD₂CH(CH₃)₂ | CD₃ | H | CD₃ | Ph |
| 1181. | CD₂CH(CH₃)₂ | H | CD₃ | H | Ph |
| 1182. | CD₂CH(CH₃)₂ | H | H | CD₃ | Ph |
| 1183. | CD₂CH(CH₃)₂ | CD₃ | CD₃ | H | Ph |
| 1184. | CD₂CH(CH₃)₂ | CD₃ | H | CD₃ | Ph |
| 1185. | CD₂CH(CH₃)₂ | H | CD₃ | CD₃ | Ph |
| 1186. | CD₂CH(CH₃)₂ | CD₃ | CD₃ | CD₃ | Ph |
| 1187. | H | CD₂CH(CH₃)₂ | H | H | Ph |
| 1188. | CD₃ | CD₂CH(CH₃)₂ | H | CD₃ | Ph |
| 1189. | H | CD₂CH(CH₃)₂ | CD₃ | H | Ph |
| 1190. | H | CD₂CH(CH₃)₂ | H | CD₃ | Ph |
| 1191. | CD₃ | CD₂CH(CH₃)₂ | CD₃ | H | Ph |
| 1192. | CD₃ | CD₂CH(CH₃)₂ | H | CD₃ | Ph |
| 1193. | H | CD₂CH(CH₃)₂ | CD₃ | CD₃ | Ph |
| 1194. | CD₃ | CD₂CH(CH₃)₂ | CD₃ | CD₃ | Ph |
| 1195. | H | H | CD₂CH(CH₃)₂ | H | Ph |
| 1196. | CD₃ | H | CD₂CH(CH₃)₂ | H | Ph |
| 1197. | H | CD₃ | CD₂CH(CH₃)₂ | H | Ph |
| 1198. | H | H | CD₂CH(CH₃)₂ | CD₃ | Ph |
| 1199. | CD₃ | CD₃ | CD₂CH(CH₃)₂ | H | Ph |
| 1200. | CD₃ | H | CD₂CH(CH₃)₂ | CD₃ | Ph |
| 1201. | H | CD₃ | CD₂CH(CH₃)₂ | CD₃ | Ph |
| 1202. | CD₃ | CD₃ | CD₂CH(CH₃)₂ | CD₃ | Ph |
| 1203. | CD₂C(CH₃)₃ | H | H | H | Ph |
| 1204. | CD₂C(CH₃)₃ | CD₃ | H | CD₃ | Ph |
| 1205. | CD₂C(CH₃)₃ | H | CD₃ | H | Ph |
| 1206. | CD₂C(CH₃)₃ | H | H | CD₃ | Ph |
| 1207. | CD₂C(CH₃)₃ | CD₃ | CD₃ | H | Ph |
| 1208. | CD₂C(CH₃)₃ | CD₃ | H | CD₃ | Ph |
| 1209. | CD₂C(CH₃)₃ | H | CD₃ | CD₃ | Ph |
| 1210. | CD₂C(CH₃)₃ | CH₃ | CD₃ | CD₃ | Ph |
| 1211. | H | CD₂C(CH₃)₃ | H | H | Ph |
| 1212. | CD₃ | CD₂C(CH₃)₃ | H | CD₃ | Ph |
| 1213. | H | CD₂C(CH₃)₃ | CD₃ | H | Ph |
| 1214. | H | CD₂C(CH₃)₃ | H | CD₃ | Ph |
| 1215. | CD₃ | CD₂C(CH₃)₃ | CD₃ | H | Ph |
| 1216. | CD₃ | CD₂C(CH₃)₃ | H | CD₃ | Ph |
| 1217. | H | CD₂C(CH₃)₃ | CD₃ | CD₃ | Ph |
| 1218. | CD₃ | CD₂C(CH₃)₃ | CD₃ | CD₃ | Ph |
| 1219. | H | H | CD₂C(CH₃)₃ | H | Ph |
| 1220. | CD₃ | H | CD₂C(CH₃)₃ | H | Ph |
| 1221. | H | CD₃ | CD₂C(CH₃)₃ | H | Ph |
| 1222. | H | H | CD₂C(CH₃)₃ | CD₃ | Ph |
| 1223. | CD₃ | CD₃ | CD₂C(CH₃)₃ | H | Ph |
| 1224. | CD₃ | H | CD₂C(CH₃)₃ | CD₃ | Ph |
| 1225. | H | CD₃ | CD₂C(CH₃)₃ | CD₃ | Ph |
| 1226. | CD₃ | CD₃ | CD₂C(CH₃)₃ | CD₃ | Ph |
| 1227. | 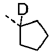 | H | H | H | Ph |
| 1228. | 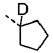 | CD₃ | H | CD₃ | Ph |
| 1229. | 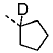 | H | CD₃ | H | Ph |
| 1230. | 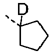 | H | H | CD₃ | Ph |
| 1231. | 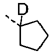 | CD₃ | CD₃ | H | Ph |
| 1232. | 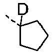 | CD₃ | H | CD₃ | Ph |
| 1233. | 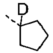 | H | CD₃ | CD₃ | Ph |
| 1234. | 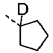 | CD₃ | CD₃ | CD₃ | Ph |
| 1235. | H | 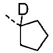 | H | H | Ph |
| 1236. | CD₃ | 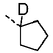 | H | CD₃ | Ph |
| 1237. | H | 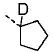 | CD₃ | H | Ph |
| 1238. | H | 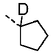 | H | CD₃ | Ph |
| 1239. | CD₃ | 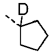 | CD₃ | H | Ph |
| 1240. | CD₃ | 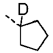 | H | CD₃ | Ph |
| 1241. | H | 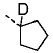 | CD₃ | CD₃ | Ph |
| 1242. | CD₃ | 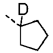 | CD₃ | CD₃ | Ph |
| 1243. | H | H | 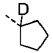 | H | Ph |
| 1244. | CD₃ | H | 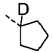 | H | Ph |
| 1245. | H | CD₃ | 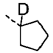 | H | Ph |
| 1246. | H | H | 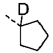 | CD₃ | Ph |
| 1247. | CD₃ | CD₃ | 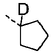 | H | Ph |
| 1248. | CD₃ | H | 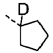 | CD₃ | Ph |
| 1249. | H | CD₃ | 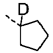 | CD₃ | Ph |
| 1250. | CD₃ | CD₃ | 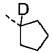 | CD₃ | Ph |
| 1251. | 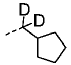 | H | H | H | Ph |
| 1252. | 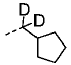 | CD₃ | H | CD₃ | Ph |
| 1253. | 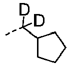 | H | CD₃ | H | Ph |
| 1254. | 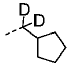 | H | H | CD₃ | Ph |
| 1255. | 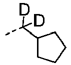 | CD₃ | CD₃ | H | Ph |
| 1256. | 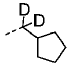 | CD₃ | H | CD₃ | Ph |
| 1257. | 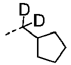 | H | CD₃ | CD₃ | Ph |
| 1258. | 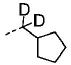 | CD₃ | CD₃ | CD₃ | Ph |
| 1259. | H | 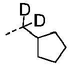 | H | H | Ph |
| 1260. | CH₃ | 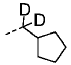 | H | CD₃ | Ph |
| 1261. | H | 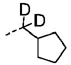 | CD₃ | H | Ph |
| 1262. | H | 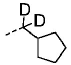 | H | CD₃ | Ph |
| 1263. | CD₃ | 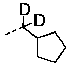 | CD₃ | H | Ph |
| 1264. | CD₃ | 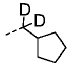 | H | CD₃ | Ph |
| 1265. | H | 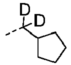 | CD₃ | CD₃ | Ph |
| 1266. | CH₃ | 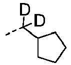 | CD₃ | CD₃ | Ph |
| 1267. | H | H | 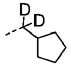 | H | Ph |
| 1268. | CD₃ | H | 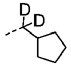 | H | Ph |
| 1269. | H | CD₃ | 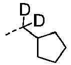 | H | Ph |
| 1270. | H | H | 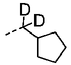 | CD₃ | Ph |
| 1271. | CD₃ | CD₃ | 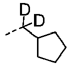 | H | Ph |
| 1272. | CD₃ | H | 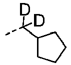 | CD₃ | Ph |
| 1273. | H | CD₃ | 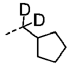 | CD₃ | Ph |
| 1274. | CD₃ | CD₃ | 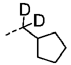 | CD₃ | Ph |
| 1275. | 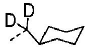 | H | H | H | Ph |
| 1276. | 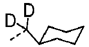 | CD₃ | H | CD₃ | Ph |
| 1277. | 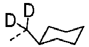 | H | CD₃ | H | Ph |
| 1278. | 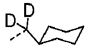 | H | H | CD₃ | Ph |
| 1279. | 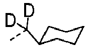 | CD₃ | CD₃ | H | Ph |
| 1280. | 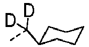 | CD₃ | H | CD₃ | Ph |
| 1281. | 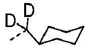 | H | CD₃ | CD₃ | Ph |
| 1282. | 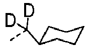 | CD₃ | CD₃ | CD₃ | Ph |
| 1283. | H | 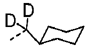 | H | H | Ph |
| 1284. | CD₃ | 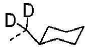 | H | CD₃ | Ph |
| 1285. | H | 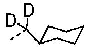 | CD₃ | H | Ph |
| 1286. | H | 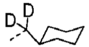 | H | CD₃ | Ph |
| 1287. | CD₃ | 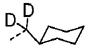 | CD₃ | H | Ph |
| 1288. | CD₃ | 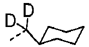 | H | CD₃ | Ph |
| 1289. | H | 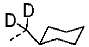 | CD₃ | CD₃ | Ph |
| 1290. | CD₃ | 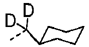 | CD₃ | CD₃ | Ph |
| 1291. | H | H | 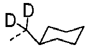 | H | Ph |
| 1292. | CD₃ | H | 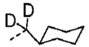 | H | Ph |
| 1293. | H | CD₃ | 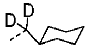 | H | Ph |
| 1294. | H | H | 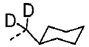 | CD₃ | Ph |
| 1295. | CD₃ | CD₃ | 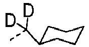 | H | Ph |
| 1296. | CD₃ | H | 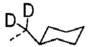 | CD₃ | Ph |
| 1297. | H | CD₃ | 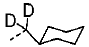 | CD₃ | Ph |
| 1298. | CD₃ | CD₃ | 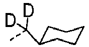 | CD₃ | Ph |
| 1299. | 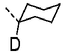 | H | H | H | Ph |
| 1300. | 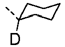 | CD₃ | H | CD₃ | Ph |
| 1301. | 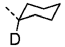 | H | CD₃ | H | Ph |
| 1302. | 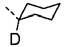 | H | H | CD₃ | Ph |
| 1303. | 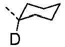 | CD₃ | CD₃ | H | Ph |
| 1304. | 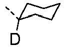 | CD₃ | H | CD₃ | Ph |
| 1305. | 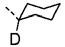 | H | CD₃ | CD₃ | Ph |
| 1306. | 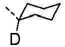 | 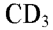 | CD₃ | CD₃ | Ph |
| 1307. | H | 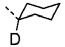 | H | H | Ph |
| 1308. | CD₃ | 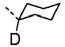 | H | CD₃ | Ph |
| 1309. | H | 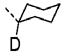 | CD₃ | H | Ph |
| 1310. | H | 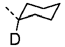 | H | CD₃ | Ph |
| 1311. | CD₃ | 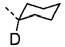 | CD₃ | H | Ph |
| 1312. | CD₃ | 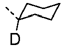 | H | CD₃ | Ph |
| 1313. | H | 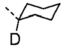 | CD₃ | CD₃ | Ph |
| 1314. | CD₃ | 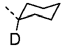 | CD₃ | CD₃ | Ph |
| 1315. | H | H | 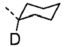 | H | Ph |
| 1316. | CD₃ | H | 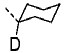 | H | Ph |
| 1317. | H | CD₃ | 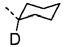 | H | Ph |
| 1318. | H | H | 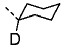 | CD₃ | Ph |
| 1319. | CD₃ | CD₃ | 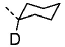 | H | Ph |
| 1320. | CD₃ | H | 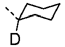 | CD₃ | Ph |
| 1321. | H | CD₃ | 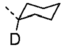 | CD₃ | Ph |
| 1322. | CD₃ | CD₃ | 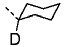 | CD₃ | Ph |
| 1323. | 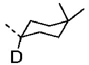 | H | H | H | Ph |
| 1324. | 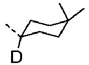 | CD₃ | H | CD₃ | Ph |
| 1325. | 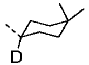 | H | CD₃ | H | Ph |
| 1326. | 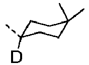 | H | H | CD₃ | Ph |
| 1327. | 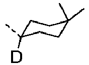 | CD₃ | CD₃ | H | Ph |
| 1328. | 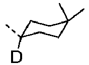 | CD₃ | H | CD₃ | Ph |
| 1329. | 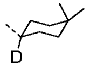 | H | CD₃ | CD₃ | Ph |
| 1330. | 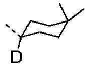 | CD₃ | CD₃ | CD₃ | Ph |
| 1331. | H | 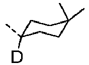 | H | H | Ph |
| 1332. | CD₃ | 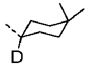 | H | CD₃ | Ph |
| 1333. | H | 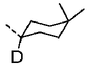 | CD₃ | H | Ph |
| 1334. | H | 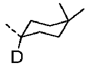 | H | CD₃ | Ph |
| 1335. | CD₃ | 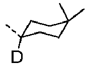 | CD₃ | H | Ph |
| 1336. | CD₃ | 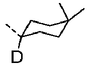 | H | CD₃ | Ph |
| 1337. | H | 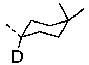 | CD₃ | CD₃ | Ph |
| 1338. | CD₃ | 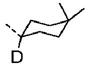 | CD₃ | CD₃ | Ph |
| 1339. | H | H | 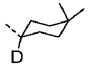 | H | Ph |
| 1340. | CD₃ | H | 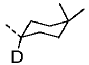 | H | Ph |
| 1341. | H | CD₃ | 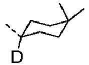 | H | Ph |
| 1342. | H | H | 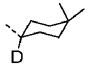 | CD₃ | Ph |
| 1343. | CD₃ | CD₃ | 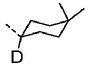 | H | Ph |
| 1344. | CD₃ | H | 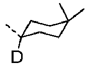 | CD₃ | Ph |
| 1345. | H | CD₃ | 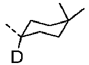 | CD₃ | Ph |
| 1346. | CD₃ | CD₃ | 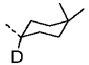 | CD₃ | Ph |
| 1347. | 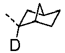 | H | H | H | Ph |
| 1348. | 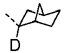 | CD₃ | H | CD₃ | Ph |
| 1349. | 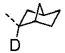 | H | CD₃ | H | Ph |
| 1350. | 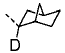 | H | H | CD₃ | Ph |
| 1351. | 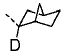 | CH₃ | CH₃ | H | Ph |
| 1352. | 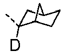 | CD₃ | H | CD₃ | Ph |
| 1353. | 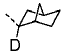 | H | CD₃ | CD₃ | Ph |
| 1354. | 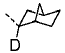 | CD₃ | CD₃ | CD₃ | Ph |
| 1355. | H | 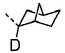 | H | H | Ph |
| 1356. | CD₃ | 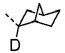 | H | CD₃ | Ph |
| 1357. | H | 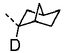 | CD₃ | H | Ph |
| 1358. | H | 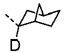 | H | CD₃ | Ph |
| 1359. | CD₃ | 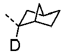 | CD₃ | H | Ph |
| 1360. | CD₃ | 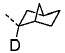 | H | CD₃ | Ph |
| 1361. | H | 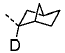 | CD₃ | CD₃ | Ph |
| 1362. | CD₃ | 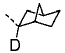 | CD₃ | CD₃ | Ph |
| 1363. | H | H | 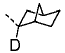 | H | Ph |
| 1364. | CD₃ | H | 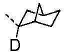 | H | Ph |
| 1365. | H | CD₃ | 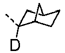 | H | Ph |
| 1366. | H | H | 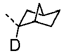 | CH₃ | Ph |
| 1367. | CD₃ | CD₃ | 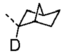 | H | Ph |
| 1368. | CD₃ | H | 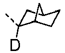 | CD₃ | Ph |
| 1369. | H | CD₃ | 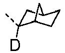 | CD₃ | Ph |
| 1370. | CD₃ | CD₃ | 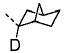 | CD₃ | Ph |
| 1371. | CD(CH₃)₂ | H | CD₂CH₃ | H | Ph |
| 1372. | CD(CH₃)₂ | H | CD(CH₃)₂ | H | Ph |
| 1373. | CD(CH₃)₂ | H | CD₂CH(CH₃)₂ | H | Ph |
| 1374. | CD(CH₃)₂ | H | C(CH₃)₃ | H | Ph |
| 1375. | CD(CH₃)₂ | H | CD₂C(CH₃)₃ | H | Ph |
| 1376. | CD(CH₃)₂ | H | 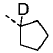 | H | Ph |
| 1377. | CD(CH₃)₂ | H | 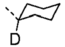 | H | Ph |
| 1378. | CD(CH₃)₂ | H | 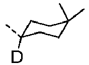 | H | Ph |
| 1379. | CD(CH₃)₂ | H | 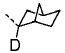 | H | Ph |
| 1380. | CD(CH₃)₂ | H | 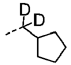 | H | Ph |
| 1381. | CD(CH₃)₂ | H | 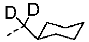 | H | Ph |
| 1382. | C(CH₃)₃ | H | CD₂CH₃ | H | Ph |
| 1383. | C(CH₃)₃ | H | CD(CH₃)₂ | H | Ph |
| 1384. | C(CH₃)₃ | H | CD₂CH(CH₃)₂ | H | Ph |
| 1385. | C(CH₃)₃ | H | C(CH₃)₃ | H | Ph |
| 1386. | C(CH₃)₃ | H | CD₂C(CH₃)₃ | H | Ph |
| 1387. | C(CH₃)₃ | H | 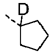 | H | Ph |
| 1388. | C(CH₃)₃ | H | 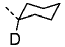 | H | Ph |
| 1389. | C(CH₃)₃ | H | 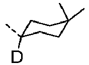 | H | Ph |
| 1390. | C(CH₃)₃ | H | 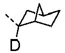 | H | Ph |
| 1391. | C(CH₃)₃ | H | 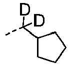 | H | Ph |
| 1392. | C(CH₃)₃ | H | 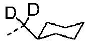 | H | Ph |
| 1393. | CD₂C(CH₃)₃ | H | CD₂CH₃ | H | Ph |
| 1394. | CD₂C(CH₃)₃ | H | CD(CH₃)₂ | H | Ph |
| 1395. | CD₂C(CH₃)₃ | H | CD₂CH(CH₃)₂ | H | Ph |
| 1396. | CD₂C(CH₃)₃ | H | C(CH₃)₃ | H | Ph |
| 1397. | CD₂C(CH₃)₃ | H | CD₂C(CH₃)₃ | H | Ph |
| 1398. | CD₂C(CH₃)₃ | H | 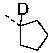 | H | Ph |
| 1399. | CD₂C(CH₃)₃ | H | 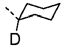 | H | Ph |
| 1400. | CD₂C(CH₃)₃ | H | 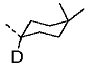 | H | Ph |
| 1401. | CD₂C(CH₃)₃ | H | 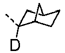 | H | Ph |
| 1402. | CD₂C(CH₃)₃ | H | 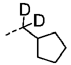 | H | Ph |
| 1403. | CD₂C(CH₃)₃ | H | 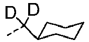 | H | Ph |
| 1404. | 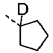 | H | CD₂CH₃ | H | Ph |
| 1405. | 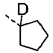 | H | CD(CH₃)₂ | H | Ph |
| 1406. | 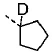 | H | CD₂CH(CH₃)₂ | H | Ph |
| 1407. | 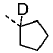 | H | C(CH₃)₃ | H | Ph |
| 1408. | 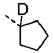 | H | CD₂C(CH₃)₃ | H | Ph |
| 1409. | 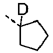 | H | 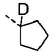 | H | Ph |
| 1410. | 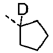 | H | 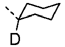 | H | Ph |
| 1411. | 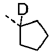 | H | 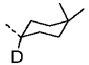 | H | Ph |
| 1412. | 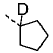 | H | 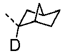 | H | Ph |
| 1413. | 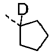 | H | 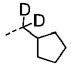 | H | Ph |
| 1414. | 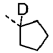 | H | 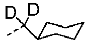 | H | Ph |
| 1415. | 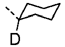 | H | CD₂CH₃ | H | Ph |
| 1416. | 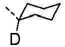 | H | CD(CH₃)₂ | H | Ph |
| 1417. | 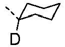 | H | CD₂CH(CH₃)₂ | H | Ph |
| 1418. | 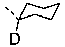 | H | C(CH₃)₃ | H | Ph |
| 1419. | 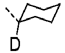 | H | CD₂C(CH₃)₃ | H | Ph |
| 1420. | 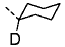 | H | 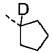 | H | Ph |
| 1421. | 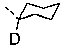 | H | 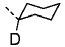 | H | Ph |
| 1422. | 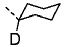 | H | 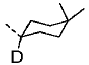 | H | Ph |
| 1423. | 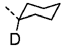 | H | 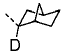 | H | Ph |
| 1424. | 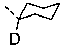 | H | 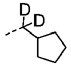 | H | Ph |
| 1425. | 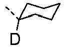 | H | 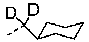 | H | Ph |
| 1426. | 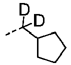 | H | CD₂CH₃ | H | Ph |
| 1427. | 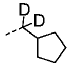 | H | CD(CH₃)₂ | H | Ph |
| 1428. | 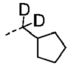 | H | CD₂CH(CH₃)₂ | H | Ph |
| 1429. | 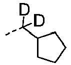 | H | C(CH₃)₃ | H | Ph |
| 1430. | 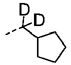 | H | CD₂C(CH₃)₃ | H | Ph |
| 1431. | 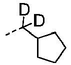 | H | 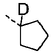 | H | Ph |
| 1432. | 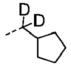 | H | 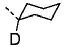 | H | Ph |
| 1433. | 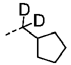 | H | 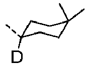 | H | Ph |
| 1434. | 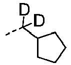 | H | 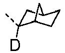 | H | Ph |
| 1435. | 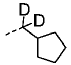 | H | 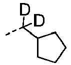 | H | Ph |
| 1436. | 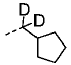 | H | 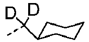 | H | Ph |
| 1437. | 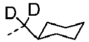 | H | CD₂CH₃ | H | Ph |
| 1438. | 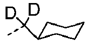 | H | CD(CH₃)₂ | H | Ph |
| 1439. | 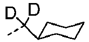 | H | CD₂CH(CH₃)₂ | H | Ph |
| 1440. | 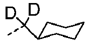 | H | C(CH₃)₃ | H | Ph |
| 1441. | 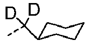 | H | CD₂C(CH₃)₃ | H | Ph |
| 1442. | 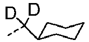 | H | 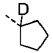 | H | Ph |
| 1443. | 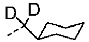 | H | 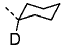 | H | Ph |
| 1444. | 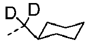 | H | 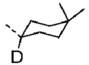 | H | Ph |
| 1445. | 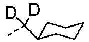 | H | 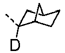 | H | Ph |
| 1446. | 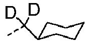 | H | 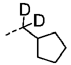 | H | Ph |
| 1447. | 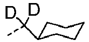 | H | 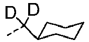 | H | Ph |
| 1448. | 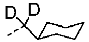 | H | CD₂CH₃ | H | Ph |
| 1449. | 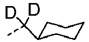 | H | CD(CH₃)₂ | H | Ph |
| 1450. | 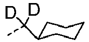 | H | CD₂CH(CH₃)₂ | H | Ph |
| 1451. | 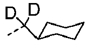 | H | C(CH₃)₃ | H | Ph |
| 1452. | 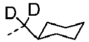 | H | CD₂C(CH₃)₃ | H | Ph |
| 1453. | 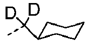 | H | 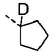 | H | Ph |
| 1454. | 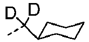 | H | 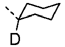 | H | Ph |
| 1455. | 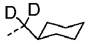 | H | 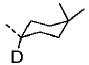 | H | Ph |
| 1456. | 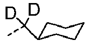 | H | 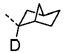 | H | Ph |
| 1457. | 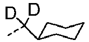 | H | 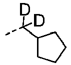 | H | Ph |
| 1458. | 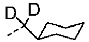 | H | 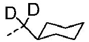 | H | Ph |
| 1459. | 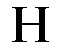 | Ph | CD3 | H | H |
| 1460. | 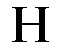 | 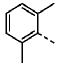 | CD3 | H | H |
| 1461. | H | 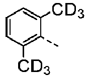 | CD3 | H | H |
| 1462. | H | 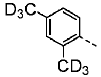 | CD3 | H | H |
| 1463 | H | 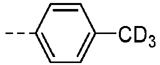 | H | H | H |

According to another aspect of the present disclosure, an OLED is disclosed. The OLED comprising: an anode; a cathode; and an organic layer, disposed between the anode and the cathode, comprising a compound having the formula Ir(L_{A})(L_{B})(L_{C}) as defined in the claims.

In some embodiments of the OLED, any two substituents among R¹, R², R³, R^{A}, R^{B}, R^{C}, R^{D}, R', and R" are optionally joined or fused into a ring.

In some embodiments of the OLED, the organic layer is an emissive layer and the compound is an emissive dopant or a non-emissive dopant.

In some embodiments of the OLED, the organic layer further comprises a host, wherein the host comprises a triphenylene containing benzo-fused thiophene or benzo-fused furan;
wherein any substituent in the host is an unfused substituent independently selected from the group consisting of CₙH₂ₙ₊₁, OCₙH₂ₙ₊₁, OAr₁, N(CₙH₂ₙ₊₁)₂, N(Ar₁)(Ar₂), CH=CH-CₙH₂ₙ₊₁, C≡CCₙH₂ₙ₊₁, Ar₁, Ar₁-Ar₂, and CₙH₂ₙ-Ar₁, or the host has no substitutions;
wherein n is from 1 to 10; and
wherein Ar₁ and Ar₂ are independently selected from the group consisting of benzene, biphenyl, naphthalene, triphenylene, carbazole, and heteroaromatic analogs thereof.

In some embodiments of the OLED, the organic layer further comprises a host, wherein host comprises at least one chemical group selected from the group consisting of triphenylene, carbazole, dibenzothiophene, dibenzofuran, dibenzoselenophene, azatriphenylene, azacarbazole, aza-dibenzothiophene, aza-dibenzofuran, and aza-dibenzoselenophene.

In some embodiments of the OLED, the organic layer further comprises a host, wherein the host is selected from the group consisting of: 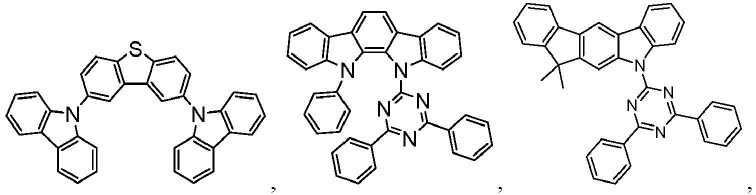 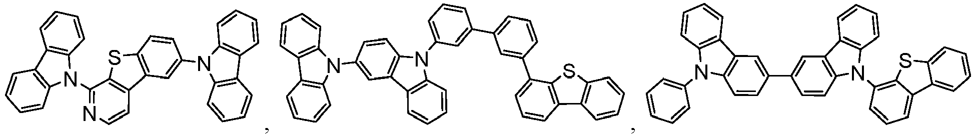 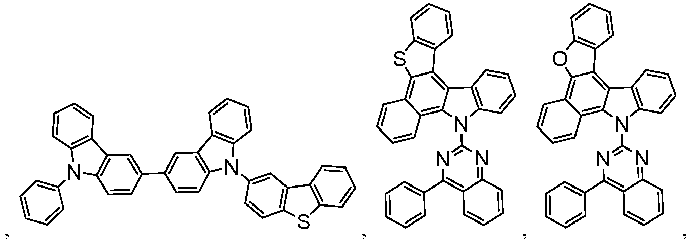 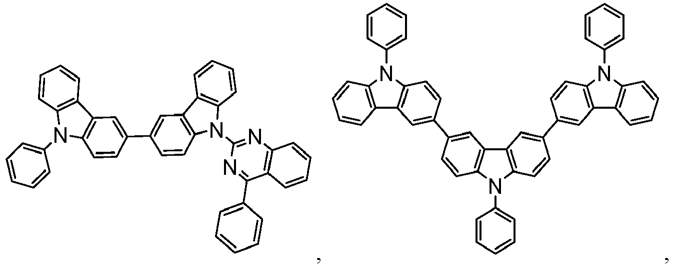 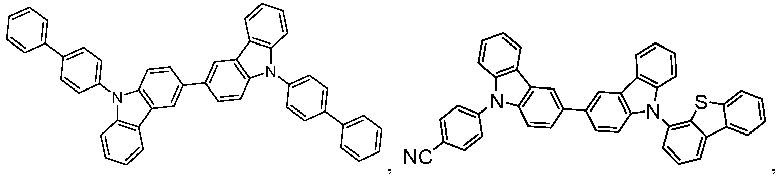 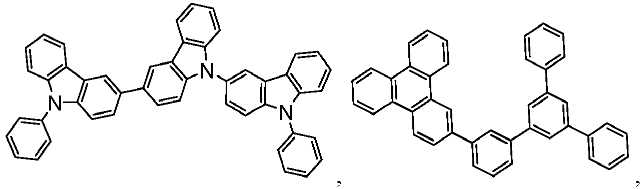 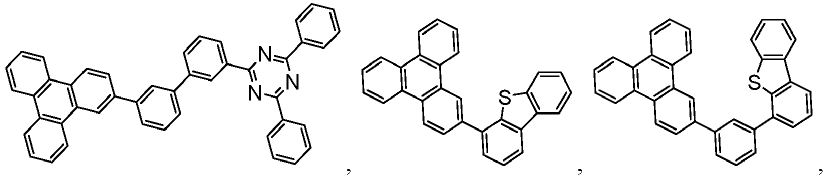 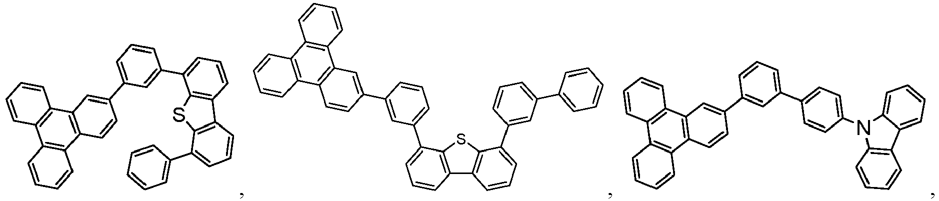 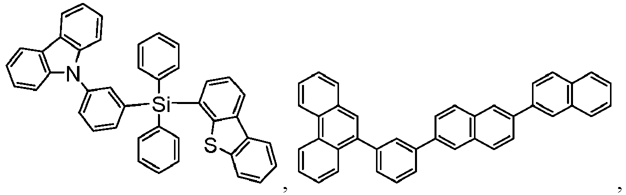 and combinations thereof.

In some embodiments of the OLED, the organic layer further comprises a host, wherein the host comprises a metal complex.

According to another aspect, a consumer product comprising the OLED defined above is disclosed.

According to another aspect, a formulation comprising the compound comprising formula Ir(L_{A})(L_{B})(L_{C}) defined above is disclosed.

In some embodiments, the compound can be an emissive dopant. In some embodiments, the compound can produce emissions via phosphorescence, fluorescence, thermally activated delayed fluorescence, i.e., TADF (also referred to as E-type delayed fluorescence), triplet-triplet annihilation, or combinations of these processes.

The OLED disclosed herein can be incorporated into one or more of a consumer product, an electronic component module, and a lighting panel. The organic layer can be an emissive layer and the compound can be an emissive dopant in some embodiments, while the compound can be a non-emissive dopant in other embodiments.

The formulation can include one or more components selected from the group consisting of a solvent, a host, a hole injection material, hole transport material, and an electron transport layer material, disclosed herein.

### Synthesis of compound 499

### Step 1

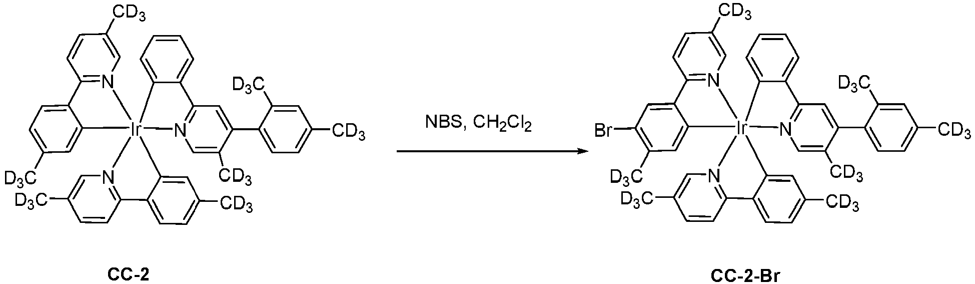

CC-2 (2.3 g, 2.71 mmol) was dissolved in dry dichloromethane (400 ml). The mixture was degassed with N₂ and cooled to 0 °C. 1-Bromopyrrolidine-2,5-dione (0.81 g, 2.71 mmol) was dissovled in DCM (300 mL) and added dropwise. After addition, the temperature was gradually raised to room temperature and reaction was stirred for 12 hrs. Saturated NaHCO₃ (20 mL) solution was added. The organic phase was separated and collected. The solvent was removed and the residue was coated on Celite and purified on silica gel column eluted with toluene/heptane 70/30 (v/v) to give the product CC-2-Br (0.6 g, 24%).

### Step 2

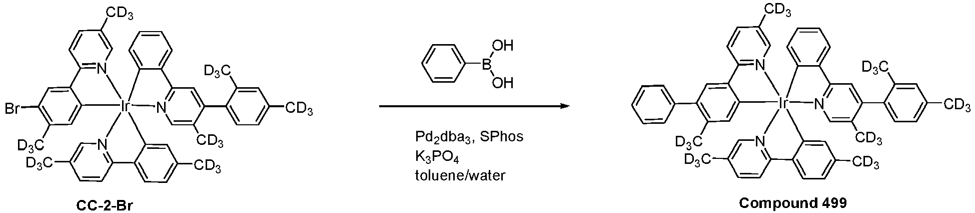

CC-2-Br (0.72 g, 0.775 mmol) was dissolved in a mixture of toluene (40 ml) and water (4 ml). The mixture was purged with N₂ for 10 mins. K₃PO₄ (0.411 gl.937 mmol), SPhos (0.095 g, 0.232 mmol), Pd₂dba₃ (0.043 g, 0.046 mmol), and phenylboronic acid (0.189 g, 1.55 mmol) were added. The mixture was heated under N₂ at 110 °C for 12 hrs. The reaction then was cooled down to room temperature, the product was extreacted with DCM. The organic phase was separated and collected. The solvent was removed and the residue was coated on Celite and purified on silica gel column eluted with toluene/heptane 70/30 (v/v). The product was purified by crysatallization from toluene/MeOH to give compound 499 (0.7 g).

### Synthesis of Compound 500

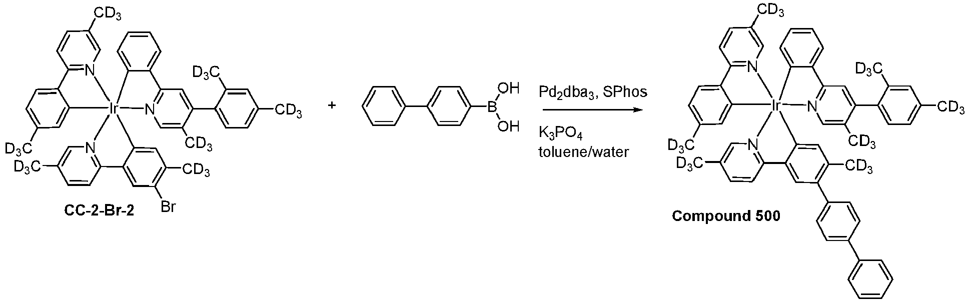

CC-2-Br-2 (0.6 g, 0.646 mmol) was dissovled in a mixture of toluene (100 ml) and water (10 ml). The mixture was purged with N₂ for 10 mins. Potassium phosphate tribasic hydrate (0.343 g, 1.61mmol), SPhos (0.080 g, 0.19 mmol), Pd₂dba₃ (0.035 g, 0.039 mmol), and [1,1-biphenyl]4-ylboronic acid (0.256 g, 1.29 mmol) were added. The mixture was heated under N₂ at 110 °C for 12 hrs. Then the reaction was cooled down to room temperature, the product was extracted with DCM and organic phase was separated. The solvent was removed and the residue was coated on Celite and purified on silica gel column eluted with toluene/heptane 70/30 (v/v). The product was purified by crysatallization from toluene/MeOH to give compound 500 (0.64 g).

### Synthesis of Compound 501

### Step 1

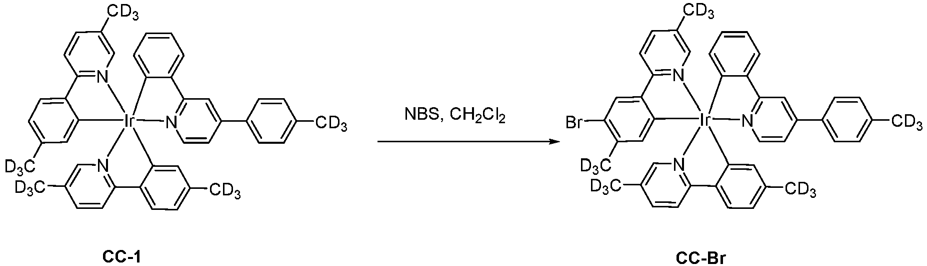

CC-1 (2.04 g, 2.500 mmol) was dissolved in dry dichloromethane (400 ml). The mixture was degassed with N₂ and cooled down to 0 °C. 1-bromopyrrolidine-2,5-dione (0.445 g, 2.500 mmol) was dissovled in DCM (200 mL) and added dropwise. After addition, the temperature was gradually raised to room temperature and stirred for 16 hrs. Sat. NaHCO₃ (20 mL) solution was added. The organic phase was separated and collected. The solvent was removed and the residue was coated on Celite and purified on silica gel column eluted by using 70/30 toluene/heptane to give the product CC-Br (0.6 g).

### Step 2

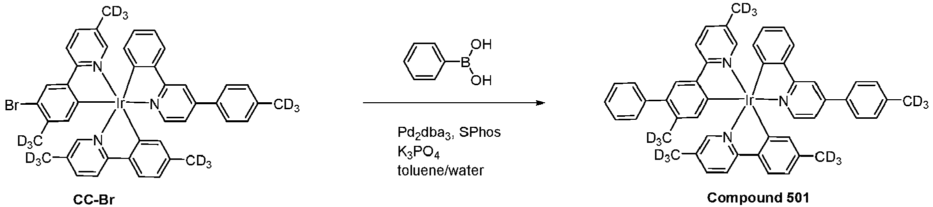

CC-Br (1.16 g, 1.296 mmol) was dissovled in a mixture of toluene (120 ml) and water (12.00 ml). The mixture was purged with N₂ for 10 mins. Potassium phosphate hydrate (0.688 g, 3.24 mmol, Sphos (0.160 g, 0.389 mmol), Pd₂dba₃ (0.071 g, 0.078 mmol), and phenylboronic acid (0.316 g, 2.59 mmol) was added. The mixture was heated under N₂ at 110 °C for 16 hrs. After the reaction was cooled down to room temperature, the product was extracted with DCM. The organic phase was separated and collected. The solvent was removed and the residue was coated on Celite and purified on silica gel column eluted by using 70/30 toluene/heptane. The product was purified by recrysatllization in toluene/MeOH to give Compound 501 (1.0 g).

### Synthesis of Compound 673 (not claimed)

### Step 1

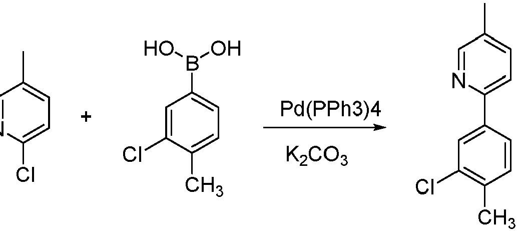

2-Chloro-5-methylpyridine (10.03 g, 79 mmol), (3-chloro-4-methylphenyl)boronic acid (13.4 g, 79 mmol), and potassium carbonate (21.74 g, 157 mmol) were dissolved in the mixture of DME (150 ml) and water (20 ml) under nitrogen to give a colorless suspension. Pd(PPh₃)₄ (0.909 g, 0.786 mmol) was added to the reaction mixture , then the reaction mixture was degassed and heated to 95 °C for 12 hrs. It was then cooled down to room temperature, separated organic phase and evaporated. The residue was subjected to column chromatography on silica gel column, eluted with heptanes/THF 9/1 (v/v), providing after crystallyzation from heptanes 10 g of 2-(3-chloro-4-methylphenyl)-5-methylpyridine (58% yield) of white solid.

### Step 2

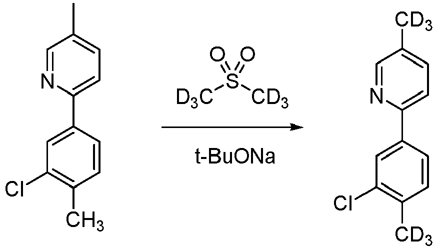

2-(3-Chloro-4-methylphenyl)-5-methylpyridine (10 g, 45.9 mmol), ((methyl-d3)sulfonyl)methane-d3 (92 g, 919 mmol), and sodium 2-methylpropan-2-olate (2.65 g, 27.6 mmol) were dissolved together under nitrogen to give a dark solution. The reaction mixture was heated to 80 °C under nitrogen for 12 hrs, cooled down, diluted with ethyl acetate, washed with water, dried over sodium sulfate, filtered and evaporated. Purified by column chromatography on silica gel, eluted with heptanes/THF 9/1 (v/v), providing off-white solid, then crystallyzed from heptanes, providing white crystalline material (9.1 g, 81% yield).

### Step 3

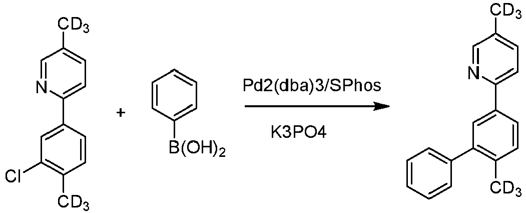

2-(3-Chloro-4-(methyl-d3)phenyl)-5-(methyl-d3)pyridine (7.45 g, 33.3 mmol), phenylboronic acid (6.09 g, 49.9 mmol), potassium phosphate (15.34 g, 66.6 mmol), Pd₂(dba)₃ (0.305 g, 0.333 mmol) and dicyclohexyl(2',6'-dimethoxy- [1,1'-biphenyl]-2-yl)phosphane (Sphos, 0.273 g, 0.666 mmol) were dissolved in the mixture of DME (150 ml) and water (25 ml) under nitrogen to give a red suspension. Ther reaction mixture was degassed and heated to reflux under nitrogen. After 14 hrs heating about 80% conversion was achieved. Addition of more Ph boronic acid and catalyst didn't improve conversion. Separated oganic phase, evaporated, purified by column chromatography on silica gel, eluted with heptanes/THF 9/1, then crystallyzed from heptanes. White solid (6.2 g, 70% yield).

### Step 4

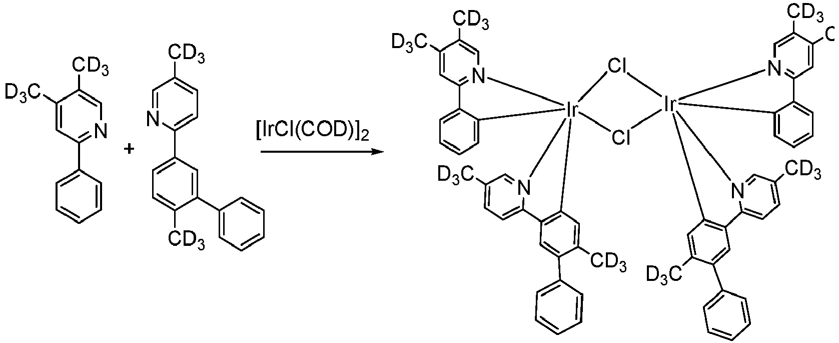

Under nitrogen atmosphere 4,5-bis(methyl-d3)-2-henylpyridine (1.427 g, 7.54 mmol), 5-(methyl-d3)-2-(6-(methyl-d3)-[1,1'-biphenyl]-3-yl)pyridine (2 g, 7.54 mmol), and [IrCl(COD)]2 (2.53 g, 3.77 mmol) were dissolved in ethoxyethanol (50 ml) under nitrogen to give a red solution. The reaction mixture was heated to reflux for 1 hr, then precipitate was formed. Added 30 mL more of ethoxyethanol and continued to reflux for 48 hrs, then the reaction mixture was cooled down to room temperature. The crude material was used without additional purification on the next step.

### Step 5

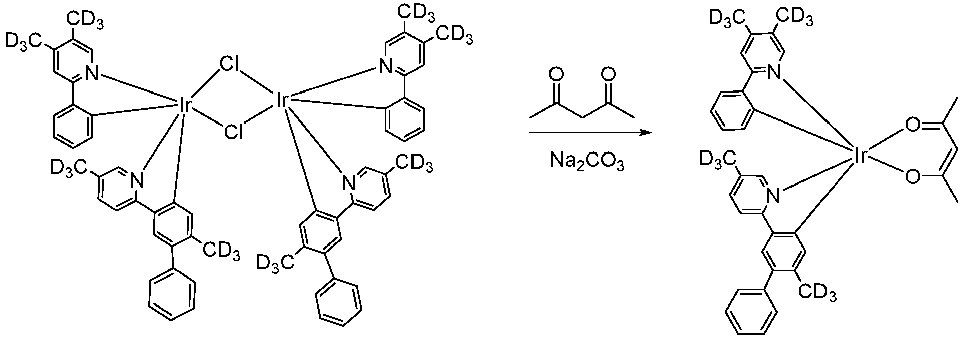

Iridium dimer suspended in ethoxyethanol was mixed under nitrogen atmosphere with pentane-2,4-dione (2.59 g, 25.9 mmol) and sodium carbonate (3.43 g, 32.3 mmol) in 50 ml of methanol, stirred 24 hrs under nitrogen at 55 °C and evaporated. The yellow residue was subjected to column chromatography on silica gel column, eluted with gradient mixture heptanes/toluene, providing 5 g (36% yield) of the target complex.

### Step 6

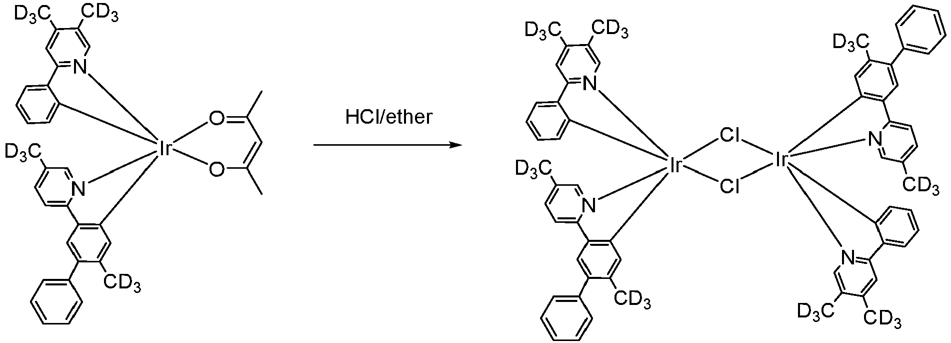

The acac complex (5 g, 6.72 mmol) was dissolved in DCM (20 mL), then HCl in ether (16.80 ml, 33.6 mmol) was added as one portion, stirred for 10 min, evaporated. The residue was triturated in methanol. The solid was filtered and washed with methanol and heptanes to obtain yellow solid (4.55 g, 100% yield).

### Step 7

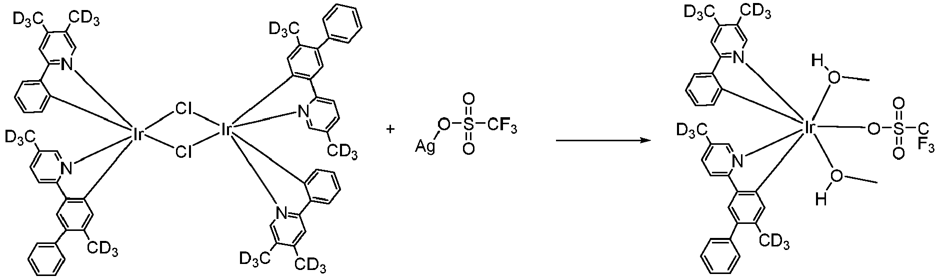

The Ir dimer (4.55 g, 3.34 mmol) and (((trifluoromethyl)sulfonyl)oxy)silver (2.062 g, 8.03 mmol) were suspended in 50 ml of DCM/methanol 1/1 (v/v) mixture and stirred over 72 hrs at room temperature, filtered through celite and evaporated, providing yellow solid (4.75 g, 83% yield).

### Step 8

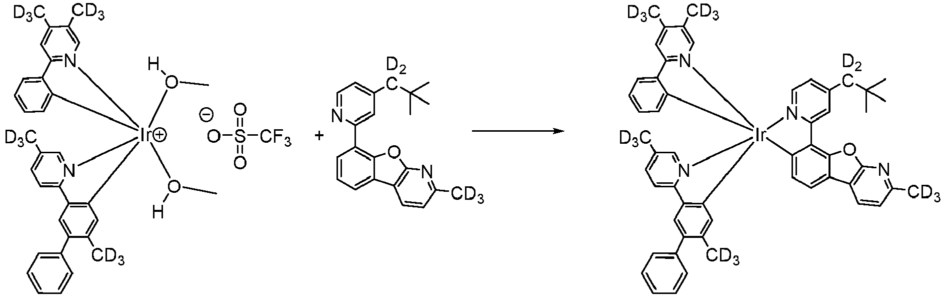

The mixture oftriflic salt (3 g, 3.5 mmol) and 2-(13-methyl-d2)-8-(4-(2,2-dimethylpropyl-1,1-d2)pyridin-2-yl)benzofuro[2,3-b]pyridine (2.56 g, 7.7 mmol) in 30 mL of methanol were stirred under nitrogen at 65 °C for 5 days. Then material was cooled down, and methanol was evaporated. The residue was subjected to column chromatography on the silica gel column, eluted with 2% of ethyl acetate in toluene, providing two isomers of the product (1.7 g with high R_{f} and 0.7 g of complex with low R_{f}). Complex with low R_{f} is the target compound 673.

### DEVICE EXAMPLES

All example devices were fabricated by high vacuum (<10⁻⁷ Torr) thermal evaporation. The anode electrode was 750 Å of indium tin oxide (ITO). The cathode consisted of 10 Å of Liq (8-hydroxyquinoline lithium) followed by 1,000 Å of Al. All devices were encapsulated with a glass lid sealed with an epoxy resin in a nitrogen glove box (<1 ppm of H₂O and O₂) immediately after fabrication with a moisture getter incorporated inside the package. The organic stack of the device examples consisted of sequentially, from the ITO Surface: 100Å of HAT-CN as the hole injection layer (HIL); 450 Å of HTM as a hole transporting layer (HTL); emissive layer (EML) with thickness 400 Å. Emissive layer containing H-host (H1): E-host (H2) in 6:4 ratio and 12 weight % of green emitter. 350 Å of Liq (8-hydroxyquinoline lithium) doped with 40% of ETM as the ETL. Device structure is shown in Table 1 below. Table 1 shows the schematic device structure. The chemical structures of the device materials are shown below.

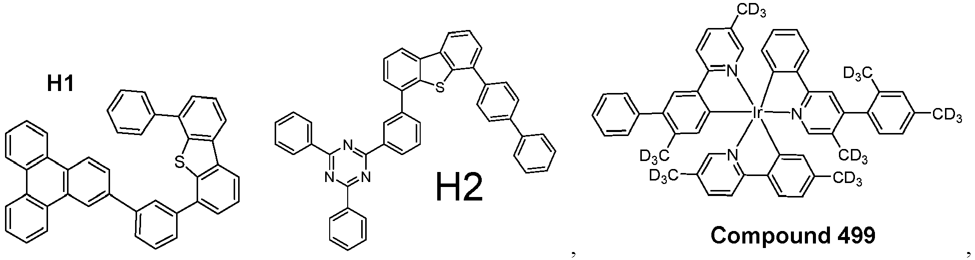

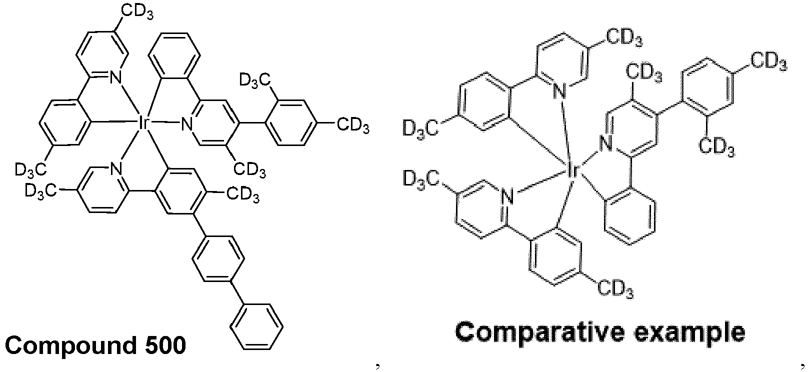

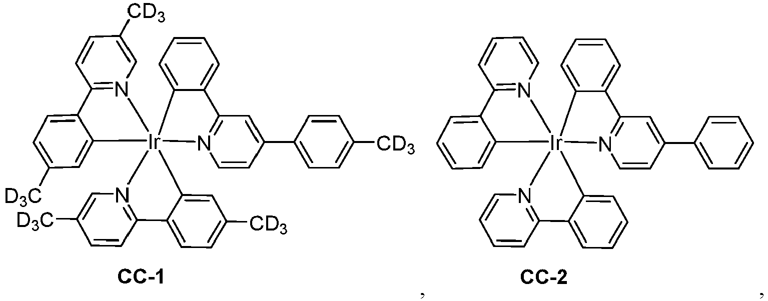

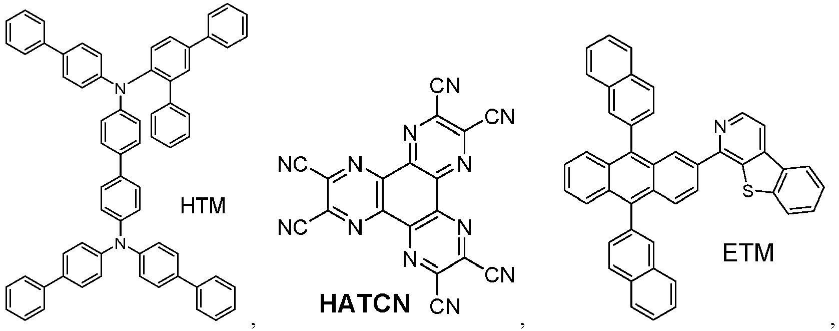

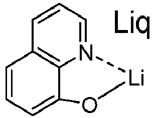

Upon fabrication the devices have been measured for EL, JVL, and lifetime tested at DC 80 mA/cm². Device performance is shown in Table 2, voltage, LE, EQE, PE, and LT97% are all normalized to the comparative compound.

**Table 1: schematic device structure**

| **Layer** | **Material** | **Thickness [Å]** |
|---|---|---|
| Anode | ITO | 800 |
| HIL | HAT-CN | 100 |
| HTL | HTM | 450 |
| Green EML | H1:H2: example dopant | 400 |
| ETL | Liq:ETM 40% | 350 |
| EIL | Liq | 10 |
| Cathode | Al | 1,000 |

**Table 2: Device performance**

| | **1931 CIE** | | | | **At 10mA/cm²** | | | | **at 80mA/cm^{2*}** | |
|---|---|---|---|---|---|---|---|---|---|---|
| **Emitter [12%]** | **x** | **y** | **λ max [nm]** | **FWHM [nm]** | **Voltage [rel]** | **LE [rel]** | **EQE [rel]** | **PE [rel]** | **Lo [nits]** | **LT_{97%} [rel]** |
| Comparative example | 0.319 | 0.624 | 521 | 73 | 1.00 | 1.00 | 1.00 | 1.00 | 46,497 | 1.00 |
| Compound 500 | 0.315 | 0.628 | 519 | 71 | 1.02 | 1.04 | 1.03 | 1.02 | 46,542 | 1.70 |
| Compound 499 | 0.313 | 0.628 | 518 | 71 | 0.99 | 1.12 | 1.12 | 1.14 | 51,738 | 3.00 |

Comparing compounds 499 and 500 with the comparative example; the efficiency of both compound 499 and 500 are higer than the compartive example. Presumably compound 499 and compound 500 have higher horizontal emitting dipole orienation than comparative example. Elongated and planar substituents with high electrostatic potential enlarge the interacting surface region between Ir complex and host molecules; resulting in stacking Ir complexes parallel to film surface and increasing the out coupling efficiency. Moreover; the LT_{97%} at 80 mA/cm² of both compound 499 and compound 500 is greater than comparative example; indicating the elongated substituents not only increase the efficiency; but also increase the stability of the complexes in device.

Provided in Table 3 below is a summary of the device data recorded at 9000 nits for device examples, the EQE value is normalized to Device C-2.

**Table 3**

| Device ID | Dopant | Color | EQE (%) |
|---|---|---|---|
| Device 3 | Compound 501 | Yellow | 1.24 |
| Device C-1 | CC-1 | Yellow | 1.10 |
| Device C-2 | CC-2 | Yellow | 1.00 |

The data in Table D2 show that the device using the inventive compound as the emitter achieves the same color but higher efficiency in comparison with the comparative examples. It is noted that the only difference between the inventive compound (Compound 501) and the comparative compound (CC-1) is that the inventive compound has a phenyl moiety replacing one of the protons in the comparative compounds, which increases the distance between the terminal atoms in one direction across the Ir metal center. The device results show that the larger aspect ratio of the emitter molecule seems to be critical in achieving higher device efficiency.

### COMBINATION WITH OTHER MATERIALS

The materials described herein as useful for a particular layer in an organic light emitting device may be used in combination with a wide variety of other materials present in the device. For example, emissive dopants disclosed herein may be used in conjunction with a wide variety of hosts, transport layers, blocking layers, injection layers, electrodes and other layers that may be present. The materials described or referred to below are non-limiting examples of materials that may be useful in combination with the compounds disclosed herein, and one of skill in the art can readily consult the literature to identify other materials that may be useful in combination.

### Conductivity Dopants:

A charge transport layer can be doped with conductivity dopants to substantially alter its density of charge carriers, which will in turn alter its conductivity. The conductivity is increased by generating charge carriers in the matrix material, and depending on the type of dopant, a change in the Fermi level of the semiconductor may also be achieved. Hole-transporting layer can be doped by p-type conductivity dopants and n-type conductivity dopants are used in the electron-transporting layer.

Non-limiting examples of the conductivity dopants that may be used in an OLED in combination with materials disclosed herein are exemplified below together with references that disclose those materials: EP01617493, EP01968131, EP2020694, EP2684932, US20050139810, US20070160905, US20090167167, US2010288362, WO06081780, WO2009003455, WO2009008277, WO2009011327, WO2014009310, US2007252140, US2015060804 and US2012146012. 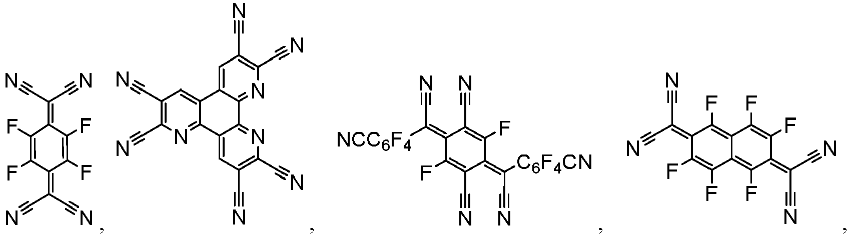 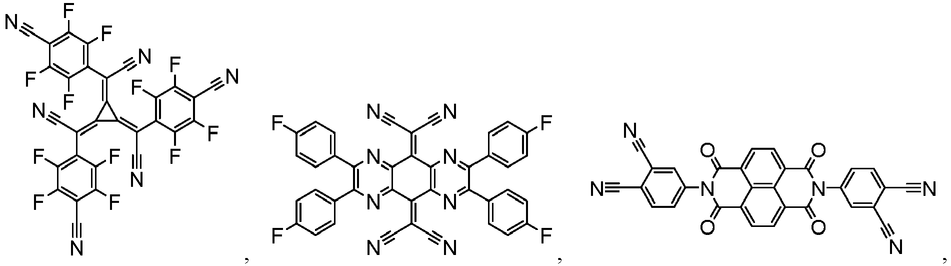 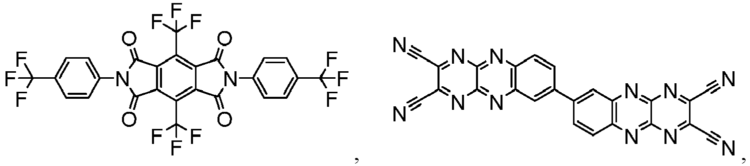 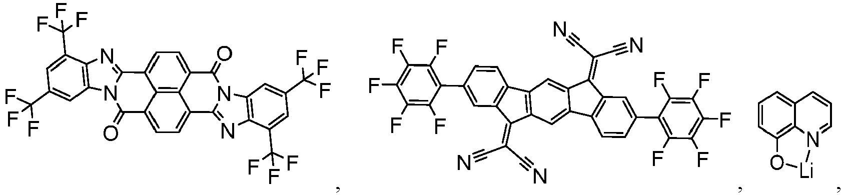 and

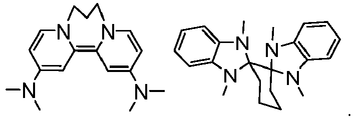

### HIL/HTL:

A hole injecting/transporting material to be used in the present invention is not particularly limited, and any compound may be used as long as the compound is typically used as a hole injecting/transporting material. Examples of the material include, but are not limited to: a phthalocyanine or porphyrin derivative; an aromatic amine derivative; an indolocarbazole derivative; a polymer containing fluorohydrocarbon; a polymer with conductivity dopants; a conducting polymer, such as PEDOT/PSS; a self-assembly monomer derived from compounds such as phosphonic acid and silane derivatives; a metal oxide derivative, such as MoOₓ; a p-type semiconducting organic compound, such as 1,4,5,8,9,12-Hexaazatriphenylenehexacarbonitrile; a metal complex, and a cross-linkable compounds.

Examples of aromatic amine derivatives used in HIL or HTL include, but not limit to the following general structures:

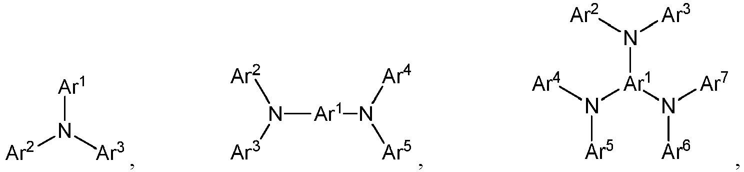

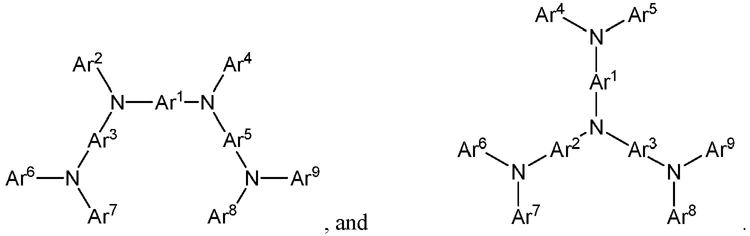

Each of Ar¹ to Ar⁹ is selected from the group consisting of aromatic hydrocarbon cyclic compounds such as benzene, biphenyl, triphenyl, triphenylene, naphthalene, anthracene, phenalene, phenanthrene, fluorene, pyrene, chrysene, perylene, and azulene; the group consisting of aromatic heterocyclic compounds such as dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine; and the group consisting of 2 to 10 cyclic structural units which are groups of the same type or different types selected from the aromatic hydrocarbon cyclic group and the aromatic heterocyclic group and are bonded to each other directly or via at least one of oxygen atom, nitrogen atom, sulfur atom, silicon atom, phosphorus atom, boron atom, chain structural unit and the aliphatic cyclic group. Each Ar may be unsubstituted or may be substituted by a substituent selected from the group consisting of deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof.

In one aspect, Ar¹ to Ar⁹ is independently selected from the group consisting of: 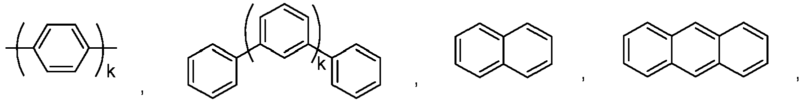 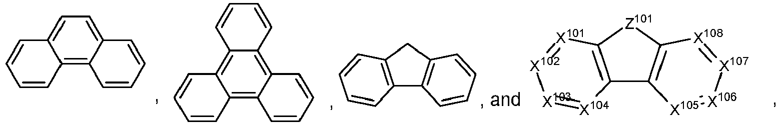 wherein k is an integer from 1 to 20; X¹⁰¹ to X¹⁰⁸ is C (including CH) or N; Z¹⁰¹ is NAr¹, O, or S; Ar¹ has the same group defined above.

Examples of metal complexes used in HIL or HTL include, but are not limited to the following general formula: 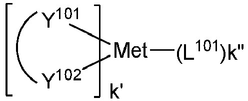 wherein Met is a metal, which can have an atomic weight greater than 40; (Y¹⁰¹-Y¹⁰²) is a bidentate ligand, Y¹⁰¹ and Y¹⁰² are independently selected from C, N, O, P, and S; L¹⁰¹ is an ancillary ligand; k' is an integer value from 1 to the maximum number of ligands that may be attached to the metal; and k'+k" is the maximum number of ligands that may be attached to the metal.

In one aspect, (Y¹⁰¹-Y¹⁰²) is a 2-phenylpyridine derivative. In another aspect, (Y¹⁰¹-Y¹⁰²) is a carbene ligand. In another aspect, Met is selected from Ir, Pt, Os, and Zn. In a further aspect, the metal complex has a smallest oxidation potential in solution vs. Fc⁺/Fc couple less than about 0.6 V.

Non-limiting examples of the HIL and HTL materials that may be used in an OLED in combination with materials disclosed herein are exemplified below together with references that disclose those materials: CN102702075, DE102012005215, EP01624500, EP01698613, EP01806334, EP01930964, EP01972613, EP01997799, EP02011790, EP02055700, EP02055701, EP1725079, EP2085382, EP2660300, EP650955, JP07-073529, JP2005112765, JP2007091719, JP2008021687, JP2014-009196, KR20110088898, KR20130077473, TW201139402, US06517957, US20020158242, US20030162053, US20050123751, US20060182993, US20060240279, US20070145888, US20070181874, US20070278938, US20080014464, US20080091025, US20080106190, US20080124572, US20080145707, US20080220265, US20080233434, US20080303417, US2008107919, US20090115320, US20090167161, US2009066235, US2011007385, US20110163302, US2011240968, US2011278551, US2012205642, US2013241401, US20140117329, US2014183517, US5061569, US5639914, WO05075451, WO07125714, WO08023550, WO08023759, WO2009145016, WO2010061824, WO2011075644, WO2012177006, WO2013018530, WO2013039073, WO2013087142, WO2013118812, WO2013120577, WO2013157367, WO2013175747, WO2014002873, WO2014015935, WO2014015937, WO2014030872, WO2014030921, WO2014034791, WO2014104514, WO2014157018. 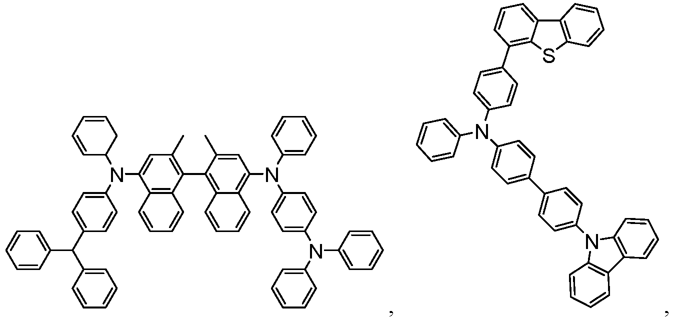 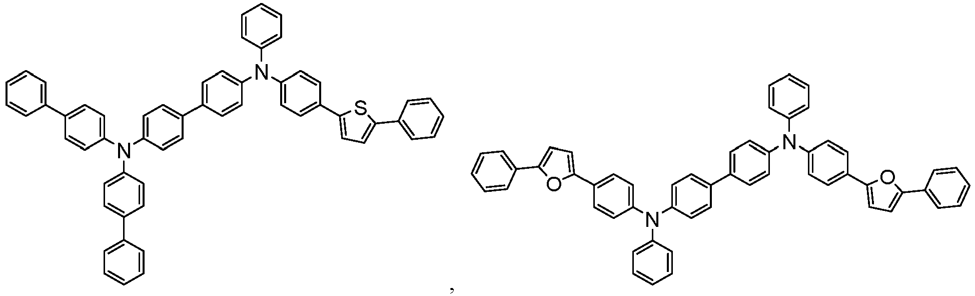 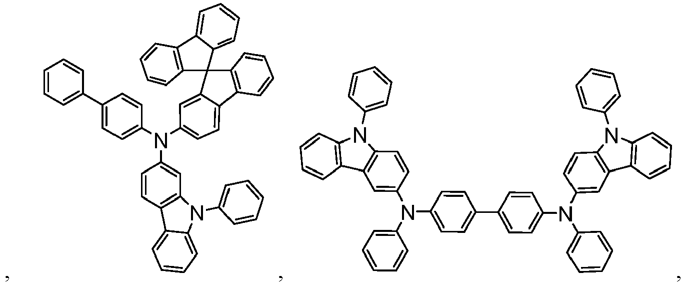 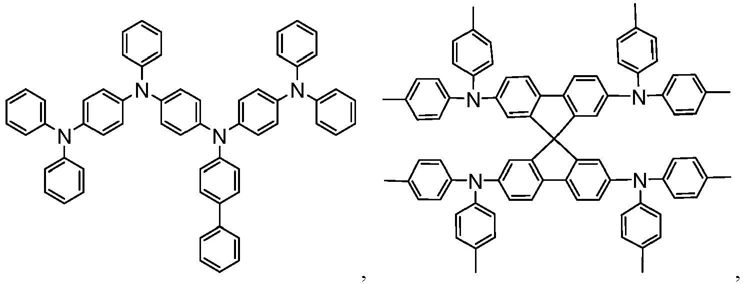 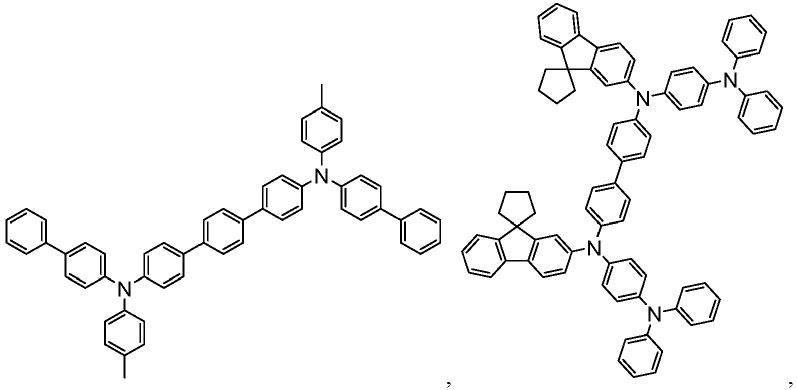 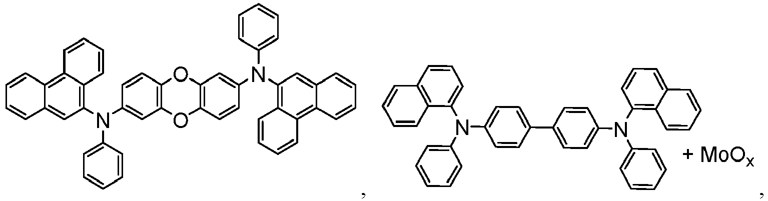 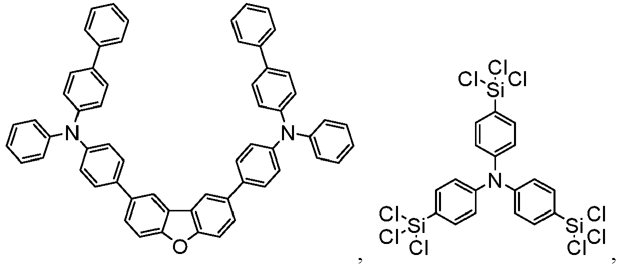 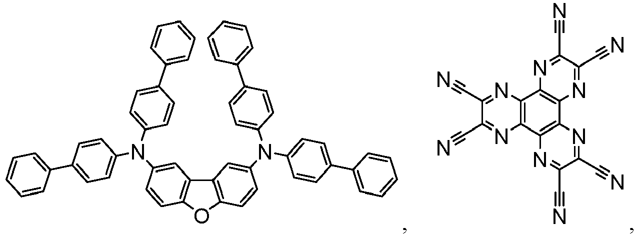 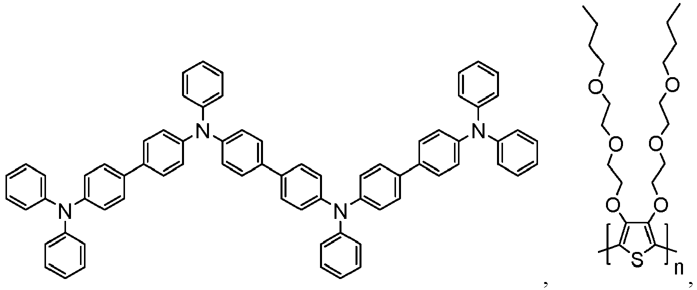 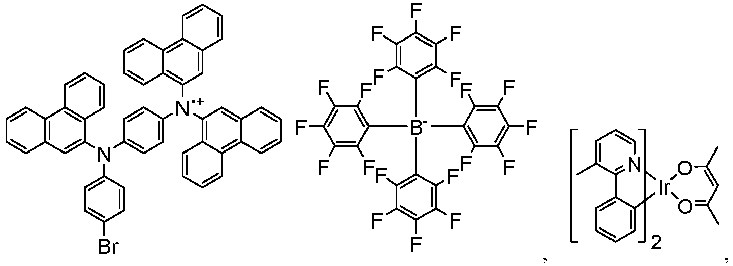 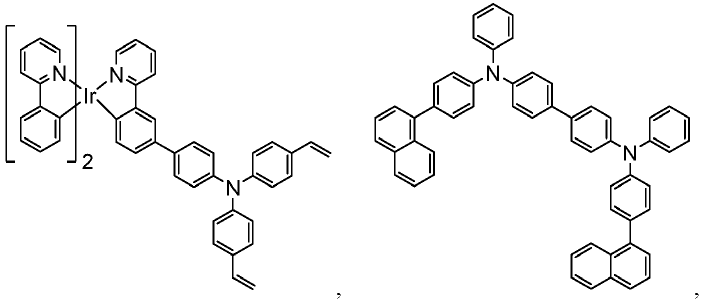 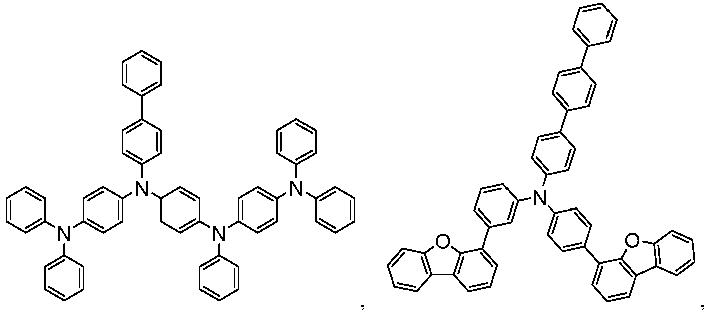 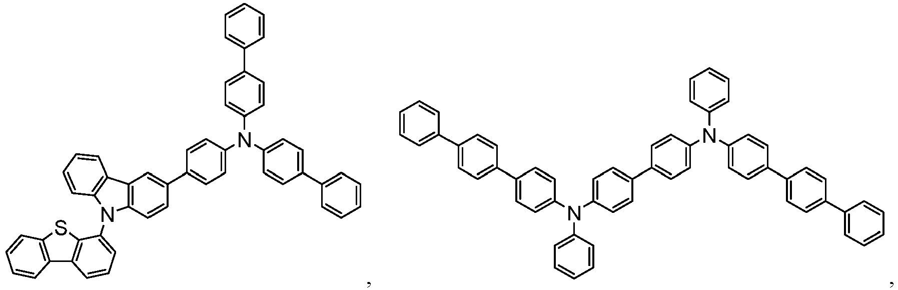 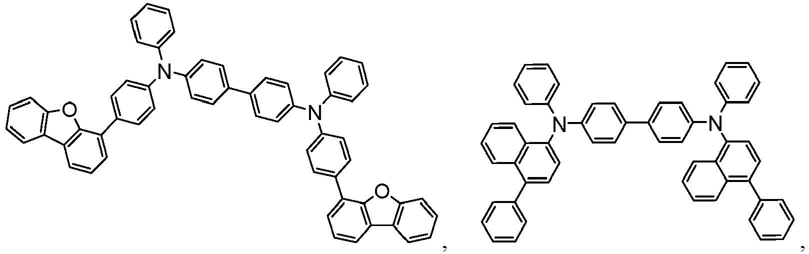 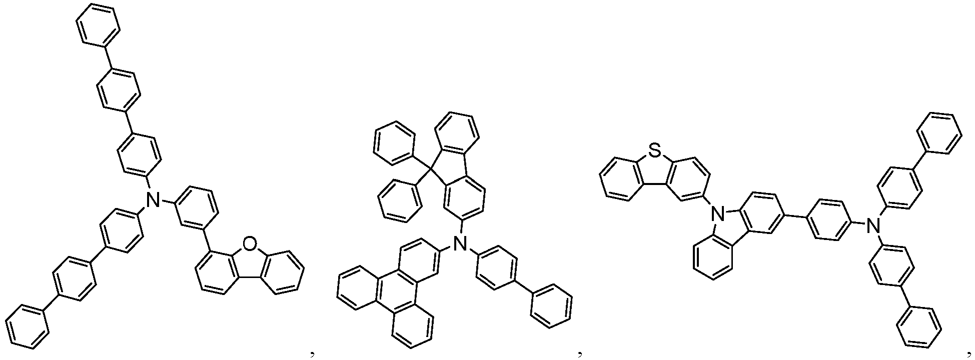 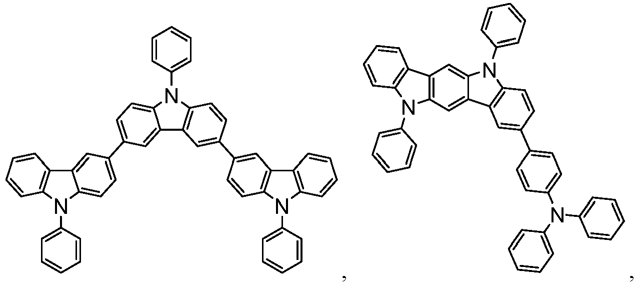 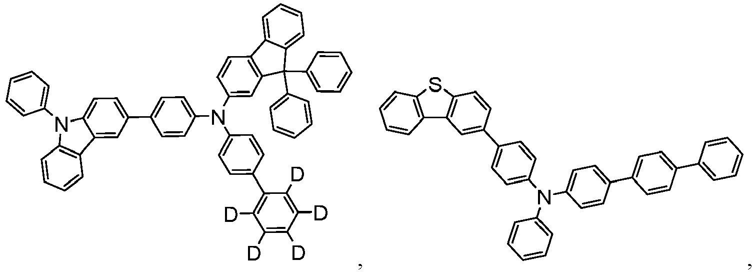 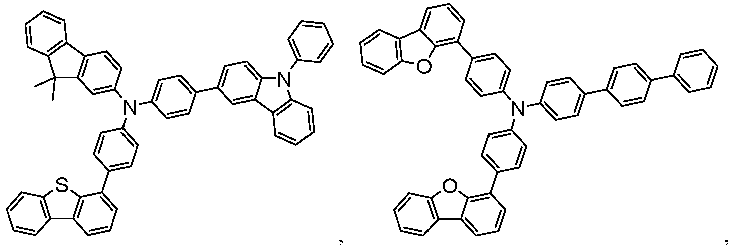 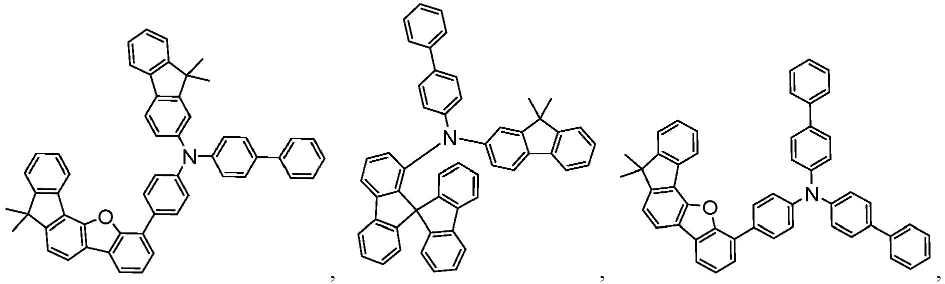 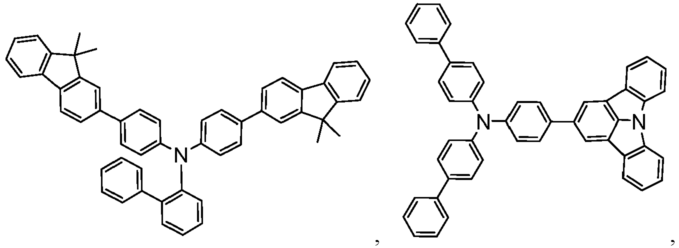 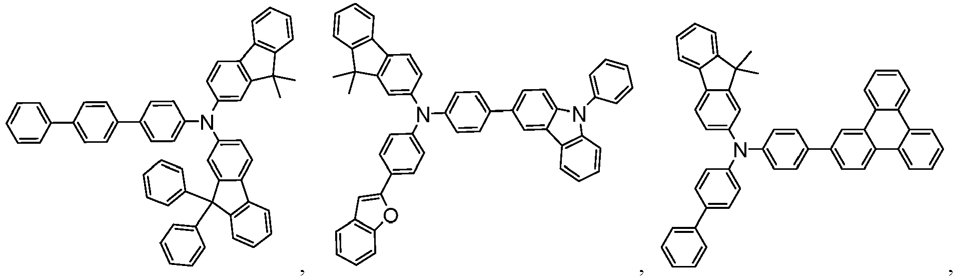 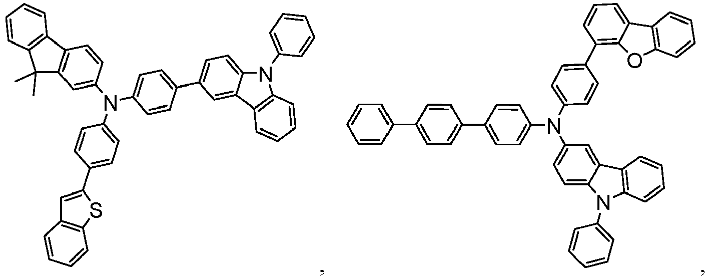 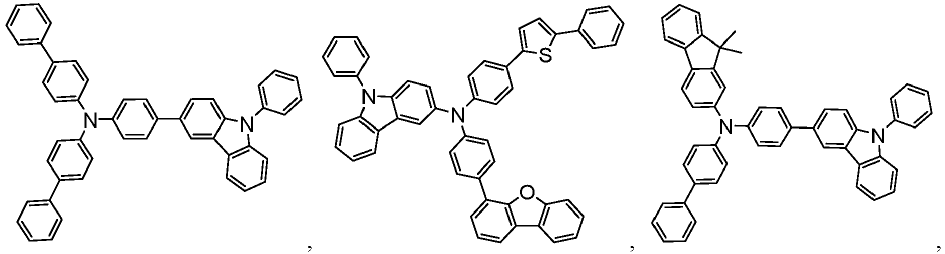 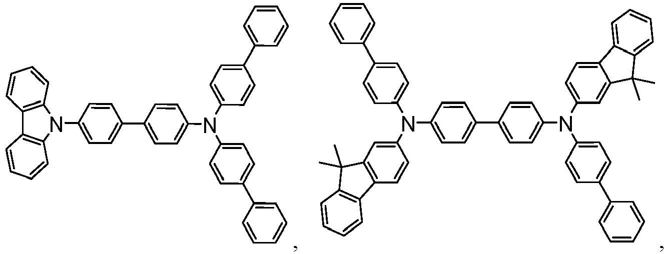 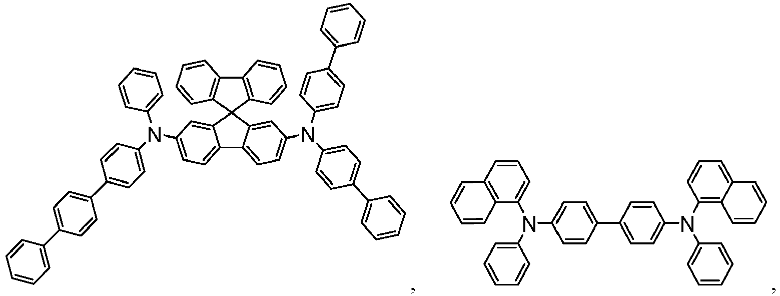 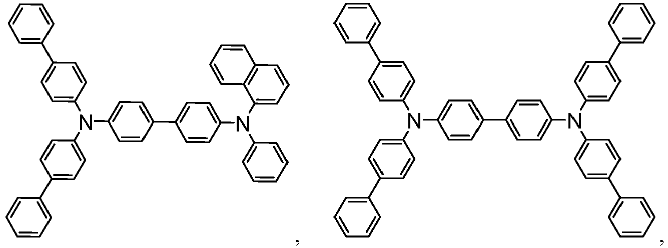 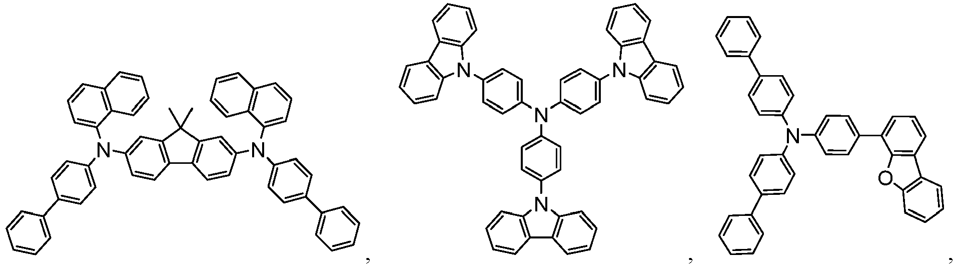 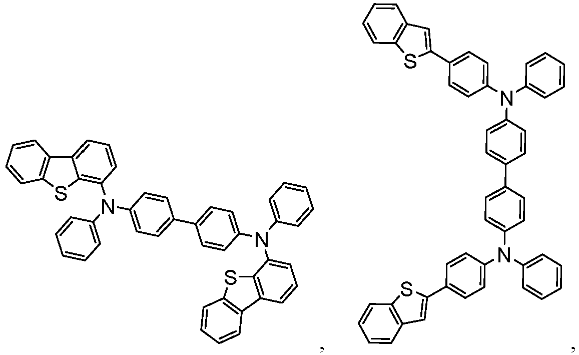 and

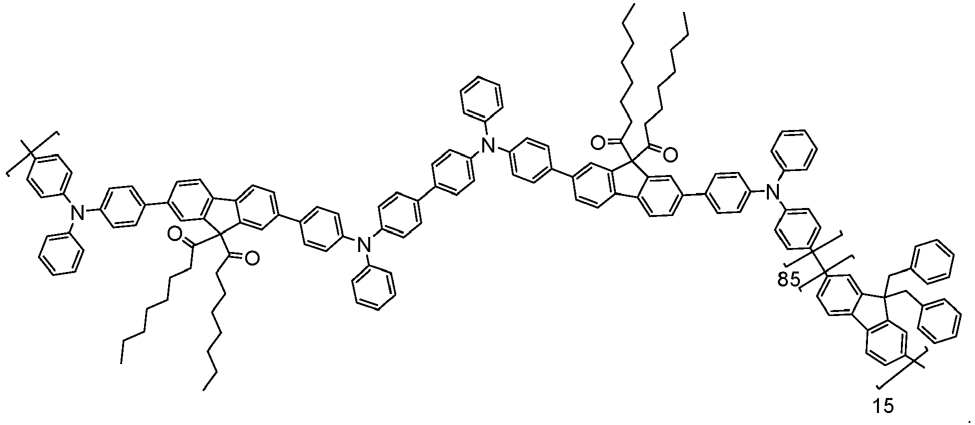

### EBL:

An electron blocking layer (EBL) may be used to reduce the number of electrons and/or excitons that leave the emissive layer. The presence of such a blocking layer in a device may result in substantially higher efficiencies, and/or longer lifetime, as compared to a similar device lacking a blocking layer. Also, a blocking layer may be used to confine emission to a desired region of an OLED. In some embodiments, the EBL material has a higher LUMO (closer to the vacuum level) and/or higher triplet energy than the emitter closest to the EBL interface. In some embodiments, the EBL material has a higher LUMO (closer to the vacuum level) and or higher triplet energy than one or more of the hosts closest to the EBL interface. In one aspect, the compound used in EBL contains the same molecule or the same functional groups used as one of the hosts described below.

### Host:

The light emitting layer of the organic EL device of the present invention preferably contains at least a metal complex as light emitting material, and may contain a host material using the metal complex as a dopant material. Examples of the host material are not particularly limited, and any metal complexes or organic compounds may be used as long as the triplet energy of the host is larger than that of the dopant. Any host material may be used with any dopant so long as the triplet criteria is satisfied.

Examples of metal complexes used as host are preferred to have the following general formula: 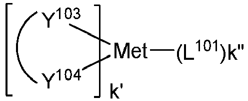 wherein Met is a metal; (Y¹⁰³-Y¹⁰⁴) is a bidentate ligand, Y¹⁰³ and Y¹⁰⁴ are independently selected from C, N, O, P, and S; L¹⁰¹ is an another ligand; k' is an integer value from 1 to the maximum number of ligands that may be attached to the metal; and k'+k" is the maximum number of ligands that may be attached to the metal.

In one aspect, the metal complexes are: 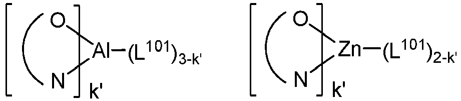 wherein (O-N) is a bidentate ligand, having metal coordinated to atoms O and N.

In another aspect, Met is selected from Ir and Pt. In a further aspect, (Y¹⁰³-Y¹⁰⁴) is a carbene ligand.

Examples of other organic compounds used as host are selected from the group consisting of aromatic hydrocarbon cyclic compounds such as benzene, biphenyl, triphenyl, triphenylene, tetraphenylene, naphthalene, anthracene, phenalene, phenanthrene, fluorene, pyrene, chrysene, perylene, and azulene; the group consisting of aromatic heterocyclic compounds such as dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine; and the group consisting of 2 to 10 cyclic structural units which are groups of the same type or different types selected from the aromatic hydrocarbon cyclic group and the aromatic heterocyclic group and are bonded to each other directly or via at least one of oxygen atom, nitrogen atom, sulfur atom, silicon atom, phosphorus atom, boron atom, chain structural unit and the aliphatic cyclic group. Each option within each group may be unsubstituted or may be substituted by a substituent selected from the group consisting of deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof.

In one aspect, the host compound contains at least one of the following groups in the molecule: 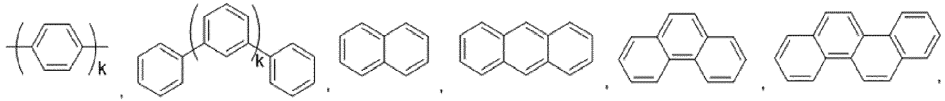 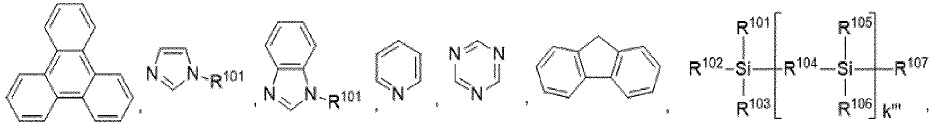 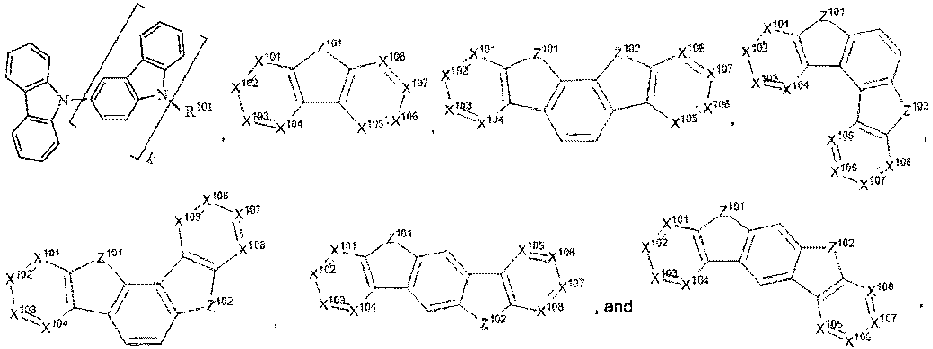
wherein each of R¹⁰¹ to R¹⁰⁷ is independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof, and when it is aryl or heteroaryl, it has the similar definition as Ar's mentioned above. k is an integer from 0 to 20 or 1 to 20; k'" is an integer from 0 to 20. X¹⁰¹ to X¹⁰⁸ is selected from C (including CH) or N.
Z¹⁰¹ and Z¹⁰² is selected from NR¹⁰¹, O, or S.

Non-limiting examples of the host materials that may be used in an OLED in combination with materials disclosed herein are exemplified below together with references that disclose those materials: EP2034538, EP2034538A, EP2757608, JP2007254297, KR20100079458, KR20120088644, KR20120129733, KR20130115564, TW201329200, US20030175553, US20050238919, US20060280965, US20090017330, US20090030202, US20090167162, US20090302743, US20090309488, US20100012931, US20100084966, US20100187984, US2010187984, US2012075273, US2012126221, US2013009543, US2013105787, US2013175519, US2014001446, US20140183503, US20140225088, US2014034914, US7154114, WO2001039234, WO2004093207, WO2005014551, WO2005089025, WO2006072002, WO2006114966, WO2007063754, WO2008056746, WO2009003898, WO2009021126, WO2009063833, WO2009066778, WO2009066779, WO2009086028, WO2010056066, WO2010107244, WO2011081423, WO2011081431, WO2011086863, WO2012128298, WO2012133644, WO2012133649, WO2013024872, WO2013035275, WO2013081315, WO2013191404, WO2014142472,

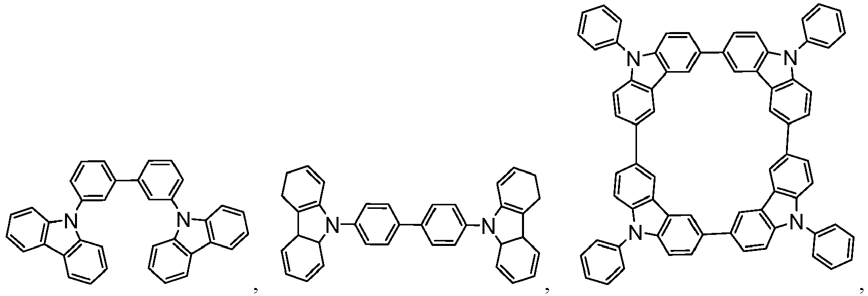

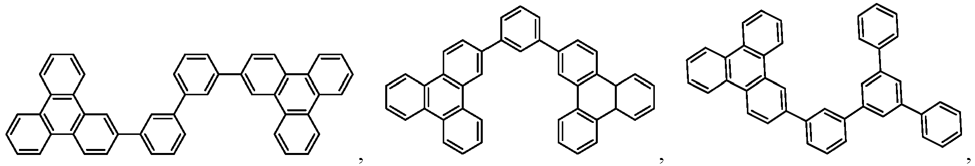

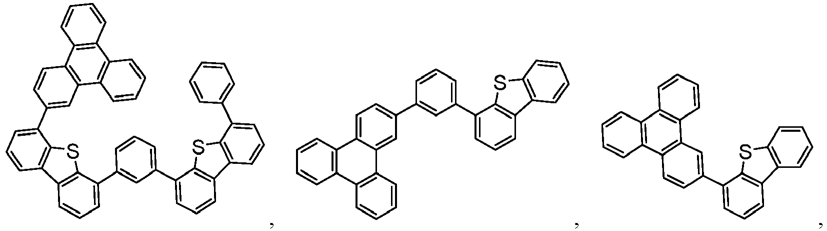

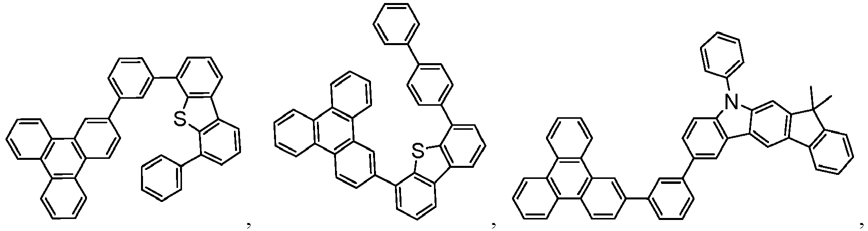

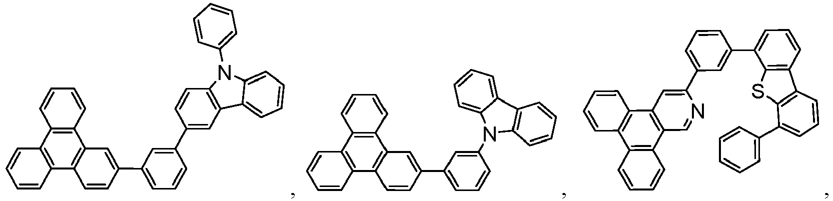

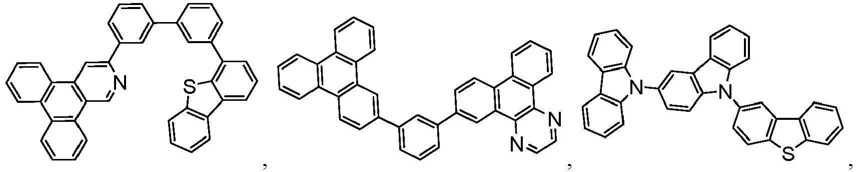

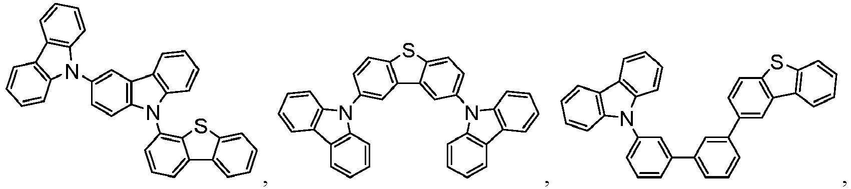

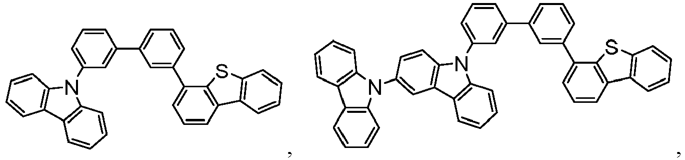

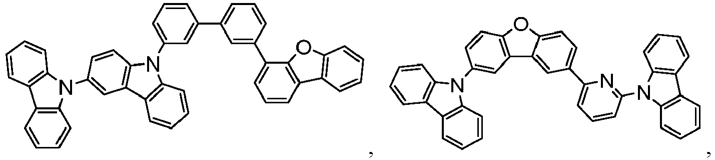

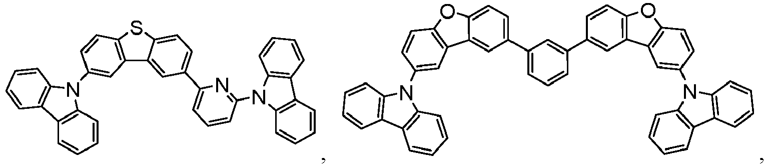

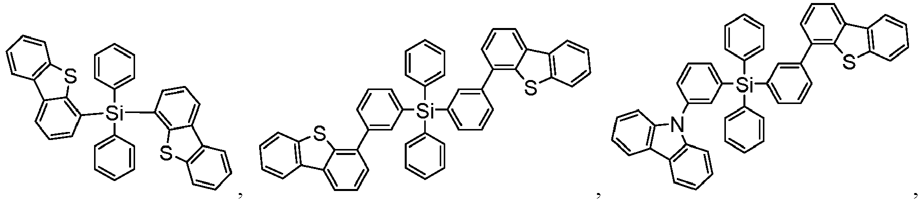

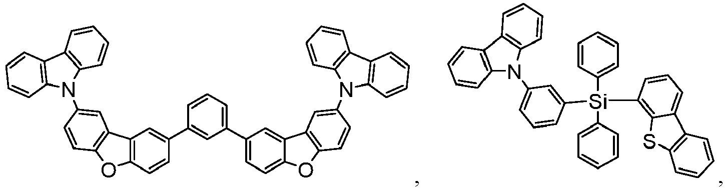

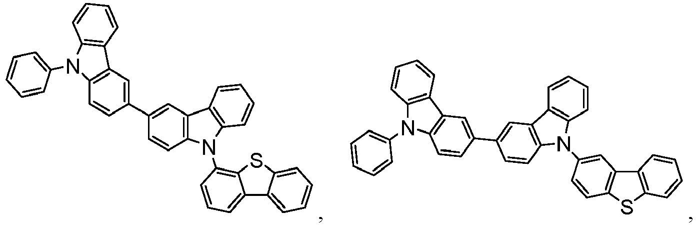

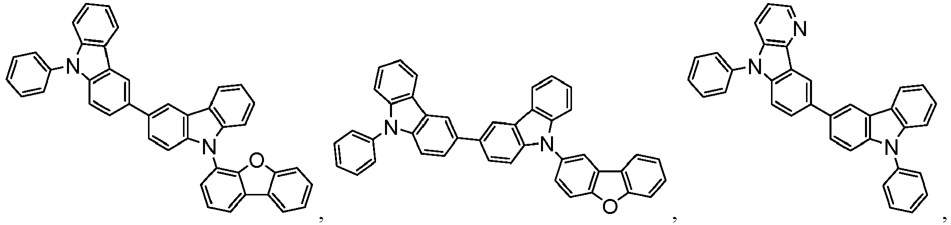

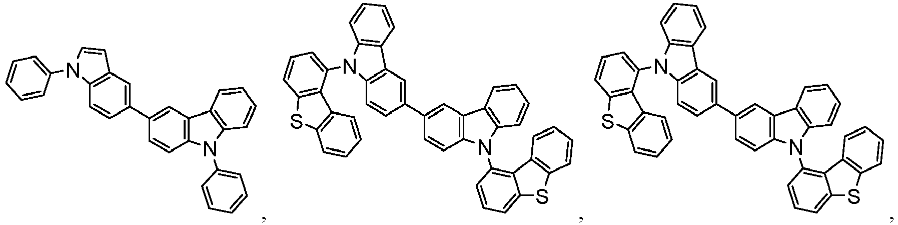

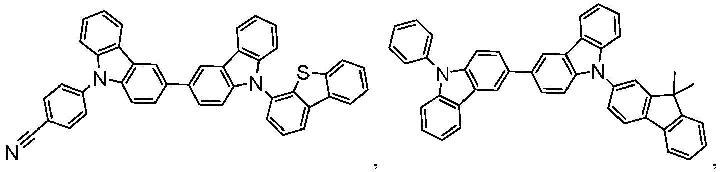

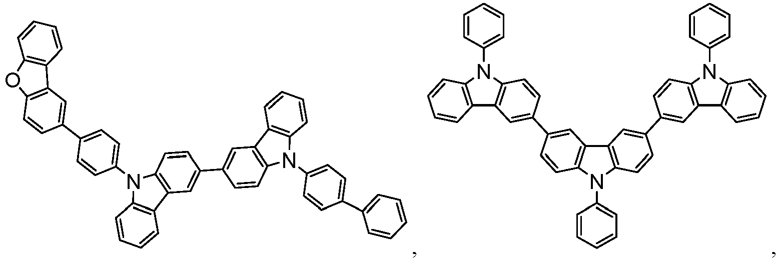

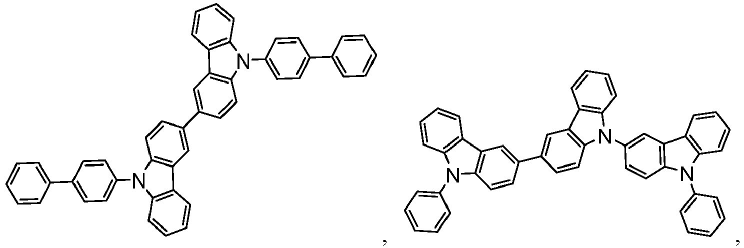

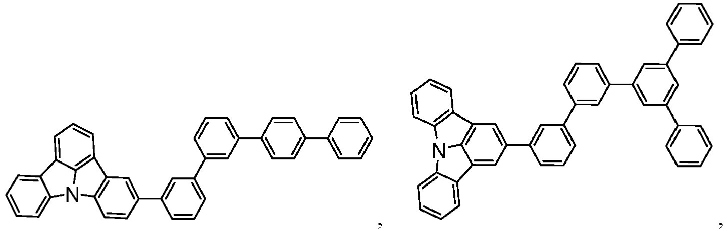

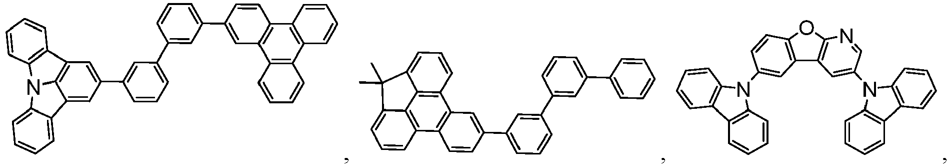

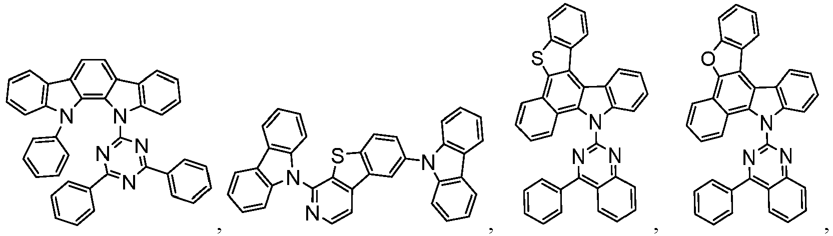

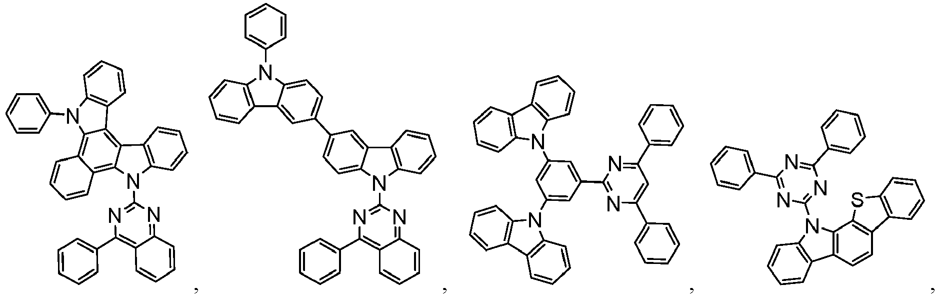

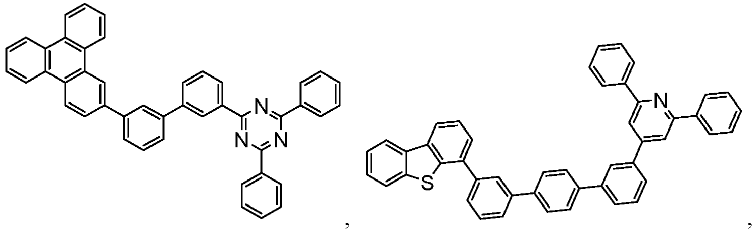

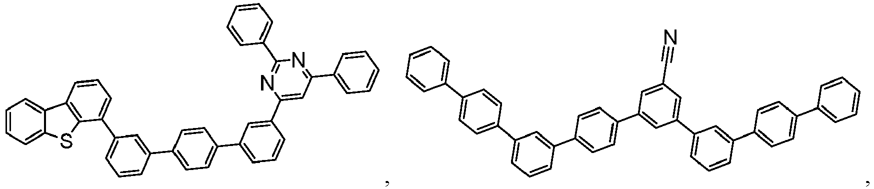

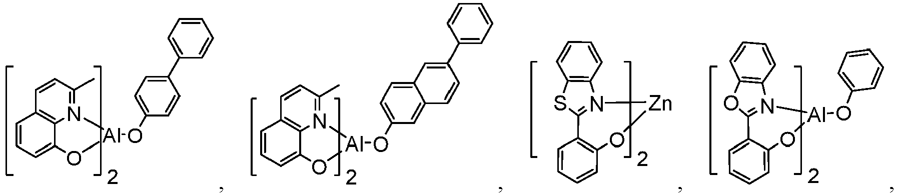

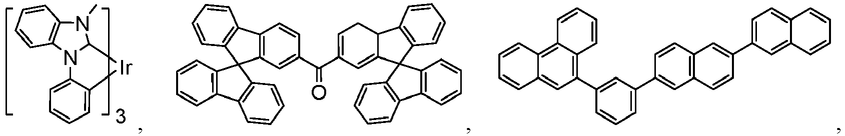

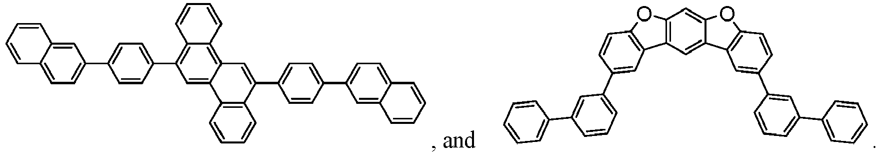

### Additional Emitters:

One or more additional emitter dopants may be used in conjunction with the compound of the present disclosure. Examples of the additional emitter dopants are not particularly limited, and any compounds may be used as long as the compounds are typically used as emitter materials. Examples of suitable emitter materials include, but are not limited to, compounds which can produce emissions via phosphorescence, fluorescence, thermally activated delayed fluorescence, i.e., TADF (also referred to as E-type delayed fluorescence), triplet-triplet annihilation, or combinations of these processes.

Non-limiting examples of the emitter materials that may be used in an OLED in combination with materials disclosed herein are exemplified below together with references that disclose those materials: CN103694277, CN1696137, EB01238981, EP01239526, EP01961743, EP1239526, EP1244155, EP1642951, EP1647554, EP1841834, EP1841834B, EP2062907, EP2730583, JP2012074444, JP2013110263, JP4478555, KR1020090133652, KR20120032054, KR20130043460, TW201332980, US06699599, US06916554, US20010019782, US20020034656, US20030068526, US20030072964, US20030138657, US20050123788, US20050244673, US2005123791, US2005260449, US20060008670, US20060065890, US20060127696, US20060134459, US20060134462, US20060202194, US20060251923, US20070034863, US20070087321, US20070103060, US20070111026, US20070190359, US20070231600, US2007034863, US2007104979, US2007104980, US2007138437, US2007224450, US2007278936, US20080020237, US20080233410, US20080261076, US20080297033, US200805851, US2008161567, US2008210930, US20090039776, US20090108737, US20090115322, US20090179555, US2009085476, US2009104472, US20100090591, US20100148663, US20100244004, US20100295032, US2010102716, US2010105902, US2010244004, US2010270916, US20110057559, US20110108822, US20110204333, US2011215710, US2011227049, US2011285275, US2012292601, US20130146848, US2013033172, US2013165653, US2013181190, US2013334521, US20140246656, US2014103305, US6303238, US6413656, US6653654, US6670645, US6687266, US6835469, US6921915, US7279704, US7332232, US7378162, US7534505, US7675228, US7728137, US7740957, US7759489, US7951947, US8067099, US8592586, US8871361, WO06081973, WO06121811, WO07018067, WO07108362, WO07115970, WO07115981, WO08035571, WO2002015645, WO2003040257, WO2005019373, WO2006056418, WO2008054584, WO2008078800, WO2008096609, WO2008101842, WO2009000673, WO2009050281, WO2009100991, WO2010028151, WO2010054731, WO2010086089, WO2010118029, WO2011044988, WO2011051404, WO2011107491, WO2012020327, WO2012163471, WO2013094620, WO2013107487, WO2013174471, WO2014007565, WO2014008982, WO2014023377, WO2014024131, WO2014031977, WO2014038456, WO2014112450. 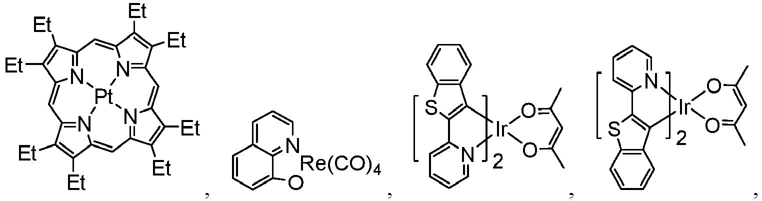 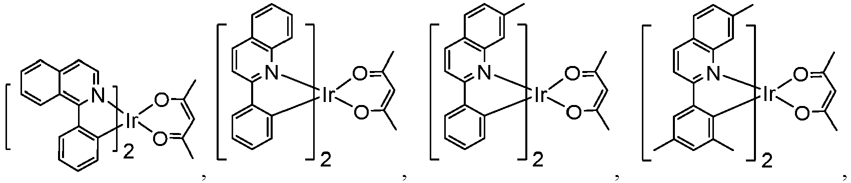 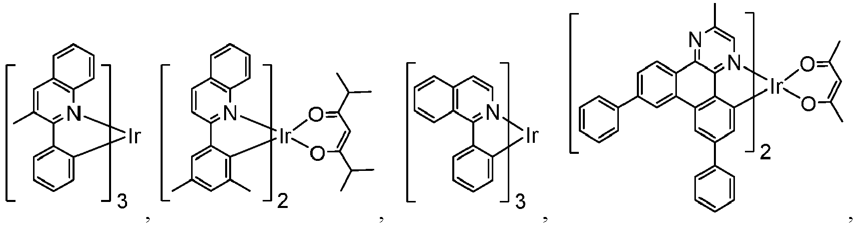 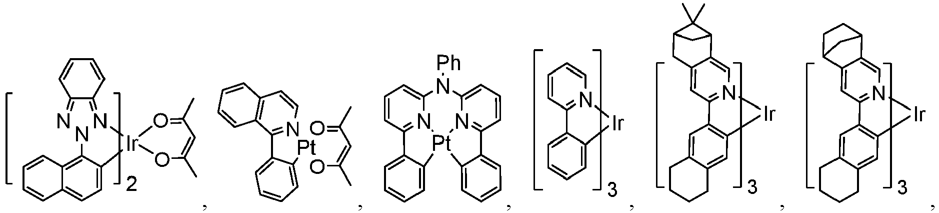 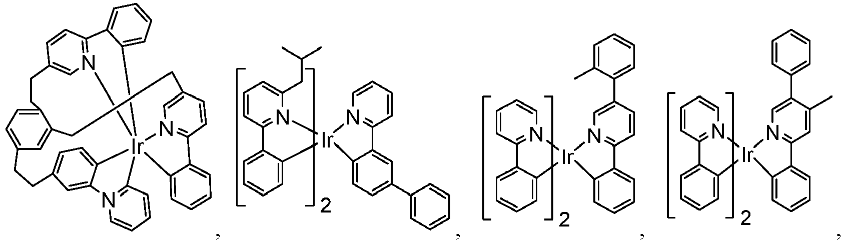 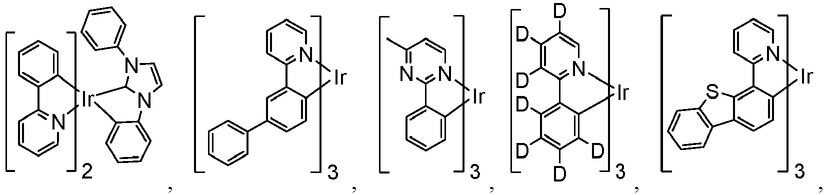 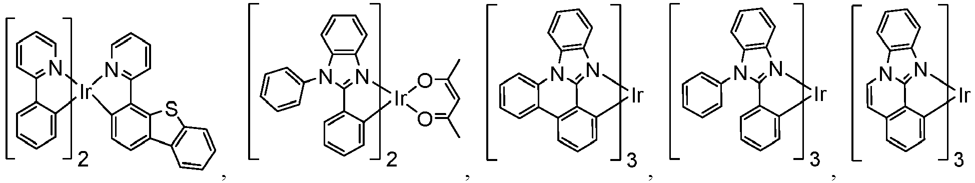 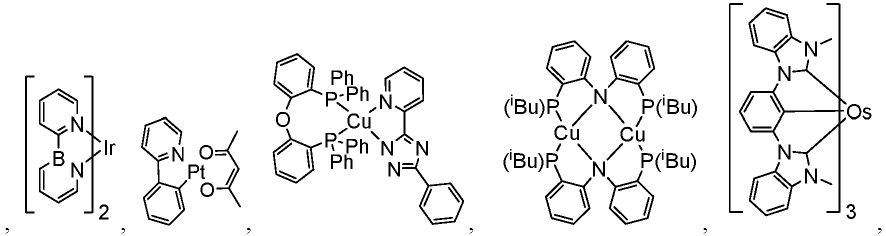 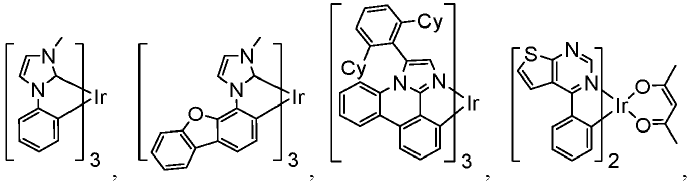 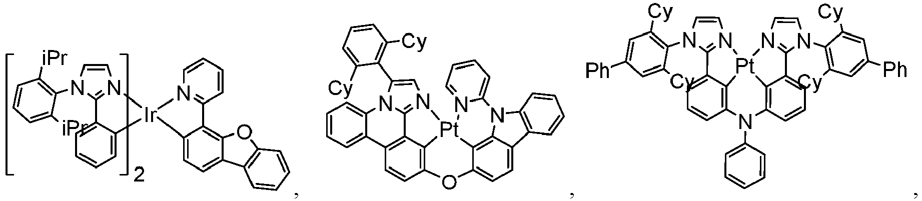 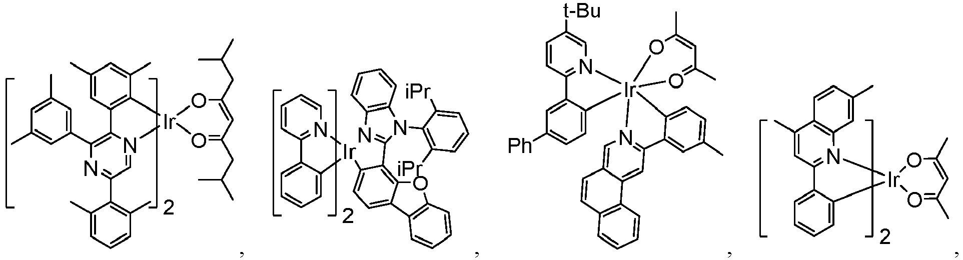 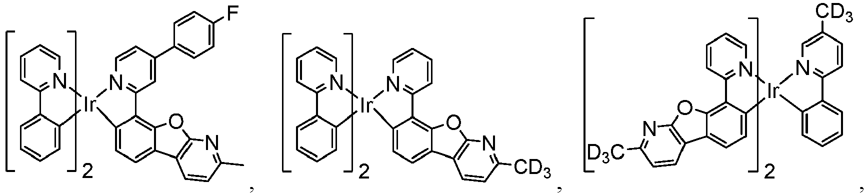 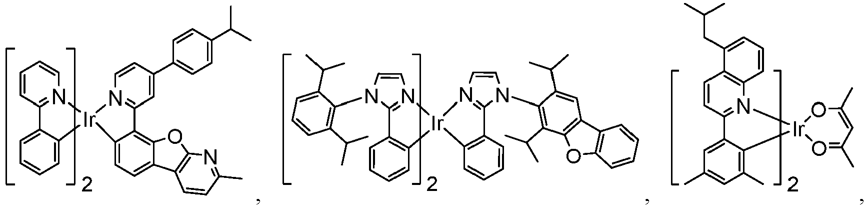 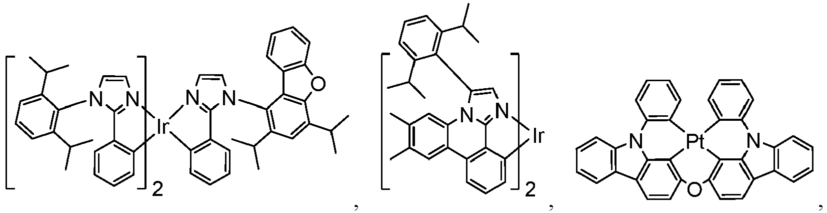 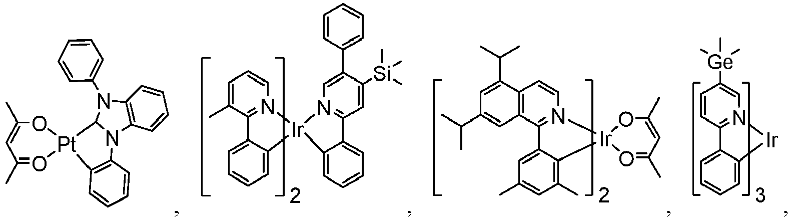 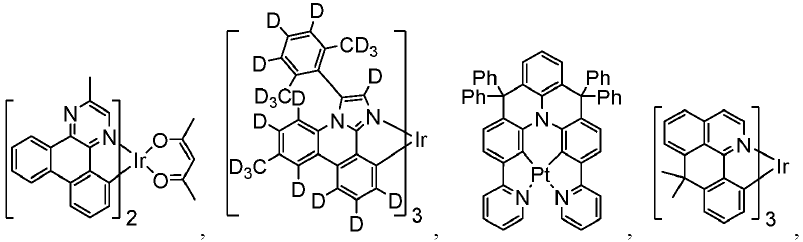 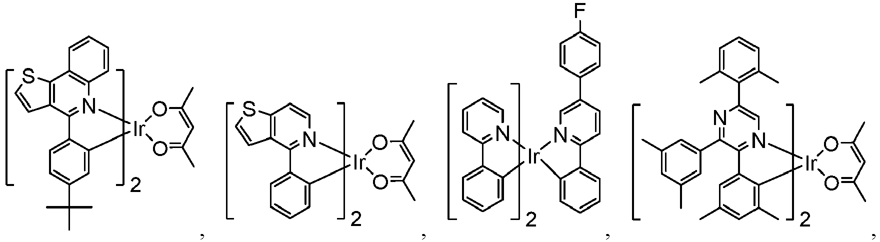 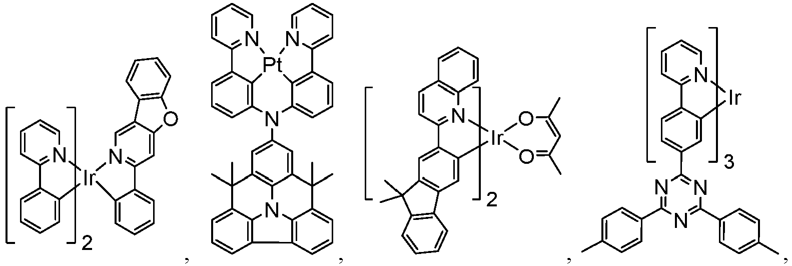 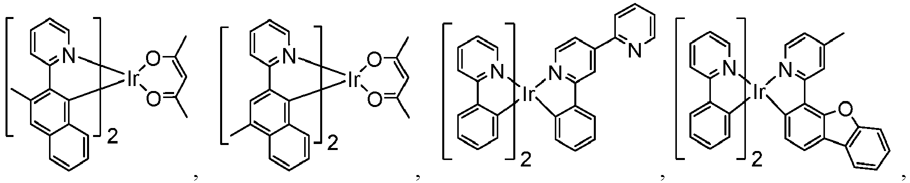 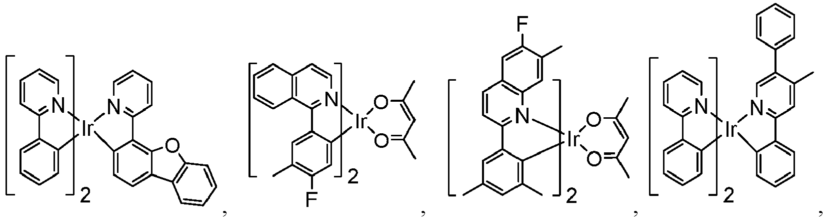 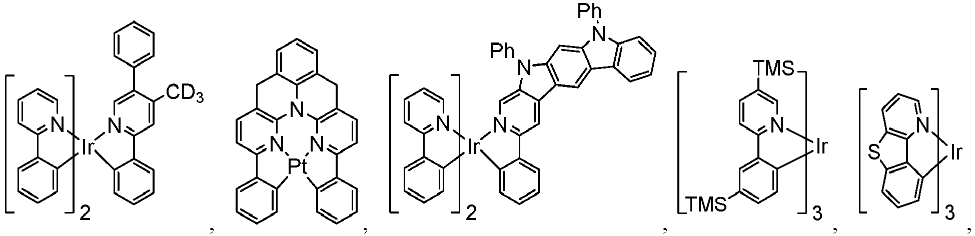 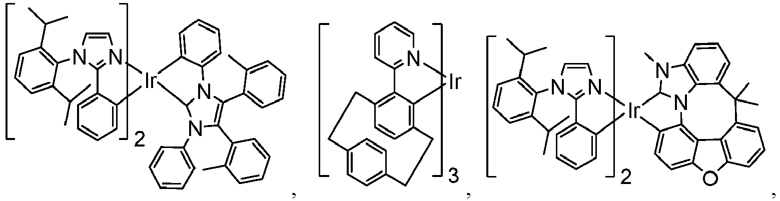 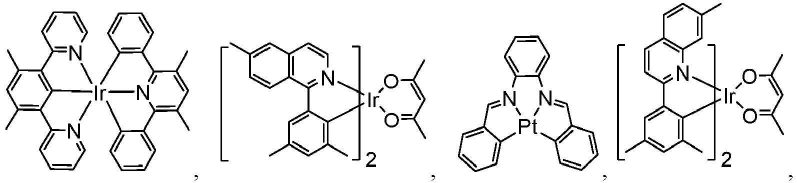 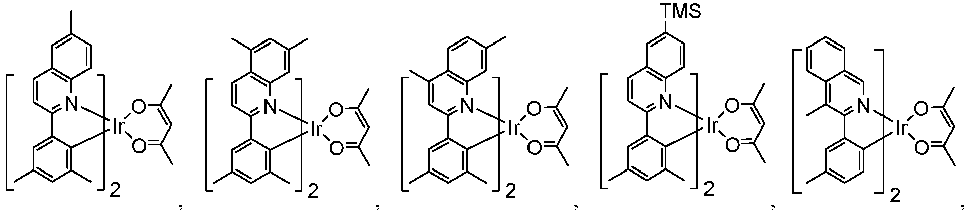 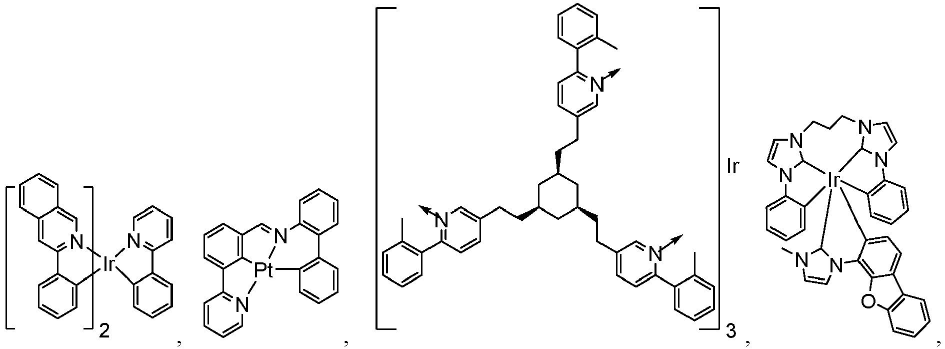 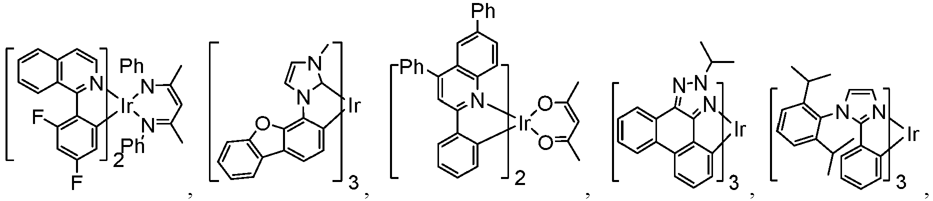 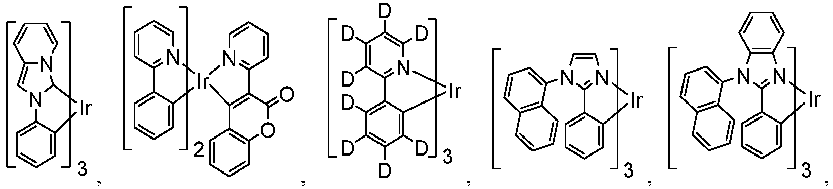 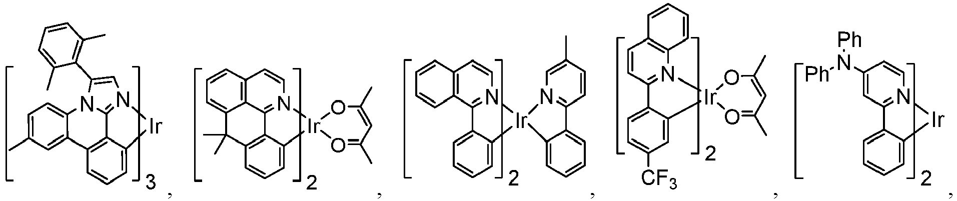 and

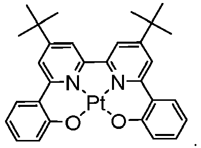

### HBL:

A hole blocking layer (HBL) may be used to reduce the number of holes and/or excitons that leave the emissive layer. The presence of such a blocking layer in a device may result in substantially higher efficiencies and/or longer lifetime as compared to a similar device lacking a blocking layer. Also, a blocking layer may be used to confine emission to a desired region of an OLED. In some embodiments, the HBL material has a lower HOMO (further from the vacuum level) and/or higher triplet energy than the emitter closest to the HBL interface. In some embodiments, the HBL material has a lower HOMO (further from the vacuum level) and/or higher triplet energy than one or more of the hosts closest to the HBL interface.

In one aspect, compound used in HBL contains the same molecule or the same functional groups used as host described above.

In another aspect, compound used in HBL contains at least one of the following groups in the molecule: 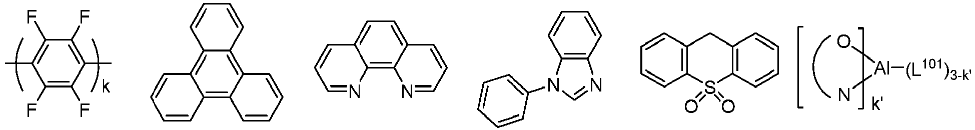 wherein k is an integer from 1 to 20; L¹⁰¹ is an another ligand, k' is an integer from 1 to 3.

### ETL:

Electron transport layer (ETL) may include a material capable of transporting electrons. Electron transport layer may be intrinsic (undoped), or doped. Doping may be used to enhance conductivity. Examples of the ETL material are not particularly limited, and any metal complexes or organic compounds may be used as long as they are typically used to transport electrons.

In one aspect, compound used in ETL contains at least one of the following groups in the molecule: 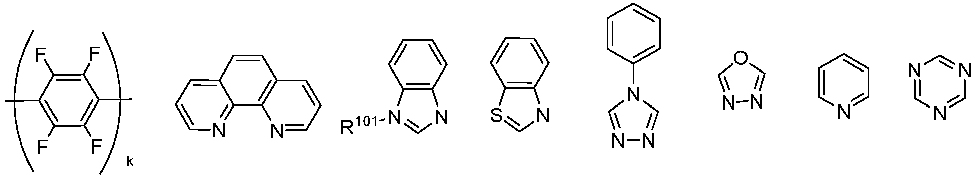 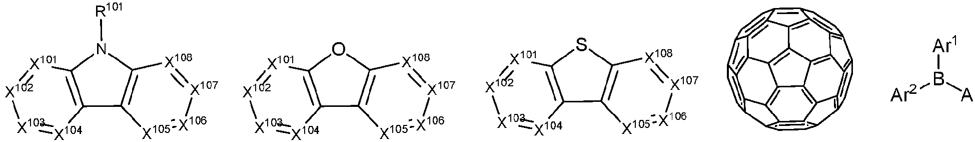 wherein R¹⁰¹ is selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof, when it is aryl or heteroaryl, it has the similar definition as Ar's mentioned above. Ar¹ to Ar³ has the similar definition as Ar's mentioned above. k is an integer from 1 to 20. X¹⁰¹ to X¹⁰⁸ is selected from C (including CH) or N.

In another aspect, the metal complexes used in ETL contains, but not limit to the following general formula: 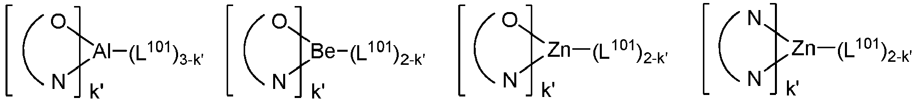 wherein (O-N) or (N-N) is a bidentate ligand, having metal coordinated to atoms O, N or N, N; L¹⁰¹ is another ligand; k' is an integer value from 1 to the maximum number of ligands that may be attached to the metal.

Non-limiting examples of the ETL materials that may be used in an OLED in combination with materials disclosed herein are exemplified below together with references that disclose those materials: CN103508940, EP01602648, EP01734038, EP01956007, JP2004-022334, JP2005149918, JP2005-268199, KR0117693, KR20130108183, US20040036077, US20070104977, US2007018155, US20090101870, US20090115316, US20090140637, US20090179554, US2009218940, US2010108990, US2011156017, US2011210320, US2012193612, US2012214993, US2014014925, US2014014927, US20140284580, US6656612, US8415031, WO2003060956, WO2007111263, WO2009148269, WO2010067894, WO2010072300, WO2011074770, WO2011105373, WO2013079217, WO2013145667, WO2013180376, WO2014104499, WO2014104535,

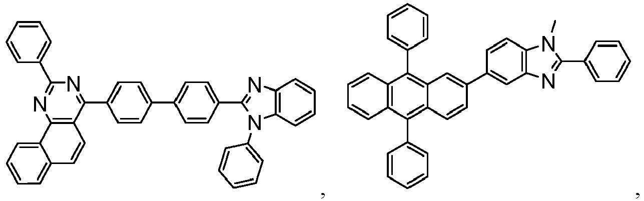

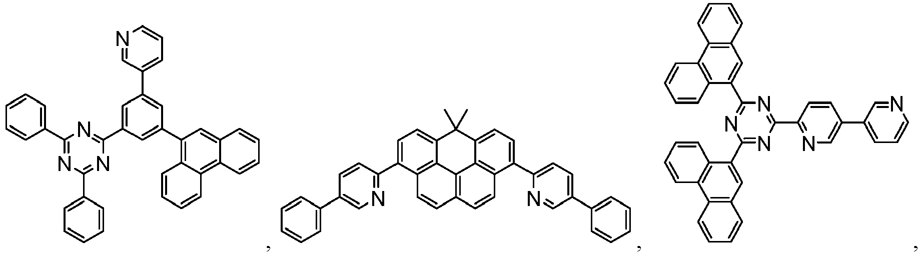

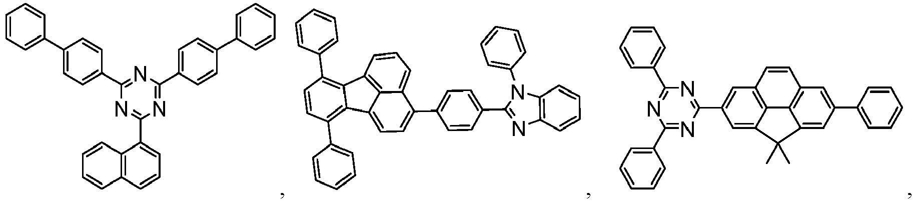

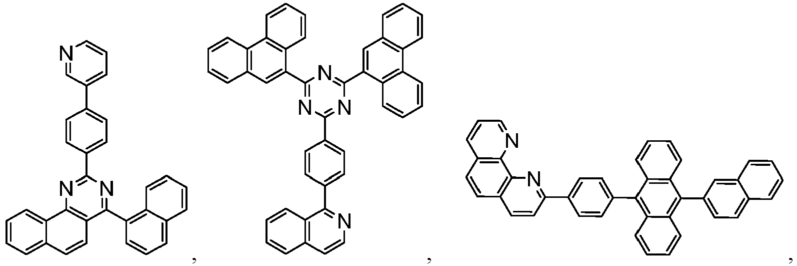

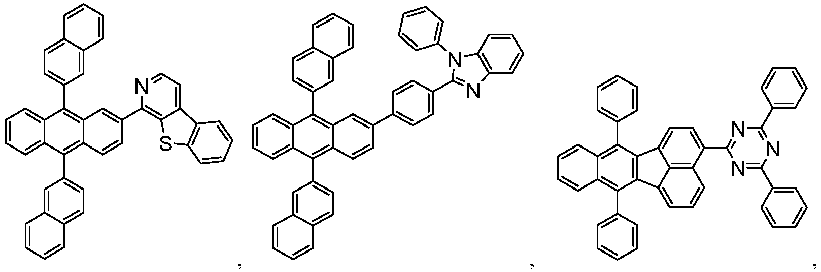

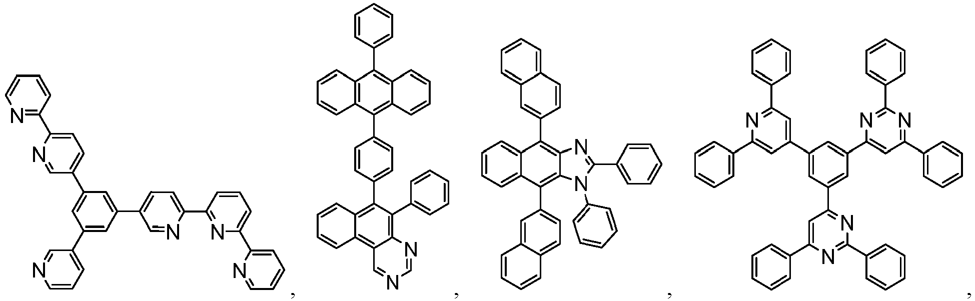

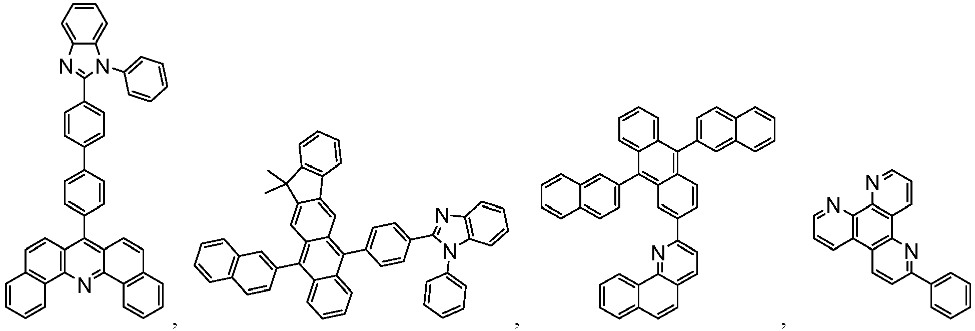

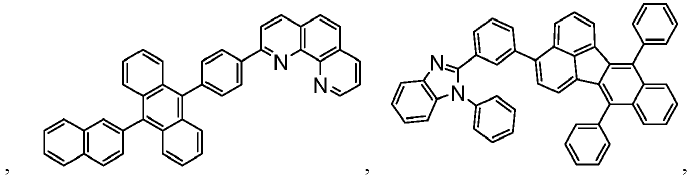

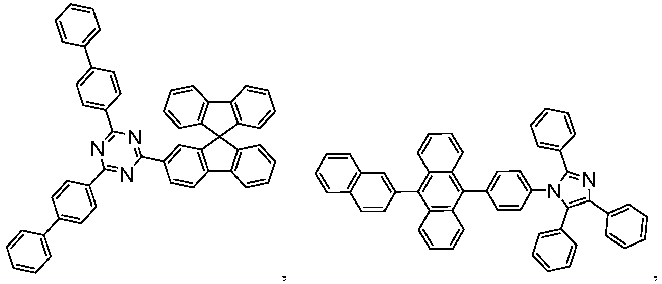

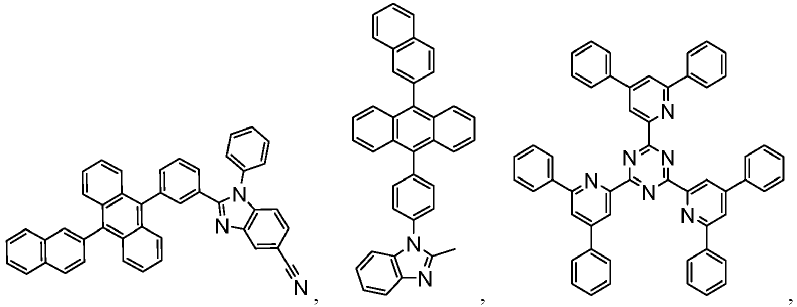

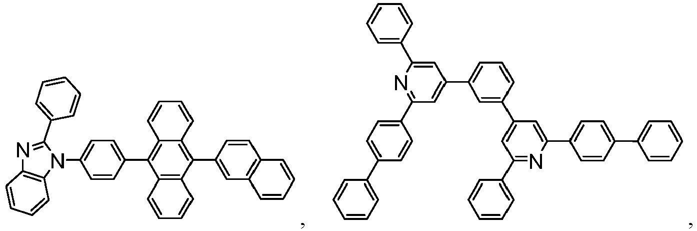

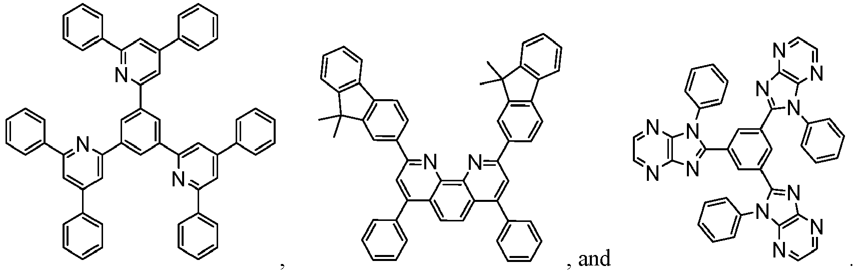

### Charge generation layer (CGL)

In tandem or stacked OLEDs, the CGL plays an essential role in the performance, which is composed of an n-doped layer and a p-doped layer for injection of electrons and holes, respectively. Electrons and holes are supplied from the CGL and electrodes. The consumed electrons and holes in the CGL are refilled by the electrons and holes injected from the cathode and anode, respectively; then, the bipolar currents reach a steady state gradually. Typical CGL materials include n and p conductivity dopants used in the transport layers.

In any above-mentioned compounds used in each layer of the OLED device, the hydrogen atoms can be partially or fully deuterated. Thus, any specifically listed substituent, such as, without limitation, methyl, phenyl, pyridyl, etc. may be undeuterated, partially deuterated, and fully deuterated versions thereof. Similarly, classes of substituents such as, without limitation, alkyl, aryl, cycloalkyl, heteroaryl, etc. also may be undeuterated, partially deuterated, and fully deuterated versions thereof.

It is understood that the various embodiments described herein are by way of example only, and are not intended to limit the scope of the invention. For example, many of the materials and structures described herein may be substituted with other materials and structures. The present invention as claimed may therefore include variations from the particular examples and preferred embodiments described herein, as will be apparent to one of skill in the art. It is understood that various theories as to why the invention works are not intended to be limiting.

## Claims

1. A compound having a formula Ir(L_{A})(L_{B})(L_{C});
wherein the ligand L_{A} is 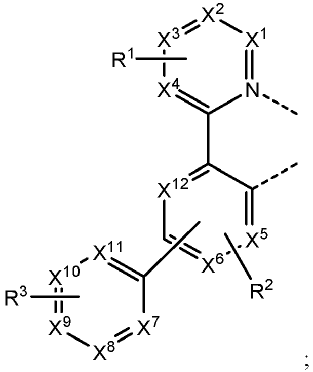 wherein the ligand L_{B} is 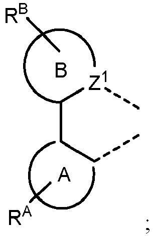
wherein the ligand L_{C} is 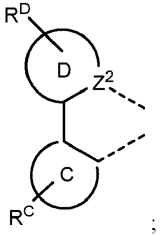
wherein rings A, B, C, and D are each independently a 5 or 6-membered carbocyclic or heterocyclic ring;
wherein R¹, R², R³, R^{A}, R^{B}, R^{C}, and R^{D} each independently represents mono, to a maximum possible number of substitutions, or no substitution;
wherein X¹ to X¹², Z¹, and Z² are each independently C or N;
wherein L_{A}, L_{B}, and L_{C} are different from each other, and can be connected to each other to form a multidentate ligand;
wherein R¹, R², R³, R^{A}, R^{B}, R^{C}, and R^{D}, are each independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof;
wherein any two or more substituents among R¹, R², R³, R^{A}, R^{B}, R^{C}, and R^{D} are optionally joined or fused into a ring; and
wherein at least one of R^{A}, R^{B}, R^{C}, and R^{D} is selected from the group consisting of alkyl, cycloalkyl, aryl, heteroaryl, partially or fully deuterated variants thereof, partially or fully fluorinated variants thereof, and combinations thereof.

2. The compound of claim 1, wherein the rings A and C are benzene, and the rings B and D are pyridine.

3. The compound of claim 1, wherein the rings A, B, C, and D are each independently selected from the group consisting of phenyl, pyridine, imidazole, and imidazole derived carbene.

4. The compound of claim 1, wherein Z¹ and Z² are N.

5. The compound of claim 1, wherein ligand L_{A} is

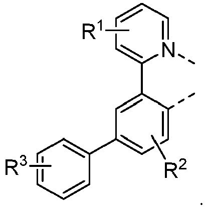

6. The compound of claim 1, wherein the compound is selected from the group consisting of: 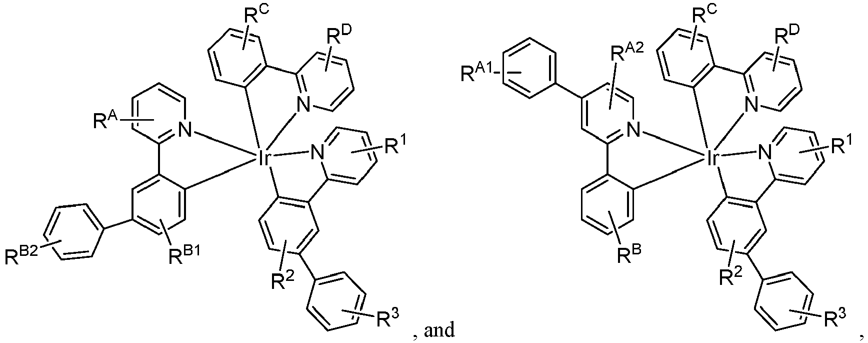
R^{A1} and R^{A2} have the same definition as R^{A}; and
R^{B1} and R^{B2} have the same definition as R^{B}.

7. The compound of claim 1, wherein at least one of L_{B} and L_{C} is selected from the group consisting of:
L*ᵢ*, wherein L*ᵢ* is 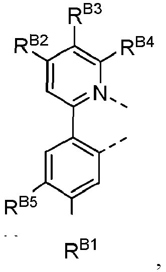 wherein for each *i* from 1 to 1462, R^{B1}, R^{B2}, R^{B3}, R^{B4} and R^{B5} are defined as follows for each *i*:
| ***i* in L*i*** | **R^{B1}** | **R^{B2}** | **R^{B3}** | **R^{B4}** | **R^{B5}** |
|---|---|---|---|---|---|
| 1. | H | H | H | H | H |
| 2. | CH₃ | H | H | H | H |
| 3. | H | CH₃ | H | H | H |
| 4. | H | H | CH₃ | H | H |
| 5. | CH₃ | CH₃ | H | CH₃ | H |
| 6. | CH₃ | H | CH₃ | H | H |
| 7. | CH₃ | H | H | CH₃ | H |
| 8. | H | CH₃ | CH₃ | H | H |
| 9. | H | CH₃ | H | CH₃ | H |
| 10. | H | H | CH₃ | CH₃ | H |
| 11. | CH₃ | CH₃ | CH₃ | H | H |
| 12. | CH₃ | CH₃ | H | CH₃ | H |
| 13. | CH₃ | H | CH₃ | CH₃ | H |
| 14. | H | CH₃ | CH₃ | CH₃ | H |
| 15. | CH₃ | CH₃ | CH₃ | CH₃ | H |
| 16. | CH₂CH₃ | H | H | H | H |
| 17. | CH₂CH₃ | CH₃ | H | CH₃ | H |
| 18. | CH₂CH₃ | H | CH₃ | H | H |
| 19. | CH₂CH₃ | H | H | CH₃ | H |
| 20. | CH₂CH₃ | CH₃ | CH₃ | H | H |
| 21. | CH₂CH₃ | CH₃ | H | CH₃ | H |
| 22. | CH₂CH₃ | H | CH₃ | CH₃ | H |
| 23. | CH₂CH₃ | CH₃ | CH₃ | CH₃ | H |
| 24. | H | CH₂CH₃ | H | H | H |
| 25. | CH₃ | CH₂CH₃ | H | CH₃ | H |
| 26. | H | CH₂CH₃ | CH₃ | H | H |
| 27. | H | CH₂CH₃ | H | CH₃ | H |
| 28. | CH₃ | CH₂CH₃ | CH₃ | H | H |
| 29. | CH₃ | CH₂CH₃ | H | CH₃ | H |
| 30. | H | CH₂CH₃ | CH₃ | CH₃ | H |
| 31. | CH₃ | CH₂CH₃ | CH₃ | CH₃ | H |
| 32. | H | H | CH₂CH₃ | H | H |
| 33. | CH₃ | H | CH₂CH₃ | H | H |
| 34. | H | CH₃ | CH₂CH₃ | H | H |
| 35. | H | H | CH₂CH₃ | CH₃ | H |
| 36. | CH₃ | CH₃ | CH₂CH₃ | H | H |
| 37. | CH₃ | H | CH₂CH₃ | CH₃ | H |
| 38. | H | CH₃ | CH₂CH₃ | CH₃ | H |
| 39. | CH₃ | CH₃ | CH₂CH₃ | CH₃ | H |
| 40. | CH(CH₃)₂ | H | H | H | H |
| 41. | CH(CH₃)₂ | CH₃ | H | CH₃ | H |
| 42. | CH(CH₃)₂ | H | CH₃ | H | H |
| 43. | CH(CH₃)₂ | H | H | CH₃ | H |
| 44. | CH(CH₃)₂ | CH₃ | CH₃ | H | H |
| 45. | CH(CH₃)₂ | CH₃ | H | CH₃ | H |
| 46. | CH(CH₃)₂ | H | CH₃ | CH₃ | H |
| 47. | CH(CH₃)₂ | CH₃ | CH₃ | CH₃ | H |
| 48. | H | CH(CH₃)₂ | H | H | H |
| 49. | CH₃ | CH(CH₃)₂ | H | CH₃ | H |
| 50. | H | CH(CH₃)₂ | CH₃ | H | H |
| 51. | H | CH(CH₃)₂ | H | CH₃ | H |
| 52. | CH₃ | CH(CH₃)₂ | CH₃ | H | H |
| 53. | CH₃ | CH(CH₃)₂ | H | CH₃ | H |
| 54. | H | CH(CH₃)₂ | CH₃ | CH₃ | H |
| 55. | CH₃ | CH(CH₃)₂ | CH₃ | CH₃ | H |
| 56. | H | H | CH(CH₃)₂ | H | H |
| 57. | CH₃ | H | CH(CH₃)₂ | H | H |
| 58. | H | CH₃ | CH(CH₃)₂ | H | H |
| 59. | H | H | CH(CH₃)₂ | CH₃ | H |
| 60. | CH₃ | CH₃ | CH(CH₃)₂ | H | H |
| 61. | CH₃ | H | CH(CH₃)₂ | CH₃ | H |
| 62. | H | CH₃ | CH(CH₃)₂ | CH₃ | H |
| 63. | CH₃ | CH₃ | CH(CH₃)₂ | CH₃ | H |
| 64. | CH₂CH(CH₃)₂ | H | H | H | H |
| 65. | CH₂CH(CH₃)₂ | CH₃ | H | CH₃ | H |
| 66. | CH₂CH(CH₃)₂ | H | CH₃ | H | H |
| 67. | CH₂CH(CH₃)₂ | H | H | CH₃ | H |
| 68. | CH₂CH(CH₃)₂ | CH₃ | CH₃ | H | H |
| 69. | CH₂CH(CH₃)₂ | CH₃ | H | CH₃ | H |
| 70. | CH₂CH(CH₃)₂ | H | CH₃ | CH₃ | H |
| 71. | CH₂CH(CH₃)₂ | CH₃ | CH₃ | CH₃ | H |
| 72. | H | CH₂CH(CH₃)₂ | H | H | H |
| 73. | CH₃ | CH₂CH(CH₃)₂ | H | CH₃ | H |
| 74. | H | CH₂CH(CH₃)₂ | CH₃ | H | H |
| 75. | H | CH₂CH(CH₃)₂ | H | CH₃ | H |
| 76. | CH₃ | CH₂CH(CH₃)₂ | CH₃ | H | H |
| 77. | CH₃ | CH₂CH(CH₃)₂ | H | CH₃ | H |
| 78. | H | CH₂CH(CH₃)₂ | CH₃ | CH₃ | H |
| 79. | CH₃ | CH₂CH(CH₃)₂ | CH₃ | CH₃ | H |
| 80. | H | H | CH₂CH(CH₃)₂ | H | H |
| 81. | CH₃ | H | CH₂CH(CH₃)₂ | H | H |
| 82. | H | CH₃ | CH₂CH(CH₃)₂ | H | H |
| 83. | H | H | CH₂CH(CH₃)₂ | CH₃ | H |
| 84. | CH₃ | CH₃ | CH₂CH(CH₃)₂ | H | H |
| 85. | CH₃ | H | CH₂CH(CH₃)₂ | CH₃ | H |
| 86. | H | CH₃ | CH₂CH(CH₃)₂ | CH₃ | H |
| 87. | CH₃ | CH₃ | CH₂CH(CH₃)₂ | CH₃ | H |
| 88. | C(CH₃)₃ | H | H | H | H |
| 89. | C(CH₃)₃ | CH₃ | H | CH₃ | H |
| 90. | C(CH₃)₃ | H | CH₃ | H | H |
| 91. | C(CH₃)₃ | H | H | CH₃ | H |
| 92. | C(CH₃)₃ | CH₃ | CH₃ | H | H |
| 93. | C(CH₃)₃ | CH₃ | H | CH₃ | H |
| 94. | C(CH₃)₃ | H | CH₃ | CH₃ | H |
| 95. | C(CH₃)₃ | CH₃ | CH₃ | CH₃ | H |
| 96. | H | C(CH₃)₃ | H | H | H |
| 97. | CH₃ | C(CH₃)₃ | H | CH₃ | H |
| 98. | H | C(CH₃)₃ | CH₃ | H | H |
| 99. | H | C(CH₃)₃ | H | CH₃ | H |
| 100. | CH₃ | C(CH₃)₃ | CH₃ | H | H |
| 101. | CH₃ | C(CH₃)₃ | H | CH₃ | H |
| 102. | H | C(CH₃)₃ | CH₃ | CH₃ | H |
| 103. | CH₃ | C(CH₃)₃ | CH₃ | CH₃ | H |
| 104. | H | H | C(CH₃)₃ | H | H |
| 105. | CH₃ | H | C(CH₃)₃ | H | H |
| 106. | H | CH₃ | C(CH₃)₃ | H | H |
| 107. | H | H | C(CH₃)₃ | CH₃ | H |
| 108. | CH₃ | CH₃ | C(CH₃)₃ | H | H |
| 109. | CH₃ | H | C(CH₃)₃ | CH₃ | H |
| 110. | H | CH₃ | C(CH₃)₃ | CH₃ | H |
| 111. | CH₃ | CH₃ | C(CH₃)₃ | CH₃ | H |
| 112. | CH₂C(CH₃)₃ | H | H | H | H |
| 113. | CH₂C(CH₃)₃ | CH₃ | H | CH₃ | H |
| 114. | CH₂C(CH₃)₃ | H | CH₃ | H | H |
| 115. | CH₂C(CH₃)₃ | H | H | CH₃ | H |
| 116. | CH₂C(CH₃)₃ | CH₃ | CH₃ | H | H |
| 117. | CH₂C(CH₃)₃ | CH₃ | H | CH₃ | H |
| 118. | CH₂C(CH₃)₃ | H | CH₃ | CH₃ | H |
| 119. | CH₂C(CH₃)₃ | CH₃ | CH₃ | CH₃ | H |
| 120. | H | CH₂C(CH₃)₃ | H | H | H |
| 121. | CH₃ | CH₂C(CH₃)₃ | H | CH₃ | H |
| 122. | H | CH₂C(CH₃)₃ | CH₃ | H | H |
| 123. | H | CH₂C(CH₃)₃ | H | CH₃ | H |
| 124. | CH₃ | CH₂C(CH₃)₃ | CH₃ | H | H |
| 125. | CH₃ | CH₂C(CH₃)₃ | H | CH₃ | H |
| 126. | H | CH₂C(CH₃)₃ | CH₃ | CH₃ | H |
| 127. | CH₃ | CH₂C(CH₃)₃ | CH₃ | CH₃ | H |
| 128. | H | H | CH₂C(CH₃)₃ | H | H |
| 129. | CH₃ | H | CH₂C(CH₃)₃ | H | H |
| 130. | H | CH₃ | CH₂C(CH₃)₃ | H | H |
| 131. | H | H | CH₂C(CH₃)₃ | CH₃ | H |
| 132. | CH₃ | CH₃ | CH₂C(CH₃)₃ | H | H |
| 133. | CH₃ | H | CH₂C(CH₃)₃ | CH₃ | H |
| 134. | H | CH₃ | CH₂C(CH₃)₃ | CH₃ | H |
| 135. | CH₃ | CH₃ | CH₂C(CH₃)₃ | CH₃ | H |
| 136. | 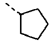 | H | H | H | H |
| 137. | 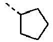 | CH₃ | H | CH₃ | H |
| 138. | 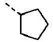 | H | CH₃ | H | H |
| 139. | 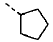 | H | H | CH₃ | H |
| 140. | 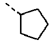 | CH₃ | CH₃ | H | H |
| 141. | 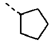 | CH₃ | H | CH₃ | H |
| 142. | 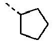 | H | CH₃ | CH₃ | H |
| 143. | 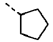 | CH₃ | CH₃ | CH₃ | H |
| 144. | H | 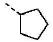 | H | H | H |
| 145. | CH₃ | 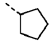 | H | CH₃ | H |
| 146. | H | 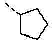 | CH₃ | H | H |
| 147. | H | 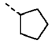 | H | CH₃ | H |
| 148. | CH₃ | 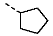 | CH₃ | H | H |
| 149. | CH₃ | 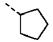 | H | CH₃ | H |
| 150. | H | 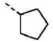 | CH₃ | CH₃ | H |
| 151. | CH₃ | 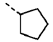 | CH₃ | CH₃ | H |
| 152. | H | H | 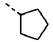 | H | H |
| 153. | CH₃ | H | 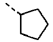 | H | H |
| 154. | H | CH₃ | 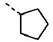 | H | H |
| 155. | H | H | 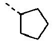 | CH₃ | H |
| 156. | CH₃ | CH₃ | 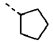 | H | H |
| 157. | CH₃ | H | 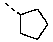 | CH₃ | H |
| 158. | H | CH₃ | 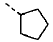 | CH₃ | H |
| 159. | CH₃ | CH₃ | 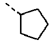 | CH₃ | H |
| 160. | 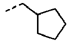 | H | H | H | H |
| 161. | 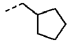 | CH₃ | H | CH₃ | H |
| 162. | 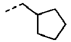 | H | CH₃ | H | H |
| 163. | 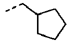 | H | H | CH₃ | H |
| 164. | 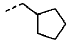 | CH₃ | CH₃ | H | H |
| 165. | 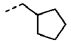 | CH₃ | H | CH₃ | H |
| 166. | 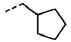 | H | CH₃ | CH₃ | H |
| 167. | 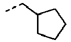 | CH₃ | CH₃ | CH₃ | H |
| 168. | H | 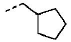 | H | H | H |
| 169. | CH₃ | 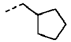 | H | CH₃ | H |
| 170. | H | 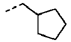 | CH₃ | H | H |
| 171. | H | 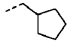 | H | CH₃ | H |
| 172. | CH₃ | 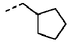 | CH₃ | H | H |
| 173. | CH₃ | 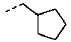 | H | CH₃ | H |
| 174. | H | 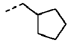 | CH₃ | CH₃ | H |
| 175. | CH₃ | 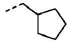 | CH₃ | CH₃ | H |
| 176. | H | H | 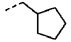 | H | H |
| 177. | CH₃ | H | 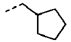 | H | H |
| 178. | H | CH₃ | 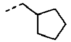 | H | H |
| 179. | H | H | 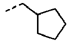 | CH₃ | H |
| 180. | CH₃ | CH₃ | 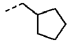 | H | H |
| 181. | CH₃ | H | 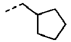 | CH₃ | H |
| 182. | H | CH₃ | 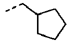 | CH₃ | H |
| 183. | CH₃ | CH₃ | 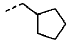 | CH₃ | H |
| 184. | 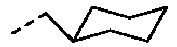 | H | H | H | H |
| 185. | 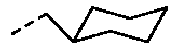 | CH₃ | H | CH₃ | H |
| 186. | 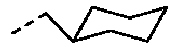 | H | CH₃ | H | H |
| 187. | 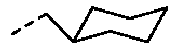 | H | H | CH₃ | H |
| 188. | 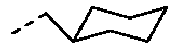 | CH₃ | CH₃ | H | H |
| 189. | 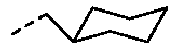 | CH₃ | H | CH₃ | H |
| 190. | 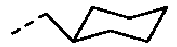 | H | CH₃ | CH₃ | H |
| 191. | 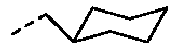 | CH₃ | CH₃ | CH₃ | H |
| 192. | H | 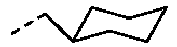 | H | H | H |
| 193. | CH₃ | 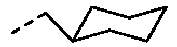 | H | CH₃ | H |
| 194. | H | 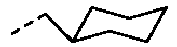 | CH₃ | H | H |
| 195. | H | 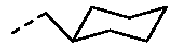 | H | CH₃ | H |
| 196. | CH₃ | 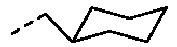 | CH₃ | H | H |
| 197. | CH₃ | 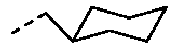 | H | CH₃ | H |
| 198. | H | 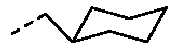 | CH₃ | CH₃ | H |
| 199. | CH₃ | 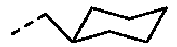 | CH₃ | CH₃ | H |
| 200. | H | H | 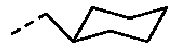 | H | H |
| 201. | CH₃ | H | 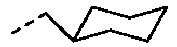 | H | H |
| 202. | H | CH₃ | 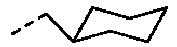 | H | H |
| 203. | H | H | 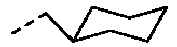 | CH₃ | H |
| 204. | CH₃ | CH₃ | 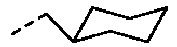 | H | H |
| 205. | CH₃ | H | 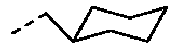 | CH₃ | H |
| 206. | H | CH₃ | 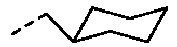 | CH₃ | H |
| 207. | CH₃ | CH₃ | 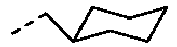 | CH₃ | H |
| 208. | 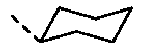 | H | H | H | H |
| 209. | 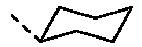 | CH₃ | H | CH₃ | H |
| 210. | 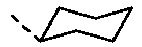 | H | CH₃ | H | H |
| 211. | 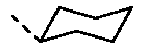 | H | H | CH₃ | H |
| 212. | 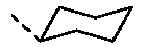 | CH₃ | CH₃ | H | H |
| 213. | 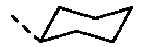 | CH₃ | H | CH₃ | H |
| 214. | 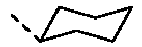 | H | CH₃ | CH₃ | H |
| 215. | 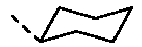 | CH₃ | CH₃ | CH₃ | H |
| 216. | H | 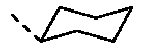 | H | H | H |
| 217. | CH₃ | 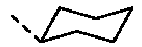 | H | CH₃ | H |
| 218. | H | 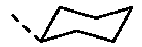 | CH₃ | H | H |
| 219. | H | 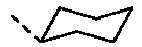 | H | CH₃ | H |
| 220. | CH₃ | 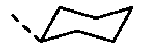 | CH₃ | H | H |
| 221. | CH₃ | 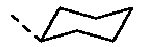 | H | CH₃ | H |
| 222. | H | 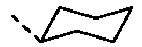 | CH₃ | CH₃ | H |
| 223. | CH₃ | 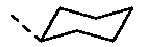 | CH₃ | CH₃ | H |
| 224. | H | H | 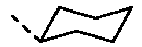 | H | H |
| 225. | CH₃ | H | 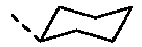 | H | H |
| 226. | H | CH₃ | 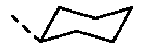 | H | H |
| 227. | H | H | 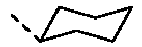 | CH₃ | H |
| 228. | CH₃ | CH₃ | 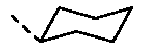 | H | H |
| 229. | CH₃ | H | 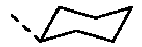 | CH₃ | H |
| 230. | H | CH₃ | 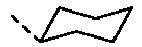 | CH₃ | H |
| 231. | CH₃ | CH₃ | 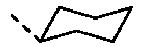 | CH₃ | H |
| 232. | 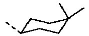 | H | H | H | H |
| 233. | 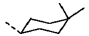 | CH₃ | H | CH₃ | H |
| 234. | 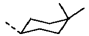 | H | CH₃ | H | H |
| 235. | 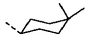 | H | H | CH₃ | H |
| 236. | 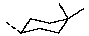 | CH₃ | CH₃ | H | H |
| 237. | 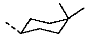 | CH₃ | H | CH₃ | H |
| 238. | 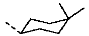 | H | CH₃ | CH₃ | H |
| 239. | 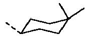 | CH₃ | CH₃ | CH₃ | H |
| 240. | H | 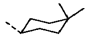 | H | H | H |
| 241. | CH₃ | 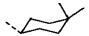 | H | CH₃ | H |
| 242. | H | 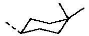 | CH₃ | H | H |
| 243. | H | 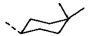 | H | CH₃ | H |
| 244. | CH₃ | 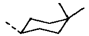 | CH₃ | H | H |
| 245. | CH₃ | 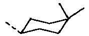 | H | CH₃ | H |
| 246. | H | 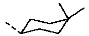 | CH₃ | CH₃ | H |
| 247. | CH₃ | 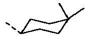 | CH₃ | CH₃ | H |
| 248. | H | H | 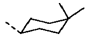 | H | H |
| 249. | CH₃ | H | 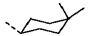 | H | H |
| 250. | H | CH₃ | 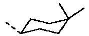 | H | H |
| 251. | H | H | 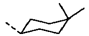 | CH₃ | H |
| 252. | CH₃ | CH₃ | 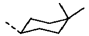 | H | H |
| 253. | CH₃ | H | 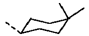 | CH₃ | H |
| 254. | H | CH₃ | 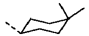 | CH₃ | H |
| 255. | CH₃ | CH₃ | 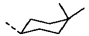 | CH₃ | H |
| 256. | 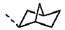 | H | H | H | H |
| 257. | 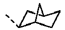 | CH₃ | H | CH₃ | H |
| 258. | 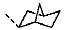 | H | CH₃ | H | H |
| 259. | 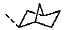 | H | H | CH₃ | H |
| 260. | 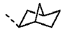 | CH₃ | CH₃ | H | H |
| 261. | 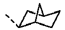 | CH₃ | H | CH₃ | H |
| 262. | 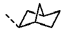 | H | CH₃ | CH₃ | H |
| 263. | 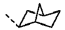 | CH₃ | CH₃ | CH₃ | H |
| 264. | H | 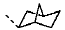 | H | H | H |
| 265. | CH₃ | 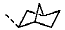 | H | CH₃ | H |
| 266. | H | 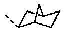 | CH₃ | H | H |
| 267. | H | 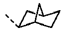 | H | CH₃ | H |
| 268. | CH₃ | 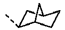 | CH₃ | H | H |
| 269. | CH₃ | 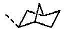 | H | CH₃ | H |
| 270. | H | 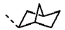 | CH₃ | CH₃ | H |
| 271. | CH₃ | 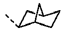 | CH₃ | CH₃ | H |
| 272. | H | H | 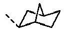 | H | H |
| 273. | CH₃ | H | 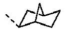 | H | H |
| 274. | H | CH₃ | 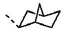 | H | H |
| 275. | H | H | 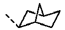 | CH₃ | H |
| 276. | CH₃ | CH₃ | 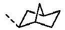 | H | H |
| 277. | CH₃ | H | 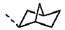 | CH₃ | H |
| 278. | H | CH₃ | 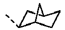 | CH₃ | H |
| 279. | CH₃ | CH₃ | 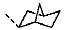 | CH₃ | H |
| 280. | CH(CH₃)₂ | H | CH₂CH₃ | H | H |
| 281. | CH(CH₃)₂ | H | CH(CH₃)₂ | H | H |
| 282. | CH(CH₃)₂ | H | CH₂CH(CH₃)₂ | H | H |
| 283. | CH(CH₃)₂ | H | C(CH₃)₃ | H | H |
| 284. | CH(CH₃)₂ | H | CH₂C(CH₃)₃ | H | H |
| 285. | CH(CH₃)₂ | H | 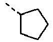 | H | H |
| 286. | CH(CH₃)₂ | H | 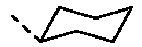 | H | H |
| 287. | CH(CH₃)₂ | H | 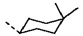 | H | H |
| 288. | CH(CH₃)₂ | H | 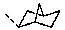 | H | H |
| 289. | CH(CH₃)₂ | H | 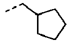 | H | H |
| 290. | CH(CH₃)₂ | H | 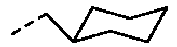 | H | H |
| 291. | C(CH₃)₃ | H | CH₂CH₃ | H | H |
| 292. | C(CH₃)₃ | H | CH(CH₃)₂ | H | H |
| 293. | C(CH₃)₃ | H | CH₂CH(CH₃)₂ | H | H |
| 294. | C(CH₃)₃ | H | C(CH₃)₃ | H | H |
| 295. | C(CH₃)₃ | H | CH₂C(CH₃)₃ | H | H |
| 296. | C(CH₃)₃ | H | 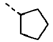 | H | H |
| 297. | C(CH₃)₃ | H | 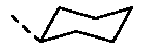 | H | H |
| 298. | C(CH₃)₃ | H | 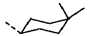 | H | H |
| 299. | C(CH₃)₃ | H | 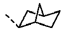 | H | H |
| 300. | C(CH₃)₃ | H | 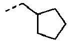 | H | H |
| 301. | C(CH₃)₃ | H | 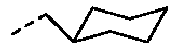 | H | H |
| 302. | CH₂C(CH₃)₃ | H | CH₂CH₃ | H | H |
| 303. | CH₂C(CH₃)₃ | H | CH(CH₃)₂ | H | H |
| 304. | CH₂C(CH₃)₃ | H | CH₂CH(CH₃)₂ | H | H |
| 305. | CH₂C(CH₃)₃ | H | C(CH₃)₃ | H | H |
| 306. | CH₂C(CH₃)₃ | H | CH₂C(CH₃)₃ | H | H |
| 307. | CH₂C(CH₃)₃ | H | CH₂CH₂CF₃ | H | H |
| 308. | CH₂C(CH₃)₃ | H | CH₂C(CH₃)₂CF₃ | H | H |
| 309. | CH₂C(CH₃)₃ | H | 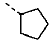 | H | H |
| 310. | CH₂C(CH₃)₃ | H | 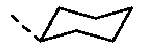 | H | H |
| 311. | CH₂C(CH₃)₃ | H | 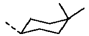 | H | H |
| 312. | CH₂C(CH₃)₃ | H | 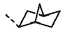 | H | H |
| 313. | CH₂C(CH₃)₃ | H | 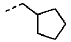 | H | H |
| 314. | CH₂C(CH₃)₃ | H | 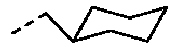 | H | H |
| 315. | 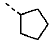 | H | CH₂CH₃ | H | H |
| 316. | 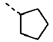 | H | CH(CH₃)₂ | H | H |
| 317. | 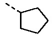 | H | CH₂CH(CH₃)₂ | H | H |
| 318. | 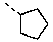 | H | C(CH₃)₃ | H | H |
| 319. | 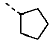 | H | CH₂C(CH₃)₃ | H | H |
| 320. | 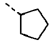 | H | 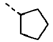 | H | H |
| 321. | 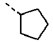 | H | 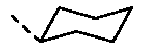 | H | H |
| 322. | 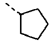 | H | 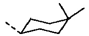 | H | H |
| 323. | 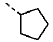 | H | 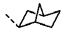 | H | H |
| 324. | 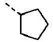 | H | 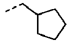 | H | H |
| 325. | 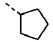 | H | 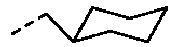 | H | H |
| 326. | 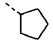 | H | CH₂CH₃ | H | H |
| 327. | 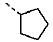 | H | CH(CH₃)₂ | H | H |
| 328. | 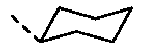 | H | CH₂CH(CH₃)₂ | H | H |
| 329. | 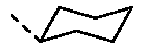 | H | C(CH₃)₃ | H | H |
| 330. | 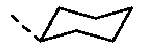 | H | CH₂C(CH₃)₃ | H | H |
| 331. | 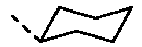 | H | 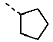 | H | H |
| 332. | 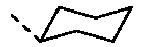 | H | 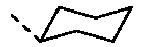 | H | H |
| 333. | 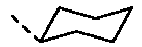 | H | 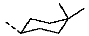 | H | H |
| 334. | 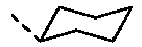 | H | 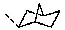 | H | H |
| 335. | 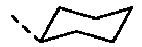 | H | 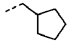 | H | H |
| 336. | 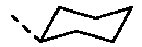 | H | 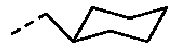 | H | H |
| 337. | 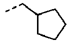 | H | CH₂CH(CH₃)₂ | H | H |
| 338. | 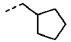 | H | C(CH₃)₃ | H | H |
| 339. | 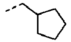 | H | CH₂C(CH₃)₃ | H | H |
| 340. | 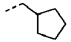 | H | 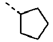 | H | H |
| 341. | 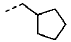 | H | 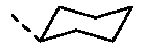 | H | H |
| 342. | 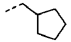 | H | 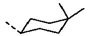 | H | H |
| 343. | 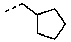 | H | 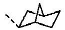 | H | H |
| 344. | 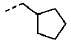 | H | 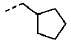 | H | H |
| 345. | 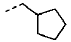 | H | 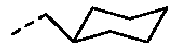 | H | H |
| 346. | 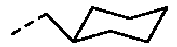 | H | CH₂CH(CH₃)₂ | H | H |
| 347. | 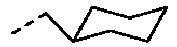 | H | C(CH₃)₃ | H | H |
| 348. | 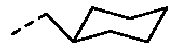 | H | CH₂C(CH₃)₃ | H | H |
| 349. | 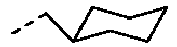 | H | 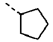 | H | H |
| 350. | 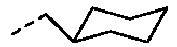 | H | 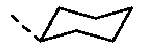 | H | H |
| 351. | 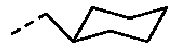 | H | 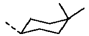 | H | H |
| 352. | 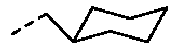 | H | 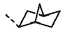 | H | H |
| 353. | 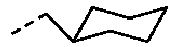 | H | 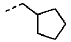 | H | H |
| 354. | 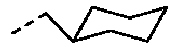 | H | 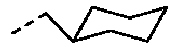 | H | H |
| 355. | 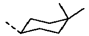 | H | CH₂CH(CH₃)₂ | H | H |
| 356. | 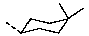 | H | C(CH₃)₃ | H | H |
| 357. | 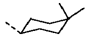 | H | CH₂C(CH₃)₃ | H | H |
| 358. | 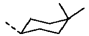 | H | 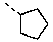 | H | H |
| 359. | 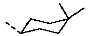 | H | 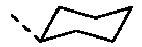 | H | H |
| 360. | 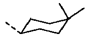 | H | 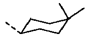 | H | H |
| 361. | 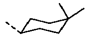 | H | 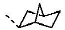 | H | H |
| 362. | 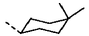 | H | 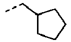 | H | H |
| 363. | 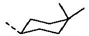 | H | 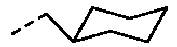 | H | H |
| 364. | H | H | H | H | H |
| 365. | CD₃ | H | H | H | H |
| 366. | H | CD₃ | H | H | H |
| 367. | H | H | CD₃ | H | H |
| 368. | CD₃ | CD₃ | H | CD₃ | H |
| 369. | CD₃ | H | CD₃ | H | H |
| 370. | CD₃ | H | H | CD₃ | H |
| 371. | H | CD₃ | CD₃ | H | H |
| 372. | H | CD₃ | H | CD₃ | H |
| 373. | H | H | CD₃ | CD₃ | H |
| 374. | CD₃ | CD₃ | CD₃ | H | H |
| 375. | CD₃ | CD₃ | H | CD₃ | H |
| 376. | CD₃ | H | CD₃ | CD₃ | H |
| 377. | H | CD₃ | CD₃ | CD₃ | H |
| 378. | CD₃ | CD₃ | CD₃ | CD₃ | H |
| 379. | CD₂CH₃ | H | H | H | H |
| 380. | CD₂CH₃ | CD₃ | H | CD₃ | H |
| 381. | CD₂CH₃ | H | CD₃ | H | H |
| 382. | CD₂CH₃ | H | H | CD₃ | H |
| 383. | CD₂CH₃ | CD₃ | CD₃ | H | H |
| 384. | CD₂CH₃ | CD₃ | H | CD₃ | H |
| 385. | CD₂CH₃ | H | CD₃ | CD₃ | H |
| 386. | CD₂CH₃ | CD₃ | CD₃ | CD₃ | H |
| 387. | H | CD₂CH₃ | H | H | H |
| 388. | CH₃ | CD₂CH₃ | H | CD₃ | H |
| 389. | H | CD₂CH₃ | CD₃ | H | H |
| 390. | H | CD₂CH₃ | H | CD₃ | H |
| 391. | CD₃ | CD₂CH₃ | CD₃ | H | H |
| 392. | CD₃ | CD₂CH₃ | H | CD₃ | H |
| 393. | H | CD₂CH₃ | CD₃ | CD₃ | H |
| 394. | CD₃ | CD₂CH₃ | CD₃ | CD₃ | H |
| 395. | H | H | CD₂CH₃ | H | H |
| 396. | CD₃ | H | CD₂CH₃ | H | H |
| 397. | H | CD₃ | CD₂CH₃ | H | H |
| 398. | H | H | CD₂CH₃ | CD₃ | H |
| 399. | CD₃ | CD₃ | CD₂CH₃ | H | H |
| 400. | CD₃ | H | CD₂CH₃ | CD₃ | H |
| 401. | H | CD₃ | CD₂CH₃ | CD₃ | H |
| 402. | CD₃ | CD₃ | CD₂CH₃ | CD₃ | H |
| 403. | CD(CH₃)₂ | H | H | H | H |
| 404. | CD(CH₃)₂ | CD₃ | H | CD₃ | H |
| 405. | CD(CH₃)₂ | H | CD₃ | H | H |
| 406. | CD(CH₃)₂ | H | H | CD₃ | H |
| 407. | CD(CH₃)₂ | CD₃ | CD₃ | H | H |
| 408. | CD(CH₃)₂ | CD₃ | H | CD₃ | H |
| 409. | CD(CH₃)₂ | H | CD₃ | CD₃ | H |
| 410. | CD(CH₃)₂ | CD₃ | CD₃ | CD₃ | H |
| 411. | H | CD(CH₃)₂ | H | H | H |
| 412. | CD₃ | CD(CH₃)₂ | H | CD₃ | H |
| 413. | H | CD(CH₃)₂ | CD₃ | H | H |
| 414. | H | CD(CH₃)₂ | H | CD₃ | H |
| 415. | CD₃ | CD(CH₃)₂ | CD₃ | H | H |
| 416. | CD₃ | CD(CH₃)₂ | H | CD₃ | H |
| 417. | H | CD(CH₃)₂ | CD₃ | CD₃ | H |
| 418. | CD₃ | CD(CH₃)₂ | CD₃ | CD₃ | H |
| 419. | H | H | CD(CH₃)₂ | H | H |
| 420. | CD₃ | H | CD(CH₃)₂ | H | H |
| 421. | H | CD₃ | CD(CH₃)₂ | H | H |
| 422. | H | H | CD(CH₃)₂ | CD₃ | H |
| 423. | CD₃ | CD₃ | CD(CH₃)₂ | H | H |
| 424. | CD₃ | H | CD(CH₃)₂ | CD₃ | H |
| 425. | H | CD₃ | CD(CH₃)₂ | CD₃ | H |
| 426. | CD₃ | CD₃ | CD(CH₃)₂ | CD₃ | H |
| 427. | CD(CD₃)₂ | H | H | H | H |
| 428. | CD(CD₃)₂ | CD₃ | H | CD₃ | H |
| 429. | CD(CD₃)₂ | H | CD₃ | H | H |
| 430. | CD(CD₃)₂ | H | H | CD₃ | H |
| 431. | CD(CD₃)₂ | CD₃ | CD₃ | H | H |
| 432. | CD(CD₃)₂ | CD₃ | H | CD₃ | H |
| 433. | CD(CD₃)₂ | H | CD₃ | CD₃ | H |
| 434. | CD(CD₃)₂ | CD₃ | CD₃ | CD₃ | H |
| 435. | H | CD(CD₃)₂ | H | H | H |
| 436. | CH₃ | CD(CD₃)₂ | H | CD₃ | H |
| 437. | H | CD(CD₃)₂ | CD₃ | H | H |
| 438. | H | CD(CD₃)₂ | H | CD₃ | H |
| 439. | CD₃ | CD(CD₃)₂ | CD₃ | H | H |
| 440. | CD₃ | CD(CD₃)₂ | H | CD₃ | H |
| 441. | H | CD(CD₃)₂ | CD₃ | CD₃ | H |
| 442. | CD₃ | CD(CD₃)₂ | CD₃ | CD₃ | H |
| 443. | H | H | CD(CD₃)₂ | H | H |
| 444. | CD₃ | H | CD(CD₃)₂ | H | H |
| 445. | H | CD₃ | CD(CD₃)₂ | H | H |
| 446. | H | H | CD(CD₃)₂ | CD₃ | H |
| 447. | CD₃ | CD₃ | CD(CD₃)₂ | H | H |
| 448. | CD₃ | H | CD(CD₃)₂ | CD₃ | H |
| 449. | H | CD₃ | CD(CD₃)₂ | CD₃ | H |
| 450. | CD₃ | CD₃ | CD(CD₃)₂ | CD₃ | H |
| 451. | CD₂CH(CH₃)₂ | H | H | H | H |
| 452. | CD₂CH(CH₃)₂ | CD₃ | H | CD₃ | H |
| 453. | CD₂CH(CH₃)₂ | H | CD₃ | H | H |
| 454. | CD₂CH(CH₃)₂ | H | H | CD₃ | H |
| 455. | CD₂CH(CH₃)₂ | CD₃ | CD₃ | H | H |
| 456. | CD₂CH(CH₃)₂ | CD₃ | H | CD₃ | H |
| 457. | CD₂CH(CH₃)₂ | H | CD₃ | CD₃ | H |
| 458. | CD₂CH(CH₃)₂ | CD₃ | CD₃ | CD₃ | H |
| 459. | H | CD₂CH(CH₃)₂ | H | H | H |
| 460. | CD₃ | CD₂CH(CH₃)₂ | H | CD₃ | H |
| 461. | H | CD₂CH(CH₃)₂ | CD₃ | H | H |
| 462. | H | CD₂CH(CH₃)₂ | H | CD₃ | H |
| 463. | CD₃ | CD₂CH(CH₃)₂ | CD₃ | H | H |
| 464. | CD₃ | CD₂CH(CH₃)₂ | H | CD₃ | H |
| 465. | H | CD₂CH(CH₃)₂ | CD₃ | CD₃ | H |
| 466. | CD₃ | CD₂CH(CH₃)₂ | CD₃ | CD₃ | H |
| 467. | H | H | CD₂CH(CH₃)₂ | H | H |
| 468. | CD₃ | H | CD₂CH(CH₃)₂ | H | H |
| 469. | H | CD₃ | CD₂CH(CH₃)₂ | H | H |
| 470. | H | H | CD₂CH(CH₃)₂ | CD₃ | H |
| 471. | CD₃ | CD₃ | CD₂CH(CH₃)₂ | H | H |
| 472. | CD₃ | H | CD₂CH(CH₃)₂ | CD₃ | H |
| 473. | H | CD₃ | CD₂CH(CH₃)₂ | CD₃ | H |
| 474. | CD₃ | CD₃ | CD₂CH(CH₃)₂ | CD₃ | H |
| 475. | CD₂C(CH₃)₃ | H | H | H | H |
| 476. | CD₂C(CH₃)₃ | CD₃ | H | CD₃ | H |
| 477. | CD₂C(CH₃)₃ | H | CD₃ | H | H |
| 478. | CD₂C(CH₃)₃ | H | H | CD₃ | H |
| 479. | CD₂C(CH₃)₃ | CD₃ | CD₃ | H | H |
| 480. | CD₂C(CH₃)₃ | CD₃ | H | CD₃ | H |
| 481. | CD₂C(CH₃)₃ | H | CD₃ | CD₃ | H |
| 482. | CD₂C(CH₃)₃ | CH₃ | CD₃ | CD₃ | H |
| 483. | H | CD₂C(CH₃)₃ | H | H | H |
| 484. | CD₃ | CD₂C(CH₃)₃ | H | CD₃ | H |
| 485. | H | CD₂C(CH₃)₃ | CD₃ | H | H |
| 486. | H | CD₂C(CH₃)₃ | H | CD₃ | H |
| 487. | CD₃ | CD₂C(CH₃)₃ | CD₃ | H | H |
| 488. | CD₃ | CD₂C(CH₃)₃ | H | CD₃ | H |
| 489. | H | CD₂C(CH₃)₃ | CD₃ | CD₃ | H |
| 490. | CD₃ | CD₂C(CH₃)₃ | CD₃ | CD₃ | H |
| 491. | H | H | CD₂C(CH₃)₃ | H | H |
| 492. | CD₃ | H | CD₂C(CH₃)₃ | H | H |
| 493. | H | CD₃ | CD₂C(CH₃)₃ | H | H |
| 494. | H | H | CD₂C(CH₃)₃ | CD₃ | H |
| 495. | CD₃ | CD₃ | CD₂C(CH₃)₃ | H | H |
| 496. | CD₃ | H | CD₂C(CH₃)₃ | CD₃ | H |
| 497. | H | CD₃ | CD₂C(CH₃)₃ | CD₃ | H |
| 498. | CD₃ | CD₃ | CD₂C(CH₃)₃ | CD₃ | H |
| 499. | 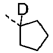 | H | H | H | H |
| 500. | 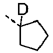 | CD₃ | H | CD₃ | H |
| 501. | 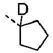 | H | CD₃ | H | H |
| 502. | 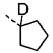 | H | H | CD₃ | H |
| 503. | 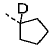 | CD₃ | CD₃ | H | H |
| 504. | 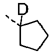 | CD₃ | H | CD₃ | H |
| 505. | 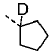 | H | CD₃ | CD₃ | H |
| 506. | 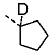 | CD₃ | CD₃ | CD₃ | H |
| 507. | H | 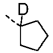 | H | H | H |
| 508. | CD₃ | 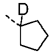 | H | CD₃ | H |
| 509. | H | 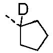 | CD₃ | H | H |
| 510. | H | 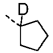 | H | CD₃ | H |
| 511. | CD₃ | 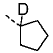 | CD₃ | H | H |
| 512. | CD₃ | 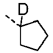 | H | CD₃ | H |
| 513. | H | 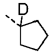 | CD₃ | CD₃ | H |
| 514. | CD₃ | 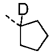 | CD₃ | CD₃ | H |
| 515. | H | H | 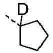 | H | H |
| 516. | CD₃ | H | 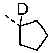 | H | H |
| 517. | H | CD₃ | 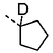 | H | H |
| 518. | H | H | 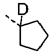 | CD₃ | H |
| 519. | CD₃ | CD₃ | 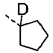 | H | H |
| 520. | CD₃ | H | 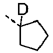 | CD₃ | H |
| 521. | H | CD₃ | 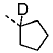 | CD₃ | H |
| 522. | CD₃ | CD₃ | 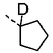 | CD₃ | H |
| 523. | 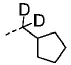 | H | H | H | H |
| 524. | 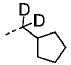 | CD₃ | H | CD₃ | H |
| 525. | 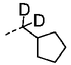 | H | CD₃ | H | H |
| 526. | 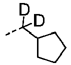 | H | H | CD₃ | H |
| 527. | 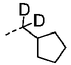 | CD₃ | CD₃ | H | H |
| 528. | 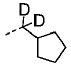 | CD₃ | H | CD₃ | H |
| 529. | 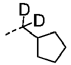 | H | CD₃ | CD₃ | H |
| 530. | 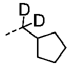 | CD₃ | CD₃ | CD₃ | H |
| 531. | H | 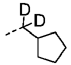 | H | H | H |
| 532. | CH₃ | 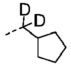 | H | CD₃ | H |
| 533. | H | 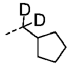 | CD₃ | H | H |
| 534. | H | 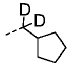 | H | CD₃ | H |
| 535. | CD₃ | 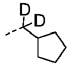 | CD₃ | H | H |
| 536. | CD₃ | 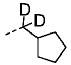 | H | CD₃ | H |
| 537. | H | 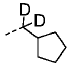 | CD₃ | CD₃ | H |
| 538. | CH₃ | 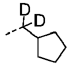 | CD₃ | CD₃ | H |
| 539. | H | H | 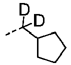 | H | H |
| 540. | CD₃ | H | 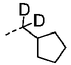 | H | H |
| 541. | H | CD₃ | 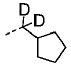 | H | H |
| 542. | H | H | 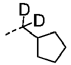 | CD₃ | H |
| 543. | CD₃ | CD₃ | 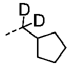 | H | H |
| 544. | CD₃ | H | 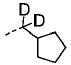 | CD₃ | H |
| 545. | H | CD₃ | 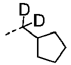 | CD₃ | H |
| 546. | CD₃ | CD₃ | 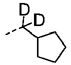 | CD₃ | H |
| 547. | 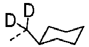 | H | H | H | H |
| 548. | 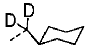 | CD₃ | H | CD₃ | H |
| 549. | 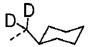 | H | CD₃ | H | H |
| 550. | 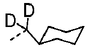 | H | H | CD₃ | H |
| 551. | 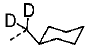 | CD₃ | CD₃ | H | H |
| 552. | 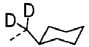 | CD₃ | H | CD₃ | H |
| 553. | 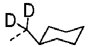 | H | CD₃ | CD₃ | H |
| 554. | 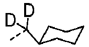 | CD₃ | CD₃ | CD₃ | H |
| 555. | H | 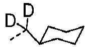 | H | H | H |
| 556. | CD₃ | 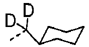 | H | CD₃ | H |
| 557. | H | 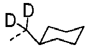 | CD₃ | H | H |
| 558. | H | 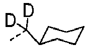 | H | CD₃ | H |
| 559. | CD₃ | 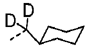 | CD₃ | H | H |
| 560. | CD₃ | 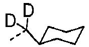 | H | CD₃ | H |
| 561. | H | 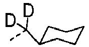 | CD₃ | CD₃ | H |
| 562. | CD₃ | 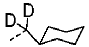 | CD₃ | CD₃ | H |
| 563. | H | H | 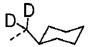 | H | H |
| 564. | CD₃ | H | 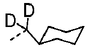 | H | H |
| 565. | H | CD₃ | 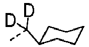 | H | H |
| 566. | H | H | 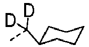 | CD₃ | H |
| 567. | CD₃ | CD₃ | 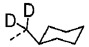 | H | H |
| 568. | CD₃ | H | 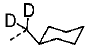 | CD₃ | H |
| 569. | H | CD₃ | 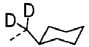 | CD₃ | H |
| 570. | CD₃ | CD₃ | 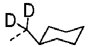 | CD₃ | H |
| 571. | 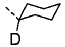 | H | H | H | H |
| 572. | 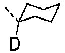 | CD₃ | H | CD₃ | H |
| 573. | 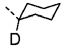 | H | CD₃ | H | H |
| 574. | 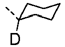 | H | H | CD₃ | H |
| 575. | 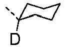 | CD₃ | CD₃ | H | H |
| 576. | 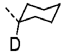 | CD₃ | H | CD₃ | H |
| 577. | 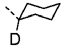 | H | CD₃ | CD₃ | H |
| 578. | 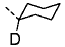 | CD₃ | CD₃ | CD₃ | H |
| 579. | H | 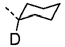 | H | H | H |
| 580. | CD₃ | 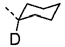 | H | CD₃ | H |
| 581. | H | 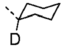 | CD₃ | H | H |
| 582. | H | 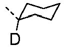 | H | CD₃ | H |
| 583. | CD₃ | 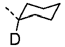 | CD₃ | H | H |
| 584. | CD₃ | 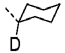 | H | CD₃ | H |
| 585. | H | 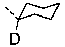 | CD₃ | CD₃ | H |
| 586. | CD₃ | 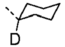 | CD₃ | CD₃ | H |
| 587. | H | H | 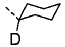 | H | H |
| 588. | CD₃ | H | 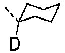 | H | H |
| 589. | H | CD₃ | 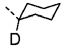 | H | H |
| 590. | H | H | 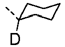 | CD₃ | H |
| 591. | CD₃ | CD₃ | 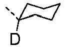 | H | H |
| 592. | CD₃ | H | 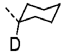 | CD₃ | H |
| 593. | H | CD₃ | 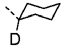 | CD₃ | H |
| 594. | CD₃ | CD₃ | 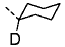 | CD₃ | H |
| 595. | 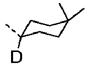 | H | H | H | H |
| 596. | 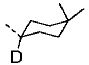 | CD₃ | H | CD₃ | H |
| 597. | 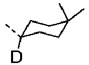 | H | CD₃ | H | H |
| 598. | 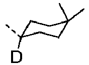 | H | H | CD₃ | H |
| 599. | 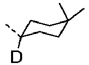 | CD₃ | CD₃ | H | H |
| 600. | 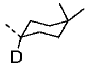 | CD₃ | H | CD₃ | H |
| 601. | 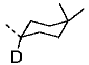 | H | CD₃ | CD₃ | H |
| 602. | 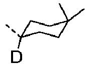 | CD₃ | CD₃ | CD₃ | H |
| 603. | H | 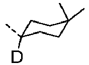 | H | H | H |
| 604. | CD₃ | 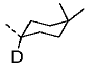 | H | CD₃ | H |
| 605. | H | 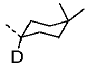 | CD₃ | H | H |
| 606. | H | 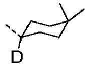 | H | CD₃ | H |
| 607. | CD₃ | 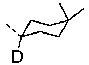 | CD₃ | H | H |
| 608. | CD₃ | 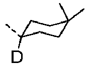 | H | CD₃ | H |
| 609. | H | 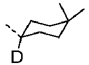 | CD₃ | CD₃ | H |
| 610. | CD₃ | 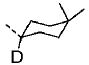 | CD₃ | CD₃ | H |
| 611. | H | H | 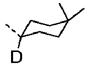 | H | H |
| 612. | CD₃ | H | 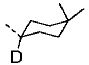 | H | H |
| 613. | H | CD₃ | 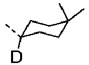 | H | H |
| 614. | H | H | 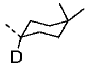 | CD₃ | H |
| 615. | CD₃ | CD₃ | 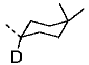 | H | H |
| 616. | CD₃ | H | 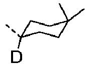 | CD₃ | H |
| 617. | H | CD₃ | 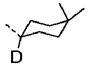 | CD₃ | H |
| 618. | CD₃ | CD₃ | 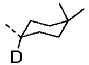 | CD₃ | H |
| 619. | 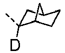 | H | H | H | H |
| 620. | 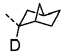 | CD₃ | H | CD₃ | H |
| 621. | 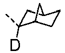 | H | CD₃ | H | H |
| 622. | 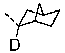 | H | H | CD₃ | H |
| 623. | 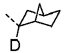 | CH₃ | CH₃ | H | H |
| 624. | 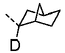 | CD₃ | H | CD₃ | H |
| 625. | 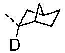 | H | CD₃ | CD₃ | H |
| 626. | 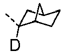 | CD₃ | CD₃ | CD₃ | H |
| 627. | H | 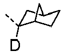 | H | H | H |
| 628. | CD₃ | 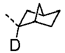 | H | CD₃ | H |
| 629. | H | 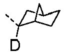 | CD₃ | H | H |
| 630. | H | 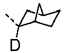 | H | CD₃ | H |
| 631. | CD₃ | 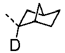 | CD₃ | H | H |
| 632. | CD₃ | 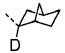 | H | CD₃ | H |
| 633. | H | 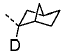 | CD₃ | CD₃ | H |
| 634. | CD₃ | 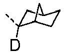 | CD₃ | CD₃ | H |
| 635. | H | H | 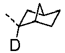 | H | H |
| 636. | CD₃ | H | 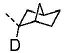 | H | H |
| 637. | H | CD₃ | 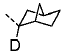 | H | H |
| 638. | H | H | 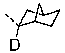 | CH₃ | H |
| 639. | CD₃ | CD₃ | 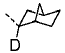 | H | H |
| 640. | CD₃ | H | 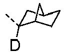 | CD₃ | H |
| 641. | H | CD₃ | 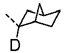 | CD₃ | H |
| 642. | CD₃ | CD₃ | 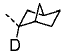 | CD₃ | H |
| 643. | CD(CH₃)₂ | H | CD₂CH₃ | H | H |
| 644. | CD(CH₃)₂ | H | CD(CH₃)₂ | H | H |
| 645. | CD(CH₃)₂ | H | CD₂CH(CH₃)₂ | H | H |
| 646. | CD(CH₃)₂ | H | C(CH₃)₃ | H | H |
| 647. | CD(CH₃)₂ | H | CD₂C(CH₃)₃ | H | H |
| 648. | CD(CH₃)₂ | H | 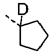 | H | H |
| 649. | CD(CH₃)₂ | H | 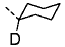 | H | H |
| 650. | CD(CH₃)₂ | H | 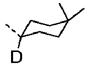 | H | H |
| 651. | CD(CH₃)₂ | H | 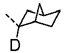 | H | H |
| 652. | CD(CH₃)₂ | H | 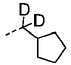 | H | H |
| 653. | CD(CH₃)₂ | H | 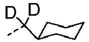 | H | H |
| 654. | C(CH₃)₃ | H | CD₂CH₃ | H | H |
| 655. | C(CH₃)₃ | H | CD(CH₃)₂ | H | H |
| 656. | C(CH₃)₃ | H | CD₂CH(CH₃)₂ | H | H |
| 657. | C(CH₃)₃ | H | C(CH₃)₃ | H | H |
| 658. | C(CH₃)₃ | H | CD₂C(CH₃)₃ | H | H |
| 659. | C(CH₃)₃ | H | 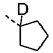 | H | H |
| 660. | C(CH₃)₃ | H | 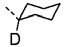 | H | H |
| 661. | C(CH₃)₃ | H | 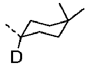 | H | H |
| 662. | C(CH₃)₃ | H | 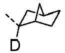 | H | H |
| 663. | C(CH₃)₃ | H | 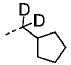 | H | H |
| 664. | C(CH₃)₃ | H | 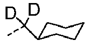 | H | H |
| 665. | CD₂C(CH₃)₃ | H | CD₂CH₃ | H | H |
| 666. | CD₂C(CH₃)₃ | H | CD(CH₃)₂ | H | H |
| 667. | CD₂C(CH₃)₃ | H | CD₂CH(CH₃)₂ | H | H |
| 668. | CD₂C(CH₃)₃ | H | C(CH₃)₃ | H | H |
| 669. | CD₂C(CH₃)₃ | H | CD₂C(CH₃)₃ | H | H |
| 670. | CD₂C(CH₃)₃ | H | 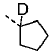 | H | H |
| 671. | CD₂C(CH₃)₃ | H | 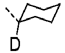 | H | H |
| 672. | CD₂C(CH₃)₃ | H | 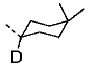 | H | H |
| 673. | CD₂C(CH₃)₃ | H | 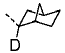 | H | H |
| 674. | CD₂C(CH₃)₃ | H | 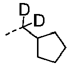 | H | H |
| 675. | CD₂C(CH₃)₃ | H | 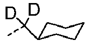 | H | H |
| 676. | 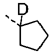 | H | CD₂CH₃ | H | H |
| 677. | 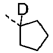 | H | CD(CH₃)₂ | H | H |
| 678. | 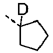 | H | CD₂CH(CH₃)₂ | H | H |
| 679. | 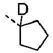 | H | C(CH₃)₃ | H | H |
| 680. | 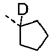 | H | CD₂C(CH₃)₃ | H | H |
| 681. | 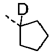 | H | 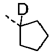 | H | H |
| 682. | 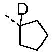 | H | 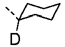 | H | H |
| 683. | 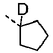 | H | 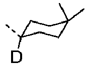 | H | H |
| 684. | 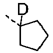 | H | 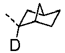 | H | H |
| 685. | 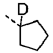 | H | 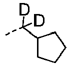 | H | H |
| 686. | 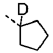 | H | 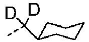 | H | H |
| 687. | 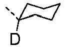 | H | CD₂CH₃ | H | H |
| 688. | 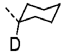 | H | CD(CH₃)₂ | H | H |
| 689. | 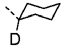 | H | CD₂CH(CH₃)₂ | H | H |
| 690. | 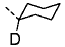 | H | C(CH₃)₃ | H | H |
| 691. | 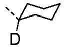 | H | CD₂C(CH₃)₃ | H | H |
| 692. | 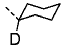 | H | 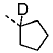 | H | H |
| 693. | 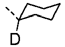 | H | 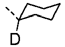 | H | H |
| 694. | 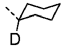 | H | 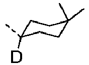 | H | H |
| 695. | 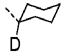 | H | 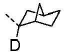 | H | H |
| 696. | 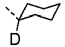 | H | 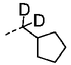 | H | H |
| 697. | 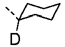 | H | 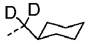 | H | H |
| 698. | 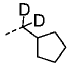 | H | CD₂CH₃ | H | H |
| 699. | 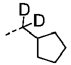 | H | CD(CH₃)₂ | H | H |
| 700. | 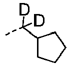 | H | CD₂CH(CH₃)₂ | H | H |
| 701. | 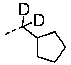 | H | C(CH₃)₃ | H | H |
| 702. | 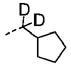 | H | CD₂C(CH₃)₃ | H | H |
| 703. | 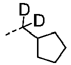 | H | 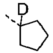 | H | H |
| 704. | 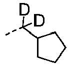 | H | 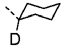 | H | H |
| 705. | 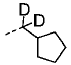 | H | 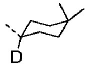 | H | H |
| 706. | 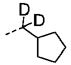 | H | 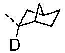 | H | H |
| 707. | 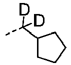 | H | 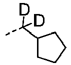 | H | H |
| 708. | 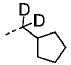 | H | 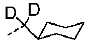 | H | H |
| 709. | 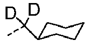 | H | CD₂CH₃ | H | H |
| 710. | 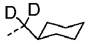 | H | CD(CH₃)₂ | H | H |
| 711. | 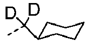 | H | CD₂CH(CH₃)₂ | H | H |
| 712. | 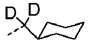 | H | C(CH₃)₃ | H | H |
| 713. | 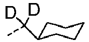 | H | CD₂C(CH₃)₃ | H | H |
| 714. | 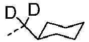 | H | 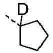 | H | H |
| 715. | 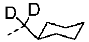 | H | 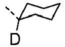 | H | H |
| 716. | 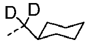 | H | 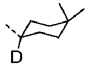 | H | H |
| 717. | 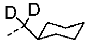 | H | 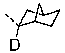 | H | H |
| 718. | 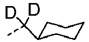 | H | 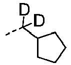 | H | H |
| 719. | 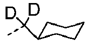 | H | 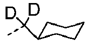 | H | H |
| 720. | 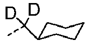 | H | CD₂CH₃ | H | H |
| 721. | 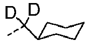 | H | CD(CH₃)₂ | H | H |
| 722. | 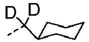 | H | CD₂CH(CH₃)₂ | H | H |
| 723. | 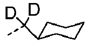 | H | C(CH₃)₃ | H | H |
| 724. | 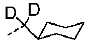 | H | CD₂C(CH₃)₃ | H | H |
| 725. | 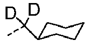 | H | 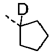 | H | H |
| 726. | 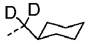 | H | 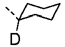 | H | H |
| 727. | 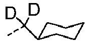 | H | 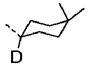 | H | H |
| 728. | 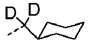 | H | 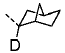 | H | H |
| 729. | 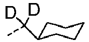 | H | 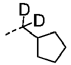 | H | H |
| 730. | 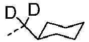 | H | 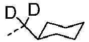 | H | H |
| 731. | H | H | H | H | Ph |
| 732. | CH₃ | H | H | H | Ph |
| 733. | H | CH₃ | H | H | Ph |
| 734. | H | H | CH₃ | H | Ph |
| 735. | CH₃ | CH₃ | H | CH₃ | Ph |
| 736. | CH₃ | H | CH₃ | H | Ph |
| 737. | CH₃ | H | H | CH₃ | Ph |
| 738. | H | CH₃ | CH₃ | H | Ph |
| 739. | H | CH₃ | H | CH₃ | Ph |
| 740. | H | H | CH₃ | CH₃ | Ph |
| 741. | CH₃ | CH₃ | CH₃ | H | Ph |
| 742. | CH₃ | CH₃ | H | CH₃ | Ph |
| 743. | CH₃ | H | CH₃ | CH₃ | Ph |
| 744. | H | CH₃ | CH₃ | CH₃ | Ph |
| 745. | CH₃ | CH₃ | CH₃ | CH₃ | Ph |
| 746. | CH₂CH₃ | H | H | H | Ph |
| 747. | CH₂CH₃ | CH₃ | H | CH₃ | Ph |
| 748. | CH₂CH₃ | H | CH₃ | H | Ph |
| 749. | CH₂CH₃ | H | H | CH₃ | Ph |
| 750. | CH₂CH₃ | CH₃ | CH₃ | H | Ph |
| 751. | CH₂CH₃ | CH₃ | H | CH₃ | Ph |
| 752. | CH₂CH₃ | H | CH₃ | CH₃ | Ph |
| 753. | CH₂CH₃ | CH₃ | CH₃ | CH₃ | Ph |
| 754. | H | CH₂CH₃ | H | H | Ph |
| 755. | CH₃ | CH₂CH₃ | H | CH₃ | Ph |
| 756. | H | CH₂CH₃ | CH₃ | H | Ph |
| 757. | H | CH₂CH₃ | H | CH₃ | Ph |
| 758. | CH₃ | CH₂CH₃ | CH₃ | H | Ph |
| 759. | CH₃ | CH₂CH₃ | H | CH₃ | Ph |
| 760. | H | CH₂CH₃ | CH₃ | CH₃ | Ph |
| 761. | CH₃ | CH₂CH₃ | CH₃ | CH₃ | Ph |
| 762. | H | H | CH₂CH₃ | H | Ph |
| 763. | CH₃ | H | CH₂CH₃ | H | Ph |
| 764. | H | CH₃ | CH₂CH₃ | H | Ph |
| 765. | H | H | CH₂CH₃ | CH₃ | Ph |
| 766. | CH₃ | CH₃ | CH₂CH₃ | H | Ph |
| 767. | CH₃ | H | CH₂CH₃ | CH₃ | Ph |
| 768. | H | CH₃ | CH₂CH₃ | CH₃ | Ph |
| 769. | CH₃ | CH₃ | CH₂CH₃ | CH₃ | Ph |
| 770. | CH(CH₃)₂ | H | H | H | Ph |
| 771. | CH(CH₃)₂ | CH₃ | H | CH₃ | Ph |
| 772. | CH(CH₃)₂ | H | CH₃ | H | Ph |
| 773. | CH(CH₃)₂ | H | H | CH₃ | Ph |
| 774. | CH(CH₃)₂ | CH₃ | CH₃ | H | Ph |
| 775. | CH(CH₃)₂ | CH₃ | H | CH₃ | Ph |
| 776. | CH(CH₃)₂ | H | CH₃ | CH₃ | Ph |
| 777. | CH(CH₃)₂ | CH₃ | CH₃ | CH₃ | Ph |
| 778. | H | CH(CH₃)₂ | H | H | Ph |
| 779. | CH₃ | CH(CH₃)₂ | H | CH₃ | Ph |
| 780. | H | CH(CH₃)₂ | CH₃ | H | Ph |
| 781. | H | CH(CH₃)₂ | H | CH₃ | Ph |
| 782. | CH₃ | CH(CH₃)₂ | CH₃ | H | Ph |
| 783. | CH₃ | CH(CH₃)₂ | H | CH₃ | Ph |
| 784. | H | CH(CH₃)₂ | CH₃ | CH₃ | Ph |
| 785. | CH₃ | CH(CH₃)₂ | CH₃ | CH₃ | Ph |
| 786. | H | H | CH(CH₃)₂ | H | Ph |
| 787. | CH₃ | H | CH(CH₃)₂ | H | Ph |
| 788. | H | CH₃ | CH(CH₃)₂ | H | Ph |
| 789. | H | H | CH(CH₃)₂ | CH₃ | Ph |
| 790. | CH₃ | CH₃ | CH(CH₃)₂ | H | Ph |
| 791. | CH₃ | H | CH(CH₃)₂ | CH₃ | Ph |
| 792. | H | CH₃ | CH(CH₃)₂ | CH₃ | Ph |
| 793. | CH₃ | CH₃ | CH(CH₃)₂ | CH₃ | Ph |
| 794. | CH₂CH(CH₃)₂ | H | H | H | Ph |
| 795. | CH₂CH(CH₃)₂ | CH₃ | H | CH₃ | Ph |
| 796. | CH₂CH(CH₃)₂ | H | CH₃ | H | Ph |
| 797. | CH₂CH(CH₃)₂ | H | H | CH₃ | Ph |
| 798. | CH₂CH(CH₃)₂ | CH₃ | CH₃ | H | Ph |
| 799. | CH₂CH(CH₃)₂ | CH₃ | H | CH₃ | Ph |
| 800. | CH₂CH(CH₃)₂ | H | CH₃ | CH₃ | Ph |
| 801. | CH₂CH(CH₃)₂ | CH₃ | CH₃ | CH₃ | Ph |
| 802. | H | CH₂CH(CH₃)₂ | H | H | Ph |
| 803. | CH₃ | CH₂CH(CH₃)₂ | H | CH₃ | Ph |
| 804. | H | CH₂CH(CH₃)₂ | CH₃ | H | Ph |
| 805. | H | CH₂CH(CH₃)₂ | H | CH₃ | Ph |
| 806. | CH₃ | CH₂CH(CH₃)₂ | CH₃ | H | Ph |
| 807. | CH₃ | CH₂CH(CH₃)₂ | H | CH₃ | Ph |
| 808. | H | CH₂CH(CH₃)₂ | CH₃ | CH₃ | Ph |
| 809. | CH₃ | CH₂CH(CH₃)₂ | CH₃ | CH₃ | Ph |
| 810. | H | H | CH₂CH(CH₃)₂ | H | Ph |
| 811. | CH₃ | H | CH₂CH(CH₃)₂ | H | Ph |
| 812. | H | CH₃ | CH₂CH(CH₃)₂ | H | Ph |
| 813. | H | H | CH₂CH(CH₃)₂ | CH₃ | Ph |
| 814. | CH₃ | CH₃ | CH₂CH(CH₃)₂ | H | Ph |
| 815. | CH₃ | H | CH₂CH(CH₃)₂ | CH₃ | Ph |
| 816. | H | CH₃ | CH₂CH(CH₃)₂ | CH₃ | Ph |
| 817. | CH₃ | CH₃ | CH₂CH(CH₃)₂ | CH₃ | Ph |
| 818. | C(CH₃)₃ | H | H | H | Ph |
| 819. | C(CH₃)₃ | CH₃ | H | CH₃ | Ph |
| 820. | C(CH₃)₃ | H | CH₃ | H | Ph |
| 821. | C(CH₃)₃ | H | H | CH₃ | Ph |
| 822. | C(CH₃)₃ | CH₃ | CH₃ | H | Ph |
| 823. | C(CH₃)₃ | CH₃ | H | CH₃ | Ph |
| 824. | C(CH₃)₃ | H | CH₃ | CH₃ | Ph |
| 825. | C(CH₃)₃ | CH₃ | CH₃ | CH₃ | Ph |
| 826. | H | C(CH₃)₃ | H | H | Ph |
| 827. | CH₃ | C(CH₃)₃ | H | CH₃ | Ph |
| 828. | H | C(CH₃)₃ | CH₃ | H | Ph |
| 829. | H | C(CH₃)₃ | H | CH₃ | Ph |
| 830. | CH₃ | C(CH₃)₃ | CH₃ | H | Ph |
| 831. | CH₃ | C(CH₃)₃ | H | CH₃ | Ph |
| 832. | H | C(CH₃)₃ | CH₃ | CH₃ | Ph |
| 833. | CH₃ | C(CH₃)₃ | CH₃ | CH₃ | Ph |
| 834. | H | H | C(CH₃)₃ | H | Ph |
| 835. | CH₃ | H | C(CH₃)₃ | H | Ph |
| 836. | H | CH₃ | C(CH₃)₃ | H | Ph |
| 837. | H | H | C(CH₃)₃ | CH₃ | Ph |
| 838. | CH₃ | CH₃ | C(CH₃)₃ | H | Ph |
| 839. | CH₃ | H | C(CH₃)₃ | CH₃ | Ph |
| 840. | H | CH₃ | C(CH₃)₃ | CH₃ | Ph |
| 841. | CH₃ | CH₃ | C(CH₃)₃ | CH₃ | Ph |
| 842. | CH₂C(CH₃)₃ | H | H | H | Ph |
| 843. | CH₂C(CH₃)₃ | CH₃ | H | CH₃ | Ph |
| 844. | CH₂C(CH₃)₃ | H | CH₃ | H | Ph |
| 845. | CH₂C(CH₃)₃ | H | H | CH₃ | Ph |
| 846. | CH₂C(CH₃)₃ | CH₃ | CH₃ | H | Ph |
| 847. | CH₂C(CH₃)₃ | CH₃ | H | CH₃ | Ph |
| 848. | CH₂C(CH₃)₃ | H | CH₃ | CH₃ | Ph |
| 849. | CH₂C(CH₃)₃ | CH₃ | CH₃ | CH₃ | Ph |
| 850. | H | CH₂C(CH₃)₃ | H | H | Ph |
| 851. | CH₃ | CH₂C(CH₃)₃ | H | CH₃ | Ph |
| 852. | H | CH₂C(CH₃)₃ | CH₃ | H | Ph |
| 853. | H | CH₂C(CH₃)₃ | H | CH₃ | Ph |
| 854. | CH₃ | CH₂C(CH₃)₃ | CH₃ | H | Ph |
| 855. | CH₃ | CH₂C(CH₃)₃ | H | CH₃ | Ph |
| 856. | H | CH₂C(CH₃)₃ | CH₃ | CH₃ | Ph |
| 857. | CH₃ | CH₂C(CH₃)₃ | CH₃ | CH₃ | Ph |
| 858. | H | H | CH₂C(CH₃)₃ | H | Ph |
| 859. | CH₃ | H | CH₂C(CH₃)₃ | H | Ph |
| 860. | H | CH₃ | CH₂C(CH₃)₃ | H | Ph |
| 861. | H | H | CH₂C(CH₃)₃ | CH₃ | Ph |
| 862. | CH₃ | CH₃ | CH₂C(CH₃)₃ | H | Ph |
| 863. | CH₃ | H | CH₂C(CH₃)₃ | CH₃ | Ph |
| 864. | H | CH₃ | CH₂C(CH₃)₃ | CH₃ | Ph |
| 865. | CH₃ | CH₃ | CH₂C(CH₃)₃ | CH₃ | Ph |
| 866. | 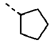 | H | H | H | Ph |
| 867. | 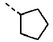 | CH₃ | H | CH₃ | Ph |
| 868. | 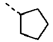 | H | CH₃ | H | Ph |
| 869. | 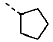 | H | H | CH₃ | Ph |
| 870. | 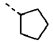 | CH₃ | CH₃ | H | Ph |
| 871. | 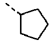 | CH₃ | H | CH₃ | Ph |
| 872. | 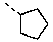 | H | CH₃ | CH₃ | Ph |
| 873. | 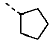 | CH₃ | CH₃ | CH₃ | Ph |
| 874. | H | 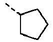 | H | H | Ph |
| 875. | CH₃ | 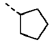 | H | CH₃ | Ph |
| 876. | H | 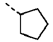 | CH₃ | H | Ph |
| 877. | H | 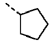 | H | CH₃ | Ph |
| 878. | CH₃ | 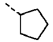 | CH₃ | H | Ph |
| 879. | CH₃ | 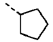 | H | CH₃ | Ph |
| 880. | H | 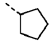 | CH₃ | CH₃ | Ph |
| 881. | CH₃ | 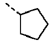 | CH₃ | CH₃ | Ph |
| 882. | H | H | 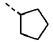 | H | Ph |
| 883. | CH₃ | H | 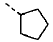 | H | Ph |
| 884. | H | CH₃ | 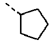 | H | Ph |
| 885. | H | H | 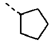 | CH₃ | Ph |
| 886. | CH₃ | CH₃ | 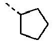 | H | Ph |
| 887. | CH₃ | H | 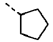 | CH₃ | Ph |
| 888. | H | CH₃ | 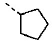 | CH₃ | Ph |
| 889. | CH₃ | CH₃ | 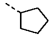 | CH₃ | Ph |
| 890. | 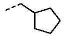 | H | H | H | Ph |
| 891. | 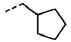 | CH₃ | H | CH₃ | Ph |
| 892. | 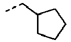 | H | CH₃ | H | Ph |
| 893. | 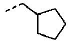 | H | H | CH₃ | Ph |
| 894. | 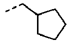 | CH₃ | CH₃ | H | Ph |
| 895. | 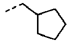 | CH₃ | H | CH₃ | Ph |
| 896. | 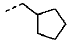 | H | CH₃ | CH₃ | Ph |
| 897. | 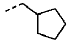 | CH₃ | CH₃ | CH₃ | Ph |
| 898. | H | 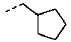 | H | H | Ph |
| 899. | CH₃ | 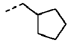 | H | CH₃ | Ph |
| 900. | H | 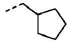 | CH₃ | H | Ph |
| 901. | H | 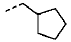 | H | CH₃ | Ph |
| 902. | CH₃ | 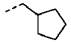 | CH₃ | H | Ph |
| 903. | CH₃ | 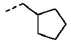 | H | CH₃ | Ph |
| 904. | H | 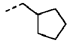 | CH₃ | CH₃ | Ph |
| 905. | CH₃ | 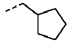 | CH₃ | CH₃ | Ph |
| 906. | H | H | 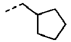 | H | Ph |
| 907. | CH₃ | H | 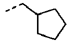 | H | Ph |
| 908. | H | CH₃ | 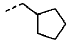 | H | Ph |
| 909. | H | H | 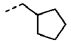 | CH₃ | Ph |
| 910. | CH₃ | CH₃ | 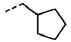 | H | Ph |
| 911. | CH₃ | H | 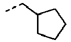 | CH₃ | Ph |
| 912. | H | CH₃ | 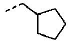 | CH₃ | Ph |
| 913. | CH₃ | CH₃ | 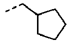 | CH₃ | Ph |
| 914. | 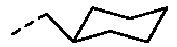 | H | H | H | Ph |
| 915. | 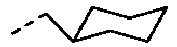 | CH₃ | H | CH₃ | Ph |
| 916. | 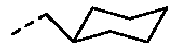 | H | CH₃ | H | Ph |
| 917. | 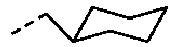 | H | H | CH₃ | Ph |
| 918. | 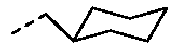 | CH₃ | CH₃ | H | Ph |
| 919. | 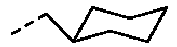 | CH₃ | H | CH₃ | Ph |
| 920. | 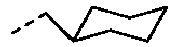 | H | CH₃ | CH₃ | Ph |
| 921. | 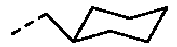 | CH₃ | CH₃ | CH₃ | Ph |
| 922. | H | 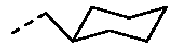 | H | H | Ph |
| 923. | CH₃ | 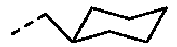 | H | CH₃ | Ph |
| 924. | H | 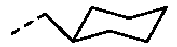 | CH₃ | H | Ph |
| 925. | H | 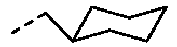 | H | CH₃ | Ph |
| 926. | CH₃ | 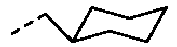 | CH₃ | H | Ph |
| 927. | CH₃ | 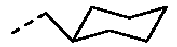 | H | CH₃ | Ph |
| 928. | H | 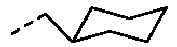 | CH₃ | CH₃ | Ph |
| 929. | CH₃ | 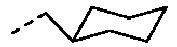 | CH₃ | CH₃ | Ph |
| 930. | H | H | 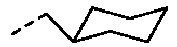 | H | Ph |
| 931. | CH₃ | H | 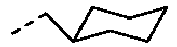 | H | Ph |
| 932. | H | CH₃ | 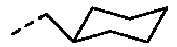 | H | Ph |
| 933. | H | H | 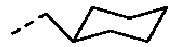 | CH₃ | Ph |
| 934. | CH₃ | CH₃ | 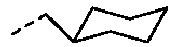 | H | Ph |
| 935. | CH₃ | H | 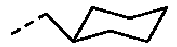 | CH₃ | Ph |
| 936. | H | CH₃ | 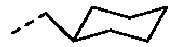 | CH₃ | Ph |
| 937. | CH₃ | CH₃ | 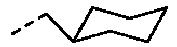 | CH₃ | Ph |
| 938. | 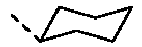 | H | H | H | Ph |
| 939. | 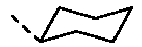 | CH₃ | H | CH₃ | Ph |
| 940. | 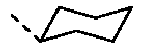 | H | CH₃ | H | Ph |
| 941. | 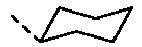 | H | H | CH₃ | Ph |
| 942. | 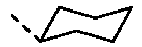 | CH₃ | CH₃ | H | Ph |
| 943. | 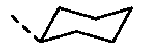 | CH₃ | H | CH₃ | Ph |
| 944. | 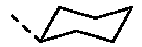 | H | CH₃ | CH₃ | Ph |
| 945. | 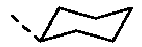 | CH₃ | CH₃ | CH₃ | Ph |
| 946. | H | 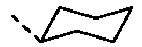 | H | H | Ph |
| 947. | CH₃ | 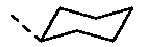 | H | CH₃ | Ph |
| 948. | H | 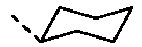 | CH₃ | H | Ph |
| 949. | H | 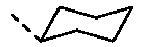 | H | CH₃ | Ph |
| 950. | CH₃ | 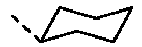 | CH₃ | H | Ph |
| 951. | CH₃ | 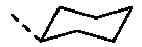 | H | CH₃ | Ph |
| 952. | H | 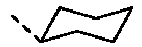 | CH₃ | CH₃ | Ph |
| 953. | CH₃ | 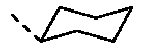 | CH₃ | CH₃ | Ph |
| 954. | H | H | 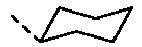 | H | Ph |
| 955. | CH₃ | H | 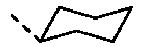 | H | Ph |
| 956. | H | CH₃ | 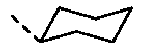 | H | Ph |
| 957. | H | H | 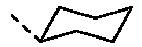 | CH₃ | Ph |
| 958. | CH₃ | CH₃ | 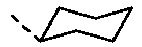 | H | Ph |
| 959. | CH₃ | H | 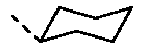 | CH₃ | Ph |
| 960. | H | CH₃ | 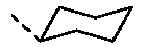 | CH₃ | Ph |
| 961. | CH₃ | CH₃ | 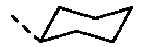 | CH₃ | Ph |
| 962. | 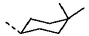 | H | H | H | Ph |
| 963. | 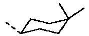 | CH₃ | H | CH₃ | Ph |
| 964. | 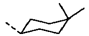 | H | CH₃ | H | Ph |
| 965. | 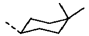 | H | H | CH₃ | Ph |
| 966. | 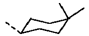 | CH₃ | CH₃ | H | Ph |
| 967. | 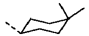 | CH₃ | H | CH₃ | Ph |
| 968. | 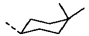 | H | CH₃ | CH₃ | Ph |
| 969. | 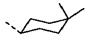 | CH₃ | CH₃ | CH₃ | Ph |
| 970. | H | 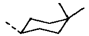 | H | H | Ph |
| 971. | CH₃ | 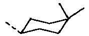 | H | CH₃ | Ph |
| 972. | H | 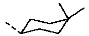 | CH₃ | H | Ph |
| 973. | H | 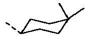 | H | CH₃ | Ph |
| 974. | CH₃ | 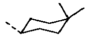 | CH₃ | H | Ph |
| 975. | CH₃ | 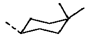 | H | CH₃ | Ph |
| 976. | H | 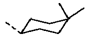 | CH₃ | CH₃ | Ph |
| 977. | CH₃ | 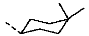 | CH₃ | CH₃ | Ph |
| 978. | H | H | 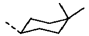 | H | Ph |
| 979. | CH₃ | H | 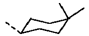 | H | Ph |
| 980. | H | CH₃ | 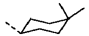 | H | Ph |
| 981. | H | H | 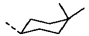 | CH₃ | Ph |
| 982. | CH₃ | CH₃ | 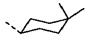 | H | Ph |
| 983. | CH₃ | H | 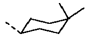 | CH₃ | Ph |
| 984. | H | CH₃ | 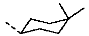 | CH₃ | Ph |
| 985. | CH₃ | CH₃ | 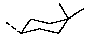 | CH₃ | Ph |
| 986. | 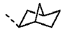 | H | H | H | Ph |
| 987. | 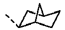 | CH₃ | H | CH₃ | Ph |
| 988. | 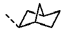 | H | CH₃ | H | Ph |
| 989. | 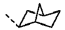 | H | H | CH₃ | Ph |
| 990. | 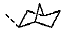 | CH₃ | CH₃ | H | Ph |
| 991. | 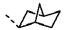 | CH₃ | H | CH₃ | Ph |
| 992. | 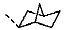 | H | CH₃ | CH₃ | Ph |
| 993. | 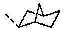 | CH₃ | CH₃ | CH₃ | Ph |
| 994. | H | 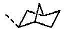 | H | H | Ph |
| 995. | CH₃ | 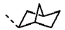 | H | CH₃ | Ph |
| 996. | H | 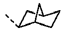 | CH₃ | H | Ph |
| 997. | H | 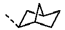 | H | CH₃ | Ph |
| 998. | CH₃ | 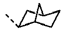 | CH₃ | H | Ph |
| 999. | CH₃ | 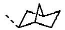 | H | CH₃ | Ph |
| 1000. | H | 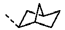 | CH₃ | CH₃ | Ph |
| 1001. | CH₃ | 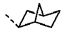 | CH₃ | CH₃ | Ph |
| 1002. | H | H | 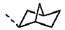 | H | Ph |
| 1003. | CH₃ | H | 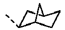 | H | Ph |
| 1004. | H | CH₃ | 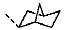 | H | Ph |
| 1005. | H | H | 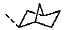 | CH₃ | Ph |
| 1006. | CH₃ | CH₃ | 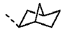 | H | Ph |
| 1007. | CH₃ | H | 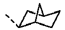 | CH₃ | Ph |
| 1008. | H | CH₃ | 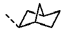 | CH₃ | Ph |
| 1009. | CH₃ | CH₃ | 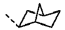 | CH₃ | Ph |
| 1010. | CH(CH₃)₂ | H | CH₂CH₃ | H | Ph |
| 1011. | CH(CH₃)₂ | H | CH(CH₃)₂ | H | Ph |
| 1012. | CH(CH₃)₂ | H | CH₂CH(CH₃)₂ | H | Ph |
| 1013. | CH(CH₃)₂ | H | C(CH₃)₃ | H | Ph |
| 1014. | CH(CH₃)₂ | H | CH₂C(CH₃)₃ | H | Ph |
| 1015. | CH(CH₃)₂ | H | 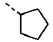 | H | Ph |
| 1016. | CH(CH₃)₂ | H | 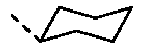 | H | Ph |
| 1017. | CH(CH₃)₂ | H | 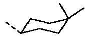 | H | Ph |
| 1018. | CH(CH₃)₂ | H | 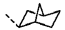 | H | Ph |
| 1019. | CH(CH₃)₂ | H | 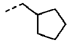 | H | Ph |
| 1020. | CH(CH₃)₂ | H | 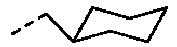 | H | Ph |
| 1021. | C(CH₃)₃ | H | CH₂CH₃ | H | Ph |
| 1022. | C(CH₃)₃ | H | CH(CH₃)₂ | H | Ph |
| 1023. | C(CH₃)₃ | H | CH₂CH(CH₃)₂ | H | Ph |
| 1024. | C(CH₃)₃ | H | C(CH₃)₃ | H | Ph |
| 1025. | C(CH₃)₃ | H | CH₂C(CH₃)₃ | H | Ph |
| 1026. | C(CH₃)₃ | H | 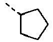 | H | Ph |
| 1027. | C(CH₃)₃ | H | 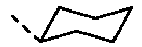 | H | Ph |
| 1028. | C(CH₃)₃ | H | 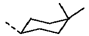 | H | Ph |
| 1029. | C(CH₃)₃ | H | 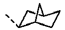 | H | Ph |
| 1030. | C(CH₃)₃ | H | 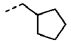 | H | Ph |
| 1031. | C(CH₃)₃ | H | 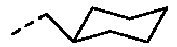 | H | Ph |
| 1032. | CH₂C(CH₃)₃ | H | CH₂CH₃ | H | Ph |
| 1033. | CH₂C(CH₃)₃ | H | CH(CH₃)₂ | H | Ph |
| 1034. | CH₂C(CH₃)₃ | H | CH₂CH(CH₃)₂ | H | Ph |
| 1035. | CH₂C(CH₃)₃ | H | C(CH₃)₃ | H | Ph |
| 1036. | CH₂C(CH₃)₃ | H | CH₂C(CH₃)₃ | H | Ph |
| 1037. | CH₂C(CH₃)₃ | H | 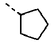 | H | Ph |
| 1038. | CH₂C(CH₃)₃ | H | 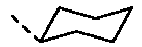 | H | Ph |
| 1039. | CH₂C(CH₃)₃ | H | 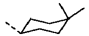 | H | Ph |
| 1040. | CH₂C(CH₃)₃ | H | 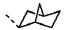 | H | Ph |
| 1041. | CH₂C(CH₃)₃ | H | 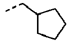 | H | Ph |
| 1042. | CH₂C(CH₃)₃ | H | 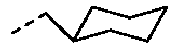 | H | Ph |
| 1043. | 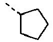 | H | CH₂CH₃ | H | Ph |
| 1044. | 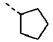 | H | CH(CH₃)₂ | H | Ph |
| 1045. | 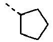 | H | CH₂CH(CH₃)₂ | H | Ph |
| 1046. | 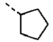 | H | C(CH₃)₃ | H | Ph |
| 1047. | 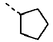 | H | CH₂C(CH₃)₃ | H | Ph |
| 1048. | 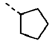 | H | 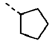 | H | Ph |
| 1049. | 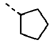 | H | 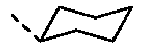 | H | Ph |
| 1050. | 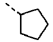 | H | 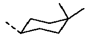 | H | Ph |
| 1051. | 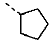 | H | 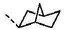 | H | Ph |
| 1052. | 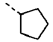 | H | 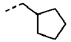 | H | Ph |
| 1053. | 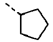 | H | 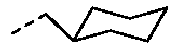 | H | Ph |
| 1054. | 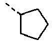 | H | CH₂CH₃ | H | Ph |
| 1055. | 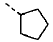 | H | CH(CH₃)₂ | H | Ph |
| 1056. | 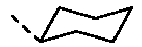 | H | CH₂CH(CH₃)₂ | H | Ph |
| 1057. | 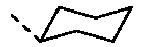 | H | C(CH₃)₃ | H | Ph |
| 1058. | 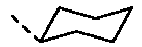 | H | CH₂C(CH₃)₃ | H | Ph |
| 1059. | 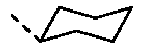 | H | 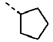 | H | Ph |
| 1060. | 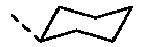 | H | 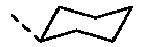 | H | Ph |
| 1061. | 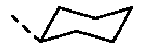 | H | 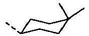 | H | Ph |
| 1062. | 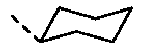 | H | 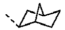 | H | Ph |
| 1063. | 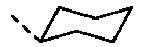 | H | 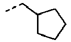 | H | Ph |
| 1064. | 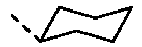 | H | 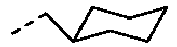 | H | Ph |
| 1065. | 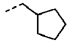 | H | CH₂CH(CH₃)₂ | H | Ph |
| 1066. | 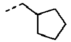 | H | C(CH₃)₃ | H | Ph |
| 1067. | 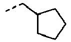 | H | CH₂C(CH₃)₃ | H | Ph |
| 1068. | 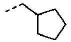 | H | 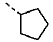 | H | Ph |
| 1069. | 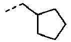 | H | 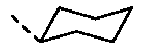 | H | Ph |
| 1070. | 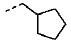 | H | 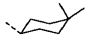 | H | Ph |
| 1071. | 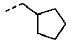 | H | 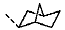 | H | Ph |
| 1072. | 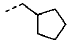 | H | 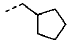 | H | Ph |
| 1073. | 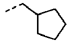 | H | 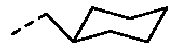 | H | Ph |
| 1074. | 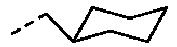 | H | CH₂CH(CH₃)₂ | H | Ph |
| 1075. | 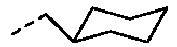 | H | C(CH₃)₃ | H | Ph |
| 1076. | 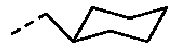 | H | CH₂C(CH₃)₃ | H | Ph |
| 1077. | 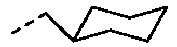 | H | 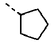 | H | Ph |
| 1078. | 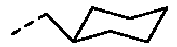 | H | 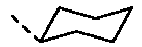 | H | Ph |
| 1079. | 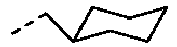 | H | 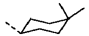 | H | Ph |
| 1080. | 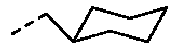 | H | 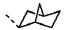 | H | Ph |
| 1081. | 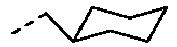 | H | 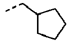 | H | Ph |
| 1082. | 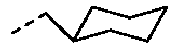 | H | 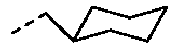 | H | Ph |
| 1083. | 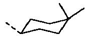 | H | CH₂CH(CH₃)₂ | H | Ph |
| 1084. | 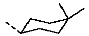 | H | C(CH₃)₃ | H | Ph |
| 1085. | 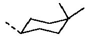 | H | CH₂C(CH₃)₃ | H | Ph |
| 1086. | 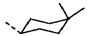 | H | 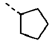 | H | Ph |
| 1087. | 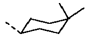 | H | 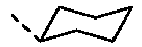 | H | Ph |
| 1088. | 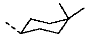 | H | 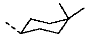 | H | Ph |
| 1089. | 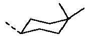 | H | 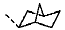 | H | Ph |
| 1090. | 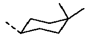 | H | 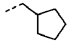 | H | Ph |
| 1091. | 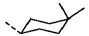 | H | 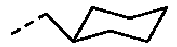 | H | Ph |
| 1092. | H | H | H | H | Ph |
| 1093. | CD₃ | H | H | H | Ph |
| 1094. | H | CD₃ | H | H | Ph |
| 1095. | H | H | CD₃ | H | Ph |
| 1096. | CD₃ | CD₃ | H | CD₃ | Ph |
| 1097. | CD₃ | H | CD₃ | H | Ph |
| 1098. | CD₃ | H | H | CD₃ | Ph |
| 1099. | H | CD₃ | CD₃ | H | Ph |
| 1100. | H | CD₃ | H | CD₃ | Ph |
| 1101. | H | H | CD₃ | CD₃ | Ph |
| 1102. | CD₃ | CD₃ | CD₃ | H | Ph |
| 1103. | CD₃ | CD₃ | H | CD₃ | Ph |
| 1104. | CD₃ | H | CD₃ | CD₃ | Ph |
| 1105. | H | CD₃ | CD₃ | CD₃ | Ph |
| 1106. | CD₃ | CD₃ | CD₃ | CD₃ | Ph |
| 1107. | CD₂CH₃ | H | H | H | Ph |
| 1108. | CD₂CH₃ | CD₃ | H | CD₃ | Ph |
| 1109. | CD₂CH₃ | H | CD₃ | H | Ph |
| 1110. | CD₂CH₃ | H | H | CD₃ | Ph |
| 1111. | CD₂CH₃ | CD₃ | CD₃ | H | Ph |
| 1112. | CD₂CH₃ | CD₃ | H | CD₃ | Ph |
| 1113. | CD₂CH₃ | H | CD₃ | CD₃ | Ph |
| 1114. | CD₂CH₃ | CD₃ | CD₃ | CD₃ | Ph |
| 1115. | H | CD₂CH₃ | H | H | Ph |
| 1116. | CH₃ | CD₂CH₃ | H | CD₃ | Ph |
| 1117. | H | CD₂CH₃ | CD₃ | H | Ph |
| 1118. | H | CD₂CH₃ | H | CD₃ | Ph |
| 1119. | CD₃ | CD₂CH₃ | CD₃ | H | Ph |
| 1120. | CD₃ | CD₂CH₃ | H | CD₃ | Ph |
| 1121. | H | CD₂CH₃ | CD₃ | CD₃ | Ph |
| 1122. | CD₃ | CD₂CH₃ | CD₃ | CD₃ | Ph |
| 1123. | H | H | CD₂CH₃ | H | Ph |
| 1124. | CD₃ | H | CD₂CH₃ | H | Ph |
| 1125. | H | CD₃ | CD₂CH₃ | H | Ph |
| 1126. | H | H | CD₂CH₃ | CD₃ | Ph |
| 1127. | CD₃ | CD₃ | CD₂CH₃ | H | Ph |
| 1128. | CD₃ | H | CD₂CH₃ | CD₃ | Ph |
| 1129. | H | CD₃ | CD₂CH₃ | CD₃ | Ph |
| 1130. | CD₃ | CD₃ | CD₂CH₃ | CD₃ | Ph |
| 1131. | CD(CH₃)₂ | H | H | H | Ph |
| 1132. | CD(CH₃)₂ | CD₃ | H | CD₃ | Ph |
| 1133. | CD(CH₃)₂ | H | CD₃ | H | Ph |
| 1134. | CD(CH₃)₂ | H | H | CD₃ | Ph |
| 1135. | CD(CH₃)₂ | CD₃ | CD₃ | H | Ph |
| 1136. | CD(CH₃)₂ | CD₃ | H | CD₃ | Ph |
| 1137. | CD(CH₃)₂ | H | CD₃ | CD₃ | Ph |
| 1138. | CD(CH₃)₂ | CD₃ | CD₃ | CD₃ | Ph |
| 1139. | H | CD(CH₃)₂ | H | H | Ph |
| 1140. | CD₃ | CD(CH₃)₂ | H | CD₃ | Ph |
| 1141. | H | CD(CH₃)₂ | CD₃ | H | Ph |
| 1142. | H | CD(CH₃)₂ | H | CD₃ | Ph |
| 1143. | CD₃ | CD(CH₃)₂ | CD₃ | H | Ph |
| 1144. | CD₃ | CD(CH₃)₂ | H | CD₃ | Ph |
| 1145. | H | CD(CH₃)₂ | CD₃ | CD₃ | Ph |
| 1146. | CD₃ | CD(CH₃)₂ | CD₃ | CD₃ | Ph |
| 1147. | H | H | CD(CH₃)₂ | H | Ph |
| 1148. | CD₃ | H | CD(CH₃)₂ | H | Ph |
| 1149. | H | CD₃ | CD(CH₃)₂ | H | Ph |
| 1150. | H | H | CD(CH₃)₂ | CD₃ | Ph |
| 1151. | CD₃ | CD₃ | CD(CH₃)₂ | H | Ph |
| 1152. | CD₃ | H | CD(CH₃)₂ | CD₃ | Ph |
| 1153. | H | CD₃ | CD(CH₃)₂ | CD₃ | Ph |
| 1154. | CD₃ | CD₃ | CD(CH₃)₂ | CD₃ | Ph |
| 1155. | CD(CD₃)₂ | H | H | H | Ph |
| 1156. | CD(CD₃)₂ | CD₃ | H | CD₃ | Ph |
| 1157. | CD(CD₃)₂ | H | CD₃ | H | Ph |
| 1158. | CD(CD₃)₂ | H | H | CD₃ | Ph |
| 1159. | CD(CD₃)₂ | CD₃ | CD₃ | H | Ph |
| 1160. | CD(CD₃)₂ | CD₃ | H | CD₃ | Ph |
| 1161. | CD(CD₃)₂ | H | CD₃ | CD₃ | Ph |
| 1162. | CD(CD₃)₂ | CD₃ | CD₃ | CD₃ | Ph |
| 1163. | H | CD(CD₃)₂ | H | H | Ph |
| 1164. | CH₃ | CD(CD₃)₂ | H | CD₃ | Ph |
| 1165. | H | CD(CD₃)₂ | CD₃ | H | Ph |
| 1166. | H | CD(CD₃)₂ | H | CD₃ | Ph |
| 1167. | CD₃ | CD(CD₃)₂ | CD₃ | H | Ph |
| 1168. | CD₃ | CD(CD₃)₂ | H | CD₃ | Ph |
| 1169. | H | CD(CD₃)₂ | CD₃ | CD₃ | Ph |
| 1170. | CD₃ | CD(CD₃)₂ | CD₃ | CD₃ | Ph |
| 1171. | H | H | CD(CD₃)₂ | H | Ph |
| 1172. | CD₃ | H | CD(CD₃)₂ | H | Ph |
| 1173. | H | CD₃ | CD(CD₃)₂ | H | Ph |
| 1174. | H | H | CD(CD₃)₂ | CD₃ | Ph |
| 1175. | CD₃ | CD₃ | CD(CD₃)₂ | H | Ph |
| 1176. | CD₃ | H | CD(CD₃)₂ | CD₃ | Ph |
| 1177. | H | CD₃ | CD(CD₃)₂ | CD₃ | Ph |
| 1178. | CD₃ | CD₃ | CD(CD₃)₂ | CD₃ | Ph |
| 1179. | CD₂CH(CH₃)₂ | H | H | H | Ph |
| 1180. | CD₂CH(CH₃)₂ | CD₃ | H | CD₃ | Ph |
| 1181. | CD₂CH(CH₃)₂ | H | CD₃ | H | Ph |
| 1182. | CD₂CH(CH₃)₂ | H | H | CD₃ | Ph |
| 1183. | CD₂CH(CH₃)₂ | CD₃ | CD₃ | H | Ph |
| 1184. | CD₂CH(CH₃)₂ | CD₃ | H | CD₃ | Ph |
| 1185. | CD₂CH(CH₃)₂ | H | CD₃ | CD₃ | Ph |
| 1186. | CD₂CH(CH₃)₂ | CD₃ | CD₃ | CD₃ | Ph |
| 1187. | H | CD₂CH(CH₃)₂ | H | H | Ph |
| 1188. | CD₃ | CD₂CH(CH₃)₂ | H | CD₃ | Ph |
| 1189. | H | CD₂CH(CH₃)₂ | CD₃ | H | Ph |
| 1190. | H | CD₂CH(CH₃)₂ | H | CD₃ | Ph |
| 1191. | CD₃ | CD₂CH(CH₃)₂ | CD₃ | H | Ph |
| 1192. | CD₃ | CD₂CH(CH₃)₂ | H | CD₃ | Ph |
| 1193. | H | CD₂CH(CH₃)₂ | CD₃ | CD₃ | Ph |
| 1194. | CD₃ | CD₂CH(CH₃)₂ | CD₃ | CD₃ | Ph |
| 1195. | H | H | CD₂CH(CH₃)₂ | H | Ph |
| 1196. | CD₃ | H | CD₂CH(CH₃)₂ | H | Ph |
| 1197. | H | CD₃ | CD₂CH(CH₃)₂ | H | Ph |
| 1198. | H | H | CD₂CH(CH₃)₂ | CD₃ | Ph |
| 1199. | CD₃ | CD₃ | CD₂CH(CH₃)₂ | H | Ph |
| 1200. | CD₃ | H | CD₂CH(CH₃)₂ | CD₃ | Ph |
| 1201. | H | CD₃ | CD₂CH(CH₃)₂ | CD₃ | Ph |
| 1202. | CD₃ | CD₃ | CD₂CH(CH₃)₂ | CD₃ | Ph |
| 1203. | CD₂C(CH₃)₃ | H | H | H | Ph |
| 1204. | CD₂C(CH₃)₃ | CD₃ | H | CD₃ | Ph |
| 1205. | CD₂C(CH₃)₃ | H | CD₃ | H | Ph |
| 1206. | CD₂C(CH₃)₃ | H | H | CD₃ | Ph |
| 1207. | CD₂C(CH₃)₃ | CD₃ | CD₃ | H | Ph |
| 1208. | CD₂C(CH₃)₃ | CD₃ | H | CD₃ | Ph |
| 1209. | CD₂C(CH₃)₃ | H | CD₃ | CD₃ | Ph |
| 1210. | CD₂C(CH₃)₃ | CH₃ | CD₃ | CD₃ | Ph |
| 1211. | H | CD₂C(CH₃)₃ | H | H | Ph |
| 1212. | CD₃ | CD₂C(CH₃)₃ | H | CD₃ | Ph |
| 1213. | H | CD₂C(CH₃)₃ | CD₃ | H | Ph |
| 1214. | H | CD₂C(CH₃)₃ | H | CD₃ | Ph |
| 1215. | CD₃ | CD₂C(CH₃)₃ | CD₃ | H | Ph |
| 1216. | CD₃ | CD₂C(CH₃)₃ | H | CD₃ | Ph |
| 1217. | H | CD₂C(CH₃)₃ | CD₃ | CD₃ | Ph |
| 1218. | CD₃ | CD₂C(CH₃)₃ | CD₃ | CD₃ | Ph |
| 1219. | H | H | CD₂C(CH₃)₃ | H | Ph |
| 1220. | CD₃ | H | CD₂C(CH₃)₃ | H | Ph |
| 1221. | H | CD₃ | CD₂C(CH₃)₃ | H | Ph |
| 1222. | H | H | CD₂C(CH₃)₃ | CD₃ | Ph |
| 1223. | CD₃ | CD₃ | CD₂C(CH₃)₃ | H | Ph |
| 1224. | CD₃ | H | CD₂C(CH₃)₃ | CD₃ | Ph |
| 1225. | H | CD₃ | CD₂C(CH₃)₃ | CD₃ | Ph |
| 1226. | CD₃ | CD₃ | CD₂C(CH₃)₃ | CD₃ | Ph |
| 1227. | 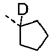 | H | H | H | Ph |
| 1228. | 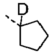 | CD₃ | H | CD₃ | Ph |
| 1229. | 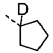 | H | CD₃ | H | Ph |
| 1230. | 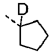 | H | H | CD₃ | Ph |
| 1231. | 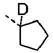 | CD₃ | CD₃ | H | Ph |
| 1232. | 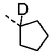 | CD₃ | H | CD₃ | Ph |
| 1233. | 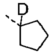 | H | CD₃ | CD₃ | Ph |
| 1234. | 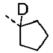 | CD₃ | CD₃ | CD₃ | Ph |
| 1235. | H | 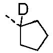 | H | H | Ph |
| 1236. | CD₃ | 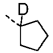 | H | CD₃ | Ph |
| 1237. | H | 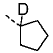 | CD₃ | H | Ph |
| 1238. | H | 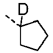 | H | CD₃ | Ph |
| 1239. | CD₃ | 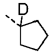 | CD₃ | H | Ph |
| 1240. | CD₃ | 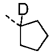 | H | CD₃ | Ph |
| 1241. | H | 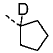 | CD₃ | CD₃ | Ph |
| 1242. | CD₃ | 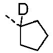 | CD₃ | CD₃ | Ph |
| 1243. | H | H | 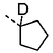 | H | Ph |
| 1244. | CD₃ | H | 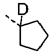 | H | Ph |
| 1245. | H | CD₃ | 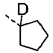 | H | Ph |
| 1246. | H | H | 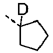 | CD₃ | Ph |
| 1247. | CD₃ | CD₃ | 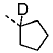 | H | Ph |
| 1248. | CD₃ | H | 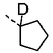 | CD₃ | Ph |
| 1249. | H | CD₃ | 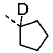 | CD₃ | Ph |
| | | | | | |
|---|---|---|---|---|---|
| 1250. | CD₃ | CD₃ | 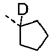 | CD₃ | Ph |
| 1251. | 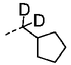 | H | H | H | Ph |
| 1252. | 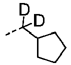 | CD₃ | H | CD₃ | Ph |
| 1253. | 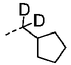 | H | CD₃ | H | Ph |
| 1254. | 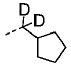 | H | H | CD₃ | Ph |
| 1255. | 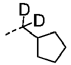 | CD₃ | CD₃ | H | Ph |
| 1256. | 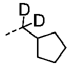 | CD₃ | H | CD₃ | Ph |
| 1257. | 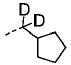 | H | CD₃ | CD₃ | Ph |
| 1258. | 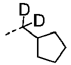 | CD₃ | CD₃ | CD₃ | Ph |
| 1259. | H | 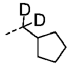 | H | H | Ph |
| 1260. | CH₃ | 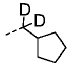 | H | CD₃ | Ph |
| 1261. | H | 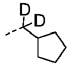 | CD₃ | H | Ph |
| 1262. | H | 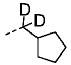 | H | CD₃ | Ph |
| 1263. | CD₃ | 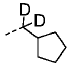 | CD₃ | H | Ph |
| 1264. | CD₃ | 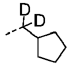 | H | CD₃ | Ph |
| 1265. | H | 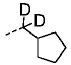 | CD₃ | CD₃ | Ph |
| 1266. | CH₃ | 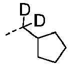 | CD₃ | CD₃ | Ph |
| 1267. | H | H | 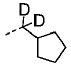 | H | Ph |
| 1268. | CD₃ | H | 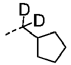 | H | Ph |
| 1269. | H | CD₃ | 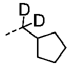 | H | Ph |
| 1270. | H | H | 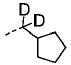 | CD₃ | Ph |
| 1271. | CD₃ | CD₃ | 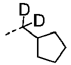 | H | Ph |
| 1272. | CD₃ | H | 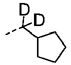 | CD₃ | Ph |
| 1273. | H | CD₃ | 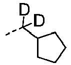 | CD₃ | Ph |
| 1274. | CD₃ | CD₃ | 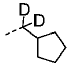 | CD₃ | Ph |
| 1275. | 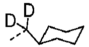 | H | H | H | Ph |
| 1276. | 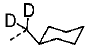 | CD₃ | H | CD₃ | Ph |
| 1277. | 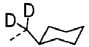 | H | CD₃ | H | Ph |
| 1278. | 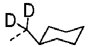 | H | H | CD₃ | Ph |
| 1279. | 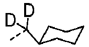 | CD₃ | CD₃ | H | Ph |
| 1280. | 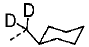 | CD₃ | H | CD₃ | Ph |
| 1281. | 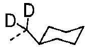 | H | CD₃ | CD₃ | Ph |
| 1282. | 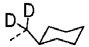 | CD₃ | CD₃ | CD₃ | Ph |
| 1283. | H | 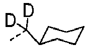 | H | H | Ph |
| 1284. | CD₃ | 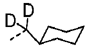 | H | CD₃ | Ph |
| 1285. | H | 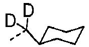 | CD₃ | H | Ph |
| 1286. | H | 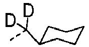 | H | CD₃ | Ph |
| 1287. | CD₃ | 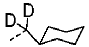 | CD₃ | H | Ph |
| 1288. | CD₃ | 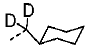 | H | CD₃ | Ph |
| 1289. | H | 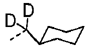 | CD₃ | CD₃ | Ph |
| 1290. | CD₃ | 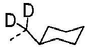 | CD₃ | CD₃ | Ph |
| 1291. | H | H | 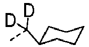 | H | Ph |
| 1292. | CD₃ | H | 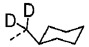 | H | Ph |
| 1293. | H | CD₃ | 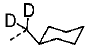 | H | Ph |
| 1294. | H | H | 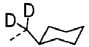 | CD₃ | Ph |
| 1295. | CD₃ | CD₃ | 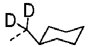 | H | Ph |
| 1296. | CD₃ | H | 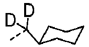 | CD₃ | Ph |
| 1297. | H | CD₃ | 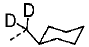 | CD₃ | Ph |
| 1298. | CD₃ | CD₃ | 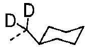 | CD₃ | Ph |
| 1299. | 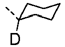 | H | H | H | Ph |
| 1300. | 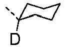 | CD₃ | H | CD₃ | Ph |
| 1301. | 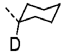 | H | CD₃ | H | Ph |
| 1302. | 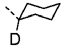 | H | H | CD₃ | Ph |
| 1303. | 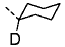 | CD₃ | CD₃ | H | Ph |
| 1304. | 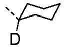 | CD₃ | H | CD₃ | Ph |
| 1305. | 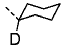 | H | CD₃ | CD₃ | Ph |
| 1306. | 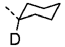 | CD₃ | CD₃ | CD₃ | Ph |
| 1307. | H | 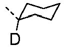 | H | H | Ph |
| 1308. | CD₃ | 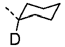 | H | CD₃ | Ph |
| 1309. | H | 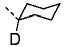 | CD₃ | H | Ph |
| 1310. | H | 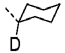 | H | CD₃ | Ph |
| 1311. | CD₃ | 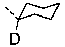 | CD₃ | H | Ph |
| 1312. | CD₃ | 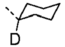 | H | CD₃ | Ph |
| 1313. | H | 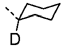 | CD₃ | CD₃ | Ph |
| 1314. | CD₃ | 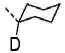 | CD₃ | CD₃ | Ph |
| 1315. | H | H | 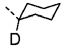 | H | Ph |
| 1316. | CD₃ | H | 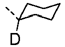 | H | Ph |
| 1317. | H | CD₃ | 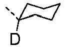 | H | Ph |
| 1318. | H | H | 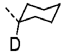 | CD₃ | Ph |
| 1319. | CD₃ | CD₃ | 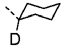 | H | Ph |
| 1320. | CD₃ | H | 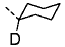 | CD₃ | Ph |
| 1321. | H | CD₃ | 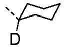 | CD₃ | Ph |
| 1322. | CD₃ | CD₃ | 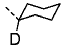 | CD₃ | Ph |
| 1323. | 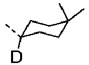 | H | H | H | Ph |
| 1324. | 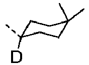 | CD₃ | H | CD₃ | Ph |
| 1325. | 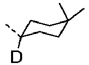 | H | CD₃ | H | Ph |
| 1326. | 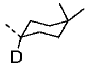 | H | H | CD₃ | Ph |
| 1327. | 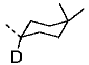 | CD₃ | CD₃ | H | Ph |
| 1328. | 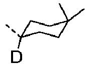 | CD₃ | H | CD₃ | Ph |
| 1329. | 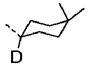 | H | CD₃ | CD₃ | Ph |
| 1330. | 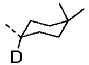 | CD₃ | CD₃ | CD₃ | Ph |
| 1331. | H | 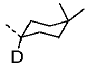 | H | H | Ph |
| 1332. | CD₃ | 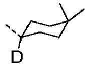 | H | CD₃ | Ph |
| 1333. | H | 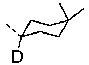 | CD₃ | H | Ph |
| 1334. | H | 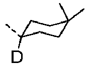 | H | CD₃ | Ph |
| 1335. | CD₃ | 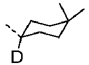 | CD₃ | H | Ph |
| 1336. | CD₃ | 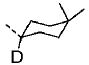 | H | CD₃ | Ph |
| 1337. | H | 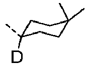 | CD₃ | CD₃ | Ph |
| 1338. | CD₃ | 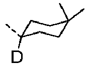 | CD₃ | CD₃ | Ph |
| 1339. | H | H | 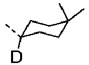 | H | Ph |
| 1340. | CD₃ | H | 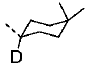 | H | Ph |
| 1341. | H | CD₃ | 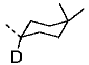 | H | Ph |
| 1342. | H | H | 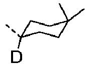 | CD₃ | Ph |
| 1343. | CD₃ | CD₃ | 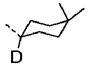 | H | Ph |
| 1344. | CD₃ | H | 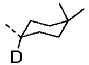 | CD₃ | Ph |
| 1345. | H | CD₃ | 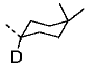 | CD₃ | Ph |
| 1346. | CD₃ | CD₃ | 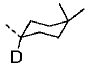 | CD₃ | Ph |
| 1347. | 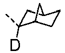 | H | H | H | Ph |
| 1348. | 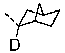 | CD₃ | H | CD₃ | Ph |
| 1349. | 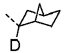 | H | CD₃ | H | Ph |
| 1350. | 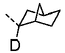 | H | H | CD₃ | Ph |
| 1351. | 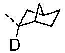 | CH₃ | CH₃ | H | Ph |
| 1352. | 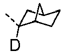 | CD₃ | H | CD₃ | Ph |
| 1353. | 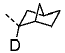 | H | CD₃ | CD₃ | Ph |
| 1354. | 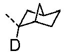 | CD₃ | CD₃ | CD₃ | Ph |
| 1355. | H | 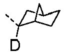 | H | H | Ph |
| 1356. | CD₃ | 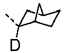 | H | CD₃ | Ph |
| 1357. | H | 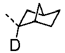 | CD₃ | H | Ph |
| 1358. | H | 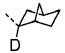 | H | CD₃ | Ph |
| 1359. | CD₃ | 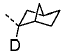 | CD₃ | H | Ph |
| 1360. | CD₃ | 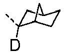 | H | CD₃ | Ph |
| 1361. | H | 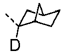 | CD₃ | CD₃ | Ph |
| 1362. | CD₃ | 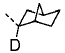 | CD₃ | CD₃ | Ph |
| 1363. | H | H | 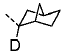 | H | Ph |
| 1364. | CD₃ | H | 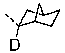 | H | Ph |
| 1365. | H | CD₃ | 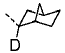 | H | Ph |
| 1366. | H | H | 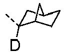 | CH₃ | Ph |
| 1367. | CD₃ | CD₃ | 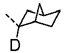 | H | Ph |
| 1368. | CD₃ | H | 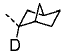 | CD₃ | Ph |
| 1369. | H | CD₃ | 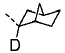 | CD₃ | Ph |
| 1370. | CD₃ | CD₃ | 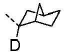 | CD₃ | Ph |
| 1371. | CD(CH₃)₂ | H | CD₂CH₃ | H | Ph |
| 1372. | CD(CH₃)₂ | H | CD(CH₃)₂ | H | Ph |
| 1373. | CD(CH₃)₂ | H | CD₂CH(CH₃)₂ | H | Ph |
| 1374. | CD(CH₃)₂ | H | C(CH₃)₃ | H | Ph |
| 1375. | CD(CH₃)₂ | H | CD₂C(CH₃)₃ | H | Ph |
| 1376. | CD(CH₃)₂ | H | 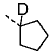 | H | Ph |
| 1377. | CD(CH₃)₂ | H | 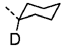 | H | Ph |
| 1378. | CD(CH₃)₂ | H | 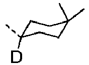 | H | Ph |
| 1379. | CD(CH₃)₂ | H | 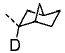 | H | Ph |
| 1380. | CD(CH₃)₂ | H | 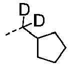 | H | Ph |
| 1381. | CD(CH₃)₂ | H | 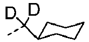 | H | Ph |
| 1382. | C(CH₃)₃ | H | CD₂CH₃ | H | Ph |
| 1383. | C(CH₃)₃ | H | CD(CH₃)₂ | H | Ph |
| 1384. | C(CH₃)₃ | H | CD₂CH(CH₃)₂ | H | Ph |
| 1385. | C(CH₃)₃ | H | C(CH₃)₃ | H | Ph |
| 1386. | C(CH₃)₃ | H | CD₂C(CH₃)₃ | H | Ph |
| 1387. | C(CH₃)₃ | H | 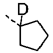 | H | Ph |
| 1388. | C(CH₃)₃ | H | 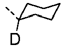 | H | Ph |
| 1389. | C(CH₃)₃ | H | 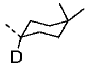 | H | Ph |
| 1390. | C(CH₃)₃ | H | 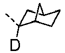 | H | Ph |
| 1391. | C(CH₃)₃ | H | 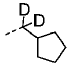 | H | Ph |
| 1392. | C(CH₃)₃ | H | 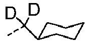 | H | Ph |
| 1393. | CD₂C(CH₃)₃ | H | CD₂CH₃ | H | Ph |
| 1394. | CD₂C(CH₃)₃ | H | CD(CH₃)₂ | H | Ph |
| 1395. | CD₂C(CH₃)₃ | H | CD₂CH(CH₃)₂ | H | Ph |
| 1396. | CD₂C(CH₃)₃ | H | C(CH₃)₃ | H | Ph |
| 1397. | CD₂C(CH₃)₃ | H | CD₂C(CH₃)₃ | H | Ph |
| 1398. | CD₂C(CH₃)₃ | H | 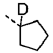 | H | Ph |
| 1399. | CD₂C(CH₃)₃ | H | 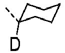 | H | Ph |
| 1400. | CD₂C(CH₃)₃ | H | 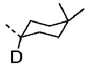 | H | Ph |
| 1401. | CD₂C(CH₃)₃ | H | 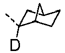 | H | Ph |
| 1402. | CD₂C(CH₃)₃ | H | 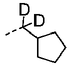 | H | Ph |
| 1403. | CD₂C(CH₃)₃ | H | 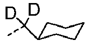 | H | Ph |
| 1404. | 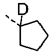 | H | CD₂CH₃ | H | Ph |
| 1405. | 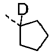 | H | CD(CH₃)₂ | H | Ph |
| 1406. | 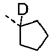 | H | CD₂CH(CH₃)₂ | H | Ph |
| 1407. | 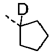 | H | C(CH₃)₃ | H | Ph |
| 1408. | 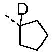 | H | CD₂C(CH₃)₃ | H | Ph |
| 1409. | 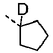 | H | 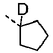 | H | Ph |
| 1410. | 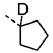 | H | 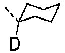 | H | Ph |
| 1411. | 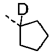 | H | 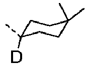 | H | Ph |
| 1412. | 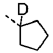 | H | 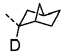 | H | Ph |
| 1413. | 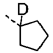 | H | 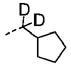 | H | Ph |
| 1414. | 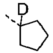 | H | 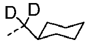 | H | Ph |
| 1415. | 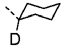 | H | CD₂CH₃ | H | Ph |
| 1416. | 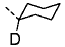 | H | CD(CH₃)₂ | H | Ph |
| 1417. | 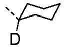 | H | CD₂CH(CH₃)₂ | H | Ph |
| 1418. | 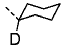 | H | C(CH₃)₃ | H | Ph |
| 1419. | 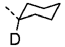 | H | CD₂C(CH₃)₃ | H | Ph |
| 1420. | 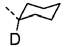 | H | 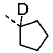 | H | Ph |
| 1421. | 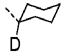 | H | 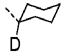 | H | Ph |
| 1422. | 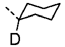 | H | 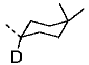 | H | Ph |
| 1423. | 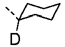 | H | 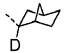 | H | Ph |
| 1424. | 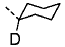 | H | 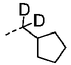 | H | Ph |
| 1425. | 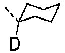 | H | 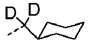 | H | Ph |
| 1426. | 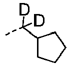 | H | CD₂CH₃ | H | Ph |
| 1427. | 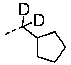 | H | CD(CH₃)₂ | H | Ph |
| 1428. | 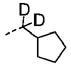 | H | CD₂CH(CH₃)₂ | H | Ph |
| 1429. | 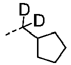 | H | C(CH₃)₃ | H | Ph |
| 1430. | 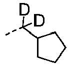 | H | CD₂C(CH₃)₃ | H | Ph |
| 1431. | 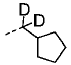 | H | 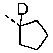 | H | Ph |
| 1432. | 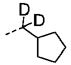 | H | 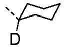 | H | Ph |
| 1433. | 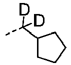 | H | 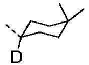 | H | Ph |
| 1434. | 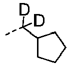 | H | 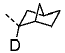 | H | Ph |
| | | | | | |
|---|---|---|---|---|---|
| 1435. | 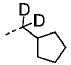 | H | 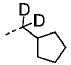 | H | Ph |
| 1436. | 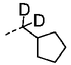 | H | 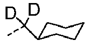 | H | Ph |
| 1437. | 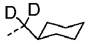 | H | CD₂CH₃ | H | Ph |
| 1438. | 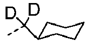 | H | CD(CH₃)₂ | H | Ph |
| 1439. | 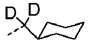 | H | CD₂CH(CH₃)₂ | H | Ph |
| 1440. | 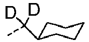 | H | C(CH₃)₃ | H | Ph |
| 1441. | 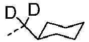 | H | CD₂C(CH₃)₃ | H | Ph |
| 1442. | 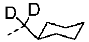 | H | 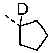 | H | Ph |
| 1443. | 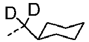 | H | 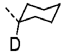 | H | Ph |
| 1444. | 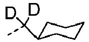 | H | 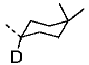 | H | Ph |
| 1445. | 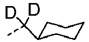 | H | 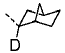 | H | Ph |
| 1446. | 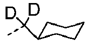 | H | 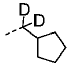 | H | Ph |
| 1447. | 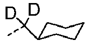 | H | 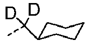 | H | Ph |
| 1448. | 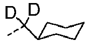 | H | CD₂CH₃ | H | Ph |
| 1449. | 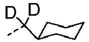 | H | CD(CH₃)₂ | H | Ph |
| 1450. | 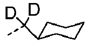 | H | CD₂CH(CH₃)₂ | H | Ph |
| 1451. | 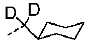 | H | C(CH₃)₃ | H | Ph |
| 1452. | 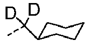 | H | CD₂C(CH₃)₃ | H | Ph |
| 1453. | 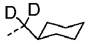 | H | 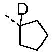 | H | Ph |
| 1454. | 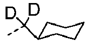 | H | 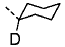 | H | Ph |
| 1455. | 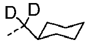 | H | 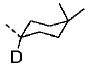 | H | Ph |
| 1456. | 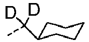 | H | 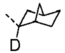 | H | Ph |
| 1457. | 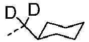 | H | 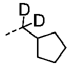 | H | Ph |
| 1458. | 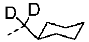 | H | 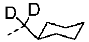 | H | Ph |
| 1459. | H | Ph | CD3 | H | H |
| 1460. | H | 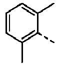 | CD3 | H | H |
| 1461. | H | 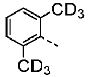 | CD3 | H | H |
| 1462. | H | 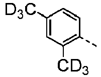 | CD3 | H | H |

8. An organic light emitting device (OLED) comprising:
an anode;
a cathode; and
an organic layer, disposed between the anode and the cathode, comprising a compound according to any of the previous claims.

9. The OLED of claim 8, wherein the organic layer further comprises a host, wherein the host comprises a triphenylene containing benzo-fused thiophene or benzo-fused furan;
wherein any substituent in the host is an unfused substituent independently selected from the group consisting of CₙH₂ₙ₊₁, OCₙH₂ₙ₊₁, OAr_{1,} N(CₙH₂ₙ₊₁)₂, N(Ar₁)(Ar₂), CH=CH-CₙH₂ₙ₊₁, C≡CCₙH₂ₙ₊₁, Ar₁, Ar₁-Ar₂, and CₙH₂ₙ-Ar₁, or the host has no substitutions;
wherein n is from 1 to 10; and
wherein Ar₁ and Ar₂ are each independently selected from the group consisting of benzene, biphenyl, naphthalene, triphenylene, carbazole, and heteroaromatic analogs thereof

10. The OLED of claim 8, wherein the organic layer further comprises a host, wherein host comprises at least one chemical group selected from the group consisting of triphenylene, carbazole, dibenzothiophene, dibenzofuran, dibenzoselenophene, azatriphenylene, azacarbazole, aza-dibenzothiophene, aza-dibenzofuran, and aza-dibenzoselenophene; or the host is selected from the group consisting of: 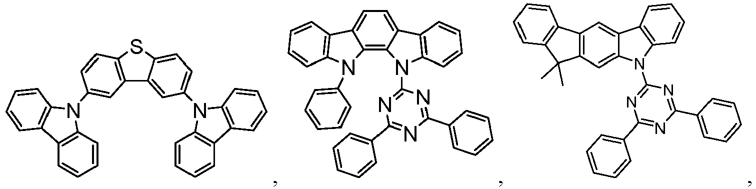 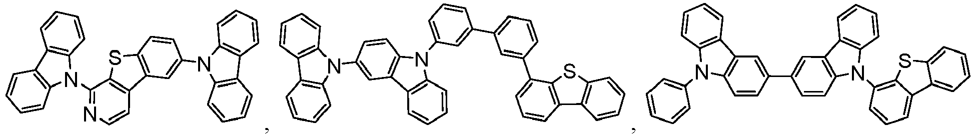 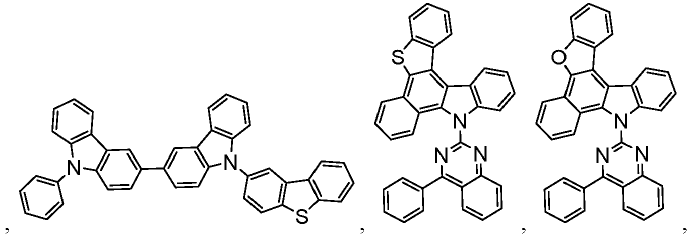 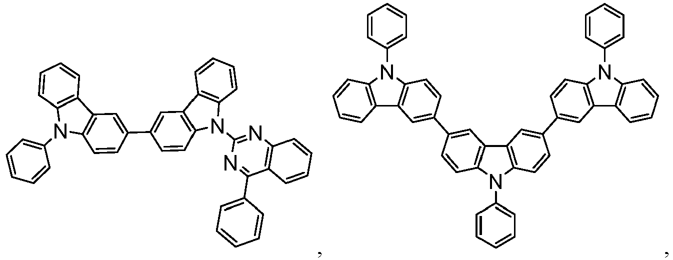 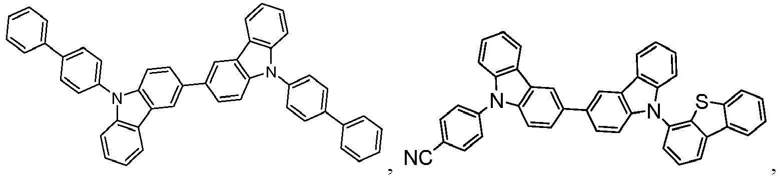 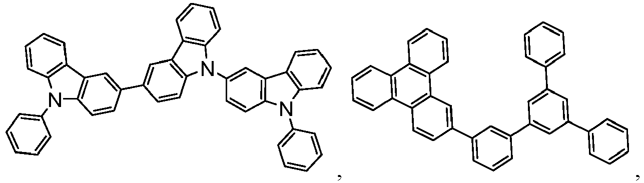 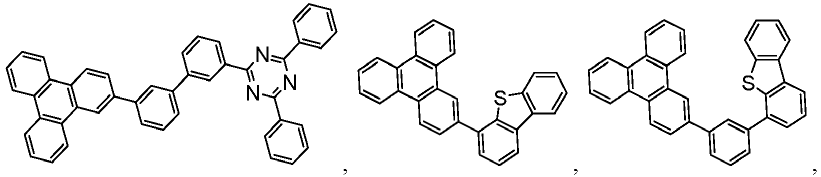 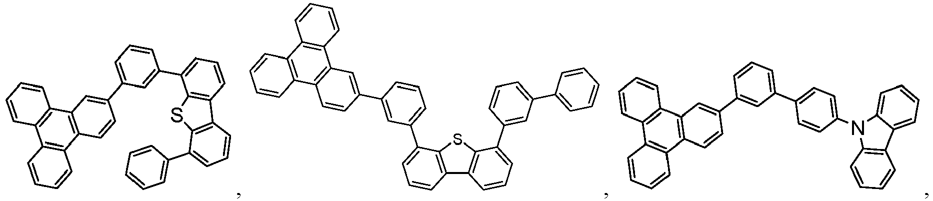 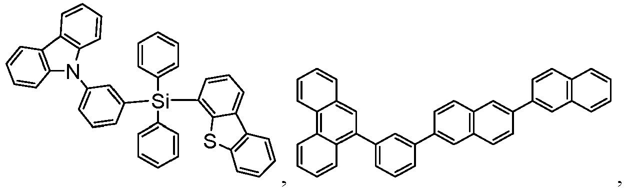 and combinations thereof; or
the host comprises a metal complex.

11. A consumer product comprising an organic light-emitting device (OLED) comprising:
an anode;
a cathode; and
an organic layer, disposed between the anode and the cathode, comprising a compound according to any of claims 1 to 7.

12. The consumer product of claim 11, wherein the consumer product is selected from the group consisting of a flat panel display, a computer monitor, a medical monitor, a television, a billboard, a light for interior or exterior illumination and/or signaling, a heads-up display, a fully or partially transparent display, a flexible display, a laser printer, a telephone, a cell phone, tablet, a phablet, a personal digital assistant (PDA), a wearable device, a laptop computer, a digital camera, a camcorder, a viewfinder, a micro-display that is less than 2 inches diagonal, a 3-D display, a virtual reality or augmented reality display, a vehicle, a video walls comprising multiple displays tiled together, a theater or stadium screen, and a sign.

## Patentansprüche

1. Eine Verbindung mit der Formel Ir(L_{A})(L_{B})(L_{C});
wobei der Ligand L_{A} ist: 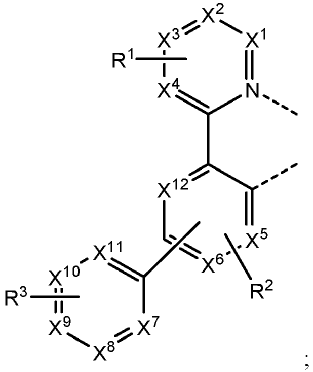 wobei der Ligand L_{B} ist 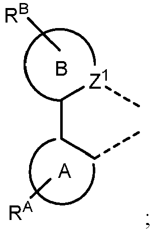
wobei der Ligand L_{C} ist 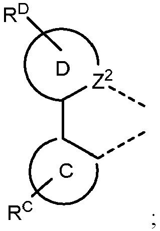
wobei die Ringe A, B, C, und D jeweils unabhängig ein 5- oder 6-gliedriger carbozyklischer oder heterozyklischer Ring sind;
wobei R¹, R², R³, R^{A}, R^{B}, R^{C}, und R^{D} jeweils unabhängig für Mono- bis zu einer maximal möglichen Anzahl von Substitutionen oder keine Substitution stehen;
wobei X¹ bis X¹², Z¹, und Z² jeweils unabhängig voneinander C oder N sind;
wobei L_{A}, L_{B}, und L_{C} voneinander verschieden sind und miteinander verbunden sein können um einen multidentaten Liganden zu bilden;
wobei R¹, R², R³, R^{A}, R^{B}, R^{C}, und R^{D} jeweils unabhängig ausgewählt sind aus der Gruppe bestehend aus Wasserstoff, Deuterium, Halogen, Alkyl, Cycloalkyl, Heteroalkyl, Arylalkyl, Alkoxy, Aryloxy, Amino, Silyl, Alkenyl, Cycloalkenyl, Heteroalkenyl, Alkinyl, Aryl, Heteroaryl, Acyl, Carbonyl, Carbonsäuren, Ester, Nitril, Isonitril, Sulfanyl, Sulfinyl, Sulfonyl, Phosphino, und deren Kombinationen;
wobei zwei oder mehr Substituenten aus R¹, R², R³, R^{A}, R^{B}, R^{C}, und R^{D} gegebenenfalls miteinander zu einem Ring verknüpft oder fusioniert sein können; und
wobei mindestens einer von R^{A}, R^{B}, R^{C}, und R^{D} ausgewählt ist aus der Gruppe bestehend aus Alkyl, Cycloalkyl, Aryl, Heteroaryl, teilweise oder vollständig deuterierte Varianten davon, teilweise oder vollständig fluorierte Varianten davon, und Kombinationen davon.

2. Die Verbindung nach Anspruch 1, wobei die Ringe A und C Benzol sind, und die Ringe B und D Pyridin.

3. Die Verbindung nach Anspruch 1, wobei die Ringe A, B, C, und D jeweils unabhängig ausgewählt sind aus der Gruppe bestehend ausPhenyl, Pyridin, Imidazol und von Imidazol abgeleitetes Carben.

4. Die Verbindung nach Anspruch 1, wobei Z¹ und Z² N sind.

5. Die Verbindung nach Anspruch 1, wobei der Ligand L_{A} 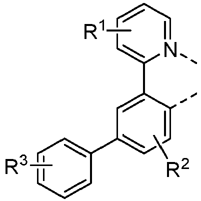 ist.

6. Die Verbindung nach Anspruch 1, wobei die Verbindung ausgewählt ist aus der Gruppe bestehend aus: 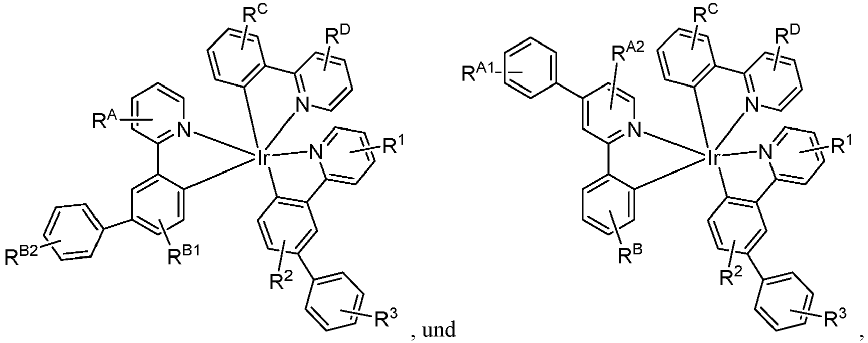
R^{A1} und R^{A2} haben die gleiche Definition wie R^{A}; und
R^{B1} und R^{B2} haben die gleiche Definition wie R^{B}.

7. Die Verbindung nach Anspruch 1, wobei mindestens einer von L_{B} und L_{C} ausgewählt ist aus der Gruppe bestehend aus:
L*ᵢ*, wobei L*ᵢ* 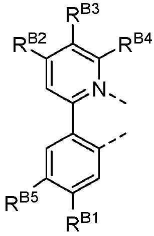 ist, wobei für jedes *i* von 1 bis 1462, R^{B1}, R^{B2}, R^{B3}, R^{B4} und R^{B5} wie folgt definiert sind:
| ***i* in L*i*** | **R^{B1}** | **R^{B2}** | **R^{B3}** | **R^{B4}** | **R^{B5}** |
|---|---|---|---|---|---|
| 1. | H | H | H | H | H |
| 2. | CH₃ | H | H | H | H |
| 3. | H | CH₃ | H | H | H |
| 4. | H | H | CH₃ | H | H |
| 5. | CH₃ | CH₃ | H | CH₃ | H |
| 6. | CH₃ | H | CH₃ | H | H |
| 7. | CH₃ | H | H | CH₃ | H |
| 8. | H | CH₃ | CH₃ | H | H |
| 9. | H | CH₃ | H | CH₃ | H |
| 10. | H | H | CH₃ | CH₃ | H |
| 11. | CH₃ | CH₃ | CH₃ | H | H |
| 12. | CH₃ | CH₃ | H | CH₃ | H |
| 13. | CH₃ | H | CH₃ | CH₃ | H |
| 14. | H | CH₃ | CH₃ | CH₃ | H |
| 15. | CH₃ | CH₃ | CH₃ | CH₃ | H |
| 16. | CH₂CH₃ | H | H | H | H |
| 17. | CH₂CH₃ | CH₃ | H | CH₃ | H |
| 18. | CH₂CH₃ | H | CH₃ | H | H |
| 19. | CH₂CH₃ | H | H | CH₃ | H |
| 20. | CH₂CH₃ | CH₃ | CH₃ | H | H |
| 21. | CH₂CH₃ | CH₃ | H | CH₃ | H |
| 22. | CH₂CH₃ | H | CH₃ | CH₃ | H |
| 23. | CH₂CH₃ | CH₃ | CH₃ | CH₃ | H |
| 24. | H | CH₂CH₃ | H | H | H |
| 25. | CH₃ | CH₂CH₃ | H | CH₃ | H |
| 26. | H | CH₂CH₃ | CH₃ | H | H |
| 27. | H | CH₂CH₃ | H | CH₃ | H |
| 28. | CH₃ | CH₂CH₃ | CH₃ | H | H |
| 29. | CH₃ | CH₂CH₃ | H | CH₃ | H |
| 30. | H | CH₂CH₃ | CH₃ | CH₃ | H |
| 31. | CH₃ | CH₂CH₃ | CH₃ | CH₃ | H |
| 32. | H | H | CH₂CH₃ | H | H |
| 33. | CH₃ | H | CH₂CH₃ | H | H |
| 34. | H | CH₃ | CH₂CH₃ | H | H |
| 35. | H | H | CH₂CH₃ | CH₃ | H |
| 36. | CH₃ | CH₃ | CH₂CH₃ | H | H |
| 37. | CH₃ | H | CH₂CH₃ | CH₃ | H |
| 38. | H | CH₃ | CH₂CH₃ | CH₃ | H |
| 39. | CH₃ | CH₃ | CH₂CH₃ | CH₃ | H |
| 40. | CH(CH₃)₂ | H | H | H | H |
| 41. | CH(CH₃)₂ | CH₃ | H | CH₃ | H |
| 42. | CH(CH₃)₂ | H | CH₃ | H | H |
| 43. | CH(CH₃)₂ | H | H | CH₃ | H |
| 44. | CH(CH₃)₂ | CH₃ | CH₃ | H | H |
| 45. | CH(CH₃)₂ | CH₃ | H | CH₃ | H |
| 46. | CH(CH₃)₂ | H | CH₃ | CH₃ | H |
| 47. | CH(CH₃)₂ | CH₃ | CH₃ | CH₃ | H |
| 48. | H | CH(CH₃)₂ | H | H | H |
| 49. | CH₃ | CH(CH₃)₂ | H | CH₃ | H |
| 50. | H | CH(CH₃)₂ | CH₃ | H | H |
| 51. | H | CH(CH₃)₂ | H | CH₃ | H |
| 52. | CH₃ | CH(CH₃)₂ | CH₃ | H | H |
| 53. | CH₃ | CH(CH₃)₂ | H | CH₃ | H |
| 54. | H | CH(CH₃)₂ | CH₃ | CH₃ | H |
| 55. | CH₃ | CH(CH₃)₂ | CH₃ | CH₃ | H |
| 56. | H | H | CH(CH₃)₂ | H | H |
| 57. | CH₃ | H | CH(CH₃)₂ | H | H |
| 58. | H | CH₃ | CH(CH₃)₂ | H | H |
| 59. | H | H | CH(CH₃)₂ | CH₃ | H |
| 60. | CH₃ | CH₃ | CH(CH₃)₂ | H | H |
| 61. | CH₃ | H | CH(CH₃)₂ | CH₃ | H |
| 62. | H | CH₃ | CH(CH₃)₂ | CH₃ | H |
| 63. | CH₃ | CH₃ | CH(CH₃)₂ | CH₃ | H |
| 64. | CH₂CH(CH₃)₂ | H | H | H | H |
| 65. | CH₂CH(CH₃)₂ | CH₃ | H | CH₃ | H |
| 66. | CH₂CH(CH₃)₂ | H | CH₃ | H | H |
| 67. | CH₂CH(CH₃)₂ | H | H | CH₃ | H |
| 68. | CH₂CH(CH₃)₂ | CH₃ | CH₃ | H | H |
| 69. | CH₂CH(CH₃)₂ | CH₃ | H | CH₃ | H |
| 70. | CH₂CH(CH₃)₂ | H | CH₃ | CH₃ | H |
| 71. | CH₂CH(CH₃)₂ | CH₃ | CH₃ | CH₃ | H |
| 72. | H | CH₂CH(CH₃)₂ | H | H | H |
| 73. | CH₃ | CH₂CH(CH₃)₂ | H | CH₃ | H |
| 74. | H | CH₂CH(CH₃)₂ | CH₃ | H | H |
| 75. | H | CH₂CH(CH₃)₂ | H | CH₃ | H |
| 76. | CH₃ | CH₂CH(CH₃)₂ | CH₃ | H | H |
| 77. | CH₃ | CH₂CH(CH₃)₂ | H | CH₃ | H |
| 78. | H | CH₂CH(CH₃)₂ | CH₃ | CH₃ | H |
| 79. | CH₃ | CH₂CH(CH₃)₂ | CH₃ | CH₃ | H |
| 80. | H | H | CH₂CH(CH₃)₂ | H | H |
| 81. | CH₃ | H | CH₂CH(CH₃)₂ | H | H |
| 82. | H | CH₃ | CH₂CH(CH₃)₂ | H | H |
| 83. | H | H | CH₂CH(CH₃)₂ | CH₃ | H |
| 84. | CH₃ | CH₃ | CH₂CH(CH₃)₂ | H | H |
| 85. | CH₃ | H | CH₂CH(CH₃)₂ | CH₃ | H |
| 86. | H | CH₃ | CH₂CH(CH₃)₂ | CH₃ | H |
| 87. | CH₃ | CH₃ | CH₂CH(CH₃)₂ | CH₃ | H |
| 88. | C(CH₃)₃ | H | H | H | H |
| 89. | C(CH₃)₃ | CH₃ | H | CH₃ | H |
| 90. | C(CH₃)₃ | H | CH₃ | H | H |
| 91. | C(CH₃)₃ | H | H | CH₃ | H |
| 92. | C(CH₃)₃ | CH₃ | CH₃ | H | H |
| 93. | C(CH₃)₃ | CH₃ | H | CH₃ | H |
| 94. | C(CH₃)₃ | H | CH₃ | CH₃ | H |
| 95. | C(CH₃)₃ | CH₃ | CH₃ | CH₃ | H |
| 96. | H | C(CH₃)₃ | H | H | H |
| 97. | CH₃ | C(CH₃)₃ | H | CH₃ | H |
| 98. | H | C(CH₃)₃ | CH₃ | H | H |
| 99. | H | C(CH₃)₃ | H | CH₃ | H |
| 100. | CH₃ | C(CH₃)₃ | CH₃ | H | H |
| 101. | CH₃ | C(CH₃)₃ | H | CH₃ | H |
| 102. | H | C(CH₃)₃ | CH₃ | CH₃ | H |
| 103. | CH₃ | C(CH₃)₃ | CH₃ | CH₃ | H |
| 104. | H | H | C(CH₃)₃ | H | H |
| 105. | CH₃ | H | C(CH₃)₃ | H | H |
| 106. | H | CH₃ | C(CH₃)₃ | H | H |
| 107. | H | H | C(CH₃)₃ | CH₃ | H |
| 108. | CH₃ | CH₃ | C(CH₃)₃ | H | H |
| 109. | CH₃ | H | C(CH₃)₃ | CH₃ | H |
| 110. | H | CH₃ | C(CH₃)₃ | CH₃ | H |
| 111. | CH₃ | CH₃ | C(CH₃)₃ | CH₃ | H |
| 112. | CH₂C(CH₃)₃ | H | H | H | H |
| 113. | CH₂C(CH₃)₃ | CH₃ | H | CH₃ | H |
| 114. | CH₂C(CH₃)₃ | H | CH₃ | H | H |
| 115. | CH₂C(CH₃)₃ | H | H | CH₃ | H |
| 116. | CH₂C(CH₃)₃ | CH₃ | CH₃ | H | H |
| 117. | CH₂C(CH₃)₃ | CH₃ | H | CH₃ | H |
| 118. | CH₂C(CH₃)₃ | H | CH₃ | CH₃ | H |
| 119. | CH₂C(CH₃)₃ | CH₃ | CH₃ | CH₃ | H |
| 120. | H | CH₂C(CH₃)₃ | H | H | H |
| 121. | CH₃ | CH₂C(CH₃)₃ | H | CH₃ | H |
| 122. | H | CH₂C(CH₃)₃ | CH₃ | H | H |
| 123. | H | CH₂C(CH₃)₃ | H | CH₃ | H |
| 124. | CH₃ | CH₂C(CH₃)₃ | CH₃ | H | H |
| 125. | CH₃ | CH₂C(CH₃)₃ | H | CH₃ | H |
| 126. | H | CH₂C(CH₃)₃ | CH₃ | CH₃ | H |
| 127. | CH₃ | CH₂C(CH₃)₃ | CH₃ | CH₃ | H |
| 128. | H | H | CH₂C(CH₃)₃ | H | H |
| 129. | CH₃ | H | CH₂C(CH₃)₃ | H | H |
| 130. | H | CH₃ | CH₂C(CH₃)₃ | H | H |
| 131. | H | H | CH₂C(CH₃)₃ | CH₃ | H |
| 132. | CH₃ | CH₃ | CH₂C(CH₃)₃ | H | H |
| 133. | CH₃ | H | CH₂C(CH₃)₃ | CH₃ | H |
| 134. | H | CH₃ | CH₂C(CH₃)₃ | CH₃ | H |
| 135. | CH₃ | CH₃ | CH₂C(CH₃)₃ | CH₃ | H |
| 136. | 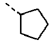 | H | H | H | H |
| 137. | 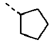 | CH₃ | H | CH₃ | H |
| 138. | 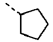 | H | CH₃ | H | H |
| 139. | 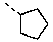 | H | H | CH₃ | H |
| 140. | 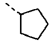 | CH₃ | CH₃ | H | H |
| 141. | 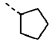 | CH₃ | H | CH₃ | H |
| 142. | 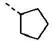 | H | CH₃ | CH₃ | H |
| 143. | 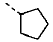 | CH₃ | CH₃ | CH₃ | H |
| 144. | H | 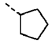 | H | H | H |
| 145. | CH₃ | 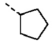 | H | CH₃ | H |
| 146. | H | 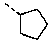 | CH₃ | H | H |
| 147. | H | 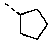 | H | CH₃ | H |
| 148. | CH₃ | 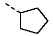 | CH₃ | H | H |
| 149. | CH₃ | 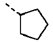 | H | CH₃ | H |
| 150. | H | 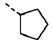 | CH₃ | CH₃ | H |
| 151. | CH₃ | 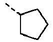 | CH₃ | CH₃ | H |
| 152. | H | H | 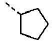 | H | H |
| 153. | CH₃ | H | 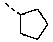 | H | H |
| 154. | H | CH₃ | 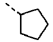 | H | H |
| 155. | H | H | 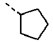 | CH₃ | H |
| 156. | CH₃ | CH₃ | 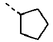 | H | H |
| 157. | CH₃ | H | 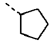 | CH₃ | H |
| 158. | H | CH₃ | 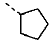 | CH₃ | H |
| 159. | CH₃ | CH₃ | 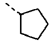 | CH₃ | H |
| 160. | 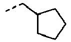 | H | H | H | H |
| 161. | 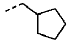 | CH₃ | H | CH₃ | H |
| 162. | 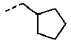 | H | CH₃ | H | H |
| 163. | 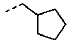 | H | H | CH₃ | H |
| 164. | 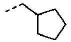 | CH₃ | CH₃ | H | H |
| 165. | 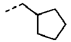 | CH₃ | H | CH₃ | H |
| 166. | 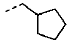 | H | CH₃ | CH₃ | H |
| 167. | 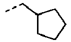 | CH₃ | CH₃ | CH₃ | H |
| 168. | H | 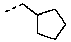 | H | H | H |
| 169. | CH₃ | 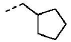 | H | CH₃ | H |
| 170. | H | 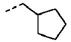 | CH₃ | H | H |
| 171. | H | 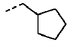 | H | CH₃ | H |
| 172. | CH₃ | 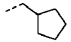 | CH₃ | H | H |
| 173. | CH₃ | 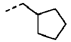 | H | CH₃ | H |
| 174. | H | 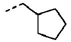 | CH₃ | CH₃ | H |
| 175. | CH₃ | 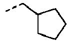 | CH₃ | CH₃ | H |
| 176. | H | H | 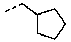 | H | H |
| 177. | CH₃ | H | 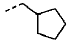 | H | H |
| 178. | H | CH₃ | 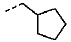 | H | H |
| 179. | H | H | 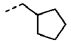 | CH₃ | H |
| 180. | CH₃ | CH₃ | 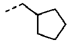 | H | H |
| 181. | CH₃ | H | 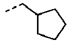 | CH₃ | H |
| 182. | H | CH₃ | 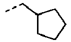 | CH₃ | H |
| 183. | CH₃ | CH₃ | 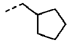 | CH₃ | H |
| 184. | 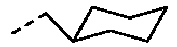 | H | H | H | H |
| 185. | 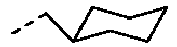 | CH₃ | H | CH₃ | H |
| 186. | 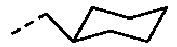 | H | CH₃ | H | H |
| 187. | 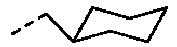 | H | H | CH₃ | H |
| 188. | 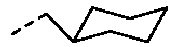 | CH₃ | CH₃ | H | H |
| 189. | 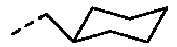 | CH₃ | H | CH₃ | H |
| 190. | 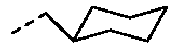 | H | CH₃ | CH₃ | H |
| 191. | 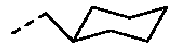 | CH₃ | CH₃ | CH₃ | H |
| 192. | H | 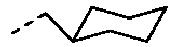 | H | H | H |
| 193. | CH₃ | 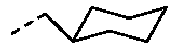 | H | CH₃ | H |
| 194. | H | 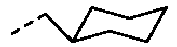 | CH₃ | H | H |
| 195. | H | 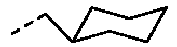 | H | CH₃ | H |
| 196. | CH₃ | 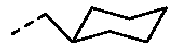 | CH₃ | H | H |
| 197. | CH₃ | 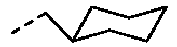 | H | CH₃ | H |
| 198. | H | 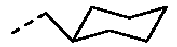 | CH₃ | CH₃ | H |
| 199. | CH₃ | 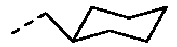 | CH₃ | CH₃ | H |
| 200. | H | H | 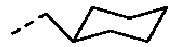 | H | H |
| 201. | CH₃ | H | 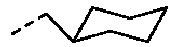 | H | H |
| 202. | H | CH₃ | 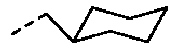 | H | H |
| 203. | H | H | 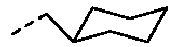 | CH₃ | H |
| 204. | CH₃ | CH₃ | 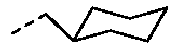 | H | H |
| 205. | CH₃ | H | 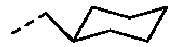 | CH₃ | H |
| 206. | H | CH₃ | 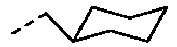 | CH₃ | H |
| 207. | CH₃ | CH₃ | 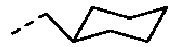 | CH₃ | H |
| 208. | 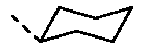 | H | H | H | H |
| 209. | 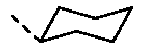 | CH₃ | H | CH₃ | H |
| 210. | 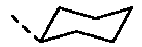 | H | CH₃ | H | H |
| 211. | 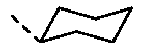 | H | H | CH₃ | H |
| 212. | 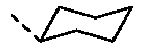 | CH₃ | CH₃ | H | H |
| 213. | 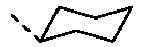 | CH₃ | H | CH₃ | H |
| 214. | 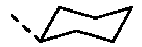 | H | CH₃ | CH₃ | H |
| 215. | 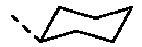 | CH₃ | CH₃ | CH₃ | H |
| 216. | H | 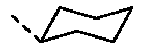 | H | H | H |
| 217. | CH₃ | 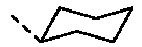 | H | CH₃ | H |
| 218. | H | 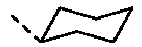 | CH₃ | H | H |
| 219. | H | 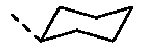 | H | CH₃ | H |
| 220. | CH₃ | 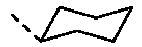 | CH₃ | H | H |
| 221. | CH₃ | 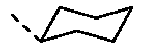 | H | CH₃ | H |
| 222. | H | 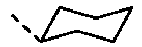 | CH₃ | CH₃ | H |
| 223. | CH₃ | 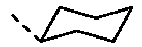 | 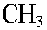 | CH₃ | H |
| 224. | H | H | 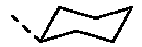 | H | H |
| 225. | CH₃ | H | 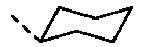 | H | H |
| 226. | H | CH₃ | 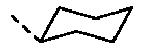 | H | H |
| 227. | H | H | 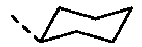 | CH₃ | H |
| 228. | CH₃ | CH₃ | 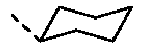 | H | H |
| 229. | CH₃ | H | 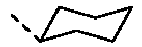 | CH₃ | H |
| 230. | H | CH₃ | 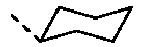 | CH₃ | H |
| 231. | CH₃ | CH₃ | 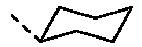 | CH₃ | H |
| 232. | 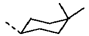 | H | H | H | H |
| 233. | 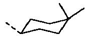 | CH₃ | H | CH₃ | H |
| 234. | 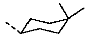 | H | CH₃ | H | H |
| 235. | 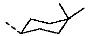 | H | H | CH₃ | H |
| 236. | 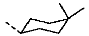 | CH₃ | CH₃ | H | H |
| 237. | 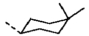 | CH₃ | H | CH₃ | H |
| 238. | 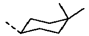 | H | CH₃ | CH₃ | H |
| 239. | 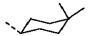 | CH₃ | CH₃ | CH₃ | H |
| 240. | H | 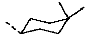 | H | H | H |
| 241. | CH₃ | 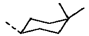 | H | CH₃ | H |
| 242. | H | 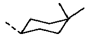 | CH₃ | H | H |
| 243. | H | 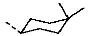 | H | CH₃ | H |
| 244. | CH₃ | 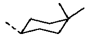 | CH₃ | H | H |
| 245. | CH₃ | 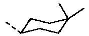 | H | CH₃ | H |
| 246. | H | 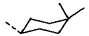 | CH₃ | CH₃ | H |
| 247. | CH₃ | 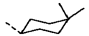 | CH₃ | CH₃ | H |
| 248. | H | H | 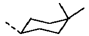 | H | H |
| 249. | CH₃ | H | 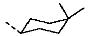 | H | H |
| 250. | H | CH₃ | 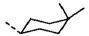 | H | H |
| 251. | H | H | 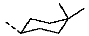 | CH₃ | H |
| 252. | CH₃ | CH₃ | 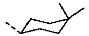 | H | H |
| 253. | CH₃ | H | 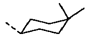 | CH₃ | H |
| 254. | H | CH₃ | 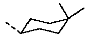 | CH₃ | H |
| 255. | CH₃ | CH₃ | 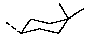 | CH₃ | H |
| 256. | 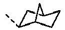 | H | H | H | H |
| 257. | 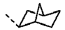 | CH₃ | H | CH₃ | H |
| 258. | 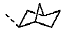 | H | CH₃ | H | H |
| 259. | 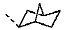 | H | H | CH₃ | H |
| 260. | 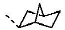 | CH₃ | CH₃ | H | H |
| 261. | 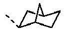 | CH₃ | H | CH₃ | H |
| 262. | 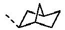 | H | CH₃ | CH₃ | H |
| 263. | 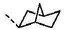 | CH₃ | CH₃ | CH₃ | H |
| 264. | H | 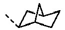 | H | H | H |
| 265. | CH₃ | 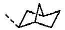 | H | CH₃ | H |
| 266. | H | 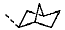 | CH₃ | H | H |
| 267. | H | 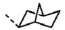 | H | CH₃ | H |
| 268. | CH₃ | 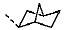 | CH₃ | H | H |
| 269. | CH₃ | 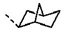 | H | CH₃ | H |
| 270. | H | 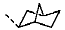 | CH₃ | CH₃ | H |
| 271. | CH₃ | 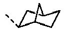 | CH₃ | CH₃ | H |
| 272. | H | H | 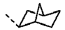 | H | H |
| 273. | CH₃ | H | 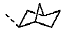 | H | H |
| 274. | H | CH₃ | 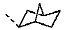 | H | H |
| 275. | H | H | 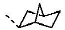 | CH₃ | H |
| 276. | CH₃ | CH₃ | 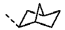 | H | H |
| 277. | CH₃ | H | 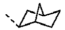 | CH₃ | H |
| 278. | H | CH₃ | 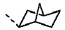 | CH₃ | H |
| 279. | CH₃ | CH₃ | 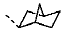 | CH₃ | H |
| 280. | CH(CH₃)₂ | H | CH₂CH₃ | H | H |
| 281. | CH(CH₃)₂ | H | CH(CH₃)₂ | H | H |
| 282. | CH(CH₃)₂ | H | CH₂CH(CH₃)₂ | H | H |
| 283. | CH(CH₃)₂ | H | C(CH₃)₃ | H | H |
| 284. | CH(CH₃)₂ | H | CH₂C(CH₃)₃ | H | H |
| 285. | CH(CH₃)₂ | H | 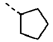 | H | H |
| 286. | CH(CH₃)₂ | H | 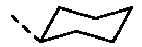 | H | H |
| 287. | CH(CH₃)₂ | H | 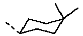 | H | H |
| 288. | CH(CH₃)₂ | H | 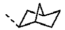 | H | H |
| 289. | CH(CH₃)₂ | H | 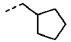 | H | H |
| 290. | CH(CH₃)₂ | H | 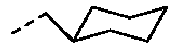 | H | H |
| 291. | C(CH₃)₃ | H | CH₂CH₃ | H | H |
| 292. | C(CH₃)₃ | H | CH(CH₃)₂ | H | H |
| 293. | C(CH₃)₃ | H | CH₂CH(CH₃)₂ | H | H |
| 294. | C(CH₃)₃ | H | C(CH₃)₃ | H | H |
| 295. | C(CH₃)₃ | H | CH₂C(CH₃)₃ | H | H |
| 296. | C(CH₃)₃ | H | 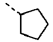 | H | H |
| 297. | C(CH₃)₃ | H | 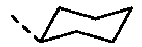 | H | H |
| 298. | C(CH₃)₃ | H | 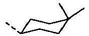 | H | H |
| 299. | C(CH₃)₃ | H | 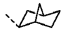 | H | H |
| 300. | C(CH₃)₃ | H | 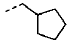 | H | H |
| 301. | C(CH₃)₃ | H | 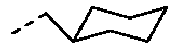 | H | H |
| 302. | CH₂C(CH₃)₃ | H | CH₂CH₃ | H | H |
| 303. | CH₂C(CH₃)₃ | H | CH(CH₃)₂ | H | H |
| 304. | CH₂C(CH₃)₃ | H | CH₂CH(CH₃)₂ | H | H |
| 305. | CH₂C(CH₃)₃ | H | C(CH₃)₃ | H | H |
| 306. | CH₂C(CH₃)₃ | H | CH₂C(CH₃)₃ | H | H |
| 307. | CH₂C(CH₃)₃ | H | CH₂CH₂CF₃ | H | H |
| 308. | CH₂C(CH₃)₃ | H | CH₂C(CH₃)₂CF₃ | H | H |
| 309. | CH₂C(CH₃)₃ | H | 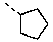 | H | H |
| 310. | CH₂C(CH₃)₃ | H | 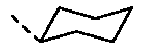 | H | H |
| 311. | CH₂C(CH₃)₃ | H | 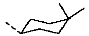 | H | H |
| 312. | CH₂C(CH₃)₃ | H | 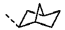 | H | H |
| 313. | CH₂C(CH₃)₃ | H | 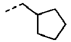 | H | H |
| 314. | CH₂C(CH₃)₃ | H | 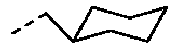 | H | H |
| 315. | 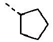 | H | CH₂CH₃ | H | H |
| 316. | 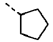 | H | CH(CH₃)₂ | H | H |
| 317. | 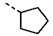 | H | CH₂CH(CH₃)₂ | H | H |
| 318. | 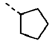 | H | C(CH₃)₃ | H | H |
| 319. | 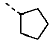 | H | CH₂C(CH₃)₃ | H | H |
| 320. | 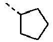 | H | 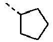 | H | H |
| 321. | 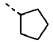 | H | 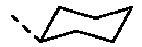 | H | H |
| 322. | 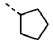 | H | 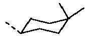 | H | H |
| 323. | 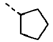 | H | 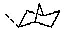 | H | H |
| 324. | 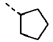 | H | 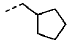 | H | H |
| 325. | 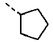 | H | 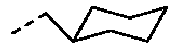 | H | H |
| 326. | 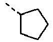 | H | CH₂CH₃ | H | H |
| 327. | 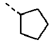 | H | CH(CH₃)₂ | H | H |
| 328. | 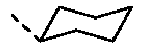 | H | CH₂CH(CH₃)₂ | H | H |
| 329. | 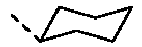 | H | C(CH₃)₃ | H | H |
| 330. | 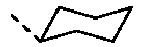 | H | CH₂C(CH₃)₃ | H | H |
| 331. | 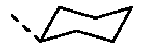 | H | 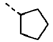 | H | H |
| 332. | 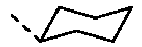 | H | 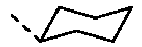 | H | H |
| 333. | 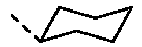 | H | 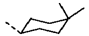 | H | H |
| 334. | 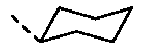 | H | 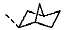 | H | H |
| 335. | 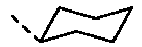 | H | 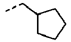 | H | H |
| 336. | 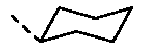 | H | 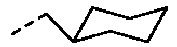 | H | H |
| 337. | 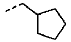 | H | CH₂CH(CH₃)₂ | H | H |
| 338. | 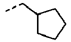 | H | C(CH₃)₃ | H | H |
| 339. | 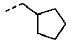 | H | CH₂C(CH₃)₃ | H | H |
| 340. | 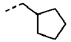 | H | 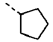 | H | H |
| 341. | 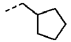 | H | 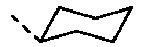 | H | H |
| 342. | 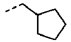 | H | 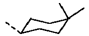 | H | H |
| 343. | 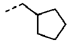 | H | 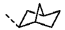 | H | H |
| 344. | 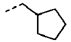 | H | 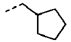 | H | H |
| 345. | 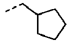 | H | 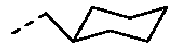 | H | H |
| 346. | 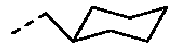 | H | CH₂CH(CH₃)₂ | H | H |
| 347. | 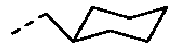 | H | C(CH₃)₃ | H | H |
| 348. | 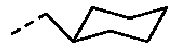 | H | CH₂C(CH₃)₃ | H | H |
| 349. | 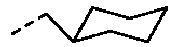 | H | 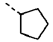 | H | H |
| 350. | 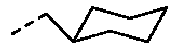 | H | 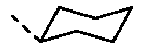 | H | H |
| 351. | 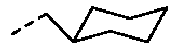 | H | 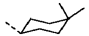 | H | H |
| 352. | 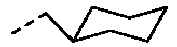 | H | 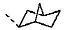 | H | H |
| 353. | 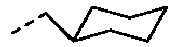 | H | 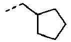 | H | H |
| 354. | 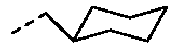 | H | 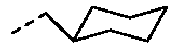 | H | H |
| 355. | 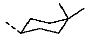 | H | CH₂CH(CH₃)₂ | H | H |
| 356. | 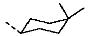 | H | C(CH₃)₃ | H | H |
| 357. | 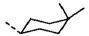 | H | CH₂C(CH₃)₃ | H | H |
| 358. | 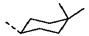 | H | 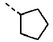 | H | H |
| 359. | 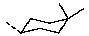 | H | 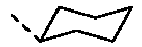 | H | H |
| 360. | 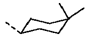 | H | 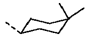 | H | H |
| 361. | 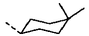 | H | 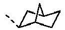 | H | H |
| 362. | 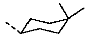 | H | 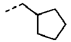 | H | H |
| 363. | 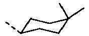 | H | 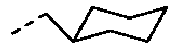 | H | H |
| 364. | H | H | H | H | H |
| 365. | CD₃ | H | H | H | H |
| 366. | H | CD₃ | H | H | H |
| 367. | H | H | CD₃ | H | H |
| 368. | CD₃ | CD₃ | H | CD₃ | H |
| 369. | CD₃ | H | CD₃ | H | H |
| 370. | CD₃ | H | H | CD₃ | H |
| 371. | H | CD₃ | CD₃ | H | H |
| 372. | H | CD₃ | H | CD₃ | H |
| 373. | H | H | CD₃ | CD₃ | H |
| 374. | CD₃ | CD₃ | CD₃ | H | H |
| 375. | CD₃ | CD₃ | H | CD₃ | H |
| 376. | CD₃ | H | CD₃ | CD₃ | H |
| 377. | H | CD₃ | CD₃ | CD₃ | H |
| 378. | CD₃ | CD₃ | CD₃ | CD₃ | H |
| 379. | CD₂CH₃ | H | H | H | H |
| 380. | CD₂CH₃ | CD₃ | H | CD₃ | H |
| 381. | CD₂CH₃ | H | CD₃ | H | H |
| 382. | CD₂CH₃ | H | H | CD₃ | H |
| 383. | CD₂CH₃ | CD₃ | CD₃ | H | H |
| 384. | CD₂CH₃ | CD₃ | H | CD₃ | H |
| 385. | CD₂CH₃ | H | CD₃ | CD₃ | H |
| 386. | CD₂CH₃ | CD₃ | CD₃ | CD₃ | H |
| 387. | H | CD₂CH₃ | H | H | H |
| 388. | CH₃ | CD₂CH₃ | H | CD₃ | H |
| 389. | H | CD₂CH₃ | CD₃ | H | H |
| 390. | H | CD₂CH₃ | H | CD₃ | H |
| 391. | CD₃ | CD₂CH₃ | CD₃ | H | H |
| 392. | CD₃ | CD₂CH₃ | H | CD₃ | H |
| 393. | H | CD₂CH₃ | CD₃ | CD₃ | H |
| 394. | CD₃ | CD₂CH₃ | CD₃ | CD₃ | H |
| 395. | H | H | CD₂CH₃ | H | H |
| 396. | CD₃ | H | CD₂CH₃ | H | H |
| 397. | H | CD₃ | CD₂CH₃ | H | H |
| 398. | H | H | CD₂CH₃ | CD₃ | H |
| 399. | CD₃ | CD₃ | CD₂CH₃ | H | H |
| 400. | CD₃ | H | CD₂CH₃ | CD₃ | H |
| 401. | H | CD₃ | CD₂CH₃ | CD₃ | H |
| 402. | CD₃ | CD₃ | CD₂CH₃ | CD₃ | H |
| 403. | CD(CH₃)₂ | H | H | H | H |
| 404. | CD(CH₃)₂ | CD₃ | H | CD₃ | H |
| 405. | CD(CH₃)₂ | H | CD₃ | H | H |
| 406. | CD(CH₃)₂ | H | H | CD₃ | H |
| 407. | CD(CH₃)₂ | CD₃ | CD₃ | H | H |
| 408. | CD(CH₃)₂ | CD₃ | H | CD₃ | H |
| 409. | CD(CH₃)₂ | H | CD₃ | CD₃ | H |
| 410. | CD(CH₃)₂ | CD₃ | CD₃ | CD₃ | H |
| 411. | H | CD(CH₃)₂ | H | H | H |
| 412. | CD₃ | CD(CH₃)₂ | H | CD₃ | H |
| 413. | H | CD(CH₃)₂ | CD₃ | H | H |
| 414. | H | CD(CH₃)₂ | H | CD₃ | H |
| 415. | CD₃ | CD(CH₃)₂ | CD₃ | H | H |
| 416. | CD₃ | CD(CH₃)₂ | H | CD₃ | H |
| 417. | H | CD(CH₃)₂ | CD₃ | CD₃ | H |
| 418. | CD₃ | CD(CH₃)₂ | CD₃ | CD₃ | H |
| 419. | H | H | CD(CH₃)₂ | H | H |
| 420. | CD₃ | H | CD(CH₃)₂ | H | H |
| 421. | H | CD₃ | CD(CH₃)₂ | H | H |
| 422. | H | H | CD(CH₃)₂ | CD₃ | H |
| 423. | CD₃ | CD₃ | CD(CH₃)₂ | H | H |
| 424. | CD₃ | H | CD(CH₃)₂ | CD₃ | H |
| 425. | H | CD₃ | CD(CH₃)₂ | CD₃ | H |
| 426. | CD₃ | CD₃ | CD(CH₃)₂ | CD₃ | H |
| 427. | CD(CD₃)₂ | H | H | H | H |
| 428. | CD(CD₃)₂ | CD₃ | H | CD₃ | H |
| 429. | CD(CD₃)₂ | H | CD₃ | H | H |
| 430. | CD(CD₃)₂ | H | H | CD₃ | H |
| 431. | CD(CD₃)₂ | CD₃ | CD₃ | H | H |
| 432. | CD(CD₃)₂ | CD₃ | H | CD₃ | H |
| 433. | CD(CD₃)₂ | H | CD₃ | CD₃ | H |
| 434. | CD(CD₃)₂ | CD₃ | CD₃ | CD₃ | H |
| 435. | H | CD(CD₃)₂ | H | H | H |
| 436. | CH₃ | CD(CD₃)₂ | H | CD₃ | H |
| 437. | H | CD(CD₃)₂ | CD₃ | H | H |
| 438. | H | CD(CD₃)₂ | H | CD₃ | H |
| 439. | CD₃ | CD(CD₃)₂ | CD₃ | H | H |
| 440. | CD₃ | CD(CD₃)₂ | H | CD₃ | H |
| 441. | H | CD(CD₃)₂ | CD₃ | CD₃ | H |
| 442. | CD₃ | CD(CD₃)₂ | CD₃ | CD₃ | H |
| 443. | H | H | CD(CD₃)₂ | H | H |
| 444. | CD₃ | H | CD(CD₃)₂ | H | H |
| 445. | H | CD₃ | CD(CD₃)₂ | H | H |
| 446. | H | H | CD(CD₃)₂ | CD₃ | H |
| 447. | CD₃ | CD₃ | CD(CD₃)₂ | H | H |
| 448. | CD₃ | H | CD(CD₃)₂ | CD₃ | H |
| 449. | H | CD₃ | CD(CD₃)₂ | CD₃ | H |
| 450. | CD₃ | CD₃ | CD(CD₃)₂ | CD₃ | H |
| 451. | CD₂CH(CH₃)₂ | H | H | H | H |
| 452. | CD₂CH(CH₃)₂ | CD₃ | H | CD₃ | H |
| 453. | CD₂CH(CH₃)₂ | H | CD₃ | H | H |
| 454. | CD₂CH(CH₃)₂ | H | H | CD₃ | H |
| 455. | CD₂CH(CH₃)₂ | CD₃ | CD₃ | H | H |
| 456. | CD₂CH(CH₃)₂ | CD₃ | H | CD₃ | H |
| 457. | CD₂CH(CH₃)₂ | H | CD₃ | CD₃ | H |
| 458. | CD₂CH(CH₃)₂ | CD₃ | CD₃ | CD₃ | H |
| 459. | H | CD₂CH(CH₃)₂ | H | H | H |
| 460. | CD₃ | CD₂CH(CH₃)₂ | H | CD₃ | H |
| 461. | H | CD₂CH(CH₃)₂ | CD₃ | H | H |
| 462. | H | CD₂CH(CH₃)₂ | H | CD₃ | H |
| 463. | CD₃ | CD₂CH(CH₃)₂ | CD₃ | H | H |
| 464. | CD₃ | CD₂CH(CH₃)₂ | H | CD₃ | H |
| 465. | H | CD₂CH(CH₃)₂ | CD₃ | CD₃ | H |
| 466. | CD₃ | CD₂CH(CH₃)₂ | CD₃ | CD₃ | H |
| 467. | H | H | CD₂CH(CH₃)₂ | H | H |
| 468. | CD₃ | H | CD₂CH(CH₃)₂ | H | H |
| 469. | H | CD₃ | CD₂CH(CH₃)₂ | H | H |
| 470. | H | H | CD₂CH(CH₃)₂ | CD₃ | H |
| 471. | CD₃ | CD₃ | CD₂CH(CH₃)₂ | H | H |
| 472. | CD₃ | H | CD₂CH(CH₃)₂ | CD₃ | H |
| 473. | H | CD₃ | CD₂CH(CH₃)₂ | CD₃ | H |
| 474. | CD₃ | CD₃ | CD₂CH(CH₃)₂ | CD₃ | H |
| 475. | CD₂C(CH₃)₃ | H | H | H | H |
| 476. | CD₂C(CH₃)₃ | CD₃ | H | CD₃ | H |
| 477. | CD₂C(CH₃)₃ | H | CD₃ | H | H |
| 478. | CD₂C(CH₃)₃ | H | H | CD₃ | H |
| 479. | CD₂C(CH₃)₃ | CD₃ | CD₃ | H | H |
| 480. | CD₂C(CH₃)₃ | CD₃ | H | CD₃ | H |
| 481. | CD₂C(CH₃)₃ | H | CD₃ | CD₃ | H |
| 482. | CD₂C(CH₃)₃ | CH₃ | CD₃ | CD₃ | H |
| 483. | H | CD₂C(CH₃)₃ | H | H | H |
| 484. | CD₃ | CD₂C(CH₃)₃ | H | CD₃ | H |
| 485. | H | CD₂C(CH₃)₃ | CD₃ | H | H |
| 486. | H | CD₂C(CH₃)₃ | H | CD₃ | H |
| 487. | CD₃ | CD₂C(CH₃)₃ | CD₃ | H | H |
| 488. | CD₃ | CD₂C(CH₃)₃ | H | CD₃ | H |
| 489. | H | CD₂C(CH₃)₃ | CD₃ | CD₃ | H |
| 490. | CD₃ | CD₂C(CH₃)₃ | CD₃ | CD₃ | H |
| 491. | H | H | CD₂C(CH₃)₃ | H | H |
| 492. | CD₃ | H | CD₂C(CH₃)₃ | H | H |
| 493. | H | CD₃ | CD₂C(CH₃)₃ | H | H |
| 494. | H | H | CD₂C(CH₃)₃ | CD₃ | H |
| 495. | CD₃ | CD₃ | CD₂C(CH₃)₃ | H | H |
| 496. | CD₃ | H | CD₂C(CH₃)₃ | CD₃ | H |
| 497. | H | CD₃ | CD₂C(CH₃)₃ | CD₃ | H |
| 498. | CD₃ | CD₃ | CD₂C(CH₃)₃ | CD₃ | H |
| 499. | 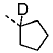 | H | H | H | H |
| 500. | 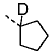 | CD₃ | H | CD₃ | H |
| 501. | 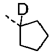 | H | CD₃ | H | H |
| 502. | 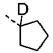 | H | H | CD₃ | H |
| 503. | 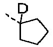 | CD₃ | CD₃ | H | H |
| 504. | 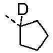 | CD₃ | H | CD₃ | H |
| 505. | 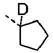 | H | CD₃ | CD₃ | H |
| 506. | 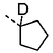 | CD₃ | CD₃ | CD₃ | H |
| 507. | H | 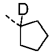 | H | H | H |
| 508. | CD₃ | 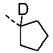 | H | CD₃ | H |
| 509. | H | 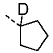 | CD₃ | H | H |
| 510. | H | 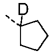 | H | CD₃ | H |
| 511. | CD₃ | 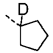 | CD₃ | H | H |
| 512. | CD₃ | 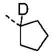 | H | CD₃ | H |
| 513. | H | 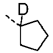 | CD₃ | CD₃ | H |
| 514. | CD₃ | 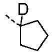 | CD₃ | CD₃ | H |
| 515. | H | H | 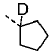 | H | H |
| 516. | CD₃ | H | 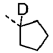 | H | H |
| 517. | H | CD₃ | 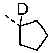 | H | H |
| 518. | H | H | 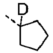 | CD₃ | H |
| 519. | CD₃ | CD₃ | 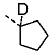 | H | H |
| 520. | CD₃ | H | 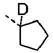 | CD₃ | H |
| 521. | H | CD₃ | 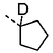 | CD₃ | H |
| 522. | CD₃ | CD₃ | 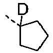 | CD₃ | H |
| 523. | 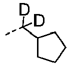 | H | H | H | H |
| 524. | 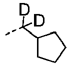 | CD₃ | H | CD₃ | H |
| 525. | 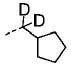 | H | CD₃ | H | H |
| 526. | 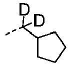 | H | H | CD₃ | H |
| 527. | 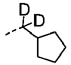 | CD₃ | CD₃ | H | H |
| 528. | 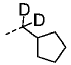 | CD₃ | H | CD₃ | H |
| 529. | 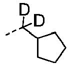 | H | CD₃ | CD₃ | H |
| 530. | 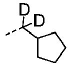 | CD₃ | CD₃ | CD₃ | H |
| 531. | H | 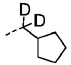 | H | H | H |
| 532. | CH₃ | 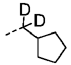 | H | CD₃ | H |
| 533. | H | 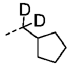 | CD₃ | H | H |
| 534. | H | 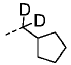 | H | CD₃ | H |
| 535. | CD₃ | 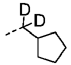 | CD₃ | H | H |
| 536. | CD₃ | 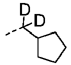 | H | CD₃ | H |
| 537. | H | 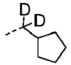 | CD₃ | CD₃ | H |
| 538. | CH₃ | 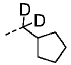 | CD₃ | CD₃ | H |
| 539. | H | H | 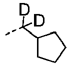 | H | H |
| 540. | CD₃ | H | 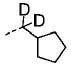 | H | H |
| 541. | H | CD₃ | 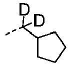 | H | H |
| 542. | H | H | 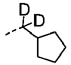 | CD₃ | H |
| 543. | CD₃ | CD₃ | 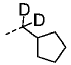 | H | H |
| 544. | CD₃ | H | 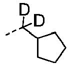 | CD₃ | H |
| 545. | H | CD₃ | 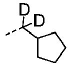 | CD₃ | H |
| 546. | CD₃ | CD₃ | 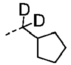 | CD₃ | H |
| 547. | 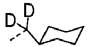 | H | H | H | H |
| 548. | 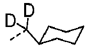 | CD₃ | H | CD₃ | H |
| 549. | 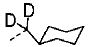 | H | CD₃ | H | H |
| 550. | 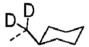 | H | H | CD₃ | H |
| 551. | 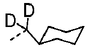 | CD₃ | CD₃ | H | H |
| 552. | 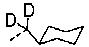 | CD₃ | H | CD₃ | H |
| 553. | 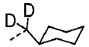 | H | CD₃ | CD₃ | H |
| 554. | 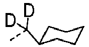 | CD₃ | CD₃ | CD₃ | H |
| 555. | H | 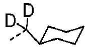 | H | H | H |
| 556. | CD₃ | 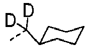 | H | CD₃ | H |
| 557. | H | 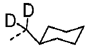 | CD₃ | H | H |
| 558. | H | 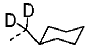 | H | CD₃ | H |
| 559. | CD₃ | 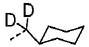 | CD₃ | H | H |
| 560. | CD₃ | 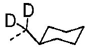 | H | CD₃ | H |
| 561. | H | 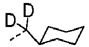 | CD₃ | CD₃ | H |
| 562. | CD₃ | 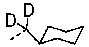 | CD₃ | CD₃ | H |
| 563. | H | H | 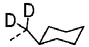 | H | H |
| 564. | CD₃ | H | 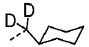 | H | H |
| 565. | H | CD₃ | 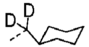 | H | H |
| 566. | H | H | 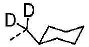 | CD₃ | H |
| 567. | CD₃ | CD₃ | 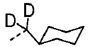 | H | H |
| 568. | CD₃ | H | 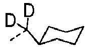 | CD₃ | H |
| 569. | H | CD₃ | 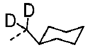 | CD₃ | H |
| 570. | CD₃ | CD₃ | 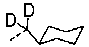 | CD₃ | H |
| 571. | 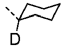 | H | H | H | H |
| 572. | 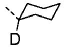 | CD₃ | H | CD₃ | H |
| 573. | 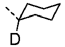 | H | CD₃ | H | H |
| 574. | 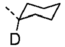 | H | H | CD₃ | H |
| 575. | 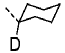 | CD₃ | CD₃ | H | H |
| 576. | 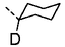 | CD₃ | H | CD₃ | H |
| 577. | 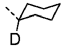 | H | CD₃ | CD₃ | H |
| 578. | 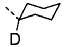 | CD₃ | CD₃ | CD₃ | H |
| 579. | H | 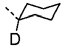 | H | H | H |
| 580. | CD₃ | 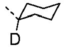 | H | CD₃ | H |
| 581. | H | 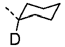 | CD₃ | H | H |
| 582. | H | 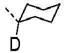 | H | CD₃ | H |
| 583. | CD₃ | 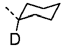 | CD₃ | H | H |
| 584. | CD₃ | 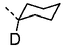 | H | CD₃ | H |
| 585. | H | 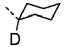 | CD₃ | CD₃ | H |
| 586. | CD₃ | 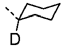 | CD₃ | CD₃ | H |
| 587. | H | H | 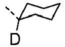 | H | H |
| 588. | CD₃ | H | 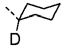 | H | H |
| 589. | H | CD₃ | 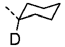 | H | H |
| 590. | H | H | 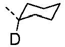 | CD₃ | H |
| 591. | CD₃ | CD₃ | 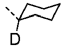 | H | H |
| 592. | CD₃ | H | 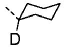 | CD₃ | H |
| 593. | H | CD₃ | 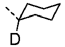 | CD₃ | H |
| 594. | CD₃ | CD₃ | 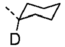 | CD₃ | H |
| 595. | 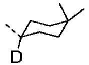 | H | H | H | H |
| 596. | 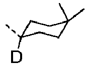 | CD₃ | H | CD₃ | H |
| 597. | 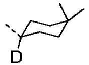 | H | CD₃ | H | H |
| 598. | 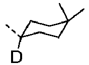 | H | H | CD₃ | H |
| 599. | 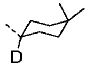 | CD₃ | CD₃ | H | H |
| 600. | 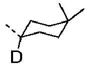 | CD₃ | H | CD₃ | H |
| 601. | 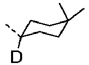 | H | CD₃ | CD₃ | H |
| 602. | 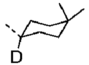 | CD₃ | CD₃ | CD₃ | H |
| 603. | H | 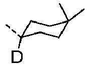 | H | H | H |
| 604. | CD₃ | 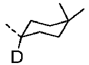 | H | CD₃ | H |
| 605. | H | 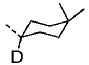 | CD₃ | H | H |
| 606. | H | 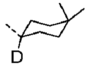 | H | CD₃ | H |
| 607. | CD₃ | 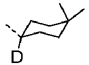 | CD₃ | H | H |
| 608. | CD₃ | 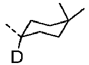 | H | CD₃ | H |
| 609. | H | 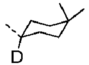 | CD₃ | CD₃ | H |
| 610. | CD₃ | 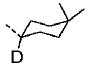 | CD₃ | CD₃ | H |
| 611. | H | H | 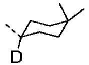 | H | H |
| 612. | CD₃ | H | 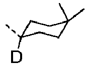 | H | H |
| 613. | H | CD₃ | 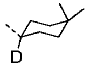 | H | H |
| 614. | H | H | 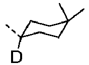 | CD₃ | H |
| 615. | CD₃ | CD₃ | 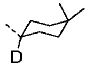 | H | H |
| 616. | CD₃ | H | 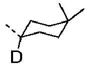 | CD₃ | H |
| 617. | H | CD₃ | 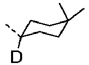 | CD₃ | H |
| 618. | CD₃ | CD₃ | 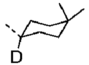 | CD₃ | H |
| 619. | 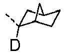 | H | H | H | H |
| 620. | 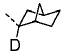 | CD₃ | H | CD₃ | H |
| 621. | 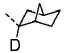 | H | CD₃ | H | H |
| 622. | 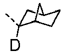 | H | H | CD₃ | H |
| 623. | 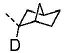 | CH₃ | CH₃ | H | H |
| 624. | 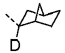 | CD₃ | H | CD₃ | H |
| 625. | 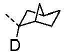 | H | CD₃ | CD₃ | H |
| 626. | 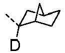 | CD₃ | CD₃ | CD₃ | H |
| 627. | H | 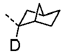 | H | H | H |
| 628. | CD₃ | 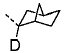 | H | CD₃ | H |
| 629. | H | 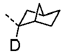 | CD₃ | H | H |
| 630. | H | 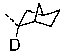 | H | CD₃ | H |
| 631. | CD₃ | 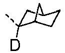 | CD₃ | H | H |
| 632. | CD₃ | 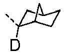 | H | CD₃ | H |
| 633. | H | 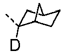 | CD₃ | CD₃ | H |
| 634. | CD₃ | 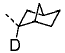 | CD₃ | CD₃ | H |
| 635. | H | H | 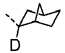 | H | H |
| 636. | CD₃ | H | 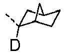 | H | H |
| 637. | H | CD₃ | 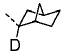 | H | H |
| 638. | H | H | 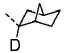 | CH₃ | H |
| 639. | CD₃ | CD₃ | 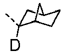 | H | H |
| 640. | CD₃ | H | 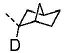 | CD₃ | H |
| 641. | H | CD₃ | 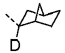 | CD₃ | H |
| 642. | CD₃ | CD₃ | 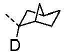 | CD₃ | H |
| 643. | CD(CH₃)₂ | H | CD₂CH₃ | H | H |
| 644. | CD(CH₃)₂ | H | CD(CH₃)₂ | H | H |
| 645. | CD(CH₃)₂ | H | CD₂CH(CH₃)₂ | H | H |
| 646. | CD(CH₃)₂ | H | C(CH₃)₃ | H | H |
| 647. | CD(CH₃)₂ | H | CD₂C(CH₃)₃ | H | H |
| 648. | CD(CH₃)₂ | H | 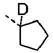 | H | H |
| 649. | CD(CH₃)₂ | H | 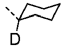 | H | H |
| 650. | CD(CH₃)₂ | H | 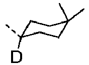 | H | H |
| 651. | CD(CH₃)₂ | H | 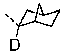 | H | H |
| 652. | CD(CH₃)₂ | H | 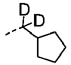 | H | H |
| 653. | CD(CH₃)₂ | H | 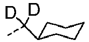 | H | H |
| 654. | C(CH₃)₃ | H | CD₂CH₃ | H | H |
| 655. | C(CH₃)₃ | H | CD(CH₃)₂ | H | H |
| 656. | C(CH₃)₃ | H | CD₂CH(CH₃)₂ | H | H |
| 657. | C(CH₃)₃ | H | C(CH₃)₃ | H | H |
| 658. | C(CH₃)₃ | H | CD₂C(CH₃)₃ | H | H |
| 659. | C(CH₃)₃ | H | 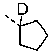 | H | H |
| 660. | C(CH₃)₃ | H | 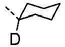 | H | H |
| 661. | C(CH₃)₃ | H | 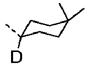 | H | H |
| 662. | C(CH₃)₃ | H | 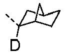 | H | H |
| 663. | C(CH₃)₃ | H | 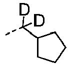 | H | H |
| 664. | C(CH₃)₃ | H | 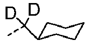 | H | H |
| 665. | CD₂C(CH₃)₃ | H | CD₂CH₃ | H | H |
| 666. | CD₂C(CH₃)₃ | H | CD(CH₃)₂ | H | H |
| 667. | CD₂C(CH₃)₃ | H | CD₂CH(CH₃)₂ | H | H |
| 668. | CD₂C(CH₃)₃ | H | C(CH₃)₃ | H | H |
| 669. | CD₂C(CH₃)₃ | H | CD₂C(CH₃)₃ | H | H |
| 670. | CD₂C(CH₃)₃ | H | 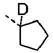 | H | H |
| 671. | CD₂C(CH₃)₃ | H | 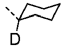 | H | H |
| 672. | CD₂C(CH₃)₃ | H | 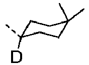 | H | H |
| 673. | CD₂C(CH₃)₃ | H | 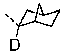 | H | H |
| 674. | CD₂C(CH₃)₃ | H | 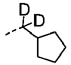 | H | H |
| 675. | CD₂C(CH₃)₃ | H | 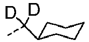 | H | H |
| 676. | 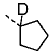 | H | CD₂CH₃ | H | H |
| 677. | 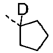 | H | CD(CH₃)₂ | H | H |
| 678. | 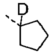 | H | CD₂CH(CH₃)₂ | H | H |
| 679. | 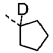 | H | C(CH₃)₃ | H | H |
| 680. | 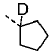 | H | CD₂C(CH₃)₃ | H | H |
| 681. | 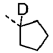 | H | 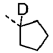 | H | H |
| 682. | 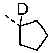 | H | 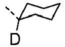 | H | H |
| 683. | 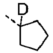 | H | 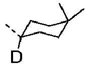 | H | H |
| 684. | 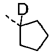 | H | 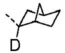 | H | H |
| 685. | 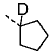 | H | 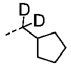 | H | H |
| 686. | 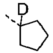 | H | 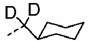 | H | H |
| 687. | 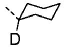 | H | CD₂CH₃ | H | H |
| 688. | 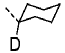 | H | CD(CH₃)₂ | H | H |
| 689. | 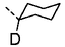 | H | CD₂CH(CH₃)₂ | H | H |
| 690. | 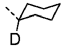 | H | C(CH₃)₃ | H | H |
| 691. | 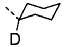 | H | CD₂C(CH₃)₃ | H | H |
| 692. | 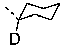 | H | 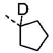 | H | H |
| 693. | 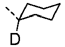 | H | 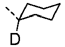 | H | H |
| 694. | 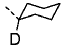 | H | 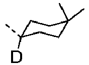 | H | H |
| 695. | 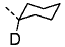 | H | 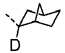 | H | H |
| 696. | 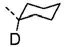 | H | 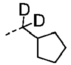 | H | H |
| 697. | 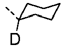 | H | 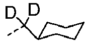 | H | H |
| 698. | 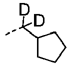 | H | CD₂CH₃ | H | H |
| 699. | 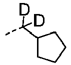 | H | CD(CH₃)₂ | H | H |
| 700. | 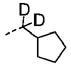 | H | CD₂CH(CH₃)₂ | H | H |
| 701. | 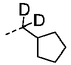 | H | C(CH₃)₃ | H | H |
| 702. | 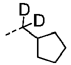 | H | CD₂C(CH₃)₃ | H | H |
| 703. | 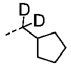 | H | 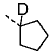 | H | H |
| 704. | 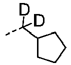 | H | 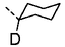 | H | H |
| 705. | 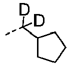 | H | 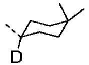 | H | H |
| 706. | 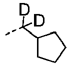 | H | 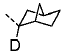 | H | H |
| 707. | 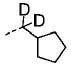 | H | 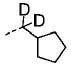 | H | H |
| 708. | 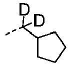 | H | 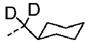 | H | H |
| 709. | 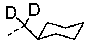 | H | CD₂CH₃ | H | H |
| 710. | 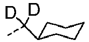 | H | CD(CH₃)₂ | H | H |
| 711. | 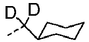 | H | CD₂CH(CH₃)₂ | H | H |
| 712. | 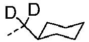 | H | C(CH₃)₃ | H | H |
| 713. | 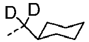 | H | CD₂C(CH₃)₃ | H | H |
| 714. | 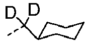 | H | 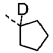 | H | H |
| 715. | 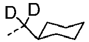 | H | 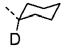 | H | H |
| 716. | 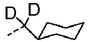 | H | 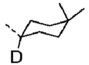 | H | H |
| 717. | 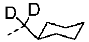 | H | 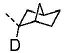 | H | H |
| 718. | 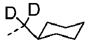 | H | 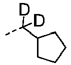 | H | H |
| 719. | 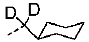 | H | 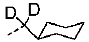 | H | H |
| 720. | 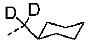 | H | CD₂CH₃ | H | H |
| 721. | 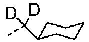 | H | CD(CH₃)₂ | H | H |
| 722. | 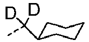 | H | CD₂CH(CH₃)₂ | H | H |
| 723. | 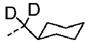 | H | C(CH₃)₃ | H | H |
| 724. | 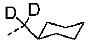 | H | CD₂C(CH₃)₃ | H | H |
| 725. | 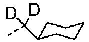 | H | 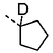 | H | H |
| 726. | 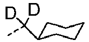 | H | 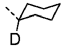 | H | H |
| 727. | 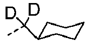 | H | 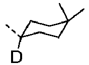 | H | H |
| 728. | 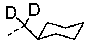 | H | 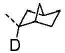 | H | H |
| 729. | 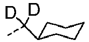 | H | 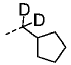 | H | H |
| 730. | 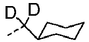 | H | 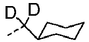 | H | H |
| 731. | H | H | H | H | Ph |
| 732. | CH₃ | H | H | H | Ph |
| 733. | H | CH₃ | H | H | Ph |
| 734. | H | H | CH₃ | H | Ph |
| 735. | CH₃ | CH₃ | H | CH₃ | Ph |
| 736. | CH₃ | H | CH₃ | H | Ph |
| 737. | CH₃ | H | H | CH₃ | Ph |
| 738. | H | CH₃ | CH₃ | H | Ph |
| 739. | H | CH₃ | H | CH₃ | Ph |
| 740. | H | H | CH₃ | CH₃ | Ph |
| 741. | CH₃ | CH₃ | CH₃ | H | Ph |
| 742. | CH₃ | CH₃ | H | CH₃ | Ph |
| 743. | CH₃ | H | CH₃ | CH₃ | Ph |
| 744. | H | CH₃ | CH₃ | CH₃ | Ph |
| 745. | CH₃ | CH₃ | CH₃ | CH₃ | Ph |
| 746. | CH₂CH₃ | H | H | H | Ph |
| 747. | CH₂CH₃ | CH₃ | H | CH₃ | Ph |
| 748. | CH₂CH₃ | H | CH₃ | H | Ph |
| 749. | CH₂CH₃ | H | H | CH₃ | Ph |
| 750. | CH₂CH₃ | CH₃ | CH₃ | H | Ph |
| 751. | CH₂CH₃ | CH₃ | H | CH₃ | Ph |
| 752. | CH₂CH₃ | H | CH₃ | CH₃ | Ph |
| 753. | CH₂CH₃ | CH₃ | CH₃ | CH₃ | Ph |
| 754. | H | CH₂CH₃ | H | H | Ph |
| 755. | CH₃ | CH₂CH₃ | H | CH₃ | Ph |
| 756. | H | CH₂CH₃ | CH₃ | H | Ph |
| 757. | H | CH₂CH₃ | H | CH₃ | Ph |
| 758. | CH₃ | CH₂CH₃ | CH₃ | H | Ph |
| 759. | CH₃ | CH₂CH₃ | H | CH₃ | Ph |
| 760. | H | CH₂CH₃ | CH₃ | CH₃ | Ph |
| 761. | CH₃ | CH₂CH₃ | CH₃ | CH₃ | Ph |
| 762. | H | H | CH₂CH₃ | H | Ph |
| 763. | CH₃ | H | CH₂CH₃ | H | Ph |
| 764. | H | CH₃ | CH₂CH₃ | H | Ph |
| 765. | H | H | CH₂CH₃ | CH₃ | Ph |
| 766. | CH₃ | CH₃ | CH₂CH₃ | H | Ph |
| 767. | CH₃ | H | CH₂CH₃ | CH₃ | Ph |
| 768. | H | CH₃ | CH₂CH₃ | CH₃ | Ph |
| 769. | CH₃ | CH₃ | CH₂CH₃ | CH₃ | Ph |
| 770. | CH(CH₃)₂ | H | H | H | Ph |
| 771. | CH(CH₃)₂ | CH₃ | H | CH₃ | Ph |
| 772. | CH(CH₃)₂ | H | CH₃ | H | Ph |
| 773. | CH(CH₃)₂ | H | H | CH₃ | Ph |
| 774. | CH(CH₃)₂ | CH₃ | CH₃ | H | Ph |
| 775. | CH(CH₃)₂ | CH₃ | H | CH₃ | Ph |
| 776. | CH(CH₃)₂ | H | CH₃ | CH₃ | Ph |
| 777. | CH(CH₃)₂ | CH₃ | CH₃ | CH₃ | Ph |
| 778. | H | CH(CH₃)₂ | H | H | Ph |
| 779. | CH₃ | CH(CH₃)₂ | H | CH₃ | Ph |
| 780. | H | CH(CH₃)₂ | CH₃ | H | Ph |
| 781. | H | CH(CH₃)₂ | H | CH₃ | Ph |
| 782. | CH₃ | CH(CH₃)₂ | CH₃ | H | Ph |
| 783. | CH₃ | CH(CH₃)₂ | H | CH₃ | Ph |
| 784. | H | CH(CH₃)₂ | CH₃ | CH₃ | Ph |
| 785. | CH₃ | CH(CH₃)₂ | CH₃ | CH₃ | Ph |
| 786. | H | H | CH(CH₃)₂ | H | Ph |
| 787. | CH₃ | H | CH(CH₃)₂ | H | Ph |
| 788. | H | CH₃ | CH(CH₃)₂ | H | Ph |
| 789. | H | H | CH(CH₃)₂ | CH₃ | Ph |
| 790. | CH₃ | CH₃ | CH(CH₃)₂ | H | Ph |
| 791. | CH₃ | H | CH(CH₃)₂ | CH₃ | Ph |
| 792. | H | CH₃ | CH(CH₃)₂ | CH₃ | Ph |
| 793. | CH₃ | CH₃ | CH(CH₃)₂ | CH₃ | Ph |
| 794. | CH₂CH(CH₃)₂ | H | H | H | Ph |
| 795. | CH₂CH(CH₃)₂ | CH₃ | H | CH₃ | Ph |
| 796. | CH₂CH(CH₃)₂ | H | CH₃ | H | Ph |
| 797. | CH₂CH(CH₃)₂ | H | H | CH₃ | Ph |
| 798. | CH₂CH(CH₃)₂ | CH₃ | CH₃ | H | Ph |
| 799. | CH₂CH(CH₃)₂ | CH₃ | H | CH₃ | Ph |
| 800. | CH₂CH(CH₃)₂ | H | CH₃ | CH₃ | Ph |
| 801. | CH₂CH(CH₃)₂ | CH₃ | CH₃ | CH₃ | Ph |
| 802. | H | CH₂CH(CH₃)₂ | H | H | Ph |
| 803. | CH₃ | CH₂CH(CH₃)₂ | H | CH₃ | Ph |
| 804. | H | CH₂CH(CH₃)₂ | CH₃ | H | Ph |
| 805. | H | CH₂CH(CH₃)₂ | H | CH₃ | Ph |
| 806. | CH₃ | CH₂CH(CH₃)₂ | CH₃ | H | Ph |
| 807. | CH₃ | CH₂CH(CH₃)₂ | H | CH₃ | Ph |
| 808. | H | CH₂CH(CH₃)₂ | CH₃ | CH₃ | Ph |
| 809. | CH₃ | CH₂CH(CH₃)₂ | CH₃ | CH₃ | Ph |
| 810. | H | H | CH₂CH(CH₃)₂ | H | Ph |
| 811. | CH₃ | H | CH₂CH(CH₃)₂ | H | Ph |
| 812. | H | CH₃ | CH₂CH(CH₃)₂ | H | Ph |
| 813. | H | H | CH₂CH(CH₃)₂ | CH₃ | Ph |
| 814. | CH₃ | CH₃ | CH₂CH(CH₃)₂ | H | Ph |
| 815. | CH₃ | H | CH₂CH(CH₃)₂ | CH₃ | Ph |
| 816. | H | CH₃ | CH₂CH(CH₃)₂ | CH₃ | Ph |
| 817. | CH₃ | CH₃ | CH₂CH(CH₃)₂ | CH₃ | Ph |
| 818. | C(CH₃)₃ | H | H | H | Ph |
| 819. | C(CH₃)₃ | CH₃ | H | CH₃ | Ph |
| 820. | C(CH₃)₃ | H | CH₃ | H | Ph |
| 821. | C(CH₃)₃ | H | H | CH₃ | Ph |
| 822. | C(CH₃)₃ | CH₃ | CH₃ | H | Ph |
| 823. | C(CH₃)₃ | CH₃ | H | CH₃ | Ph |
| 824. | C(CH₃)₃ | H | CH₃ | CH₃ | Ph |
| 825. | C(CH₃)₃ | CH₃ | CH₃ | CH₃ | Ph |
| 826. | H | C(CH₃)₃ | H | H | Ph |
| 827. | CH₃ | C(CH₃)₃ | H | CH₃ | Ph |
| 828. | H | C(CH₃)₃ | CH₃ | H | Ph |
| 829. | H | C(CH₃)₃ | H | CH₃ | Ph |
| 830. | CH₃ | C(CH₃)₃ | CH₃ | H | Ph |
| 831. | CH₃ | C(CH₃)₃ | H | CH₃ | Ph |
| 832. | H | C(CH₃)₃ | CH₃ | CH₃ | Ph |
| 833. | CH₃ | C(CH₃)₃ | CH₃ | CH₃ | Ph |
| 834. | H | H | C(CH₃)₃ | H | Ph |
| 835. | CH₃ | H | C(CH₃)₃ | H | Ph |
| 836. | H | CH₃ | C(CH₃)₃ | H | Ph |
| 837. | H | H | C(CH₃)₃ | CH₃ | Ph |
| 838. | CH₃ | CH₃ | C(CH₃)₃ | H | Ph |
| 839. | CH₃ | H | C(CH₃)₃ | CH₃ | Ph |
| 840. | H | CH₃ | C(CH₃)₃ | CH₃ | Ph |
| 841. | CH₃ | CH₃ | C(CH₃)₃ | CH₃ | Ph |
| 842. | CH₂C(CH₃)₃ | H | H | H | Ph |
| 843. | CH₂C(CH₃)₃ | CH₃ | H | CH₃ | Ph |
| 844. | CH₂C(CH₃)₃ | H | CH₃ | H | Ph |
| 845. | CH₂C(CH₃)₃ | H | H | CH₃ | Ph |
| 846. | CH₂C(CH₃)₃ | CH₃ | CH₃ | H | Ph |
| 847. | CH₂C(CH₃)₃ | CH₃ | H | CH₃ | Ph |
| 848. | CH₂C(CH₃)₃ | H | CH₃ | CH₃ | Ph |
| 849. | CH₂C(CH₃)₃ | CH₃ | CH₃ | CH₃ | Ph |
| 850. | H | CH₂C(CH₃)₃ | H | H | Ph |
| 851. | CH₃ | CH₂C(CH₃)₃ | H | CH₃ | Ph |
| 852. | H | CH₂C(CH₃)₃ | CH₃ | H | Ph |
| 853. | H | CH₂C(CH₃)₃ | H | CH₃ | Ph |
| 854. | CH₃ | CH₂C(CH₃)₃ | CH₃ | H | Ph |
| 855. | CH₃ | CH₂C(CH₃)₃ | H | CH₃ | Ph |
| 856. | H | CH₂C(CH₃)₃ | CH₃ | CH₃ | Ph |
| 857. | CH₃ | CH₂C(CH₃)₃ | CH₃ | CH₃ | Ph |
| 858. | H | H | CH₂C(CH₃)₃ | H | Ph |
| 859. | CH₃ | H | CH₂C(CH₃)₃ | H | Ph |
| 860. | H | CH₃ | CH₂C(CH₃)₃ | H | Ph |
| 861. | H | H | CH₂C(CH₃)₃ | CH₃ | Ph |
| 862. | CH₃ | CH₃ | CH₂C(CH₃)₃ | H | Ph |
| 863. | CH₃ | H | CH₂C(CH₃)₃ | CH₃ | Ph |
| 864. | H | CH₃ | CH₂C(CH₃)₃ | CH₃ | Ph |
| 865. | CH₃ | CH₃ | CH₂C(CH₃)₃ | CH₃ | Ph |
| 866. | 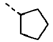 | H | H | H | Ph |
| 867. | 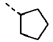 | CH₃ | H | CH₃ | Ph |
| 868. | 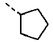 | H | CH₃ | H | Ph |
| 869. | 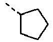 | H | H | CH₃ | Ph |
| 870. | 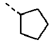 | CH₃ | CH₃ | H | Ph |
| 871. | 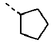 | CH₃ | H | CH₃ | Ph |
| 872. | 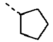 | H | CH₃ | CH₃ | Ph |
| 873. | 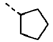 | CH₃ | CH₃ | CH₃ | Ph |
| 874. | H | 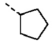 | H | H | Ph |
| 875. | CH₃ | 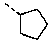 | H | CH₃ | Ph |
| 876. | H | 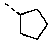 | CH₃ | H | Ph |
| 877. | H | 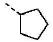 | H | CH₃ | Ph |
| 878. | CH₃ | 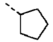 | CH₃ | H | Ph |
| 879. | CH₃ | 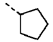 | H | CH₃ | Ph |
| 880. | H | 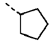 | CH₃ | CH₃ | Ph |
| 881. | CH₃ | 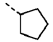 | CH₃ | CH₃ | Ph |
| 882. | H | H | 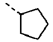 | H | Ph |
| 883. | CH₃ | H | 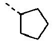 | H | Ph |
| 884. | H | CH₃ | 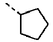 | H | Ph |
| 885. | H | H | 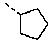 | CH₃ | Ph |
| 886. | CH₃ | CH₃ | 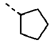 | H | Ph |
| 887. | CH₃ | H | 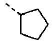 | CH₃ | Ph |
| 888. | H | CH₃ | 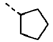 | CH₃ | Ph |
| 889. | CH₃ | CH₃ | 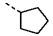 | CH₃ | Ph |
| 890. | 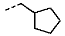 | H | H | H | Ph |
| 891. | 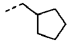 | CH₃ | H | CH₃ | Ph |
| 892. | 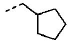 | H | CH₃ | H | Ph |
| 893. | 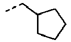 | H | H | CH₃ | Ph |
| 894. | 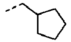 | CH₃ | CH₃ | H | Ph |
| 895. | 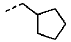 | CH₃ | H | CH₃ | Ph |
| 896. | 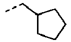 | H | CH₃ | CH₃ | Ph |
| 897. | 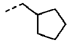 | CH₃ | CH₃ | CH₃ | Ph |
| 898. | H | 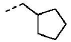 | H | H | Ph |
| 899. | CH₃ | 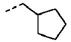 | H | CH₃ | Ph |
| 900. | H | 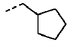 | CH₃ | H | Ph |
| 901. | H | 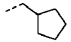 | H | CH₃ | Ph |
| 902. | CH₃ | 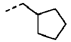 | CH₃ | H | Ph |
| 903. | CH₃ | 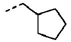 | H | CH₃ | Ph |
| 904. | H | 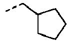 | CH₃ | CH₃ | Ph |
| 905. | CH₃ | 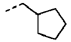 | CH₃ | CH₃ | Ph |
| 906. | H | H | 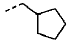 | H | Ph |
| 907. | CH₃ | H | 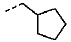 | H | Ph |
| 908. | H | CH₃ | 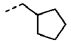 | H | Ph |
| 909. | H | H | 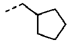 | CH₃ | Ph |
| 910. | CH₃ | CH₃ | 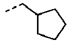 | H | Ph |
| 911. | CH₃ | H | 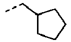 | CH₃ | Ph |
| 912. | H | CH₃ | 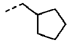 | CH₃ | Ph |
| 913. | CH₃ | CH₃ | 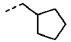 | CH₃ | Ph |
| 914. | 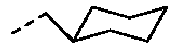 | H | H | H | Ph |
| 915. | 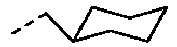 | CH₃ | H | CH₃ | Ph |
| 916. | 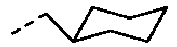 | H | CH₃ | H | Ph |
| 917. | 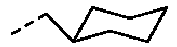 | H | H | CH₃ | Ph |
| 918. | 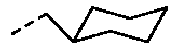 | CH₃ | CH₃ | H | Ph |
| 919. | 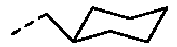 | CH₃ | H | CH₃ | Ph |
| 920. | 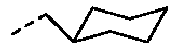 | H | CH₃ | CH₃ | Ph |
| 921. | 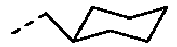 | CH₃ | CH₃ | CH₃ | Ph |
| 922. | H | 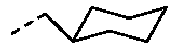 | H | H | Ph |
| 923. | CH₃ | 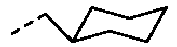 | H | CH₃ | Ph |
| 924. | H | 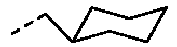 | CH₃ | H | Ph |
| 925. | H | 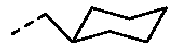 | H | CH₃ | Ph |
| 926. | CH₃ | 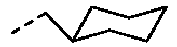 | CH₃ | H | Ph |
| 927. | CH₃ | 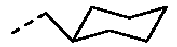 | H | CH₃ | Ph |
| 928. | H | 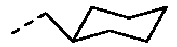 | CH₃ | CH₃ | Ph |
| 929. | CH₃ | 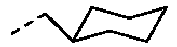 | CH₃ | CH₃ | Ph |
| 930. | H | H | 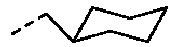 | H | Ph |
| 931. | CH₃ | H | 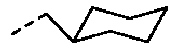 | H | Ph |
| 932. | H | CH₃ | 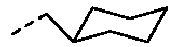 | H | Ph |
| 933. | H | H | 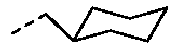 | CH₃ | Ph |
| 934. | CH₃ | CH₃ | 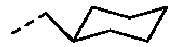 | H | Ph |
| 935. | CH₃ | H | 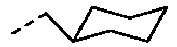 | CH₃ | Ph |
| 936. | H | CH₃ | 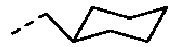 | CH₃ | Ph |
| 937. | CH₃ | CH₃ | 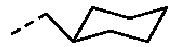 | CH₃ | Ph |
| 938. | 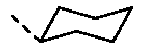 | H | H | H | Ph |
| 939. | 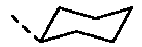 | CH₃ | H | CH₃ | Ph |
| 940. | 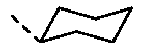 | H | CH₃ | H | Ph |
| 941. | 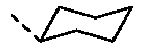 | H | H | CH₃ | Ph |
| 942. | 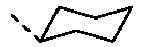 | CH₃ | CH₃ | H | Ph |
| 943. | 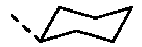 | CH₃ | H | CH₃ | Ph |
| 944. | 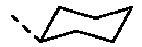 | H | CH₃ | CH₃ | Ph |
| 945. | 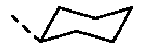 | CH₃ | CH₃ | CH₃ | Ph |
| 946. | H | 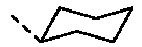 | H | H | Ph |
| 947. | CH₃ | 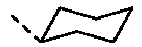 | H | CH₃ | Ph |
| 948. | H | 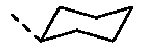 | CH₃ | H | Ph |
| 949. | H | 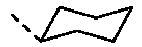 | H | CH₃ | Ph |
| 950. | CH₃ | 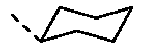 | CH₃ | H | Ph |
| 951. | CH₃ | 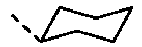 | H | CH₃ | Ph |
| 952. | H | 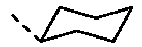 | CH₃ | CH₃ | Ph |
| 953. | CH₃ | 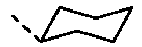 | CH₃ | CH₃ | Ph |
| 954. | H | H | 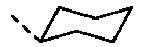 | H | Ph |
| 955. | CH₃ | H | 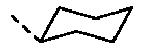 | H | Ph |
| 956. | H | CH₃ | 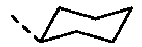 | H | Ph |
| 957. | H | H | 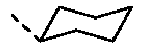 | CH₃ | Ph |
| 958. | CH₃ | CH₃ | 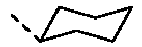 | H | Ph |
| 959. | CH₃ | H | 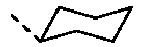 | CH₃ | Ph |
| 960. | H | CH₃ | 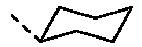 | CH₃ | Ph |
| 961. | CH₃ | CH₃ | 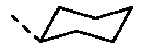 | CH₃ | Ph |
| 962. | 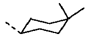 | H | H | H | Ph |
| 963. | 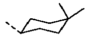 | CH₃ | H | CH₃ | Ph |
| 964. | 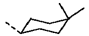 | H | CH₃ | H | Ph |
| 965. | 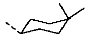 | H | H | CH₃ | Ph |
| 966. | 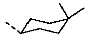 | CH₃ | CH₃ | H | Ph |
| 967. | 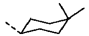 | CH₃ | H | CH₃ | Ph |
| 968. | 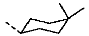 | H | CH₃ | CH₃ | Ph |
| 969. | 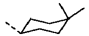 | CH₃ | CH₃ | CH₃ | Ph |
| 970. | H | 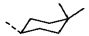 | H | H | Ph |
| 971. | CH₃ | 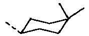 | H | CH₃ | Ph |
| 972. | H | 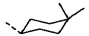 | CH₃ | H | Ph |
| 973. | H | 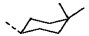 | H | CH₃ | Ph |
| 974. | CH₃ | 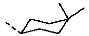 | CH₃ | H | Ph |
| 975. | CH₃ | 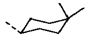 | H | CH₃ | Ph |
| 976. | H | 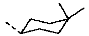 | CH₃ | CH₃ | Ph |
| 977. | CH₃ | 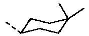 | CH₃ | CH₃ | Ph |
| 978. | H | H | 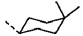 | H | Ph |
| 979. | CH₃ | H | 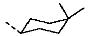 | H | Ph |
| 980. | H | CH₃ | 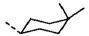 | H | Ph |
| 981. | H | H | 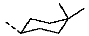 | CH₃ | Ph |
| 982. | CH₃ | CH₃ | 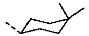 | H | Ph |
| 983. | CH₃ | H | 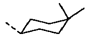 | CH₃ | Ph |
| 984. | H | CH₃ | 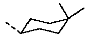 | CH₃ | Ph |
| 985. | CH₃ | CH₃ | 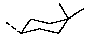 | CH₃ | Ph |
| 986. | 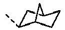 | H | H | H | Ph |
| 987. | 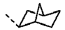 | CH₃ | H | CH₃ | Ph |
| 988. | 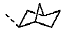 | H | CH₃ | H | Ph |
| 989. | 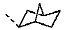 | H | H | CH₃ | Ph |
| 990. | 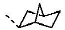 | CH₃ | CH₃ | H | Ph |
| 991. | 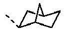 | CH₃ | H | CH₃ | Ph |
| 992. | 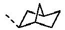 | H | CH₃ | CH₃ | Ph |
| 993. | 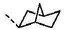 | CH₃ | CH₃ | CH₃ | Ph |
| 994. | H | 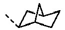 | H | H | Ph |
| 995. | CH₃ | 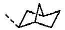 | H | CH₃ | Ph |
| 996. | H | 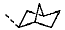 | CH₃ | H | Ph |
| 997. | H | 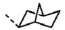 | H | CH₃ | Ph |
| 998. | CH₃ | 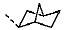 | CH₃ | H | Ph |
| 999. | CH₃ | 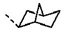 | H | CH₃ | Ph |
| 1000. | H | 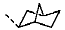 | CH₃ | CH₃ | Ph |
| 1001. | CH₃ | 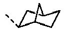 | CH₃ | CH₃ | Ph |
| 1002. | H | H | 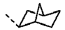 | H | Ph |
| 1003. | CH₃ | H | 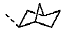 | H | Ph |
| 1004. | H | CH₃ | 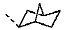 | H | Ph |
| 1005. | H | H | 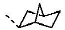 | CH₃ | Ph |
| 1006. | CH₃ | CH₃ | 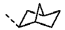 | H | Ph |
| 1007. | CH₃ | H | 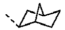 | CH₃ | Ph |
| 1008. | H | CH₃ | 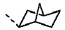 | CH₃ | Ph |
| 1009. | CH₃ | CH₃ | 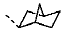 | CH₃ | Ph |
| 1010. | CH(CH₃)₂ | H | CH₂CH₃ | H | Ph |
| 1011. | CH(CH₃)₂ | H | CH(CH₃)₂ | H | Ph |
| 1012. | CH(CH₃)₂ | H | CH₂CH(CH₃)₂ | H | Ph |
| 1013. | CH(CH₃)₂ | H | C(CH₃)₃ | H | Ph |
| 1014. | CH(CH₃)₂ | H | CH₂C(CH₃)₃ | H | Ph |
| 1015. | CH(CH₃)₂ | H | 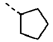 | H | Ph |
| 1016. | CH(CH₃)₂ | H | 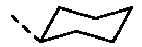 | H | Ph |
| 1017. | CH(CH₃)₂ | H | 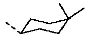 | H | Ph |
| 1018. | CH(CH₃)₂ | H | 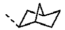 | H | Ph |
| 1019. | CH(CH₃)₂ | H | 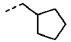 | H | Ph |
| 1020. | CH(CH₃)₂ | H | 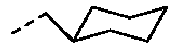 | H | Ph |
| 1021. | C(CH₃)₃ | H | CH₂CH₃ | H | Ph |
| 1022. | C(CH₃)₃ | H | CH(CH₃)₂ | H | Ph |
| 1023. | C(CH₃)₃ | H | CH₂CH(CH₃)₂ | H | Ph |
| 1024. | C(CH₃)₃ | H | C(CH₃)₃ | H | Ph |
| 1025. | C(CH₃)₃ | H | CH₂C(CH₃)₃ | H | Ph |
| 1026. | C(CH₃)₃ | H | 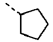 | H | Ph |
| 1027. | C(CH₃)₃ | H | 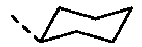 | H | Ph |
| 1028. | C(CH₃)₃ | H | 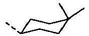 | H | Ph |
| 1029. | C(CH₃)₃ | H | 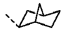 | H | Ph |
| 1030. | C(CH₃)₃ | H | 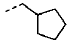 | H | Ph |
| 1031. | C(CH₃)₃ | H | 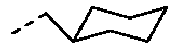 | H | Ph |
| 1032. | CH₂C(CH₃)₃ | H | CH₂CH₃ | H | Ph |
| 1033. | CH₂C(CH₃)₃ | H | CH(CH₃)₂ | H | Ph |
| 1034. | CH₂C(CH₃)₃ | H | CH₂CH(CH₃)₂ | H | Ph |
| 1035. | CH₂C(CH₃)₃ | H | C(CH₃)₃ | H | Ph |
| 1036. | CH₂C(CH₃)₃ | H | CH₂C(CH₃)₃ | H | Ph |
| 1037. | CH₂C(CH₃)₃ | H | 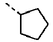 | H | Ph |
| 1038. | CH₂C(CH₃)₃ | H | 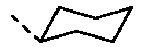 | H | Ph |
| 1039. | CH₂C(CH₃)₃ | H | 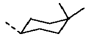 | H | Ph |
| 1040. | CH₂C(CH₃)₃ | H | 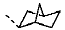 | H | Ph |
| 1041. | CH₂C(CH₃)₃ | H | 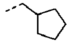 | H | Ph |
| 1042. | CH₂C(CH₃)₃ | H | 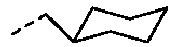 | H | Ph |
| 1043. | 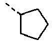 | H | CH₂CH₃ | H | Ph |
| 1044. | 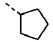 | H | CH(CH₃)₂ | H | Ph |
| 1045. | 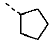 | H | CH₂CH(CH₃)₂ | H | Ph |
| 1046. | 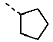 | H | C(CH₃)₃ | H | Ph |
| 1047. | 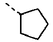 | H | CH₂C(CH₃)₃ | H | Ph |
| 1048. | 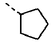 | H | 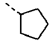 | H | Ph |
| 1049. | 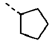 | H | 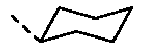 | H | Ph |
| 1050. | 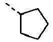 | H | 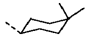 | H | Ph |
| 1051. | 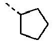 | H | 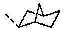 | H | Ph |
| 1052. | 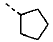 | H | 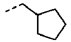 | H | Ph |
| 1053. | 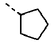 | H | 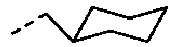 | H | Ph |
| 1054. | 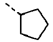 | H | CH₂CH₃ | H | Ph |
| 1055. | 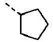 | H | CH(CH₃)₂ | H | Ph |
| 1056. | 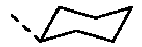 | H | CH₂CH(CH₃)₂ | H | Ph |
| 1057. | 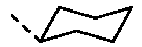 | H | C(CH₃)₃ | H | Ph |
| 1058. | 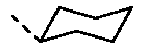 | H | CH₂C(CH₃)₃ | H | Ph |
| 1059. | 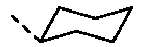 | H | 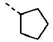 | H | Ph |
| 1060. | 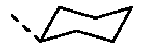 | H | 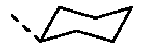 | H | Ph |
| 1061. | 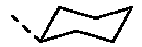 | H | 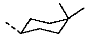 | H | Ph |
| 1062. | 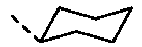 | H | 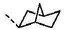 | H | Ph |
| 1063. | 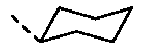 | H | 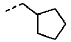 | H | Ph |
| 1064. | 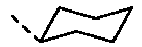 | H | 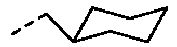 | H | Ph |
| 1065. | 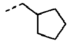 | H | CH₂CH(CH₃)₂ | H | Ph |
| 1066. | 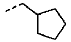 | H | C(CH₃)₃ | H | Ph |
| 1067. | 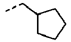 | H | CH₂C(CH₃)₃ | H | Ph |
| 1068. | 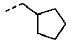 | H | 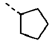 | H | Ph |
| 1069. | 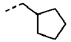 | H | 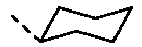 | H | Ph |
| 1070. | 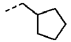 | H | 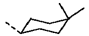 | H | Ph |
| 1071. | 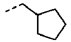 | H | 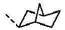 | H | Ph |
| 1072. | 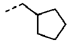 | H | 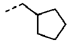 | H | Ph |
| 1073. | 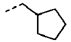 | H | 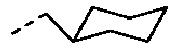 | H | Ph |
| 1074. | 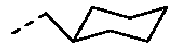 | H | CH₂CH(CH₃)₂ | H | Ph |
| 1075. | 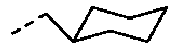 | H | C(CH₃)₃ | H | Ph |
| 1076. | 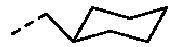 | H | CH₂C(CH₃)₃ | H | Ph |
| 1077. | 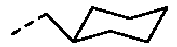 | H | 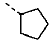 | H | Ph |
| 1078. | 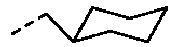 | H | 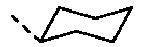 | H | Ph |
| 1079. | 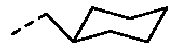 | H | 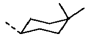 | H | Ph |
| 1080. | 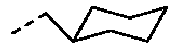 | H | 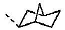 | H | Ph |
| 1081. | 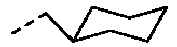 | H | 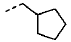 | H | Ph |
| 1082. | 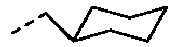 | H | 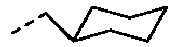 | H | Ph |
| 1083. | 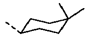 | H | CH₂CH(CH₃)₂ | H | Ph |
| 1084. | 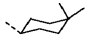 | H | C(CH₃)₃ | H | Ph |
| 1085. | 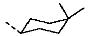 | H | CH₂C(CH₃)₃ | H | Ph |
| 1086. | 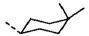 | H | 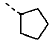 | H | Ph |
| 1087. | 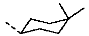 | H | 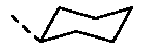 | H | Ph |
| 1088. | 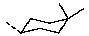 | H | 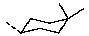 | H | Ph |
| 1089. | 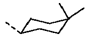 | H | 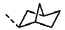 | H | Ph |
| 1090. | 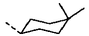 | H | 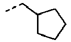 | H | Ph |
| 1091. | 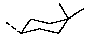 | H | 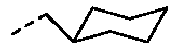 | H | Ph |
| 1092. | H | H | H | H | Ph |
| 1093. | CD₃ | H | H | H | Ph |
| 1094. | H | CD₃ | H | H | Ph |
| 1095. | H | H | CD₃ | H | Ph |
| 1096. | CD₃ | CD₃ | H | CD₃ | Ph |
| 1097. | CD₃ | H | CD₃ | H | Ph |
| 1098. | CD₃ | H | H | CD₃ | Ph |
| 1099. | H | CD₃ | CD₃ | H | Ph |
| 1100. | H | CD₃ | H | CD₃ | Ph |
| 1101. | H | H | CD₃ | CD₃ | Ph |
| 1102. | CD₃ | CD₃ | CD₃ | H | Ph |
| 1103. | CD₃ | CD₃ | H | CD₃ | Ph |
| 1104. | CD₃ | H | CD₃ | CD₃ | Ph |
| 1105. | H | CD₃ | CD₃ | CD₃ | Ph |
| 1106. | CD₃ | CD₃ | CD₃ | CD₃ | Ph |
| 1107. | CD₂CH₃ | H | H | H | Ph |
| 1108. | CD₂CH₃ | CD₃ | H | CD₃ | Ph |
| 1109. | CD₂CH₃ | H | CD₃ | H | Ph |
| 1110. | CD₂CH₃ | H | H | CD₃ | Ph |
| 1111. | CD₂CH₃ | CD₃ | CD₃ | H | Ph |
| 1112. | CD₂CH₃ | CD₃ | H | CD₃ | Ph |
| 1113. | CD₂CH₃ | H | CD₃ | CD₃ | Ph |
| 1114. | CD₂CH₃ | CD₃ | CD₃ | CD₃ | Ph |
| 1115. | H | CD₂CH₃ | H | H | Ph |
| 1116. | CH₃ | CD₂CH₃ | H | CD₃ | Ph |
| 1117. | H | CD₂CH₃ | CD₃ | H | Ph |
| 1118. | H | CD₂CH₃ | H | CD₃ | Ph |
| 1119. | CD₃ | CD₂CH₃ | CD₃ | H | Ph |
| 1120. | CD₃ | CD₂CH₃ | H | CD₃ | Ph |
| 1121. | H | CD₂CH₃ | CD₃ | CD₃ | Ph |
| 1122. | CD₃ | CD₂CH₃ | CD₃ | CD₃ | Ph |
| 1123. | H | H | CD₂CH₃ | H | Ph |
| 1124. | CD₃ | H | CD₂CH₃ | H | Ph |
| 1125. | H | CD₃ | CD₂CH₃ | H | Ph |
| 1126. | H | H | CD₂CH₃ | CD₃ | Ph |
| 1127. | CD₃ | CD₃ | CD₂CH₃ | H | Ph |
| 1128. | CD₃ | H | CD₂CH₃ | CD₃ | Ph |
| 1129. | H | CD₃ | CD₂CH₃ | CD₃ | Ph |
| 1130. | CD₃ | CD₃ | CD₂CH₃ | CD₃ | Ph |
| 1131. | CD(CH₃)₂ | H | H | H | Ph |
| 1132. | CD(CH₃)₂ | CD₃ | H | CD₃ | Ph |
| 1133. | CD(CH₃)₂ | H | CD₃ | H | Ph |
| 1134. | CD(CH₃)₂ | H | H | CD₃ | Ph |
| 1135. | CD(CH₃)₂ | CD₃ | CD₃ | H | Ph |
| 1136. | CD(CH₃)₂ | CD₃ | H | CD₃ | Ph |
| 1137. | CD(CH₃)₂ | H | CD₃ | CD₃ | Ph |
| 1138. | CD(CH₃)₂ | CD₃ | CD₃ | CD₃ | Ph |
| 1139. | H | CD(CH₃)₂ | H | H | Ph |
| 1140. | CD₃ | CD(CH₃)₂ | H | CD₃ | Ph |
| 1141. | H | CD(CH₃)₂ | CD₃ | H | Ph |
| 1142. | H | CD(CH₃)₂ | H | CD₃ | Ph |
| 1143. | CD₃ | CD(CH₃)₂ | CD₃ | H | Ph |
| 1144. | CD₃ | CD(CH₃)₂ | H | CD₃ | Ph |
| 1145. | H | CD(CH₃)₂ | CD₃ | CD₃ | Ph |
| 1146. | CD₃ | CD(CH₃)₂ | CD₃ | CD₃ | Ph |
| 1147. | H | H | CD(CH₃)₂ | H | Ph |
| 1148. | CD₃ | H | CD(CH₃)₂ | H | Ph |
| 1149. | H | CD₃ | CD(CH₃)₂ | H | Ph |
| 1150. | H | H | CD(CH₃)₂ | CD₃ | Ph |
| 1151. | CD₃ | CD₃ | CD(CH₃)₂ | H | Ph |
| 1152. | CD₃ | H | CD(CH₃)₂ | CD₃ | Ph |
| 1153. | H | CD₃ | CD(CH₃)₂ | CD₃ | Ph |
| 1154. | CD₃ | CD₃ | CD(CH₃)₂ | CD₃ | Ph |
| 1155. | CD(CD₃)₂ | H | H | H | Ph |
| 1156. | CD(CD₃)₂ | CD₃ | H | CD₃ | Ph |
| 1157. | CD(CD₃)₂ | H | CD₃ | H | Ph |
| 1158. | CD(CD₃)₂ | H | H | CD₃ | Ph |
| 1159. | CD(CD₃)₂ | CD₃ | CD₃ | H | Ph |
| 1160. | CD(CD₃)₂ | CD₃ | H | CD₃ | Ph |
| 1161. | CD(CD₃)₂ | H | CD₃ | CD₃ | Ph |
| 1162. | CD(CD₃)₂ | CD₃ | CD₃ | CD₃ | Ph |
| 1163. | H | CD(CD₃)₂ | H | H | Ph |
| 1164. | CH₃ | CD(CD₃)₂ | H | CD₃ | Ph |
| 1165. | H | CD(CD₃)₂ | CD₃ | H | Ph |
| 1166. | H | CD(CD₃)₂ | H | CD₃ | Ph |
| 1167. | CD₃ | CD(CD₃)₂ | CD₃ | H | Ph |
| 1168. | CD₃ | CD(CD₃)₂ | H | CD₃ | Ph |
| 1169. | H | CD(CD₃)₂ | CD₃ | CD₃ | Ph |
| 1170. | CD₃ | CD(CD₃)₂ | CD₃ | CD₃ | Ph |
| 1171. | H | H | CD(CD₃)₂ | H | Ph |
| 1172. | CD₃ | H | CD(CD₃)₂ | H | Ph |
| 1173. | H | CD₃ | CD(CD₃)₂ | H | Ph |
| 1174. | H | H | CD(CD₃)₂ | CD₃ | Ph |
| 1175. | CD₃ | CD₃ | CD(CD₃)₂ | H | Ph |
| 1176. | CD₃ | H | CD(CD₃)₂ | CD₃ | Ph |
| 1177. | H | CD₃ | CD(CD₃)₂ | CD₃ | Ph |
| 1178. | CD₃ | CD₃ | CD(CD₃)₂ | CD₃ | Ph |
| 1179. | CD₂CH(CH₃)₂ | H | H | H | Ph |
| 1180. | CD₂CH(CH₃)₂ | CD₃ | H | CD₃ | Ph |
| 1181. | CD₂CH(CH₃)₂ | H | CD₃ | H | Ph |
| 1182. | CD₂CH(CH₃)₂ | H | H | CD₃ | Ph |
| 1183. | CD₂CH(CH₃)₂ | CD₃ | CD₃ | H | Ph |
| 1184. | CD₂CH(CH₃)₂ | CD₃ | H | CD₃ | Ph |
| 1185. | CD₂CH(CH₃)₂ | H | CD₃ | CD₃ | Ph |
| 1186. | CD₂CH(CH₃)₂ | CD₃ | CD₃ | CD₃ | Ph |
| 1187. | H | CD₂CH(CH₃)₂ | H | H | Ph |
| 1188. | CD₃ | CD₂CH(CH₃)₂ | H | CD₃ | Ph |
| 1189. | H | CD₂CH(CH₃)₂ | CD₃ | H | Ph |
| 1190. | H | CD₂CH(CH₃)₂ | H | CD₃ | Ph |
| 1191. | CD₃ | CD₂CH(CH₃)₂ | CD₃ | H | Ph |
| 1192. | CD₃ | CD₂CH(CH₃)₂ | H | CD₃ | Ph |
| 1193. | H | CD₂CH(CH₃)₂ | CD₃ | CD₃ | Ph |
| 1194. | CD₃ | CD₂CH(CH₃)₂ | CD₃ | CD₃ | Ph |
| 1195. | H | H | CD₂CH(CH₃)₂ | H | Ph |
| 1196. | CD₃ | H | CD₂CH(CH₃)₂ | H | Ph |
| 1197. | H | CD₃ | CD₂CH(CH₃)₂ | H | Ph |
| 1198. | H | H | CD₂CH(CH₃)₂ | CD₃ | Ph |
| 1199. | CD₃ | CD₃ | CD₂CH(CH₃)₂ | H | Ph |
| 1200. | CD₃ | H | CD₂CH(CH₃)₂ | CD₃ | Ph |
| 1201. | H | CD₃ | CD₂CH(CH₃)₂ | CD₃ | Ph |
| 1202. | CD₃ | CD₃ | CD₂CH(CH₃)₂ | CD₃ | Ph |
| 1203. | CD₂C(CH₃)₃ | H | H | H | Ph |
| 1204. | CD₂C(CH₃)₃ | CD₃ | H | CD₃ | Ph |
| 1205. | CD₂C(CH₃)₃ | H | CD₃ | H | Ph |
| 1206. | CD₂C(CH₃)₃ | H | H | CD₃ | Ph |
| 1207. | CD₂C(CH₃)₃ | CD₃ | CD₃ | H | Ph |
| 1208. | CD₂C(CH₃)₃ | CD₃ | H | CD₃ | Ph |
| 1209. | CD₂C(CH₃)₃ | H | CD₃ | CD₃ | Ph |
| 1210. | CD₂C(CH₃)₃ | CH₃ | CD₃ | CD₃ | Ph |
| 1211. | H | CD₂C(CH₃)₃ | H | H | Ph |
| 1212. | CD₃ | CD₂C(CH₃)₃ | H | CD₃ | Ph |
| 1213. | H | CD₂C(CH₃)₃ | CD₃ | H | Ph |
| 1214. | H | CD₂C(CH₃)₃ | H | CD₃ | Ph |
| 1215. | CD₃ | CD₂C(CH₃)₃ | CD₃ | H | Ph |
| 1216. | CD₃ | CD₂C(CH₃)₃ | H | CD₃ | Ph |
| 1217. | H | CD₂C(CH₃)₃ | CD₃ | CD₃ | Ph |
| 1218. | CD₃ | CD₂C(CH₃)₃ | CD₃ | CD₃ | Ph |
| 1219. | H | H | CD₂C(CH₃)₃ | H | Ph |
| 1220. | CD₃ | H | CD₂C(CH₃)₃ | H | Ph |
| 1221. | H | CD₃ | CD₂C(CH₃)₃ | H | Ph |
| 1222. | H | H | CD₂C(CH₃)₃ | CD₃ | Ph |
| 1223. | CD₃ | CD₃ | CD₂C(CH₃)₃ | H | Ph |
| 1224. | CD₃ | H | CD₂C(CH₃)₃ | CD₃ | Ph |
| 1225. | H | CD₃ | CD₂C(CH₃)₃ | CD₃ | Ph |
| 1226. | CD₃ | CD₃ | CD₂C(CH₃)₃ | CD₃ | Ph |
| 1227. | 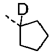 | H | H | H | Ph |
| 1228. | 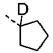 | CD₃ | H | CD₃ | Ph |
| 1229. | 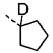 | H | CD₃ | H | Ph |
| 1230. | 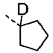 | H | H | CD₃ | Ph |
| 1231. | 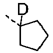 | CD₃ | CD₃ | H | Ph |
| 1232. | 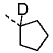 | CD₃ | H | CD₃ | Ph |
| 1233. | 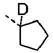 | H | CD₃ | CD₃ | Ph |
| 1234. | 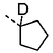 | CD₃ | CD₃ | CD₃ | Ph |
| 1235. | H | 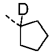 | H | H | Ph |
| 1236. | CD₃ | 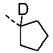 | H | CD₃ | Ph |
| 1237. | H | 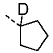 | CD₃ | H | Ph |
| 1238. | H | 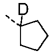 | H | CD₃ | Ph |
| 1239. | CD₃ | 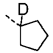 | CD₃ | H | Ph |
| 1240. | CD₃ | 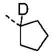 | H | CD₃ | Ph |
| 1241. | H | 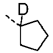 | CD₃ | CD₃ | Ph |
| 1242. | CD₃ | 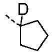 | CD₃ | CD₃ | Ph |
| 1243. | H | H | 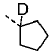 | H | Ph |
| 1244. | CD₃ | H | 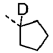 | H | Ph |
| 1245. | H | CD₃ | 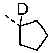 | H | Ph |
| 1246. | H | H | 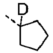 | CD₃ | Ph |
| 1247. | CD₃ | CD₃ | 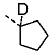 | H | Ph |
| 1248. | CD₃ | H | 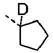 | CD₃ | Ph |
| 1249. | H | CD₃ | 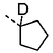 | CD₃ | Ph |
| 1250. | CD₃ | CD₃ | 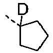 | CD₃ | Ph |
| 1251. | 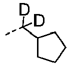 | H | H | H | Ph |
| 1252. | 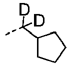 | CD₃ | H | CD₃ | Ph |
| 1253. | 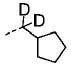 | H | CD₃ | H | Ph |
| 1254. | 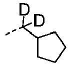 | H | H | CD₃ | Ph |
| 1255. | 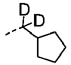 | CD₃ | CD₃ | H | Ph |
| 1256. | 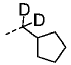 | CD₃ | H | CD₃ | Ph |
| 1257. | 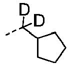 | H | CD₃ | CD₃ | Ph |
| 1258. | 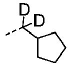 | CD₃ | CD₃ | CD₃ | Ph |
| 1259. | H | 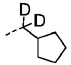 | H | H | Ph |
| 1260. | CH₃ | 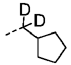 | H | CD₃ | Ph |
| 1261. | H | 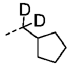 | CD₃ | H | Ph |
| 1262. | H | 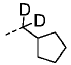 | H | CD₃ | Ph |
| 1263. | CD₃ | 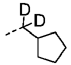 | CD₃ | H | Ph |
| 1264. | CD₃ | 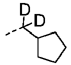 | H | CD₃ | Ph |
| 1265. | H | 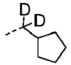 | CD₃ | CD₃ | Ph |
| 1266. | CH₃ | 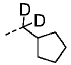 | CD₃ | CD₃ | Ph |
| 1267. | H | H | 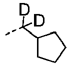 | H | Ph |
| 1268. | CD₃ | H | 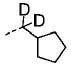 | H | Ph |
| 1269. | H | CD₃ | 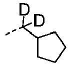 | H | Ph |
| 1270. | H | H | 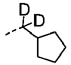 | CD₃ | Ph |
| 1271. | CD₃ | CD₃ | 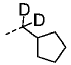 | H | Ph |
| 1272. | CD₃ | H | 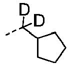 | CD₃ | Ph |
| 1273. | H | CD₃ | 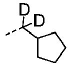 | CD₃ | Ph |
| 1274. | CD₃ | CD₃ | 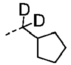 | CD₃ | Ph |
| 1275. | 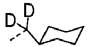 | H | H | H | Ph |
| 1276. | 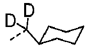 | CD₃ | H | CD₃ | Ph |
| 1277. | 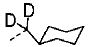 | H | CD₃ | H | Ph |
| 1278. | 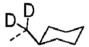 | H | H | CD₃ | Ph |
| 1279. | 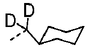 | CD₃ | CD₃ | H | Ph |
| 1280. | 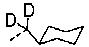 | CD₃ | H | CD₃ | Ph |
| 1281. | 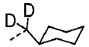 | H | CD₃ | CD₃ | Ph |
| 1282. | 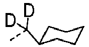 | CD₃ | CD₃ | CD₃ | Ph |
| 1283. | H | 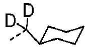 | H | H | Ph |
| 1284. | CD₃ | 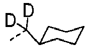 | H | CD₃ | Ph |
| 1285. | H | 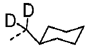 | CD₃ | H | Ph |
| 1286. | H | 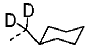 | H | CD₃ | Ph |
| 1287. | CD₃ | 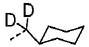 | CD₃ | H | Ph |
| 1288. | CD₃ | 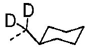 | H | CD₃ | Ph |
| 1289. | H | 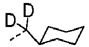 | CD₃ | CD₃ | Ph |
| 1290. | CD₃ | 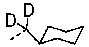 | CD₃ | CD₃ | Ph |
| 1291. | H | H | 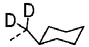 | H | Ph |
| 1292. | CD₃ | H | 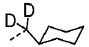 | H | Ph |
| 1293. | H | CD₃ | 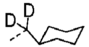 | H | Ph |
| 1294. | H | H | 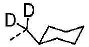 | CD₃ | Ph |
| 1295. | CD₃ | CD₃ | 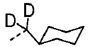 | H | Ph |
| 1296. | CD₃ | H | 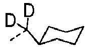 | CD₃ | Ph |
| 1297. | H | CD₃ | 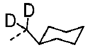 | CD₃ | Ph |
| 1298. | CD₃ | CD₃ | 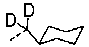 | CD₃ | Ph |
| 1299. | 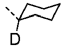 | H | H | H | Ph |
| 1300. | 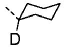 | CD₃ | H | CD₃ | Ph |
| 1301. | 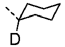 | H | CD₃ | H | Ph |
| 1302. | 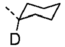 | H | H | CD₃ | Ph |
| 1303. | 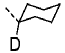 | 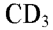 | CD₃ | H | Ph |
| 1304. | 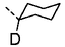 | 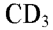 | H | CD₃ | Ph |
| 1305. | 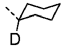 | 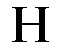 | CD₃ | CD₃ | Ph |
| 1306. | 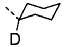 | 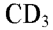 | CD₃ | CD₃ | Ph |
| 1307. | H | 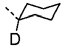 | H | H | Ph |
| 1308. | CD₃ | 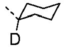 | H | CD₃ | Ph |
| 1309. | H | 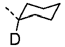 | CD₃ | H | Ph |
| 1310. | H | 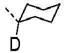 | H | CD₃ | Ph |
| 1311. | CD₃ | 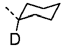 | CD₃ | H | Ph |
| 1312. | CD₃ | 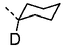 | H | CD₃ | Ph |
| 1313. | H | 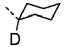 | CD₃ | CD₃ | Ph |
| 1314. | CD₃ | 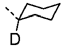 | CD₃ | CD₃ | Ph |
| 1315. | H | H | 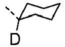 | H | Ph |
| 1316. | CD₃ | H | 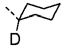 | H | Ph |
| 1317. | H | CD₃ | 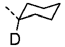 | H | Ph |
| 1318. | H | H | 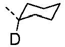 | CD₃ | Ph |
| 1319. | CD₃ | CD₃ | 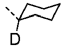 | H | Ph |
| 1320. | CD₃ | H | 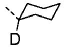 | CD₃ | Ph |
| 1321. | H | CD₃ | 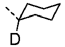 | CD₃ | Ph |
| 1322. | CD₃ | CD₃ | 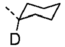 | CD₃ | Ph |
| 1323. | 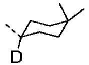 | H | H | H | Ph |
| 1324. | 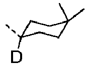 | CD₃ | H | CD₃ | Ph |
| 1325. | 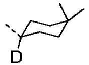 | H | CD₃ | H | Ph |
| 1326. | 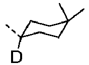 | H | H | CD₃ | Ph |
| 1327. | 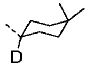 | CD₃ | CD₃ | H | Ph |
| 1328. | 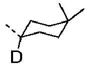 | CD₃ | H | CD₃ | Ph |
| 1329. | 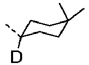 | H | CD₃ | CD₃ | Ph |
| 1330. | 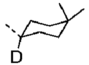 | CD₃ | CD₃ | CD₃ | Ph |
| 1331. | H | 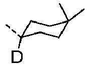 | H | H | Ph |
| 1332. | CD₃ | 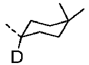 | H | CD₃ | Ph |
| 1333. | H | 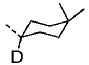 | CD₃ | H | Ph |
| 1334. | H | 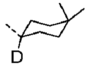 | H | CD₃ | Ph |
| 1335. | CD₃ | 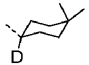 | CD₃ | H | Ph |
| 1336. | CD₃ | 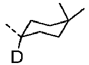 | H | CD₃ | Ph |
| 1337. | H | 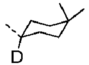 | CD₃ | CD₃ | Ph |
| 1338. | CD₃ | 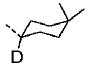 | CD₃ | CD₃ | Ph |
| 1339. | H | H | 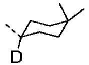 | H | Ph |
| 1340. | CD₃ | H | 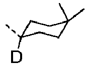 | H | Ph |
| 1341. | H | CD₃ | 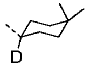 | H | Ph |
| 1342. | H | H | 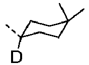 | CD₃ | Ph |
| 1343. | CD₃ | CD₃ | 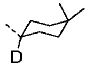 | H | Ph |
| 1344. | CD₃ | H | 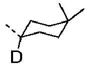 | CD₃ | Ph |
| 1345. | H | CD₃ | 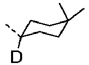 | CD₃ | Ph |
| 1346. | CD₃ | CD₃ | 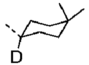 | CD₃ | Ph |
| 1347. | 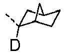 | H | H | H | Ph |
| 1348. | 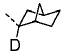 | CD₃ | H | CD₃ | Ph |
| 1349. | 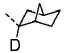 | H | CD₃ | H | Ph |
| 1350. | 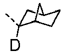 | H | H | CD₃ | Ph |
| 1351. | 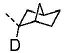 | CH₃ | CH₃ | H | Ph |
| 1352. | 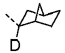 | CD₃ | H | CD₃ | Ph |
| 1353. | 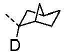 | H | CD₃ | CD₃ | Ph |
| 1354. | 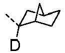 | CD₃ | CD₃ | CD₃ | Ph |
| 1355. | H | 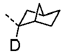 | H | H | Ph |
| 1356. | CD₃ | 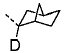 | H | CD₃ | Ph |
| 1357. | H | 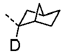 | CD₃ | H | Ph |
| 1358. | H | 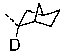 | H | CD₃ | Ph |
| 1359. | CD₃ | 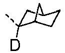 | CD₃ | H | Ph |
| 1360. | CD₃ | 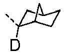 | H | CD₃ | Ph |
| 1361. | H | 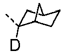 | CD₃ | CD₃ | Ph |
| 1362. | CD₃ | 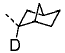 | CD₃ | CD₃ | Ph |
| 1363. | H | H | 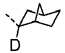 | H | Ph |
| 1364. | CD₃ | H | 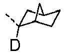 | H | Ph |
| 1365. | H | CD₃ | 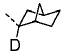 | H | Ph |
| 1366. | H | H | 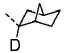 | CH₃ | Ph |
| 1367. | CD₃ | CD₃ | 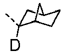 | H | Ph |
| 1368. | CD₃ | H | 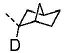 | CD₃ | Ph |
| 1369. | H | CD₃ | 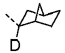 | CD₃ | Ph |
| 1370. | CD₃ | CD₃ | 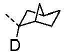 | CD₃ | Ph |
| 1371. | CD(CH₃)₂ | H | CD₂CH₃ | H | Ph |
| 1372. | CD(CH₃)₂ | H | CD(CH₃)₂ | H | Ph |
| 1373. | CD(CH₃)₂ | H | CD₂CH(CH₃)₂ | H | Ph |
| 1374. | CD(CH₃)₂ | H | C(CH₃)₃ | H | Ph |
| 1375. | CD(CH₃)₂ | H | CD₂C(CH₃)₃ | H | Ph |
| 1376. | CD(CH₃)₂ | H | 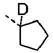 | H | Ph |
| 1377. | CD(CH₃)₂ | H | 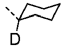 | H | Ph |
| 1378. | CD(CH₃)₂ | H | 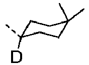 | H | Ph |
| 1379. | CD(CH₃)₂ | H | 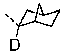 | H | Ph |
| 1380. | CD(CH₃)₂ | H | 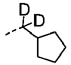 | H | Ph |
| 1381. | CD(CH₃)₂ | H | 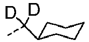 | H | Ph |
| 1382. | C(CH₃)₃ | H | CD₂CH₃ | H | Ph |
| 1383. | C(CH₃)₃ | H | CD(CH₃)₂ | H | Ph |
| 1384. | C(CH₃)₃ | H | CD₂CH(CH₃)₂ | H | Ph |
| 1385. | C(CH₃)₃ | H | C(CH₃)₃ | H | Ph |
| 1386. | C(CH₃)₃ | H | CD₂C(CH₃)₃ | H | Ph |
| 1387. | C(CH₃)₃ | H | 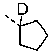 | H | Ph |
| 1388. | C(CH₃)₃ | H | 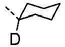 | H | Ph |
| 1389. | C(CH₃)₃ | H | 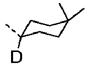 | H | Ph |
| 1390. | C(CH₃)₃ | H | 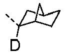 | H | Ph |
| 1391. | C(CH₃)₃ | H | 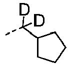 | H | Ph |
| 1392. | C(CH₃)₃ | H | 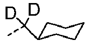 | H | Ph |
| 1393. | CD₂C(CH₃)₃ | H | CD₂CH₃ | H | Ph |
| 1394. | CD₂C(CH₃)₃ | H | CD(CH₃)₂ | H | Ph |
| 1395. | CD₂C(CH₃)₃ | H | CD₂CH(CH₃)₂ | H | Ph |
| 1396. | CD₂C(CH₃)₃ | H | C(CH₃)₃ | H | Ph |
| 1397. | CD₂C(CH₃)₃ | H | CD₂C(CH₃)₃ | H | Ph |
| 1398. | CD₂C(CH₃)₃ | H | 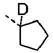 | H | Ph |
| 1399. | CD₂C(CH₃)₃ | H | 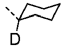 | H | Ph |
| 1400. | CD₂C(CH₃)₃ | H | 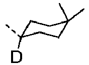 | H | Ph |
| 1401. | CD₂C(CH₃)₃ | H | 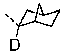 | H | Ph |
| 1402. | CD₂C(CH₃)₃ | H | 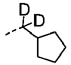 | H | Ph |
| 1403. | CD₂C(CH₃)₃ | H | 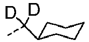 | H | Ph |
| 1404. | 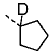 | H | CD₂CH₃ | H | Ph |
| 1405. | 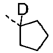 | H | CD(CH₃)₂ | H | Ph |
| 1406. | 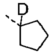 | H | CD₂CH(CH₃)₂ | H | Ph |
| 1407. | 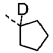 | H | C(CH₃)₃ | H | Ph |
| 1408. | 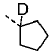 | H | CD₂C(CH₃)₃ | H | Ph |
| 1409. | 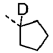 | H | 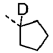 | H | Ph |
| 1410. | 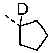 | H | 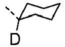 | H | Ph |
| 1411. | 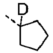 | H | 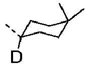 | H | Ph |
| 1412. | 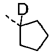 | H | 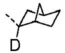 | H | Ph |
| 1413. | 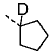 | H | 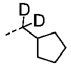 | H | Ph |
| 1414. | 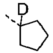 | H | 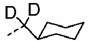 | H | Ph |
| 1415. | 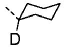 | H | CD₂CH₃ | H | Ph |
| 1416. | 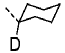 | H | CD(CH₃)₂ | H | Ph |
| 1417. | 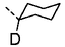 | H | CD₂CH(CH₃)₂ | H | Ph |
| 1418. | 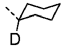 | H | C(CH₃)₃ | H | Ph |
| 1419. | 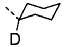 | H | CD₂C(CH₃)₃ | H | Ph |
| 1420. | 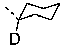 | H | 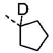 | H | Ph |
| 1421. | 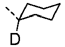 | H | 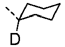 | H | Ph |
| 1422. | 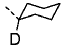 | H | 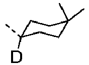 | H | Ph |
| 1423. | 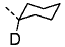 | H | 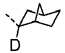 | H | Ph |
| 1424. | 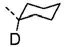 | H | 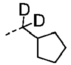 | H | Ph |
| 1425. | 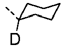 | H | 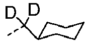 | H | Ph |
| 1426. | 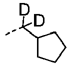 | H | CD₂CH₃ | H | Ph |
| 1427. | 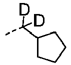 | H | CD(CH₃)₂ | H | Ph |
| 1428. | 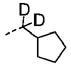 | H | CD₂CH(CH₃)₂ | H | Ph |
| 1429. | 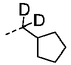 | H | C(CH₃)₃ | H | Ph |
| 1430. | 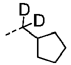 | H | CD₂C(CH₃)₃ | H | Ph |
| 1431. | 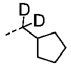 | H | 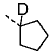 | H | Ph |
| 1432. | 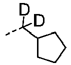 | H | 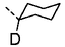 | H | Ph |
| 1433. | 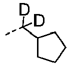 | H | 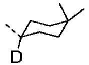 | H | Ph |
| 1434. | 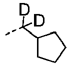 | H | 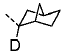 | H | Ph |
| 1435. | 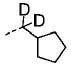 | H | 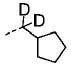 | H | Ph |
| 1436. | 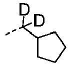 | H | 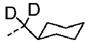 | H | Ph |
| 1437. | 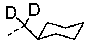 | H | CD₂CH₃ | H | Ph |
| 1438. | 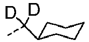 | H | CD(CH₃)₂ | H | Ph |
| 1439. | 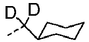 | H | CD₂CH(CH₃)₂ | H | Ph |
| 1440. | 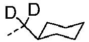 | H | C(CH₃)₃ | H | Ph |
| 1441. | 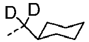 | H | CD₂C(CH₃)₃ | H | Ph |
| 1442. | 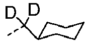 | H | 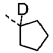 | H | Ph |
| 1443. | 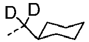 | H | 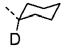 | H | Ph |
| 1444. | 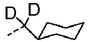 | H | 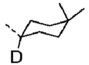 | H | Ph |
| 1445. | 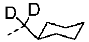 | H | 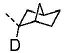 | H | Ph |
| 1446. | 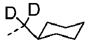 | H | 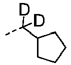 | H | Ph |
| 1447. | 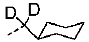 | H | 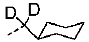 | H | Ph |
| 1448. | 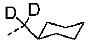 | H | CD₂CH₃ | H | Ph |
| 1449. | 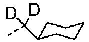 | H | CD(CH₃)₂ | H | Ph |
| 1450. | 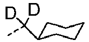 | H | CD₂CH(CH₃)₂ | H | Ph |
| 1451. | 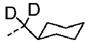 | H | C(CH₃)₃ | H | Ph |
| 1452. | 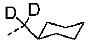 | H | CD₂C(CH₃)₃ | H | Ph |
| 1453. | 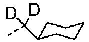 | H | 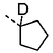 | H | Ph |
| 1454. | 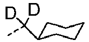 | H | 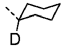 | H | Ph |
| 1455. | 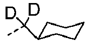 | H | 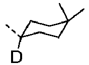 | H | Ph |
| 1456. | 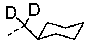 | H | 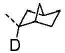 | H | Ph |
| 1457. | 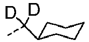 | H | 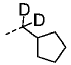 | H | Ph |
| 1458. | 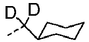 | H | 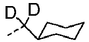 | H | Ph |
| 1459. | H | Ph | CD3 | H | H |
| 1460. | H | 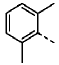 | CD₃ | H | H |
| 1461. | H | 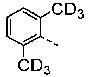 | CD₃ | H | H |
| 1462. | H | 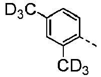 | CD₃ | H | H |

8. Eine organische Licht emittierende Vorrichtung (OLED) umfassend:
eine Anode;
eine Kathode; und
eine organische Schicht, angeordnet zwischen der Anode und der Kathode, umfassend eine Verbindung gemäß einem der vorhergehenden Ansprüche.

9. Die OLED nach Anspruch 8, wobei die organische Schicht ferner einen Wirt umfasst, wobei der Wirt ein Triphenylen enthaltendes Benzo-fusioniertes Thiophen oder Benzo-fusioniertes Furan umfasst;
wobei jeder Substituent in dem Wirt ein nicht fusionierter Substituent unabhängig ausgewählt aus der Gruppe bestehend aus CₙH₂ₙ₊₁, OCₙH₂ₙ₊₁, OAr₁, N(CₙH₂ₙ₊₁)₂, N(Ar₁)(Ar₂), CH=CH-CₙH₂ₙ₊₁, C=CCₙH₂ₙ₊₁, Ar₁, Ar₁₋Ar₂, und CₙH₂ₙ-Ar₁ ist, oder der Wirt keine Substitutionen aufweist;
wobei n von 1 bis 10 ist; und
wobei Ar₁ und Ar₂ jeweils unabhängig ausgewählt sind aus der Gruppe bestehend aus Benzol, Biphenyl, Naphthalen, Triphenylen, Carbazol, und heteroaromatische Analogata davon.

10. Die OLED nach Anspruch 8, wobei die organische Schicht ferner einen Wirt umfasst, wobei der Wirt mindestens eine chemische Gruppe umfasst, die ausgewählt ist aus der Gruppe bestehend aus Triphenylen, Carbazol, Dibenzothiophen, Dibenzofuran, Dibenzoselenophen, Azatriphenylen, Azacarbazol, Aza-dibenzothiophen, Aza-dibenzofuran, und Aza-dibenzoselenophen; oder der Wirt ausgewählt ist aus der Gruppe bestehend aus: 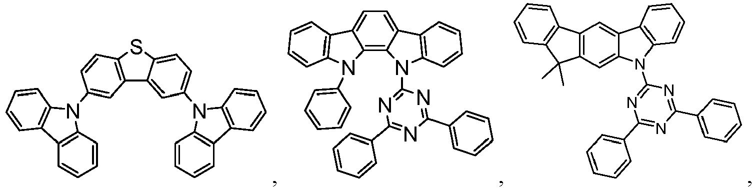 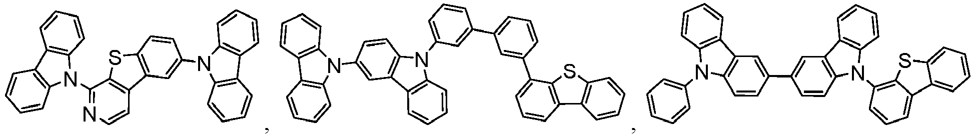 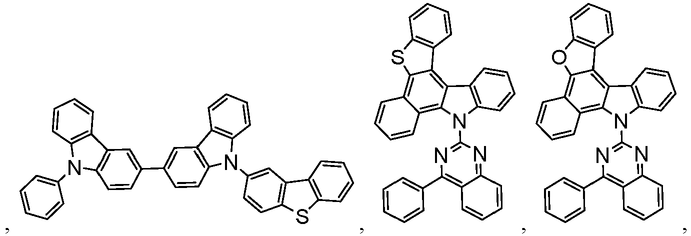 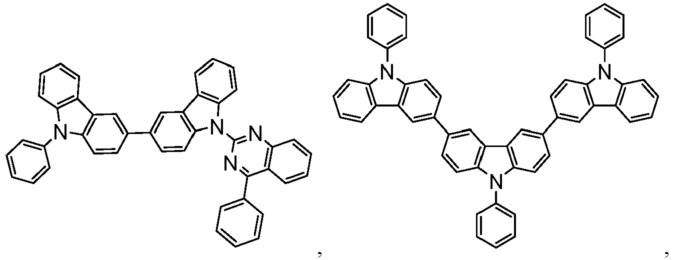 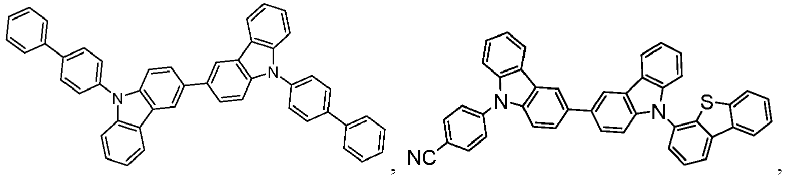 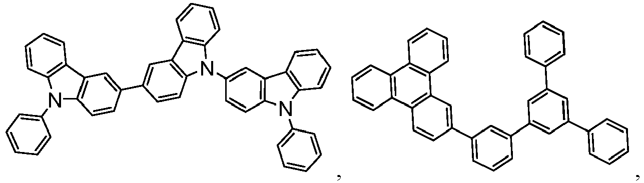 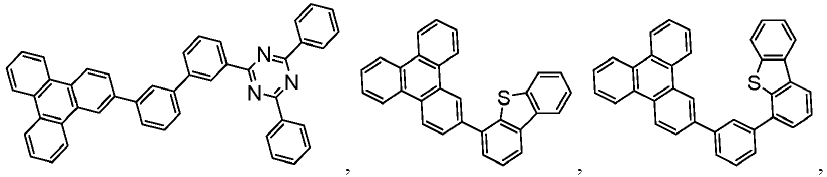 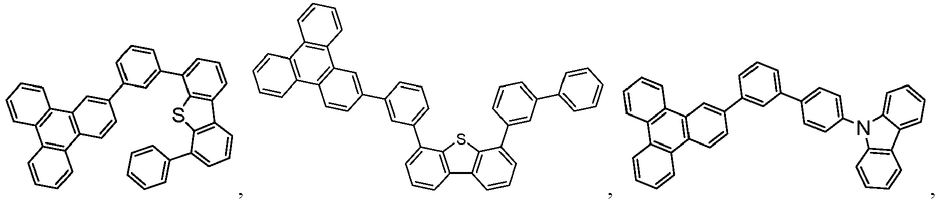 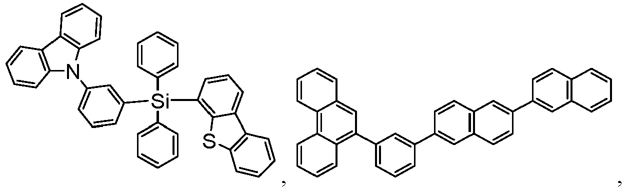 und deren Kombinationen; oder
der Wirt umfasst einen Metallkomplex.

11. Ein Konsumentenprodukt umfassend eine organische Licht emittierende Vorrichtung (OLED) umfassend:
eine Anode;
eine Kathode; und
eine organische Schicht, angeordnet zwischen der Anode und der Kathode, umfassend eine Verbindung gemäß einem der Ansprüche 1 bis 7.

12. Das Konsumentenprodukt nach Anspruch 11, wobei das Konsumentenprodukt ausgewählt ist aus der Gruppe bestehend aus einem Flachbildschirm, einem Computermonitor, einem medizinischen Monitor, einem Fernseher, einer Anzeigetafel, einem Licht für interne oder externe Beleuchtung und/oder Signalgebung, ein Heads-up-Display, eine vollständig oder teilweise transparente Anzeigevorrichtung, eine flexible Anzeigevorrichtung, ein Laserdrucker, ein Telefon, ein Mobiltelefon, ein Tablet, ein Phablet, ein persönlicher Digitalassistent (PDA), eine tragbare Vorrichtung, ein Laptopcomputer, eine Digitalkamera, ein Camcorder, ein Sucher, ein Mikrodisplay, das weniger als 2 Inch diagonal groß ist, ein 3-D-Display, eine Anzeigevorrichtung für virtuelle Realität oder augmentierte Realität, ein Fahrzeug, eine Videowand umfassend eine Vielzahl von Bildschirmen, die plattenartig zusammengefasst sind, ein Theater- oder Stadionbildschirm, und ein Zeichen.

## Revendications

1. Composé ayant une formule Ir(L_{A})(L_{B})(L_{C});
où le ligand L_{A} est 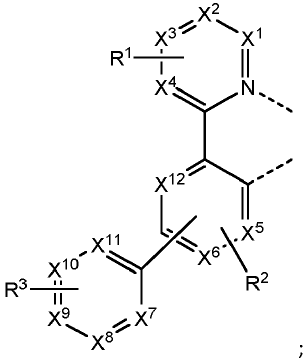 où le ligand L_{B} est 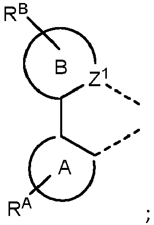
où le ligand L_{C} est 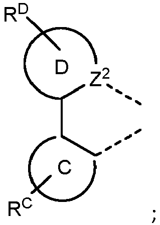
où les cycles A, B, C, et D sont chacun indépendamment un cycle carbocyclique ou hétérocyclique à 5 ou 6 chaînons ;
où chaque R¹, R², R³, R^{A}, R^{B}, R^{C}, et R^{D} représente indépendamment des mono substitutions à un nombre maximal possible de substitutions, ou aucune substitution ;
où X¹ à X¹², Z¹, et Z² sont chacun indépendamment C ou N ;
où L_{A}, L_{B}, et L_{C} sont différents les uns des autres, et peuvent être reliés les uns aux autres afin de former un ligand multidentate ;
où R¹, R², R³, R^{A}, R^{B}, R^{C}, et R^{D} sont chacun indépendamment choisis dans le groupe constitué par hydrogène, deutérium, halogénure, alkyle, cycloalkyle, hétéroalkyle, arylalkyle, alcoxy, aryloxy, amino, silyle, alcényle, cycloalcényle, hétéroalcényle, alcynyle, aryle, hétéroaryle, acyle, carbonyle, acides carboxyliques, ester, nitrile, isonitrile, sulfanyle, sulfinyle, sulfonyle, phosphino, et leurs combinaisons ;
où deux substituants quelconques ou plus parmi R¹, R², R³, R^{A}, R^{B}, R^{C}, et R^{D} sont facultativement liés ou fusionnés en un cycle ; et
où au moins l'un parmi R^{A}, R^{B}, R^{C}, et R^{D} est choisi dans le groupe constitué par alkyle, cycloalkyle, aryle, hétéroaryle, leurs variantes partiellement ou totalement deutérées, leurs variantes partiellement ou totalement fluorées, et leurs combinaisons.

2. Composé selon la revendication 1, où les cycles A et C sont un benzène, et les cycles B et D sont une pyridine.

3. Composé selon la revendication 1, où les cycles A, B, C, et D sont chacun indépendamment choisis dans le groupe constitué par phényle, pyridine, imidazole, et carbène dérivé d'imidazole.

4. Composé selon la revendication 1, où Z¹ et Z² sont N.

5. Composé selon la revendication 1, où le ligand L_{A} est

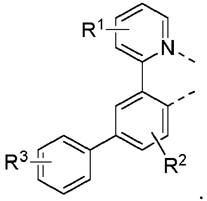

6. Composé selon la revendication 1, où le composé est choisi dans le groupe constitué par : 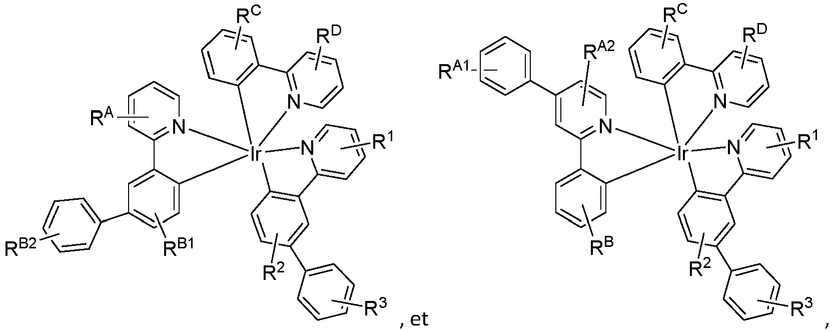
R^{A1} et R^{A2} ont la même définition que R^{A}; et
R^{B1} et R^{B2} ont la même définition que R^{B}.

7. Composé selon la revendication 1, où au moins l'un parmi L_{B} et L_{C} est choisi dans le groupe constitué par :
L*ᵢ*, où L*ᵢ* est 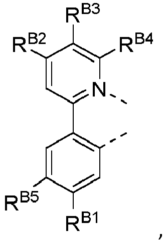 où pour chaque *i* allant de 1 à 1462, R^{B1}, R^{B2}, R^{B3}, R^{B4}, et R^{B5} sont définis comme suit pour chaque *i* :
| ***i* dans L*i*** | **R^{B1}** | **R^{B2}** | **R^{B3}** | **R^{B4}** | **R^{B5}** |
|---|---|---|---|---|---|
| 1. | H | H | H | H | H |
| 2. | CH₃ | H | H | H | H |
| 3. | H | CH₃ | H | H | H |
| 4. | H | H | CH₃ | H | H |
| 5. | CH₃ | CH₃ | H | CH₃ | H |
| 6. | CH₃ | H | CH₃ | H | H |
| 7. | CH₃ | H | H | CH₃ | H |
| 8. | H | CH₃ | CH₃ | H | H |
| 9. | H | CH₃ | H | CH₃ | H |
| 10. | H | H | CH₃ | CH₃ | H |
| 11. | CH₃ | CH₃ | CH₃ | H | H |
| 12. | CH₃ | CH₃ | H | CH₃ | H |
| 13. | CH₃ | H | CH₃ | CH₃ | H |
| 14. | H | CH₃ | CH₃ | CH₃ | H |
| 15. | CH₃ | CH₃ | CH₃ | CH₃ | H |
| 16. | CH₂CH₃ | H | H | H | H |
| 17. | CH₂CH₃ | CH₃ | H | CH₃ | H |
| 18. | CH₂CH₃ | H | CH₃ | H | H |
| 19. | CH₂CH₃ | H | H | CH₃ | H |
| 20. | CH₂CH₃ | CH₃ | CH₃ | H | H |
| 21. | CH₂CH₃ | CH₃ | H | CH₃ | H |
| 22. | CH₂CH₃ | H | CH₃ | CH₃ | H |
| 23. | CH₂CH₃ | CH₃ | CH₃ | CH₃ | H |
| 24. | H | CH₂CH₃ | H | H | H |
| 25. | CH₃ | CH₂CH₃ | H | CH₃ | H |
| 26. | H | CH₂CH₃ | CH₃ | H | H |
| 27. | H | CH₂CH₃ | H | CH₃ | H |
| 28. | CH₃ | CH₂CH₃ | CH₃ | H | H |
| 29. | CH₃ | CH₂CH₃ | H | CH₃ | H |
| 30. | H | CH₂CH₃ | CH₃ | CH₃ | H |
| 31. | CH₃ | CH₂CH₃ | CH₃ | CH₃ | H |
| 32. | H | H | CH₂CH₃ | H | H |
| 33. | CH₃ | H | CH₂CH₃ | H | H |
| 34. | H | CH₃ | CH₂CH₃ | H | H |
| 35. | H | H | CH₂CH₃ | CH₃ | H |
| 36. | CH₃ | CH₃ | CH₂CH₃ | H | H |
| 37. | CH₃ | H | CH₂CH₃ | CH₃ | H |
| 38. | H | CH₃ | CH₂CH₃ | CH₃ | H |
| 39. | CH₃ | CH₃ | CH₂CH₃ | CH₃ | H |
| 40. | CH(CH₃)₂ | H | H | H | H |
| 41. | CH(CH₃)₂ | CH₃ | H | CH₃ | H |
| 42. | CH(CH₃)₂ | H | CH₃ | H | H |
| 43. | CH(CH₃)₂ | H | H | CH₃ | H |
| 44. | CH(CH₃)₂ | CH₃ | CH₃ | H | H |
| 45. | CH(CH₃)₂ | CH₃ | H | CH₃ | H |
| 46. | CH(CH₃)₂ | H | CH₃ | CH₃ | H |
| 47. | CH(CH₃)₂ | CH₃ | CH₃ | CH₃ | H |
| 48. | H | CH(CH₃)₂ | H | H | H |
| 49. | CH₃ | CH(CH₃)₂ | H | CH₃ | H |
| 50. | H | CH(CH₃)₂ | CH₃ | H | H |
| 51. | H | CH(CH₃)₂ | H | CH₃ | H |
| 52. | CH₃ | CH(CH₃)₂ | CH₃ | H | H |
| 53. | CH₃ | CH(CH₃)₂ | H | CH₃ | H |
| 54. | H | CH(CH₃)₂ | CH₃ | CH₃ | H |
| 55. | CH₃ | CH(CH₃)₂ | CH₃ | CH₃ | H |
| 56. | H | H | CH(CH₃)₂ | H | H |
| 57. | CH₃ | H | CH(CH₃)₂ | H | H |
| 58. | H | CH₃ | CH(CH₃)₂ | H | H |
| 59. | H | H | CH(CH₃)₂ | CH₃ | H |
| 60. | CH₃ | CH₃ | CH(CH₃)₂ | H | H |
| 61. | CH₃ | H | CH(CH₃)₂ | CH₃ | H |
| 62. | H | CH₃ | CH(CH₃)₂ | CH₃ | H |
| 63. | CH₃ | CH₃ | CH(CH₃)₂ | CH₃ | H |
| 64. | CH₂CH(CH₃)₂ | H | H | H | H |
| 65. | CH₂CH(CH₃)₂ | CH₃ | H | CH₃ | H |
| 66. | CH₂CH(CH₃)₂ | H | CH₃ | H | H |
| 67. | CH₂CH(CH₃)₂ | H | H | CH₃ | H |
| 68. | CH₂CH(CH₃)₂ | CH₃ | CH₃ | H | H |
| 69. | CH₂CH(CH₃)₂ | CH₃ | H | CH₃ | H |
| 70. | CH₂CH(CH₃)₂ | H | CH₃ | CH₃ | H |
| 71. | CH₂CH(CH₃)₂ | CH₃ | CH₃ | CH₃ | H |
| 72. | H | CH₂CH(CH₃)₂ | H | H | H |
| 73. | CH₃ | CH₂CH(CH₃)₂ | H | CH₃ | H |
| 74. | H | CH₂CH(CH₃)₂ | CH₃ | H | H |
| 75. | H | CH₂CH(CH₃)₂ | H | CH₃ | H |
| 76. | CH₃ | CH₂CH(CH₃)₂ | CH₃ | H | H |
| 77. | CH₃ | CH₂CH(CH₃)₂ | H | CH₃ | H |
| 78. | H | CH₂CH(CH₃)₂ | CH₃ | CH₃ | H |
| 79. | CH₃ | CH₂CH(CH₃)₂ | CH₃ | CH₃ | H |
| 80. | H | H | CH₂CH(CH₃)₂ | H | H |
| 81. | CH₃ | H | CH₂CH(CH₃)₂ | H | H |
| 82. | H | CH₃ | CH₂CH(CH₃)₂ | H | H |
| 83. | H | H | CH₂CH(CH₃)₂ | CH₃ | H |
| 84. | CH₃ | CH₃ | CH₂CH(CH₃)₂ | H | H |
| 85. | CH₃ | H | CH₂CH(CH₃)₂ | CH₃ | H |
| 86. | H | CH₃ | CH₂CH(CH₃)₂ | CH₃ | H |
| 87. | CH₃ | CH₃ | CH₂CH(CH₃)₂ | CH₃ | H |
| 88. | C(CH₃)₃ | H | H | H | H |
| 89. | C(CH₃)₃ | CH₃ | H | CH₃ | H |
| 90. | C(CH₃)₃ | H | CH₃ | H | H |
| 91. | C(CH₃)₃ | H | H | CH₃ | H |
| 92. | C(CH₃)₃ | CH₃ | CH₃ | H | H |
| 93. | C(CH₃)₃ | CH₃ | H | CH₃ | H |
| 94. | C(CH₃)₃ | H | CH₃ | CH₃ | H |
| 95. | C(CH₃)₃ | CH₃ | CH₃ | CH₃ | H |
| 96. | H | C(CH₃)₃ | H | H | H |
| 97. | CH₃ | C(CH₃)₃ | H | CH₃ | H |
| 98. | H | C(CH₃)₃ | CH₃ | H | H |
| 99. | H | C(CH₃)₃ | H | CH₃ | H |
| 100. | CH₃ | C(CH₃)₃ | CH₃ | H | H |
| 101. | CH₃ | C(CH₃)₃ | H | CH₃ | H |
| 102. | H | C(CH₃)₃ | CH₃ | CH₃ | H |
| 103. | CH₃ | C(CH₃)₃ | CH₃ | CH₃ | H |
| 104. | H | H | C(CH₃)₃ | H | H |
| 105. | CH₃ | H | C(CH₃)₃ | H | H |
| 106. | H | CH₃ | C(CH₃)₃ | H | H |
| 107. | H | H | C(CH₃)₃ | CH₃ | H |
| 108. | CH₃ | CH₃ | C(CH₃)₃ | H | H |
| 109. | CH₃ | H | C(CH₃)₃ | CH₃ | H |
| 110. | H | CH₃ | C(CH₃)₃ | CH₃ | H |
| 111. | CH₃ | CH₃ | C(CH₃)₃ | CH₃ | H |
| 112. | CH₂C(CH₃)₃ | H | H | H | H |
| 113. | CH₂C(CH₃)₃ | CH₃ | H | CH₃ | H |
| 114. | CH₂C(CH₃)₃ | H | CH₃ | H | H |
| 115. | CH₂C(CH₃)₃ | H | H | CH₃ | H |
| 116. | CH₂C(CH₃)₃ | CH₃ | CH₃ | H | H |
| 117. | CH₂C(CH₃)₃ | CH₃ | H | CH₃ | H |
| 118. | CH₂C(CH₃)₃ | H | CH₃ | CH₃ | H |
| 119. | CH₂C(CH₃)₃ | CH₃ | CH₃ | CH₃ | H |
| 120. | H | CH₂C(CH₃)₃ | H | H | H |
| 121. | CH₃ | CH₂C(CH₃)₃ | H | CH₃ | H |
| 122. | H | CH₂C(CH₃)₃ | CH₃ | H | H |
| 123. | H | CH₂C(CH₃)₃ | H | CH₃ | H |
| 124. | CH₃ | CH₂C(CH₃)₃ | CH₃ | H | H |
| 125. | CH₃ | CH₂C(CH₃)₃ | H | CH₃ | H |
| 126. | H | CH₂C(CH₃)₃ | CH₃ | CH₃ | H |
| 127. | CH₃ | CH₂C(CH₃)₃ | CH₃ | CH₃ | H |
| 128. | H | H | CH₂C(CH₃)₃ | H | H |
| 129. | CH₃ | H | CH₂C(CH₃)₃ | H | H |
| 130. | H | CH₃ | CH₂C(CH₃)₃ | H | H |
| 131. | H | H | CH₂C(CH₃)₃ | CH₃ | H |
| 132. | CH₃ | CH₃ | CH₂C(CH₃)₃ | H | H |
| 133. | CH₃ | H | CH₂C(CH₃)₃ | CH₃ | H |
| 134. | H | CH₃ | CH₂C(CH₃)₃ | CH₃ | H |
| 135. | CH₃ | CH₃ | CH₂C(CH₃)₃ | CH₃ | H |
| 136. | 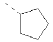 | H | H | H | H |
| 137. | 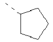 | CH₃ | H | CH₃ | H |
| 138. | 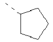 | H | CH₃ | H | H |
| 139. | 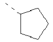 | H | H | CH₃ | H |
| 140. | 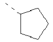 | CH₃ | CH₃ | H | H |
| 141. | 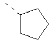 | CH₃ | H | CH₃ | H |
| 142. | 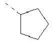 | H | CH₃ | CH₃ | H |
| 143. | 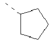 | CH₃ | CH₃ | CH₃ | H |
| 144. | H | 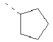 | H | H | H |
| 145. | CH₃ | 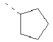 | H | CH₃ | H |
| 146. | H | 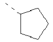 | CH₃ | H | H |
| 147. | H | 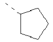 | H | CH₃ | H |
| 148. | CH₃ | 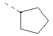 | CH₃ | H | H |
| 149. | CH₃ | 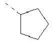 | H | CH₃ | H |
| 150. | H | 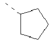 | CH₃ | CH₃ | H |
| 151. | CH₃ | 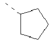 | CH₃ | CH₃ | H |
| 152. | H | H | 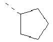 | H | H |
| 153. | CH₃ | H | 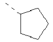 | H | H |
| 154. | H | CH₃ | 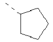 | H | H |
| 155. | H | H | 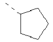 | CH₃ | H |
| 156. | CH₃ | CH₃ | 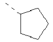 | H | H |
| 157. | CH₃ | H | 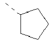 | CH₃ | H |
| 158. | H | CH₃ | 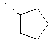 | CH₃ | H |
| 159. | CH₃ | CH₃ | 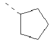 | CH₃ | H |
| 160. | 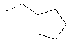 | H | H | H | H |
| 161. | 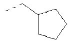 | CH₃ | H | CH₃ | H |
| 162. | 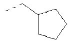 | H | CH₃ | H | H |
| 163. | 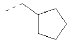 | H | H | CH₃ | H |
| 164. | 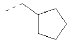 | CH₃ | CH₃ | H | H |
| 165. | 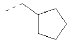 | CH₃ | H | CH₃ | H |
| 166. | 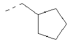 | H | CH₃ | CH₃ | H |
| 167. | 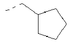 | CH₃ | CH₃ | CH₃ | H |
| 168. | H | 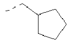 | H | H | H |
| 169. | CH₃ | 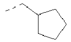 | H | CH₃ | H |
| 170. | H | 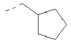 | CH₃ | H | H |
| 171. | H | 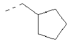 | H | CH₃ | H |
| 172. | CH₃ | 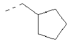 | CH₃ | H | H |
| 173. | CH₃ | 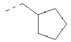 | H | CH₃ | H |
| 174. | H | 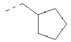 | CH₃ | CH₃ | H |
| 175. | CH₃ | 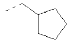 | CH₃ | CH₃ | H |
| 176. | H | H | 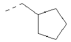 | H | H |
| 177. | CH₃ | H | 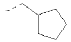 | H | H |
| 178. | H | CH₃ | 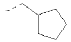 | H | H |
| 179. | H | H | 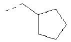 | CH₃ | H |
| 180. | CH₃ | CH₃ | 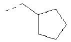 | H | H |
| 181. | CH₃ | H | 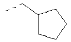 | CH₃ | H |
| 182. | H | CH₃ | 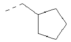 | CH₃ | H |
| 183. | CH₃ | CH₃ | 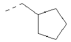 | CH₃ | H |
| 184. | 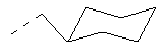 | H | H | H | H |
| 185. | 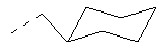 | CH₃ | H | CH₃ | H |
| 186. | 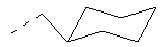 | H | CH₃ | H | H |
| 187. | 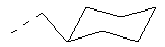 | H | H | CH₃ | H |
| 188. | 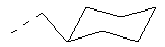 | CH₃ | CH₃ | H | H |
| 189. | 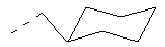 | CH₃ | H | CH₃ | H |
| 190. | 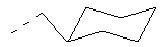 | H | CH₃ | CH₃ | H |
| 191. | 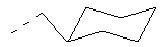 | CH₃ | CH₃ | CH₃ | H |
| 192. | H | 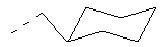 | H | H | H |
| 193. | CH₃ | 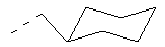 | H | CH₃ | H |
| 194. | H | 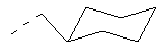 | CH₃ | H | H |
| 195. | H | 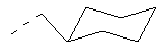 | H | CH₃ | H |
| 196. | CH₃ | 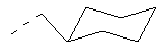 | CH₃ | H | H |
| 197. | CH₃ | 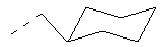 | H | CH₃ | H |
| 198. | H | 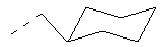 | CH₃ | CH₃ | H |
| 199. | CH₃ | 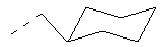 | CH₃ | CH₃ | H |
| 200. | H | H | 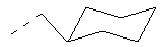 | H | H |
| 201. | CH₃ | H | 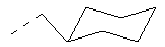 | H | H |
| 202. | H | CH₃ | 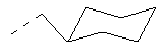 | H | H |
| 203. | H | H | 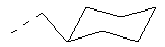 | CH₃ | H |
| 204. | CH₃ | CH₃ | 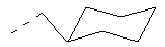 | H | H |
| 205. | CH₃ | H | 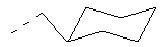 | CH₃ | H |
| 206. | H | CH₃ | 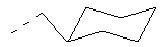 | CH₃ | H |
| 207. | CH₃ | CH₃ | 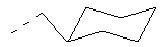 | CH₃ | H |
| 208. | 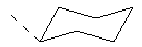 | H | H | H | H |
| 209. | 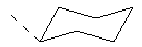 | CH₃ | H | CH₃ | H |
| 210. | 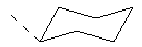 | H | CH₃ | H | H |
| 211. | 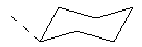 | H | H | CH₃ | H |
| 212. | 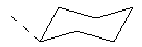 | CH₃ | CH₃ | H | H |
| 213. | 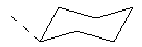 | CH₃ | H | CH₃ | H |
| 214. | 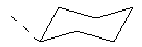 | H | CH₃ | CH₃ | H |
| 215. | 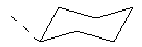 | CH₃ | CH₃ | CH₃ | H |
| 216. | H | 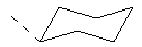 | H | H | H |
| 217. | CH₃ | 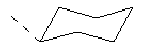 | H | CH₃ | H |
| 218. | H | 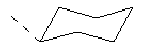 | CH₃ | H | H |
| 219. | H | 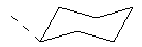 | H | CH₃ | H |
| 220. | CH₃ | 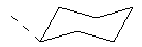 | CH₃ | H | H |
| 221. | CH₃ | 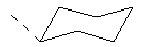 | H | CH₃ | H |
| 222. | H | 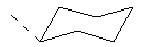 | CH₃ | CH₃ | H |
| 223. | CH₃ | 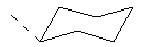 | CH₃ | CH₃ | H |
| 224. | H | H | 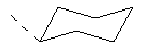 | H | H |
| 225. | CH₃ | H | 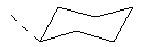 | H | H |
| 226. | H | CH₃ | 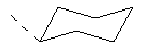 | H | H |
| 227. | H | H | 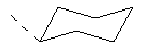 | CH₃ | H |
| 228. | CH₃ | CH₃ | 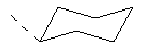 | H | H |
| 229. | CH₃ | H | 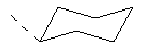 | CH₃ | H |
| 230. | H | CH₃ | 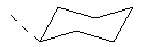 | CH₃ | H |
| 231. | CH₃ | CH₃ | 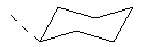 | CH₃ | H |
| 232. | 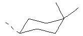 | H | H | H | H |
| 233. | 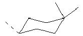 | CH₃ | H | CH₃ | H |
| 234. | 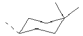 | H | CH₃ | H | H |
| 235. | 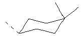 | H | H | CH₃ | H |
| 236. | 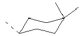 | CH₃ | CH₃ | H | H |
| 237. | 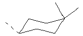 | CH₃ | H | CH₃ | H |
| 238. | 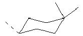 | H | CH₃ | CH₃ | H |
| 239. | 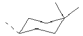 | CH₃ | CH₃ | CH₃ | H |
| 240. | H | 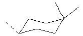 | H | H | H |
| 241. | CH₃ | 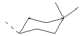 | H | CH₃ | H |
| 242. | H | 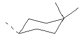 | CH₃ | H | H |
| 243. | H | 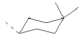 | H | CH₃ | H |
| 244. | CH₃ | 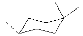 | CH₃ | H | H |
| 245. | CH₃ | 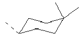 | H | CH₃ | H |
| 246. | H | 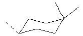 | CH₃ | CH₃ | H |
| 247. | CH₃ | 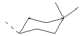 | CH₃ | CH₃ | H |
| 248. | H | H | 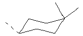 | H | H |
| 249. | CH₃ | H | 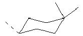 | H | H |
| 250. | H | CH₃ | 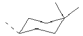 | H | H |
| 251. | H | H | 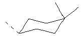 | CH₃ | H |
| 252. | CH₃ | CH₃ | 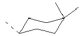 | H | H |
| 253. | CH₃ | H | 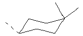 | CH₃ | H |
| 254. | H | CH₃ | 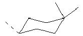 | CH₃ | H |
| 255. | CH₃ | CH₃ | 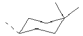 | CH₃ | H |
| 256. | 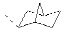 | H | H | H | H |
| 257. | 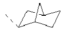 | CH₃ | H | CH₃ | H |
| 258. | 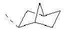 | H | CH₃ | H | H |
| 259. | 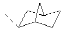 | H | H | CH₃ | H |
| 260. | 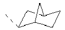 | CH₃ | CH₃ | H | H |
| 261. | 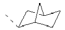 | CH₃ | H | CH₃ | H |
| 262. | 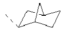 | H | CH₃ | CH₃ | H |
| 263. | 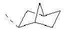 | CH₃ | CH₃ | CH₃ | H |
| 264. | H | 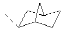 | H | H | H |
| 265. | CH₃ | 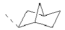 | H | CH₃ | H |
| 266. | H | 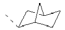 | CH₃ | H | H |
| 267. | H | 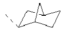 | H | CH₃ | H |
| 268. | CH₃ | 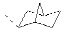 | CH₃ | H | H |
| 269. | CH₃ | 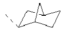 | H | CH₃ | H |
| 270. | H | 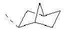 | CH₃ | CH₃ | H |
| 271. | CH₃ | 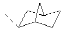 | CH₃ | CH₃ | H |
| 272. | H | H | 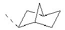 | H | H |
| 273. | CH₃ | H | 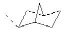 | H | H |
| 274. | H | CH₃ | 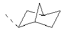 | H | H |
| 275. | H | H | 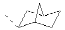 | CH₃ | H |
| 276. | CH₃ | CH₃ | 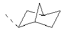 | H | H |
| 277. | CH₃ | H | 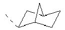 | CH₃ | H |
| 278. | H | CH₃ | 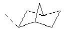 | CH₃ | H |
| 279. | CH₃ | CH₃ | 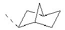 | CH₃ | H |
| 280. | CH(CH₃)₂ | H | CH₂CH₃ | H | H |
| 281. | CH(CH₃)₂ | H | CH(CH₃)₂ | H | H |
| 282. | CH(CH₃)₂ | H | CH₂CH(CH₃)₂ | H | H |
| 283. | CH(CH₃)₂ | H | C(CH₃)₃ | H | H |
| 284. | CH(CH₃)₂ | H | CH₂C(CH₃)₃ | H | H |
| 285. | CH(CH₃)₂ | H | 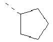 | H | H |
| 286. | CH(CH₃)₂ | H | 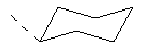 | H | H |
| 287. | CH(CH₃)₂ | H | 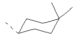 | H | H |
| 288. | CH(CH₃)₂ | H | 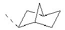 | H | H |
| 289. | CH(CH₃)₂ | H | 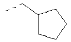 | H | H |
| 290. | CH(CH₃)₂ | H | 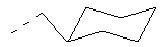 | H | H |
| 291. | C(CH₃)₃ | H | CH₂CH₃ | H | H |
| 292. | C(CH₃)₃ | H | CH(CH₃)₂ | H | H |
| 293. | C(CH₃)₃ | H | CH₂CH(CH₃)₂ | H | H |
| 294. | C(CH₃)₃ | H | C(CH₃)₃ | H | H |
| 295. | C(CH₃)₃ | H | CH₂C(CH₃)₃ | H | H |
| 296. | C(CH₃)₃ | H | 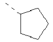 | H | H |
| 297. | C(CH₃)₃ | H | 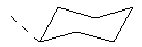 | H | H |
| 298. | C(CH₃)₃ | H | 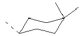 | H | H |
| 299. | C(CH₃)₃ | H | 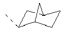 | H | H |
| 300. | C(CH₃)₃ | H | 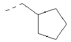 | H | H |
| 301. | C(CH₃)₃ | H | 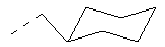 | H | H |
| 302. | CH₂C(CH₃)₃ | H | CH₂CH₃ | H | H |
| 303. | CH₂C(CH₃)₃ | H | CH(CH₃)₂ | H | H |
| 304. | CH₂C(CH₃)₃ | H | CH₂CH(CH₃)₂ | H | H |
| 305. | CH₂C(CH₃)₃ | H | C(CH₃)₃ | H | H |
| 306. | CH₂C(CH₃)₃ | H | CH₂C(CH₃)₃ | H | H |
| 307. | CH₂C(CH₃)₃ | H | CH₂CH₂CF₃ | H | H |
| 308. | CH₂C(CH₃)₃ | H | CH₂C(CH₃)₂CF₃ | H | H |
| 309. | CH₂C(CH₃)₃ | H | 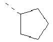 | H | H |
| 310. | CH₂C(CH₃)₃ | H | 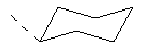 | H | H |
| 311. | CH₂C(CH₃)₃ | H | 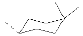 | H | H |
| 312. | CH₂C(CH₃)₃ | H | 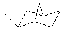 | H | H |
| 313. | CH₂C(CH₃)₃ | H | 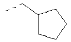 | H | H |
| 314. | CH₂C(CH₃)₃ | H | 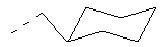 | H | H |
| 315. | 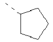 | H | CH₂CH₃ | H | H |
| 316. | 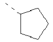 | H | CH(CH₃)₂ | H | H |
| 317. | 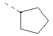 | H | CH₂CH(CH₃)₂ | H | H |
| 318. | 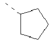 | H | C(CH₃)₃ | H | H |
| 319. | 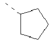 | H | CH₂C(CH₃)₃ | H | H |
| 320. | 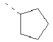 | H | 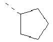 | H | H |
| 321. | 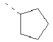 | H | 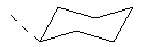 | H | H |
| 322. | 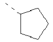 | H | 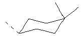 | H | H |
| 323. | 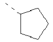 | H | 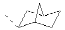 | H | H |
| 324. | 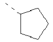 | H | 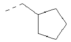 | H | H |
| 325. | 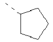 | H | 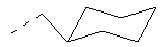 | H | H |
| 326. | 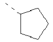 | H | CH₂CH₃ | H | H |
| 327. | 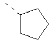 | H | CH(CH₃)₂ | H | H |
| 328. | 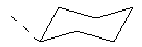 | H | CH₂CH(CH₃)₂ | H | H |
| 329. | 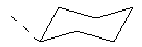 | H | C(CH₃)₃ | H | H |
| 330. | 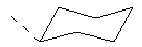 | H | CH₂C(CH₃)₃ | H | H |
| 331. | 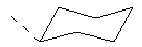 | H | 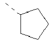 | H | H |
| 332. | 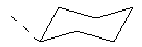 | H | 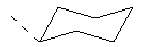 | H | H |
| 333. | 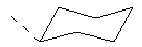 | H | 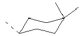 | H | H |
| 334. | 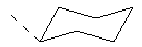 | H | 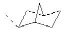 | H | H |
| 335. | 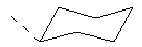 | H | 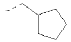 | H | H |
| 336. | 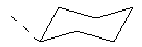 | H | 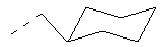 | H | H |
| 337. | 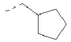 | H | CH₂CH(CH₃)₂ | H | H |
| 338. | 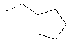 | H | C(CH₃)₃ | H | H |
| 339. | 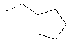 | H | CH₂C(CH₃)₃ | H | H |
| 340. | 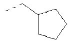 | H | 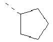 | H | H |
| 341. | 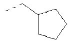 | H | 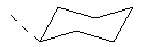 | H | H |
| 342. | 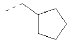 | H | 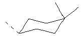 | H | H |
| 343. | 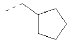 | H | 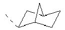 | H | H |
| 344. | 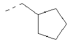 | H | 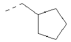 | H | H |
| 345. | 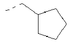 | H | 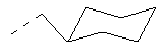 | H | H |
| 346. | 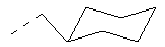 | H | CH₂CH(CH₃)₂ | H | H |
| 347. | 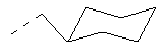 | H | C(CH₃)₃ | H | H |
| 348. | 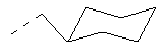 | H | CH₂C(CH₃)₃ | H | H |
| 349. | 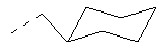 | H | 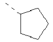 | H | H |
| 350. | 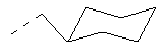 | H | 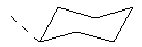 | H | H |
| 351. | 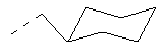 | H | 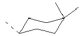 | H | H |
| 352. | 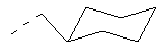 | H | 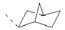 | H | H |
| 353. | 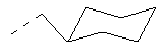 | H | 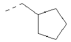 | H | H |
| 354. | 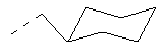 | H | 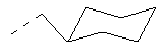 | H | H |
| 355. | 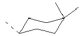 | H | CH₂CH(CH₃)₂ | H | H |
| 356. | 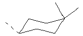 | H | C(CH₃)₃ | H | H |
| 357. | 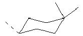 | H | CH₂C(CH₃)₃ | H | H |
| 358. | 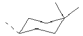 | H | 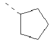 | H | H |
| 359. | 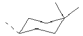 | H | 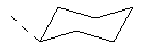 | H | H |
| 360. | 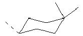 | H | 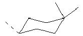 | H | H |
| 361. | 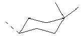 | H | 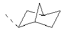 | H | H |
| 362. | 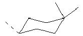 | H | 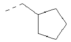 | H | H |
| 363. | 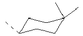 | H | 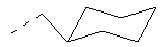 | H | H |
| 364. | H | H | H | H | H |
| 365. | CD₃ | H | H | H | H |
| 366. | H | CD₃ | H | H | H |
| 367. | H | H | CD₃ | H | H |
| 368. | CD₃ | CD₃ | H | CD₃ | H |
| 369. | CD₃ | H | CD₃ | H | H |
| 370. | CD₃ | H | H | CD₃ | H |
| 371. | H | CD₃ | CD₃ | H | H |
| 372. | H | CD₃ | H | CD₃ | H |
| 373. | H | H | CD₃ | CD₃ | H |
| 374. | CD₃ | CD₃ | CD₃ | H | H |
| 375. | CD₃ | CD₃ | H | CD₃ | H |
| 376. | CD₃ | H | CD₃ | CD₃ | H |
| 377. | H | CD₃ | CD₃ | CD₃ | H |
| 378. | CD₃ | CD₃ | CD₃ | CD₃ | H |
| 379. | CD₂CH₃ | H | H | H | H |
| 380. | CD₂CH₃ | CD₃ | H | CD₃ | H |
| 381. | CD₂CH₃ | H | CD₃ | H | H |
| 382. | CD₂CH₃ | H | H | CD₃ | H |
| 383. | CD₂CH₃ | CD₃ | CD₃ | H | H |
| 384. | CD₂CH₃ | CD₃ | H | CD₃ | H |
| 385. | CD₂CH₃ | H | CD₃ | CD₃ | H |
| 386. | CD₂CH₃ | CD₃ | CD₃ | CD₃ | H |
| 387. | H | CD₂CH₃ | H | H | H |
| 388. | CH₃ | CD₂CH₃ | H | CD₃ | H |
| 389. | H | CD₂CH₃ | CD₃ | H | H |
| 390. | H | CD₂CH₃ | H | CD₃ | H |
| 391. | CD₃ | CD₂CH₃ | CD₃ | H | H |
| 392. | CD₃ | CD₂CH₃ | H | CD₃ | H |
| 393. | H | CD₂CH₃ | CD₃ | CD₃ | H |
| 394. | CD₃ | CD₂CH₃ | CD₃ | CD₃ | H |
| 395. | H | H | CD₂CH₃ | H | H |
| 396. | CD₃ | H | CD₂CH₃ | H | H |
| 397. | H | CD₃ | CD₂CH₃ | H | H |
| 398. | H | H | CD₂CH₃ | CD₃ | H |
| 399. | CD₃ | CD₃ | CD₂CH₃ | H | H |
| 400. | CD₃ | H | CD₂CH₃ | CD₃ | H |
| 401. | H | CD₃ | CD₂CH₃ | CD₃ | H |
| 402. | CD₃ | CD₃ | CD₂CH₃ | CD₃ | H |
| 403. | CD(CH₃)₂ | H | H | H | H |
| 404. | CD(CH₃)₂ | CD₃ | H | CD₃ | H |
| 405. | CD(CH₃)₂ | H | CD₃ | H | H |
| 406. | CD(CH₃)₂ | H | H | CD₃ | H |
| 407. | CD(CH₃)₂ | CD₃ | CD₃ | H | H |
| 408. | CD(CH₃)₂ | CD₃ | H | CD₃ | H |
| 409. | CD(CH₃)₂ | H | CD₃ | CD₃ | H |
| 410. | CD(CH₃)₂ | CD₃ | CD₃ | CD₃ | H |
| 411. | H | CD(CH₃)₂ | H | H | H |
| 412. | CD₃ | CD(CH₃)₂ | H | CD₃ | H |
| 413. | H | CD(CH₃)₂ | CD₃ | H | H |
| 414. | H | CD(CH₃)₂ | H | CD₃ | H |
| 415. | CD₃ | CD(CH₃)₂ | CD₃ | H | H |
| 416. | CD₃ | CD(CH₃)₂ | H | CD₃ | H |
| 417. | H | CD(CH₃)₂ | CD₃ | CD₃ | H |
| 418. | CD₃ | CD(CH₃)₂ | CD₃ | CD₃ | H |
| 419. | H | H | CD(CH₃)₂ | H | H |
| 420. | CD₃ | H | CD(CH₃)₂ | H | H |
| 421. | H | CD₃ | CD(CH₃)₂ | H | H |
| 422. | H | H | CD(CH₃)₂ | CD₃ | H |
| 423. | CD₃ | CD₃ | CD(CH₃)₂ | H | H |
| 424. | CD₃ | H | CD(CH₃)₂ | CD₃ | H |
| 425. | H | CD₃ | CD(CH₃)₂ | CD₃ | H |
| 426. | CD₃ | CD₃ | CD(CH₃)₂ | CD₃ | H |
| 427. | CD(CD₃)₂ | H | H | H | H |
| 428. | CD(CD₃)₂ | CD₃ | H | CD₃ | H |
| 429. | CD(CD₃)₂ | H | CD₃ | H | H |
| 430. | CD(CD₃)₂ | H | H | CD₃ | H |
| 431. | CD(CD₃)₂ | CD₃ | CD₃ | H | H |
| 432. | CD(CD₃)₂ | CD₃ | H | CD₃ | H |
| 433. | CD(CD₃)₂ | H | CD₃ | CD₃ | H |
| 434. | CD(CD₃)₂ | CD₃ | CD₃ | CD₃ | H |
| 435. | H | CD(CD₃)₂ | H | H | H |
| 436. | CH₃ | CD(CD₃)₂ | H | CD₃ | H |
| 437. | H | CD(CD₃)₂ | CD₃ | H | H |
| 438. | H | CD(CD₃)₂ | H | CD₃ | H |
| 439. | CD₃ | CD(CD₃)₂ | CD₃ | H | H |
| 440. | CD₃ | CD(CD₃)₂ | H | CD₃ | H |
| 441. | H | CD(CD₃)₂ | CD₃ | CD₃ | H |
| 442. | CD₃ | CD(CD₃)₂ | CD₃ | CD₃ | H |
| 443. | H | H | CD(CD₃)₂ | H | H |
| 444. | CD₃ | H | CD(CD₃)₂ | H | H |
| 445. | H | CD₃ | CD(CD₃)₂ | H | H |
| 446. | H | H | CD(CD₃)₂ | CD₃ | H |
| 447. | CD₃ | CD₃ | CD(CD₃)₂ | H | H |
| 448. | CD₃ | H | CD(CD₃)₂ | CD₃ | H |
| 449. | H | CD₃ | CD(CD₃)₂ | CD₃ | H |
| 450. | CD₃ | CD₃ | CD(CD₃)₂ | CD₃ | H |
| 451. | CD₂CH(CH₃)₂ | H | H | H | H |
| 452. | CD₂CH(CH₃)₂ | CD₃ | H | CD₃ | H |
| 453. | CD₂CH(CH₃)₂ | H | CD₃ | H | H |
| 454. | CD₂CH(CH₃)₂ | H | H | CD₃ | H |
| 455. | CD₂CH(CH₃)₂ | CD₃ | CD₃ | H | H |
| 456. | CD₂CH(CH₃)₂ | CD₃ | H | CD₃ | H |
| 457. | CD₂CH(CH₃)₂ | H | CD₃ | CD₃ | H |
| 458. | CD₂CH(CH₃)₂ | CD₃ | CD₃ | CD₃ | H |
| 459. | H | CD₂CH(CH₃)₂ | H | H | H |
| 460. | CD₃ | CD₂CH(CH₃)₂ | H | CD₃ | H |
| 461. | H | CD₂CH(CH₃)₂ | CD₃ | H | H |
| 462. | H | CD₂CH(CH₃)₂ | H | CD₃ | H |
| 463. | CD₃ | CD₂CH(CH₃)₂ | CD₃ | H | H |
| 464. | CD₃ | CD₂CH(CH₃)₂ | H | CD₃ | H |
| 465. | H | CD₂CH(CH₃)₂ | CD₃ | CD₃ | H |
| 466. | CD₃ | CD₂CH(CH₃)₂ | CD₃ | CD₃ | H |
| 467. | H | H | CD₂CH(CH₃)₂ | H | H |
| 468. | CD₃ | H | CD₂CH(CH₃)₂ | H | H |
| 469. | H | CD₃ | CD₂CH(CH₃)₂ | H | H |
| 470. | H | H | CD₂CH(CH₃)₂ | CD₃ | H |
| 471. | CD₃ | CD₃ | CD₂CH(CH₃)₂ | H | H |
| 472. | CD₃ | H | CD₂CH(CH₃)₂ | CD₃ | H |
| 473. | H | CD₃ | CD₂CH(CH₃)₂ | CD₃ | H |
| 474. | CD₃ | CD₃ | CD₂CH(CH₃)₂ | CD₃ | H |
| 475. | CD₂C(CH₃)₃ | H | H | H | H |
| 476. | CD₂C(CH₃)₃ | CD₃ | H | CD₃ | H |
| 477. | CD₂C(CH₃)₃ | H | CD₃ | H | H |
| 478. | CD₂C(CH₃)₃ | H | H | CD₃ | H |
| 479. | CD₂C(CH₃)₃ | CD₃ | CD₃ | H | H |
| 480. | CD₂C(CH₃)₃ | CD₃ | H | CD₃ | H |
| 481. | CD₂C(CH₃)₃ | H | CD₃ | CD₃ | H |
| 482. | CD₂C(CH₃)₃ | CH₃ | CD₃ | CD₃ | H |
| 483. | H | CD₂C(CH₃)₃ | H | H | H |
| 484. | CD₃ | CD₂C(CH₃)₃ | H | CD₃ | H |
| 485. | H | CD₂C(CH₃)₃ | CD₃ | H | H |
| 486. | H | CD₂C(CH₃)₃ | H | CD₃ | H |
| 487. | CD₃ | CD₂C(CH₃)₃ | CD₃ | H | H |
| 488. | CD₃ | CD₂C(CH₃)₃ | H | CD₃ | H |
| 489. | H | CD₂C(CH₃)₃ | CD₃ | CD₃ | H |
| 490. | CD₃ | CD₂C(CH₃)₃ | CD₃ | CD₃ | H |
| 491. | H | H | CD₂C(CH₃)₃ | H | H |
| 492. | CD₃ | H | CD₂C(CH₃)₃ | H | H |
| 493. | H | CD₃ | CD₂C(CH₃)₃ | H | H |
| 494. | H | H | CD₂C(CH₃)₃ | CD₃ | H |
| 495. | CD₃ | CD₃ | CD₂C(CH₃)₃ | H | H |
| 496. | CD₃ | H | CD₂C(CH₃)₃ | CD₃ | H |
| 497. | H | CD₃ | CD₂C(CH₃)₃ | CD₃ | H |
| 498. | CD₃ | CD₃ | CD₂C(CH₃)₃ | CD₃ | H |
| 499. | 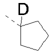 | H | H | H | H |
| 500. | 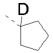 | CD₃ | H | CD₃ | H |
| 501. | 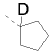 | H | CD₃ | H | H |
| 502. | 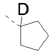 | H | H | CD₃ | H |
| 503. | 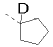 | CD₃ | CD₃ | H | H |
| 504. | 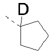 | CD₃ | H | CD₃ | H |
| 505. | 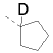 | H | CD₃ | CD₃ | H |
| 506. | 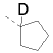 | CD₃ | CD₃ | CD₃ | H |
| 507. | H | 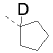 | H | H | H |
| 508. | CD₃ | 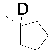 | H | CD₃ | H |
| 509. | H | 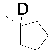 | CD₃ | H | H |
| 510. | H | 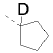 | H | CD₃ | H |
| 511. | CD₃ | 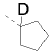 | CD₃ | H | H |
| 512. | CD₃ | 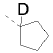 | H | CD₃ | H |
| 513. | H | 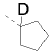 | CD₃ | CD₃ | H |
| 514. | CD₃ | 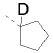 | CD₃ | CD₃ | H |
| 515. | H | H | 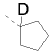 | H | H |
| 516. | CD₃ | H | 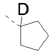 | H | H |
| 517. | H | CD₃ | 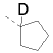 | H | H |
| 518. | H | H | 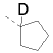 | CD₃ | H |
| 519. | CD₃ | CD₃ | 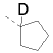 | H | H |
| 520. | CD₃ | H | 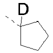 | CD₃ | H |
| 521. | H | CD₃ | 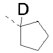 | CD₃ | H |
| 522. | CD₃ | CD₃ | 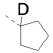 | CD₃ | H |
| 523. | 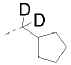 | H | H | H | H |
| 524. | 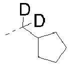 | CD₃ | H | CD₃ | H |
| 525. | 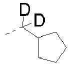 | H | CD₃ | H | H |
| 526. | 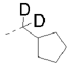 | H | H | CD₃ | H |
| 527. | 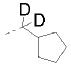 | CD₃ | CD₃ | H | H |
| 528. | 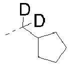 | CD₃ | H | CD₃ | H |
| 529. | 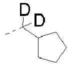 | H | CD₃ | CD₃ | H |
| 530. | 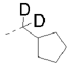 | CD₃ | CD₃ | CD₃ | H |
| 531. | H | 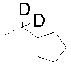 | H | H | H |
| 532. | CH₃ | 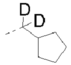 | H | CD₃ | H |
| 533. | H | 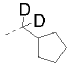 | CD₃ | H | H |
| 534. | H | 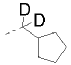 | H | CD₃ | H |
| 535. | CD₃ | 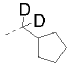 | CD₃ | H | H |
| 536. | CD₃ | 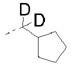 | H | CD₃ | H |
| 537. | H | 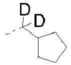 | CD₃ | CD₃ | H |
| 538. | CH₃ | 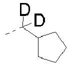 | CD₃ | CD₃ | H |
| 539. | H | H | 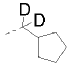 | H | H |
| 540. | CD₃ | H | 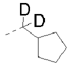 | H | H |
| 541. | H | CD₃ | 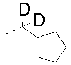 | H | H |
| 542. | H | H | 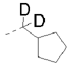 | CD₃ | H |
| 543. | CD₃ | CD₃ | 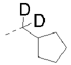 | H | H |
| 544. | CD₃ | H | 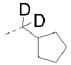 | CD₃ | H |
| 545. | H | CD₃ | 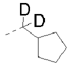 | CD₃ | H |
| 546. | CD₃ | CD₃ | 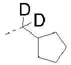 | CD₃ | H |
| 547. | 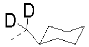 | H | H | H | H |
| 548. | 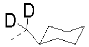 | CD₃ | H | CD₃ | H |
| 549. | 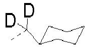 | H | CD₃ | H | H |
| 550. | 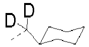 | H | H | CD₃ | H |
| 551. | 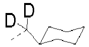 | CD₃ | CD₃ | H | H |
| 552. | 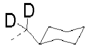 | CD₃ | H | CD₃ | H |
| 553. | 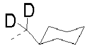 | H | CD₃ | CD₃ | H |
| 554. | 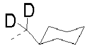 | CD₃ | CD₃ | CD₃ | H |
| 555. | H | 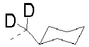 | H | H | H |
| 556. | CD₃ | 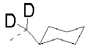 | H | CD₃ | H |
| 557. | H | 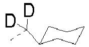 | CD₃ | H | H |
| 558. | H | 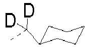 | H | CD₃ | H |
| 559. | CD₃ | 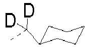 | CD₃ | H | H |
| 560. | CD₃ | 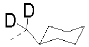 | H | CD₃ | H |
| 561. | H | 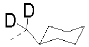 | CD₃ | CD₃ | H |
| 562. | CD₃ | 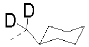 | CD₃ | CD₃ | H |
| 563. | H | H | 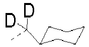 | H | H |
| 564. | CD₃ | H | 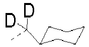 | H | H |
| 565. | H | CD₃ | 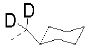 | H | H |
| 566. | H | H | 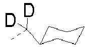 | CD₃ | H |
| 567. | CD₃ | CD₃ | 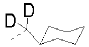 | H | H |
| 568. | CD₃ | H | 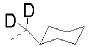 | CD₃ | H |
| 569. | H | CD₃ | 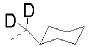 | CD₃ | H |
| 570. | CD₃ | CD₃ | 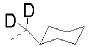 | CD₃ | H |
| 571. | 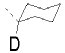 | H | H | H | H |
| 572. | 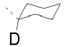 | CD₃ | H | CD₃ | H |
| 573. | 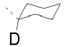 | H | CD₃ | H | H |
| 574. | 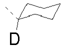 | H | H | CD₃ | H |
| 575. | 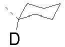 | CD₃ | CD₃ | H | H |
| 576. | 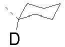 | CD₃ | H | CD₃ | H |
| 577. | 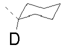 | H | CD₃ | CD₃ | H |
| 578. | 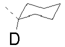 | CD₃ | CD₃ | CD₃ | H |
| 579. | H | 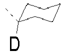 | H | H | H |
| 580. | CD₃ | 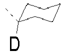 | H | CD₃ | H |
| 581. | H | 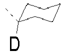 | CD₃ | H | H |
| 582. | H | 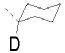 | H | CD₃ | H |
| 583. | CD₃ | 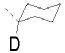 | CD₃ | H | H |
| 584. | CD₃ | 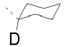 | H | CD₃ | H |
| 585. | H | 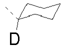 | CD₃ | CD₃ | H |
| 586. | CD₃ | 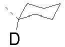 | CD₃ | CD₃ | H |
| 587. | H | H | 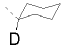 | H | H |
| 588. | CD₃ | H | 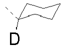 | H | H |
| 589. | H | CD₃ | 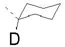 | H | H |
| 590. | H | H | 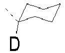 | CD₃ | H |
| 591. | CD₃ | CD₃ | 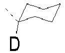 | H | H |
| 592. | CD₃ | H | 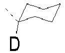 | CD₃ | H |
| 593. | H | CD₃ | 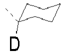 | CD₃ | H |
| 594. | CD₃ | CD₃ | 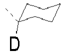 | CD₃ | H |
| 595. | 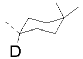 | H | H | H | H |
| 596. | 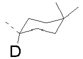 | CD₃ | H | CD₃ | H |
| 597. | 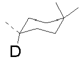 | H | CD₃ | H | H |
| 598. | 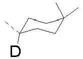 | H | H | CD₃ | H |
| 599. | 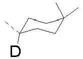 | CD₃ | CD₃ | H | H |
| 600. | 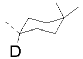 | CD₃ | H | CD₃ | H |
| 601. | 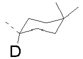 | H | CD₃ | CD₃ | H |
| 602. | 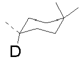 | CD₃ | CD₃ | CD₃ | H |
| 603. | H | 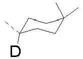 | H | H | H |
| 604. | CD₃ | 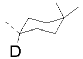 | H | CD₃ | H |
| 605. | H | 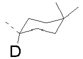 | CD₃ | H | H |
| 606. | H | 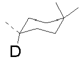 | H | CD₃ | H |
| 607. | CD₃ | 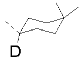 | CD₃ | H | H |
| 608. | CD₃ | 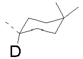 | H | CD₃ | H |
| 609. | H | 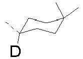 | CD₃ | CD₃ | H |
| 610. | CD₃ | 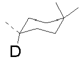 | CD₃ | CD₃ | H |
| 611. | H | H | 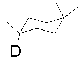 | H | H |
| 612. | CD₃ | H | 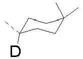 | H | H |
| 613. | H | CD₃ | 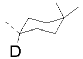 | H | H |
| 614. | H | H | 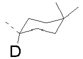 | CD₃ | H |
| 615. | CD₃ | CD₃ | 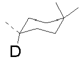 | H | H |
| 616. | CD₃ | H | 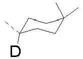 | CD₃ | H |
| 617. | H | CD₃ | 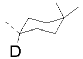 | CD₃ | H |
| 618. | CD₃ | CD₃ | 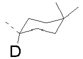 | CD₃ | H |
| 619. | 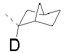 | H | H | H | H |
| 620. | 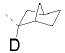 | CD₃ | H | CD₃ | H |
| 621. | 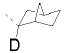 | H | CD₃ | H | H |
| 622. | 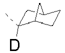 | H | H | CD₃ | H |
| 623. | 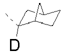 | CH₃ | CH₃ | H | H |
| 624. | 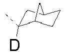 | CD₃ | H | CD₃ | H |
| 625. | 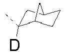 | H | CD₃ | CD₃ | H |
| 626. | 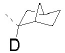 | CD₃ | CD₃ | CD₃ | H |
| 627. | H | 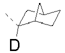 | H | H | H |
| 628. | CD₃ | 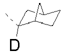 | H | CD₃ | H |
| 629. | H | 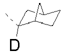 | CD₃ | H | H |
| 630. | H | 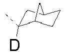 | H | CD₃ | H |
| 631. | CD₃ | 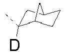 | CD₃ | H | H |
| 632. | CD₃ | 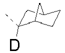 | H | CD₃ | H |
| 633. | H | 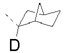 | CD₃ | CD₃ | H |
| 634. | CD₃ | 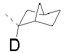 | CD₃ | CD₃ | H |
| 635. | H | H | 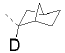 | H | H |
| 636. | CD₃ | H | 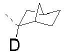 | H | H |
| 637. | H | CD₃ | 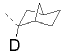 | H | H |
| 638. | H | H | 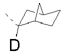 | CH₃ | H |
| 639. | CD₃ | CD₃ | 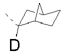 | H | H |
| 640. | CD₃ | H | 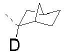 | CD₃ | H |
| 641. | H | CD₃ | 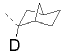 | CD₃ | H |
| 642. | CD₃ | CD₃ | 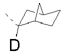 | CD₃ | H |
| 643. | CD(CH₃)₂ | H | CD₂CH₃ | H | H |
| 644. | CD(CH₃)₂ | H | CD(CH₃)₂ | H | H |
| 645. | CD(CH₃)₂ | H | CD₂CH(CH₃)₂ | H | H |
| 646. | CD(CH₃)₂ | H | C(CH₃)₃ | H | H |
| 647. | CD(CH₃)₂ | H | CD₂C(CH₃)₃ | H | H |
| 648. | CD(CH₃)₂ | H | 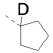 | H | H |
| 649. | CD(CH₃)₂ | H | 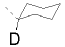 | H | H |
| 650. | CD(CH₃)₂ | H | 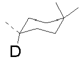 | H | H |
| 651. | CD(CH₃)₂ | H | 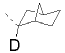 | H | H |
| 652. | CD(CH₃)₂ | H | 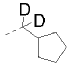 | H | H |
| 653. | CD(CH₃)₂ | H | 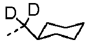 | H | H |
| 654. | C(CH₃)₃ | H | CD₂CH₃ | H | H |
| 655. | C(CH₃)₃ | H | CD(CH₃)₂ | H | H |
| 656. | C(CH₃)₃ | H | CD₂CH(CH₃)₂ | H | H |
| 657. | C(CH₃)₃ | H | C(CH₃)₃ | H | H |
| 658. | C(CH₃)₃ | H | CD₂C(CH₃)₃ | H | H |
| 659. | C(CH₃)₃ | H | 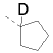 | H | H |
| 660. | C(CH₃)₃ | H | 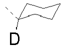 | H | H |
| 661. | C(CH₃)₃ | H | 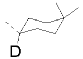 | H | H |
| 662. | C(CH₃)₃ | H | 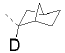 | H | H |
| 663. | C(CH₃)₃ | H | 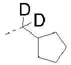 | H | H |
| 664. | C(CH₃)₃ | H | 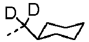 | H | H |
| 665. | CD₂C(CH₃)₃ | H | CD₂CH₃ | H | H |
| 666. | CD₂C(CH₃)₃ | H | CD(CH₃)₂ | H | H |
| 667. | CD₂C(CH₃)₃ | H | CD₂CH(CH₃)₂ | H | H |
| 668. | CD₂C(CH₃)₃ | H | C(CH₃)₃ | H | H |
| 669. | CD₂C(CH₃)₃ | H | CD₂C(CH₃)₃ | H | H |
| 670. | CD₂C(CH₃)₃ | H | 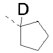 | H | H |
| 671. | CD₂C(CH₃)₃ | H | 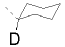 | H | H |
| 672. | CD₂C(CH₃)₃ | H | 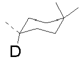 | H | H |
| 673. | CD₂C(CH₃)₃ | H | 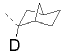 | H | H |
| 674. | CD₂C(CH₃)₃ | H | 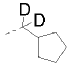 | H | H |
| 675. | CD₂C(CH₃)₃ | H | 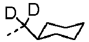 | H | H |
| 676. | 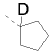 | H | CD₂CH₃ | H | H |
| 677. | 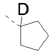 | H | CD(CH₃)₂ | H | H |
| 678. | 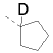 | H | CD₂CH(CH₃)₂ | H | H |
| 679. | 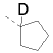 | H | C(CH₃)₃ | H | H |
| 680. | 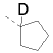 | H | CD₂C(CH₃)₃ | H | H |
| 681. | 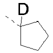 | H | 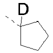 | H | H |
| 682. | 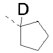 | H | 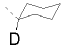 | H | H |
| 683. | 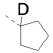 | H | 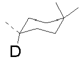 | H | H |
| 684. | 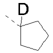 | H | 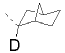 | H | H |
| 685. | 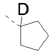 | H | 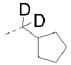 | H | H |
| 686. | 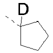 | H | 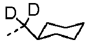 | H | H |
| 687. | 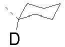 | H | CD₂CH₃ | H | H |
| 688. | 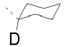 | H | CD(CH₃)₂ | H | H |
| 689. | 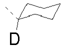 | H | CD₂CH(CH₃)₂ | H | H |
| 690. | 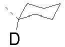 | H | C(CH₃)₃ | H | H |
| 691. | 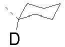 | H | CD₂C(CH₃)₃ | H | H |
| 692. | 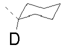 | H | 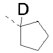 | H | H |
| 693. | 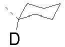 | H | 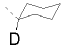 | H | H |
| 694. | 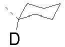 | H | 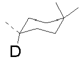 | H | H |
| 695. | 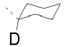 | H | 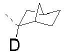 | H | H |
| 696. | 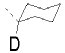 | H | 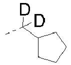 | H | H |
| 697. | 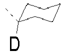 | H | 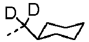 | H | H |
| 698. | 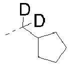 | H | CD₂CH₃ | H | H |
| 699. | 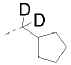 | H | CD(CH₃)₂ | H | H |
| 700. | 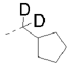 | H | CD₂CH(CH₃)₂ | H | H |
| 701. | 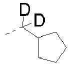 | H | C(CH₃)₃ | H | H |
| 702. | 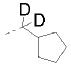 | H | CD₂C(CH₃)₃ | H | H |
| 703. | 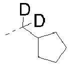 | H | 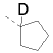 | H | H |
| 704. | 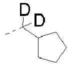 | H | 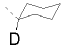 | H | H |
| 705. | 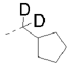 | H | 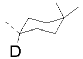 | H | H |
| 706. | 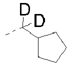 | H | 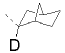 | H | H |
| 707. | 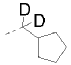 | H | 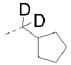 | H | H |
| 708. | 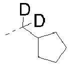 | H | 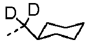 | H | H |
| 709. | 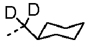 | H | CD₂CH₃ | H | H |
| 710. | 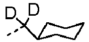 | H | CD(CH₃)₂ | H | H |
| 711. | 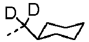 | H | CD₂CH(CH₃)₂ | H | H |
| 712. | 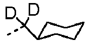 | H | C(CH₃)₃ | H | H |
| 713. | 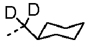 | H | CD₂C(CH₃)₃ | H | H |
| 714. | 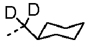 | H | 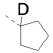 | H | H |
| 715. | 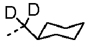 | H | 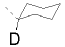 | H | H |
| 716. | 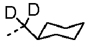 | H | 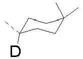 | H | H |
| 717. | 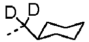 | H | 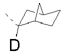 | H | H |
| 718. | 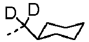 | H | 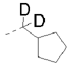 | H | H |
| 719. | 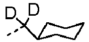 | H | 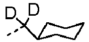 | H | H |
| 720. | 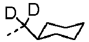 | H | CD₂CH₃ | H | H |
| 721. | 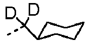 | H | CD(CH₃)₂ | H | H |
| 722. | 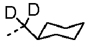 | H | CD₂CH(CH₃)₂ | H | H |
| 723. | 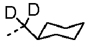 | H | C(CH₃)₃ | H | H |
| 724. | 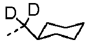 | H | CD₂C(CH₃)₃ | H | H |
| 725. | 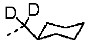 | H | 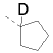 | H | H |
| 726. | 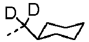 | H | 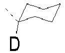 | H | H |
| 727. | 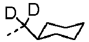 | H | 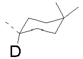 | H | H |
| 728. | 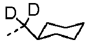 | H | 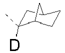 | H | H |
| 729. | 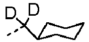 | H | 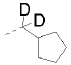 | H | H |
| 730. | 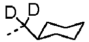 | H | 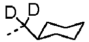 | H | H |
| 731. | H | H | H | H | Ph |
| 732. | CH₃ | H | H | H | Ph |
| 733. | H | CH₃ | H | H | Ph |
| 734. | H | H | CH₃ | H | Ph |
| 735. | CH₃ | CH₃ | H | CH₃ | Ph |
| 736. | CH₃ | H | CH₃ | H | Ph |
| 737. | CH₃ | H | H | CH₃ | Ph |
| 738. | H | CH₃ | CH₃ | H | Ph |
| 739. | H | CH₃ | H | CH₃ | Ph |
| 740. | H | H | CH₃ | CH₃ | Ph |
| 741. | CH₃ | CH₃ | CH₃ | H | Ph |
| 742. | CH₃ | CH₃ | H | CH₃ | Ph |
| 743. | CH₃ | H | CH₃ | CH₃ | Ph |
| 744. | H | CH₃ | CH₃ | CH₃ | Ph |
| 745. | CH₃ | CH₃ | CH₃ | CH₃ | Ph |
| 746. | CH₂CH₃ | H | H | H | Ph |
| 747. | CH₂CH₃ | CH₃ | H | CH₃ | Ph |
| 748. | CH₂CH₃ | H | CH₃ | H | Ph |
| 749. | CH₂CH₃ | H | H | CH₃ | Ph |
| 750. | CH₂CH₃ | CH₃ | CH₃ | H | Ph |
| 751. | CH₂CH₃ | CH₃ | H | CH₃ | Ph |
| 752. | CH₂CH₃ | H | CH₃ | CH₃ | Ph |
| 753. | CH₂CH₃ | CH₃ | CH₃ | CH₃ | Ph |
| 754. | H | CH₂CH₃ | H | H | Ph |
| 755. | CH₃ | CH₂CH₃ | H | CH₃ | Ph |
| 756. | H | CH₂CH₃ | CH₃ | H | Ph |
| 757. | H | CH₂CH₃ | H | CH₃ | Ph |
| 758. | CH₃ | CH₂CH₃ | CH₃ | H | Ph |
| 759. | CH₃ | CH₂CH₃ | H | CH₃ | Ph |
| 760. | H | CH₂CH₃ | CH₃ | CH₃ | Ph |
| 761. | CH₃ | CH₂CH₃ | CH₃ | CH₃ | Ph |
| 762. | H | H | CH₂CH₃ | H | Ph |
| 763. | CH₃ | H | CH₂CH₃ | H | Ph |
| 764. | H | CH₃ | CH₂CH₃ | H | Ph |
| 765. | H | H | CH₂CH₃ | CH₃ | Ph |
| 766. | CH₃ | CH₃ | CH₂CH₃ | H | Ph |
| 767. | CH₃ | H | CH₂CH₃ | CH₃ | Ph |
| 768. | H | CH₃ | CH₂CH₃ | CH₃ | Ph |
| 769. | CH₃ | CH₃ | CH₂CH₃ | CH₃ | Ph |
| 770. | CH(CH₃)₂ | H | H | H | Ph |
| 771. | CH(CH₃)₂ | CH₃ | H | CH₃ | Ph |
| 772. | CH(CH₃)₂ | H | CH₃ | H | Ph |
| 773. | CH(CH₃)₂ | H | H | CH₃ | Ph |
| 774. | CH(CH₃)₂ | CH₃ | CH₃ | H | Ph |
| 775. | CH(CH₃)₂ | CH₃ | H | CH₃ | Ph |
| 776. | CH(CH₃)₂ | H | CH₃ | CH₃ | Ph |
| 777. | CH(CH₃)₂ | CH₃ | CH₃ | CH₃ | Ph |
| 778. | H | CH(CH₃)₂ | H | H | Ph |
| 779. | CH₃ | CH(CH₃)₂ | H | CH₃ | Ph |
| 780. | H | CH(CH₃)₂ | CH₃ | H | Ph |
| 781. | H | CH(CH₃)₂ | H | CH₃ | Ph |
| 782. | CH₃ | CH(CH₃)₂ | CH₃ | H | Ph |
| 783. | CH₃ | CH(CH₃)₂ | H | CH₃ | Ph |
| 784. | H | CH(CH₃)₂ | CH₃ | CH₃ | Ph |
| 785. | CH₃ | CH(CH₃)₂ | CH₃ | CH₃ | Ph |
| 786. | H | H | CH(CH₃)₂ | H | Ph |
| 787. | CH₃ | H | CH(CH₃)₂ | H | Ph |
| 788. | H | CH₃ | CH(CH₃)₂ | H | Ph |
| 789. | H | H | CH(CH₃)₂ | CH₃ | Ph |
| 790. | CH₃ | CH₃ | CH(CH₃)₂ | H | Ph |
| 791. | CH₃ | H | CH(CH₃)₂ | CH₃ | Ph |
| 792. | H | CH₃ | CH(CH₃)₂ | CH₃ | Ph |
| 793. | CH₃ | CH₃ | CH(CH₃)₂ | CH₃ | Ph |
| 794. | CH₂CH(CH₃)₂ | H | H | H | Ph |
| 795. | CH₂CH(CH₃)₂ | CH₃ | H | CH₃ | Ph |
| 796. | CH₂CH(CH₃)₂ | H | CH₃ | H | Ph |
| 797. | CH₂CH(CH₃)₂ | H | H | CH₃ | Ph |
| 798. | CH₂CH(CH₃)₂ | CH₃ | CH₃ | H | Ph |
| 799. | CH₂CH(CH₃)₂ | CH₃ | H | CH₃ | Ph |
| 800. | CH₂CH(CH₃)₂ | H | CH₃ | CH₃ | Ph |
| 801. | CH₂CH(CH₃)₂ | CH₃ | CH₃ | CH₃ | Ph |
| 802. | H | CH₂CH(CH₃)₂ | H | H | Ph |
| 803. | CH₃ | CH₂CH(CH₃)₂ | H | CH₃ | Ph |
| 804. | H | CH₂CH(CH₃)₂ | CH₃ | H | Ph |
| 805. | H | CH₂CH(CH₃)₂ | H | CH₃ | Ph |
| 806. | CH₃ | CH₂CH(CH₃)₂ | CH₃ | H | Ph |
| 807. | CH₃ | CH₂CH(CH₃)₂ | H | CH₃ | Ph |
| 808. | H | CH₂CH(CH₃)₂ | CH₃ | CH₃ | Ph |
| 809. | CH₃ | CH₂CH(CH₃)₂ | CH₃ | CH₃ | Ph |
| 810. | H | H | CH₂CH(CH₃)₂ | H | Ph |
| 811. | CH₃ | H | CH₂CH(CH₃)₂ | H | Ph |
| 812. | H | CH₃ | CH₂CH(CH₃)₂ | H | Ph |
| 813. | H | H | CH₂CH(CH₃)₂ | CH₃ | Ph |
| 814. | CH₃ | CH₃ | CH₂CH(CH₃)₂ | H | Ph |
| 815. | CH₃ | H | CH₂CH(CH₃)₂ | CH₃ | Ph |
| 816. | H | CH₃ | CH₂CH(CH₃)₂ | CH₃ | Ph |
| 817. | CH₃ | CH₃ | CH₂CH(CH₃)₂ | CH₃ | Ph |
| 818. | C(CH₃)₃ | H | H | H | Ph |
| 819. | C(CH₃)₃ | CH₃ | H | CH₃ | Ph |
| 820. | C(CH₃)₃ | H | CH₃ | H | Ph |
| 821. | C(CH₃)₃ | H | H | CH₃ | Ph |
| 822. | C(CH₃)₃ | CH₃ | CH₃ | H | Ph |
| 823. | C(CH₃)₃ | CH₃ | H | CH₃ | Ph |
| 824. | C(CH₃)₃ | H | CH₃ | CH₃ | Ph |
| 825. | C(CH₃)₃ | CH₃ | CH₃ | CH₃ | Ph |
| 826. | H | C(CH₃)₃ | H | H | Ph |
| 827. | CH₃ | C(CH₃)₃ | H | CH₃ | Ph |
| 828. | H | C(CH₃)₃ | CH₃ | H | Ph |
| 829. | H | C(CH₃)₃ | H | CH₃ | Ph |
| 830. | CH₃ | C(CH₃)₃ | CH₃ | H | Ph |
| 831. | CH₃ | C(CH₃)₃ | H | CH₃ | Ph |
| 832. | H | C(CH₃)₃ | CH₃ | CH₃ | Ph |
| 833. | CH₃ | C(CH₃)₃ | CH₃ | CH₃ | Ph |
| 834. | H | H | C(CH₃)₃ | H | Ph |
| 835. | CH₃ | H | C(CH₃)₃ | H | Ph |
| 836. | H | CH₃ | C(CH₃)₃ | H | Ph |
| 837. | H | H | C(CH₃)₃ | CH₃ | Ph |
| 838. | CH₃ | CH₃ | C(CH₃)₃ | H | Ph |
| 839. | CH₃ | H | C(CH₃)₃ | CH₃ | Ph |
| 840. | H | CH₃ | C(CH₃)₃ | CH₃ | Ph |
| 841. | CH₃ | CH₃ | C(CH₃)₃ | CH₃ | Ph |
| 842. | CH₂C(CH₃)₃ | H | H | H | Ph |
| 843. | CH₂C(CH₃)₃ | CH₃ | H | CH₃ | Ph |
| 844. | CH₂C(CH₃)₃ | H | CH₃ | H | Ph |
| 845. | CH₂C(CH₃)₃ | H | H | CH₃ | Ph |
| 846. | CH₂C(CH₃)₃ | CH₃ | CH₃ | H | Ph |
| 847. | CH₂C(CH₃)₃ | CH₃ | H | CH₃ | Ph |
| 848. | CH₂C(CH₃)₃ | H | CH₃ | CH₃ | Ph |
| 849. | CH₂C(CH₃)₃ | CH₃ | CH₃ | CH₃ | Ph |
| 850. | H | CH₂C(CH₃)₃ | H | H | Ph |
| 851. | CH₃ | CH₂C(CH₃)₃ | H | CH₃ | Ph |
| 852. | H | CH₂C(CH₃)₃ | CH₃ | H | Ph |
| 853. | H | CH₂C(CH₃)₃ | H | CH₃ | Ph |
| 854. | CH₃ | CH₂C(CH₃)₃ | CH₃ | H | Ph |
| 855. | CH₃ | CH₂C(CH₃)₃ | H | CH₃ | Ph |
| 856. | H | CH₂C(CH₃)₃ | CH₃ | CH₃ | Ph |
| 857. | CH₃ | CH₂C(CH₃)₃ | CH₃ | CH₃ | Ph |
| 858. | H | H | CH₂C(CH₃)₃ | H | Ph |
| 859. | CH₃ | H | CH₂C(CH₃)₃ | H | Ph |
| 860. | H | CH₃ | CH₂C(CH₃)₃ | H | Ph |
| 861. | H | H | CH₂C(CH₃)₃ | CH₃ | Ph |
| 862. | CH₃ | CH₃ | CH₂C(CH₃)₃ | H | Ph |
| 863. | CH₃ | H | CH₂C(CH₃)₃ | CH₃ | Ph |
| 864. | H | CH₃ | CH₂C(CH₃)₃ | CH₃ | Ph |
| 865. | CH₃ | CH₃ | CH₂C(CH₃)₃ | CH₃ | Ph |
| 866. | 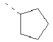 | H | H | H | Ph |
| 867. | 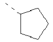 | CH₃ | H | CH₃ | Ph |
| 868. | 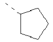 | H | CH₃ | H | Ph |
| 869. | 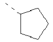 | H | H | CH₃ | Ph |
| 870. | 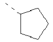 | CH₃ | CH₃ | H | Ph |
| 871. | 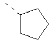 | CH₃ | H | CH₃ | Ph |
| 872. | 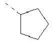 | H | CH₃ | CH₃ | Ph |
| 873. | 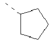 | CH₃ | CH₃ | CH₃ | Ph |
| 874. | H | 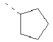 | H | H | Ph |
| 875. | CH₃ | 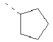 | H | CH₃ | Ph |
| 876. | H | 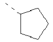 | CH₃ | H | Ph |
| 877. | H | 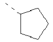 | H | CH₃ | Ph |
| 878. | CH₃ | 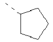 | CH₃ | H | Ph |
| 879. | CH₃ | 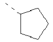 | H | CH₃ | Ph |
| 880. | H | 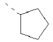 | CH₃ | CH₃ | Ph |
| 881. | CH₃ | 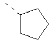 | CH₃ | CH₃ | Ph |
| 882. | H | H | 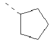 | H | Ph |
| 883. | CH₃ | H | 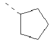 | H | Ph |
| 884. | H | CH₃ | 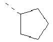 | H | Ph |
| 885. | H | H | 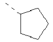 | CH₃ | Ph |
| 886. | CH₃ | CH₃ | 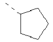 | H | Ph |
| 887. | CH₃ | H | 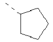 | CH₃ | Ph |
| 888. | H | CH₃ | 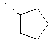 | CH₃ | Ph |
| 889. | CH₃ | CH₃ | 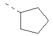 | CH₃ | Ph |
| 890. | 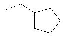 | H | H | H | Ph |
| 891. | 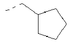 | CH₃ | H | CH₃ | Ph |
| 892. | 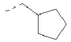 | H | CH₃ | H | Ph |
| 893. | 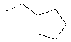 | H | H | CH₃ | Ph |
| 894. | 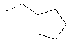 | CH₃ | CH₃ | H | Ph |
| 895. | 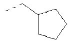 | CH₃ | H | CH₃ | Ph |
| 896. | 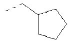 | H | CH₃ | CH₃ | Ph |
| 897. | 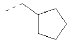 | CH₃ | CH₃ | CH₃ | Ph |
| 898. | H | 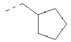 | H | H | Ph |
| 899. | CH₃ | 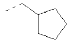 | H | CH₃ | Ph |
| 900. | H | 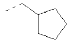 | CH₃ | H | Ph |
| 901. | H | 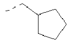 | H | CH₃ | Ph |
| 902. | CH₃ | 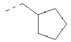 | CH₃ | H | Ph |
| 903. | CH₃ | 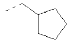 | H | CH₃ | Ph |
| 904. | H | 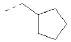 | CH₃ | CH₃ | Ph |
| 905. | CH₃ | 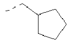 | CH₃ | CH₃ | Ph |
| 906. | H | H | 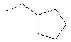 | H | Ph |
| 907. | CH₃ | H | 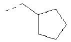 | H | Ph |
| 908. | H | CH₃ | 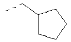 | H | Ph |
| 909. | H | H | 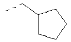 | CH₃ | Ph |
| 910. | CH₃ | CH₃ | 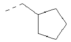 | H | Ph |
| 911. | CH₃ | H | 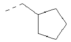 | CH₃ | Ph |
| 912. | H | CH₃ | 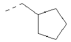 | CH₃ | Ph |
| 913. | CH₃ | CH₃ | 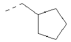 | CH₃ | Ph |
| 914. | 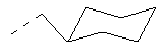 | H | H | H | Ph |
| 915. | 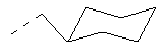 | CH₃ | H | CH₃ | Ph |
| 916. | 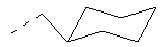 | H | CH₃ | H | Ph |
| 917. | 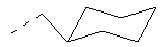 | H | H | CH₃ | Ph |
| 918. | 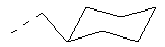 | CH₃ | CH₃ | H | Ph |
| 919. | 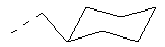 | CH₃ | H | CH₃ | Ph |
| 920. | 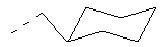 | H | CH₃ | CH₃ | Ph |
| 921. | 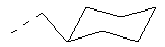 | CH₃ | CH₃ | CH₃ | Ph |
| 922. | H | 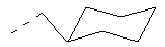 | H | H | Ph |
| 923. | CH₃ | 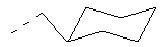 | H | CH₃ | Ph |
| 924. | H | 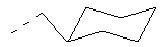 | CH₃ | H | Ph |
| 925. | H | 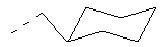 | H | CH₃ | Ph |
| 926. | CH₃ | 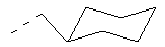 | CH₃ | H | Ph |
| 927. | CH₃ | 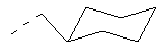 | H | CH₃ | Ph |
| 928. | H | 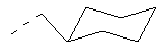 | CH₃ | CH₃ | Ph |
| 929. | CH₃ | 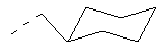 | CH₃ | CH₃ | Ph |
| 930. | H | H | 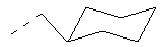 | H | Ph |
| 931. | CH₃ | H | 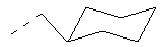 | H | Ph |
| 932. | H | CH₃ | 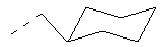 | H | Ph |
| 933. | H | H | 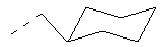 | CH₃ | Ph |
| 934. | CH₃ | CH₃ | 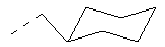 | H | Ph |
| 935. | CH₃ | H | 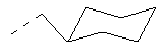 | CH₃ | Ph |
| 936. | H | CH₃ | 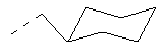 | CH₃ | Ph |
| 937. | CH₃ | CH₃ | 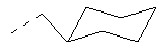 | CH₃ | Ph |
| 938. | 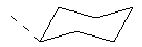 | H | H | H | Ph |
| 939. | 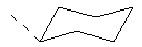 | CH₃ | H | CH₃ | Ph |
| 940. | 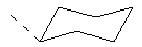 | H | CH₃ | H | Ph |
| 941. | 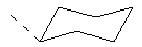 | H | H | CH₃ | Ph |
| 942. | 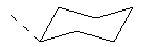 | CH₃ | CH₃ | H | Ph |
| 943. | 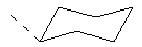 | CH₃ | H | CH₃ | Ph |
| 944. | 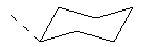 | H | CH₃ | CH₃ | Ph |
| 945. | 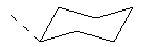 | CH₃ | CH₃ | CH₃ | Ph |
| 946. | H | 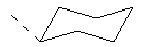 | H | H | Ph |
| 947. | CH₃ | 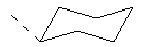 | H | CH₃ | Ph |
| 948. | H | 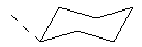 | CH₃ | H | Ph |
| 949. | H | 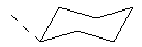 | H | CH₃ | Ph |
| 950. | CH₃ | 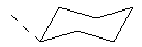 | CH₃ | H | Ph |
| 951. | CH₃ | 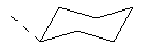 | H | CH₃ | Ph |
| 952. | H | 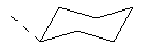 | CH₃ | CH₃ | Ph |
| 953. | CH₃ | 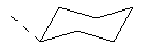 | CH₃ | CH₃ | Ph |
| 954. | H | H | 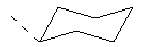 | H | Ph |
| 955. | CH₃ | H | 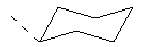 | H | Ph |
| 956. | H | CH₃ | 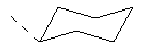 | H | Ph |
| 957. | H | H | 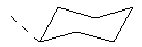 | CH₃ | Ph |
| 958. | CH₃ | CH₃ | 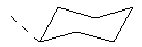 | H | Ph |
| 959. | CH₃ | H | 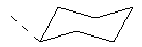 | CH₃ | Ph |
| 960. | H | CH₃ | 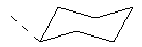 | CH₃ | Ph |
| 961. | CH₃ | CH₃ | 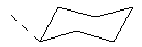 | CH₃ | Ph |
| 962. | 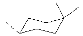 | H | H | H | Ph |
| 963. | 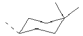 | CH₃ | H | CH₃ | Ph |
| 964. | 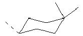 | H | CH₃ | H | Ph |
| 965. | 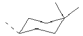 | H | H | CH₃ | Ph |
| 966. | 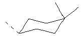 | CH₃ | CH₃ | H | Ph |
| 967. | 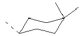 | CH₃ | H | CH₃ | Ph |
| 968. | 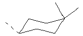 | H | CH₃ | CH₃ | Ph |
| 969. | 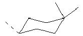 | CH₃ | CH₃ | CH₃ | Ph |
| 970. | H | 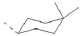 | H | H | Ph |
| 971. | CH₃ | 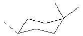 | H | CH₃ | Ph |
| 972. | H | 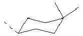 | CH₃ | H | Ph |
| 973. | H | 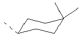 | H | CH₃ | Ph |
| 974. | CH₃ | 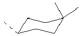 | CH₃ | H | Ph |
| 975. | CH₃ | 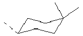 | H | CH₃ | Ph |
| 976. | H | 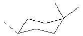 | CH₃ | CH₃ | Ph |
| 977. | CH₃ | 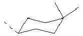 | CH₃ | CH₃ | Ph |
| 978. | H | H | 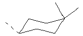 | H | Ph |
| 979. | CH₃ | H | 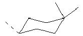 | H | Ph |
| 980. | H | CH₃ | 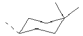 | H | Ph |
| 981. | H | H | 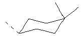 | CH₃ | Ph |
| 982. | CH₃ | CH₃ | 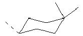 | H | Ph |
| 983. | CH₃ | H | 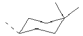 | CH₃ | Ph |
| 984. | H | CH₃ | 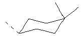 | CH₃ | Ph |
| 985. | CH₃ | CH₃ | 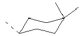 | CH₃ | Ph |
| 986. | 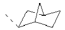 | H | H | H | Ph |
| 987. | 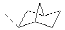 | CH₃ | H | CH₃ | Ph |
| 988. | 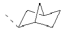 | H | CH₃ | H | Ph |
| 989. | 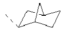 | H | H | CH₃ | Ph |
| 990. | 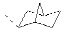 | CH₃ | CH₃ | H | Ph |
| 991. | 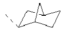 | CH₃ | H | CH₃ | Ph |
| 992. | 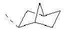 | H | CH₃ | CH₃ | Ph |
| 993. | 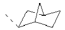 | CH₃ | CH₃ | CH₃ | Ph |
| 994. | H | 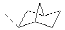 | H | H | Ph |
| 995. | CH₃ | 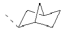 | H | CH₃ | Ph |
| 996. | H | 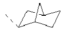 | CH₃ | H | Ph |
| 997. | H | 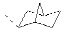 | H | CH₃ | Ph |
| 998. | CH₃ | 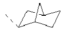 | CH₃ | H | Ph |
| 999. | CH₃ | 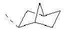 | H | CH₃ | Ph |
| 1000. | H | 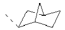 | CH₃ | CH₃ | Ph |
| 1001. | CH₃ | 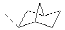 | CH₃ | CH₃ | Ph |
| 1002. | H | H | 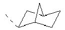 | H | Ph |
| 1003. | CH₃ | H | 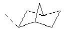 | H | Ph |
| 1004. | H | CH₃ | 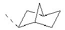 | H | Ph |
| 1005. | H | H | 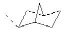 | CH₃ | Ph |
| 1006. | CH₃ | CH₃ | 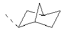 | H | Ph |
| 1007. | CH₃ | H | 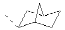 | CH₃ | Ph |
| 1008. | H | CH₃ | 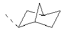 | CH₃ | Ph |
| 1009. | CH₃ | CH₃ | 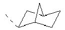 | CH₃ | Ph |
| 1010. | CH(CH₃)₂ | H | CH₂CH₃ | H | Ph |
| 1011. | CH(CH₃)₂ | H | CH(CH₃)₂ | H | Ph |
| 1012. | CH(CH₃)₂ | H | CH₂CH(CH₃)₂ | H | Ph |
| 1013. | CH(CH₃)₂ | H | C(CH₃)₃ | H | Ph |
| 1014. | CH(CH₃)₂ | H | CH₂C(CH₃)₃ | H | Ph |
| 1015. | CH(CH₃)₂ | H | 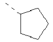 | H | Ph |
| 1016. | CH(CH₃)₂ | H | 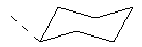 | H | Ph |
| 1017. | CH(CH₃)₂ | H | 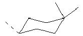 | H | Ph |
| 1018. | CH(CH₃)₂ | H | 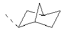 | H | Ph |
| 1019. | CH(CH₃)₂ | H | 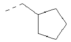 | H | Ph |
| 1020. | CH(CH₃)₂ | H | 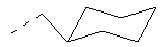 | H | Ph |
| 1021. | C(CH₃)₃ | H | CH₂CH₃ | H | Ph |
| 1022. | C(CH₃)₃ | H | CH(CH₃)₂ | H | Ph |
| 1023. | C(CH₃)₃ | H | CH₂CH(CH₃)₂ | H | Ph |
| 1024. | C(CH₃)₃ | H | C(CH₃)₃ | H | Ph |
| 1025. | C(CH₃)₃ | H | CH₂C(CH₃)₃ | H | Ph |
| 1026. | C(CH₃)₃ | H | 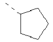 | H | Ph |
| 1027. | C(CH₃)₃ | H | 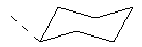 | H | Ph |
| 1028. | C(CH₃)₃ | H | 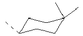 | H | Ph |
| 1029. | C(CH₃)₃ | H | 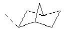 | H | Ph |
| 1030. | C(CH₃)₃ | H | 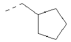 | H | Ph |
| 1031. | C(CH₃)₃ | H | 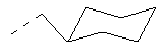 | H | Ph |
| 1032. | CH₂C(CH₃)₃ | H | CH₂CH₃ | H | Ph |
| 1033. | CH₂C(CH₃)₃ | H | CH(CH₃)₂ | H | Ph |
| 1034. | CH₂C(CH₃)₃ | H | CH₂CH(CH₃)₂ | H | Ph |
| 1035. | CH₂C(CH₃)₃ | H | C(CH₃)₃ | H | Ph |
| 1036. | CH₂C(CH₃)₃ | H | CH₂C(CH₃)₃ | H | Ph |
| 1037. | CH₂C(CH₃)₃ | H | 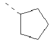 | H | Ph |
| 1038. | CH₂C(CH₃)₃ | H | 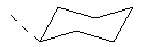 | H | Ph |
| 1039. | CH₂C(CH₃)₃ | H | 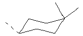 | H | Ph |
| 1040. | CH₂C(CH₃)₃ | H | 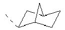 | H | Ph |
| 1041. | CH₂C(CH₃)₃ | H | 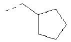 | H | Ph |
| 1042. | CH₂C(CH₃)₃ | H | 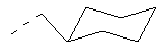 | H | Ph |
| 1043. | 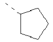 | H | CH₂CH₃ | H | Ph |
| 1044. | 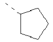 | H | CH(CH₃)₂ | H | Ph |
| 1045. | 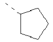 | H | CH₂CH(CH₃)₂ | H | Ph |
| 1046. | 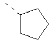 | H | C(CH₃)₃ | H | Ph |
| 1047. | 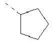 | H | CH₂C(CH₃)₃ | H | Ph |
| 1048. | 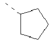 | H | 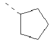 | H | Ph |
| 1049. | 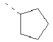 | H | 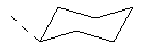 | H | Ph |
| 1050. | 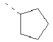 | H | 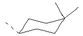 | H | Ph |
| 1051. | 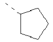 | H | 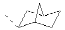 | H | Ph |
| 1052. | 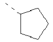 | H | 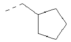 | H | Ph |
| 1053. | 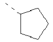 | H | 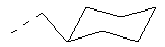 | H | Ph |
| 1054. | 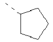 | H | CH₂CH₃ | H | Ph |
| 1055. | 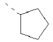 | H | CH(CH₃)₂ | H | Ph |
| 1056. | 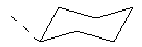 | H | CH₂CH(CH₃)₂ | H | Ph |
| 1057. | 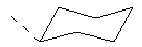 | H | C(CH₃)₃ | H | Ph |
| 1058. | 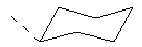 | H | CH₂C(CH₃)₃ | H | Ph |
| 1059. | 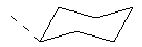 | H | 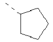 | H | Ph |
| 1060. | 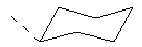 | H | 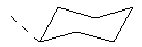 | H | Ph |
| 1061. | 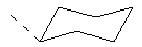 | H | 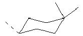 | H | Ph |
| 1062. | 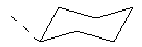 | H | 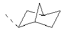 | H | Ph |
| 1063. | 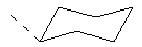 | H | 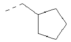 | H | Ph |
| 1064. | 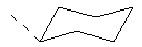 | H | 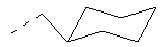 | H | Ph |
| 1065. | 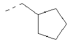 | H | CH₂CH(CH₃)₂ | H | Ph |
| 1066. | 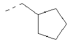 | H | C(CH₃)₃ | H | Ph |
| 1067. | 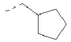 | H | CH₂C(CH₃)₃ | H | Ph |
| 1068. | 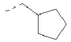 | H | 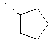 | H | Ph |
| 1069. | 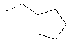 | H | 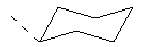 | H | Ph |
| 1070. | 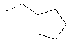 | H | 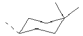 | H | Ph |
| 1071. | 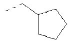 | H | 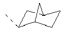 | H | Ph |
| 1072. | 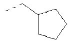 | H | 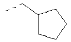 | H | Ph |
| 1073. | 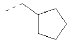 | H | 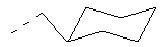 | H | Ph |
| 1074. | 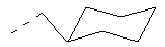 | H | CH₂CH(CH₃)₂ | H | Ph |
| 1075. | 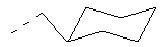 | H | C(CH₃)₃ | H | Ph |
| 1076. | 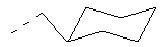 | H | CH₂C(CH₃)₃ | H | Ph |
| 1077. | 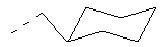 | H | 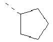 | H | Ph |
| 1078. | 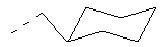 | H | 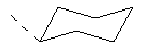 | H | Ph |
| 1079. | 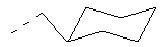 | H | 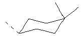 | H | Ph |
| 1080. | 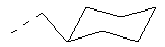 | H | 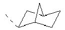 | H | Ph |
| 1081. | 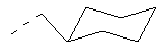 | H | 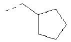 | H | Ph |
| 1082. | 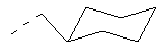 | H | 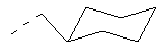 | H | Ph |
| 1083. | 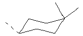 | H | CH₂CH(CH₃)₂ | H | Ph |
| 1084. | 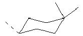 | H | C(CH₃)₃ | H | Ph |
| 1085. | 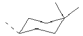 | H | CH₂C(CH₃)₃ | H | Ph |
| 1086. | 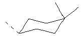 | H | 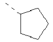 | H | Ph |
| 1087. | 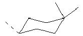 | H | 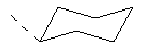 | H | Ph |
| 1088. | 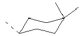 | H | 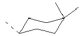 | H | Ph |
| 1089. | 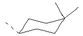 | H | 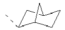 | H | Ph |
| 1090. | 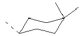 | H | 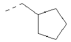 | H | Ph |
| 1091. | 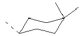 | H | 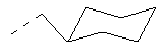 | H | Ph |
| 1092. | H | H | H | H | Ph |
| 1093. | CD₃ | H | H | H | Ph |
| 1094. | H | CD₃ | H | H | Ph |
| 1095. | H | H | CD₃ | H | Ph |
| 1096. | CD₃ | CD₃ | H | CD₃ | Ph |
| 1097. | CD₃ | H | CD₃ | H | Ph |
| 1098. | CD₃ | H | H | CD₃ | Ph |
| 1099. | H | CD₃ | CD₃ | H | Ph |
| 1100. | H | CD₃ | H | CD₃ | Ph |
| 1101. | H | H | CD₃ | CD₃ | Ph |
| 1102. | CD₃ | CD₃ | CD₃ | H | Ph |
| 1103. | CD₃ | CD₃ | H | CD₃ | Ph |
| 1104. | CD₃ | H | CD₃ | CD₃ | Ph |
| 1105. | H | CD₃ | CD₃ | CD₃ | Ph |
| 1106. | CD₃ | CD₃ | CD₃ | CD₃ | Ph |
| 1107. | CD₂CH₃ | H | H | H | Ph |
| 1108. | CD₂CH₃ | CD₃ | H | CD₃ | Ph |
| 1109. | CD₂CH₃ | H | CD₃ | H | Ph |
| 1110. | CD₂CH₃ | H | H | CD₃ | Ph |
| 1111. | CD₂CH₃ | CD₃ | CD₃ | H | Ph |
| 1112. | CD₂CH₃ | CD₃ | H | CD₃ | Ph |
| 1113. | CD₂CH₃ | H | CD₃ | CD₃ | Ph |
| 1114. | CD₂CH₃ | CD₃ | CD₃ | CD₃ | Ph |
| 1115. | H | CD₂CH₃ | H | H | Ph |
| 1116. | CH₃ | CD₂CH₃ | H | CD₃ | Ph |
| 1117. | H | CD₂CH₃ | CD₃ | H | Ph |
| 1118. | H | CD₂CH₃ | H | CD₃ | Ph |
| 1119. | CD₃ | CD₂CH₃ | CD₃ | H | Ph |
| 1120. | CD₃ | CD₂CH₃ | H | CD₃ | Ph |
| 1121. | H | CD₂CH₃ | CD₃ | CD₃ | Ph |
| 1122. | CD₃ | CD₂CH₃ | CD₃ | CD₃ | Ph |
| 1123. | H | H | CD₂CH₃ | H | Ph |
| 1124. | CD₃ | H | CD₂CH₃ | H | Ph |
| 1125. | H | CD₃ | CD₂CH₃ | H | Ph |
| 1126. | H | H | CD₂CH₃ | CD₃ | Ph |
| 1127. | CD₃ | CD₃ | CD₂CH₃ | H | Ph |
| 1128. | CD₃ | H | CD₂CH₃ | CD₃ | Ph |
| 1129. | H | CD₃ | CD₂CH₃ | CD₃ | Ph |
| 1130. | CD₃ | CD₃ | CD₂CH₃ | CD₃ | Ph |
| 1131. | CD(CH₃)₂ | H | H | H | Ph |
| 1132. | CD(CH₃)₂ | CD₃ | H | CD₃ | Ph |
| 1133. | CD(CH₃)₂ | H | CD₃ | H | Ph |
| 1134. | CD(CH₃)₂ | H | H | CD₃ | Ph |
| 1135. | CD(CH₃)₂ | CD₃ | CD₃ | H | Ph |
| 1136. | CD(CH₃)₂ | CD₃ | H | CD₃ | Ph |
| 1137. | CD(CH₃)₂ | H | CD₃ | CD₃ | Ph |
| 1138. | CD(CH₃)₂ | CD₃ | CD₃ | CD₃ | Ph |
| 1139. | H | CD(CH₃)₂ | H | H | Ph |
| 1140. | CD₃ | CD(CH₃)₂ | H | CD₃ | Ph |
| 1141. | H | CD(CH₃)₂ | CD₃ | H | Ph |
| 1142. | H | CD(CH₃)₂ | H | CD₃ | Ph |
| 1143. | CD₃ | CD(CH₃)₂ | CD₃ | H | Ph |
| 1144. | CD₃ | CD(CH₃)₂ | H | CD₃ | Ph |
| 1145. | H | CD(CH₃)₂ | CD₃ | CD₃ | Ph |
| 1146. | CD₃ | CD(CH₃)₂ | CD₃ | CD₃ | Ph |
| 1147. | H | H | CD(CH₃)₂ | H | Ph |
| 1148. | CD₃ | H | CD(CH₃)₂ | H | Ph |
| 1149. | H | CD₃ | CD(CH₃)₂ | H | Ph |
| 1150. | H | H | CD(CH₃)₂ | CD₃ | Ph |
| 1151. | CD₃ | CD₃ | CD(CH₃)₂ | H | Ph |
| 1152. | CD₃ | H | CD(CH₃)₂ | CD₃ | Ph |
| 1153. | H | CD₃ | CD(CH₃)₂ | CD₃ | Ph |
| 1154. | CD₃ | CD₃ | CD(CH₃)₂ | CD₃ | Ph |
| 1155. | CD(CD₃)₂ | H | H | H | Ph |
| 1156. | CD(CD₃)₂ | CD₃ | H | CD₃ | Ph |
| 1157. | CD(CD₃)₂ | H | CD₃ | H | Ph |
| 1158. | CD(CD₃)₂ | H | H | CD₃ | Ph |
| 1159. | CD(CD₃)₂ | CD₃ | CD₃ | H | Ph |
| 1160. | CD(CD₃)₂ | CD₃ | H | CD₃ | Ph |
| 1161. | CD(CD₃)₂ | H | CD₃ | CD₃ | Ph |
| 1162. | CD(CD₃)₂ | CD₃ | CD₃ | CD₃ | Ph |
| 1163. | H | CD(CD₃)₂ | H | H | Ph |
| 1164. | CH₃ | CD(CD₃)₂ | H | CD₃ | Ph |
| 1165. | H | CD(CD₃)₂ | CD₃ | H | Ph |
| 1166. | H | CD(CD₃)₂ | H | CD₃ | Ph |
| 1167. | CD₃ | CD(CD₃)₂ | CD₃ | H | Ph |
| 1168. | CD₃ | CD(CD₃)₂ | H | CD₃ | Ph |
| 1169. | H | CD(CD₃)₂ | CD₃ | CD₃ | Ph |
| 1170. | CD₃ | CD(CD₃)₂ | CD₃ | CD₃ | Ph |
| 1171. | H | H | CD(CD₃)₂ | H | Ph |
| 1172. | CD₃ | H | CD(CD₃)₂ | H | Ph |
| 1173. | H | CD₃ | CD(CD₃)₂ | H | Ph |
| 1174. | H | H | CD(CD₃)₂ | CD₃ | Ph |
| 1175. | CD₃ | CD₃ | CD(CD₃)₂ | H | Ph |
| 1176. | CD₃ | H | CD(CD₃)₂ | CD₃ | Ph |
| 1177. | H | CD₃ | CD(CD₃)₂ | CD₃ | Ph |
| 1178. | CD₃ | CD₃ | CD(CD₃)₂ | CD₃ | Ph |
| 1179. | CD₂CH(CH₃)₂ | H | H | H | Ph |
| 1180. | CD₂CH(CH₃)₂ | CD₃ | H | CD₃ | Ph |
| 1181. | CD₂CH(CH₃)₂ | H | CD₃ | H | Ph |
| 1182. | CD₂CH(CH₃)₂ | H | H | CD₃ | Ph |
| 1183. | CD₂CH(CH₃)₂ | CD₃ | CD₃ | H | Ph |
| 1184. | CD₂CH(CH₃)₂ | CD₃ | H | CD₃ | Ph |
| 1185. | CD₂CH(CH₃)₂ | H | CD₃ | CD₃ | Ph |
| 1186. | CD₂CH(CH₃)₂ | CD₃ | CD₃ | CD₃ | Ph |
| 1187. | H | CD₂CH(CH₃)₂ | H | H | Ph |
| 1188. | CD₃ | CD₂CH(CH₃)₂ | H | CD₃ | Ph |
| 1189. | H | CD₂CH(CH₃)₂ | CD₃ | H | Ph |
| 1190. | H | CD₂CH(CH₃)₂ | H | CD₃ | Ph |
| 1191. | CD₃ | CD₂CH(CH₃)₂ | CD₃ | H | Ph |
| 1192. | CD₃ | CD₂CH(CH₃)₂ | H | CD₃ | Ph |
| 1193. | H | CD₂CH(CH₃)₂ | CD₃ | CD₃ | Ph |
| 1194. | CD₃ | CD₂CH(CH₃)₂ | CD₃ | CD₃ | Ph |
| 1195. | H | H | CD₂CH(CH₃)₂ | H | Ph |
| 1196. | CD₃ | H | CD₂CH(CH₃)₂ | H | Ph |
| 1197. | H | CD₃ | CD₂CH(CH₃)₂ | H | Ph |
| 1198. | H | H | CD₂CH(CH₃)₂ | CD₃ | Ph |
| 1199. | CD₃ | CD₃ | CD₂CH(CH₃)₂ | H | Ph |
| 1200. | CD₃ | H | CD₂CH(CH₃)₂ | CD₃ | Ph |
| 1201. | H | CD₃ | CD₂CH(CH₃)₂ | CD₃ | Ph |
| 1202. | CD₃ | CD₃ | CD₂CH(CH₃)₂ | CD₃ | Ph |
| 1203. | CD₂C(CH₃)₃ | H | H | H | Ph |
| 1204. | CD₂C(CH₃)₃ | CD₃ | H | CD₃ | Ph |
| 1205. | CD₂C(CH₃)₃ | H | CD₃ | H | Ph |
| 1206. | CD₂C(CH₃)₃ | H | H | CD₃ | Ph |
| 1207. | CD₂C(CH₃)₃ | CD₃ | CD₃ | H | Ph |
| 1208. | CD₂C(CH₃)₃ | CD₃ | H | CD₃ | Ph |
| 1209. | CD₂C(CH₃)₃ | H | CD₃ | CD₃ | Ph |
| 1210. | CD₂C(CH₃)₃ | CH₃ | CD₃ | CD₃ | Ph |
| 1211. | H | CD₂C(CH₃)₃ | H | H | Ph |
| 1212. | CD₃ | CD₂C(CH₃)₃ | H | CD₃ | Ph |
| 1213. | H | CD₂C(CH₃)₃ | CD₃ | H | Ph |
| 1214. | H | CD₂C(CH₃)₃ | H | CD₃ | Ph |
| 1215. | CD₃ | CD₂C(CH₃)₃ | CD₃ | H | Ph |
| 1216. | CD₃ | CD₂C(CH₃)₃ | H | CD₃ | Ph |
| 1217. | H | CD₂C(CH₃)₃ | CD₃ | CD₃ | Ph |
| 1218. | CD₃ | CD₂C(CH₃)₃ | CD₃ | CD₃ | Ph |
| 1219. | H | H | CD₂C(CH₃)₃ | H | Ph |
| 1220. | CD₃ | H | CD₂C(CH₃)₃ | H | Ph |
| 1221. | H | CD₃ | CD₂C(CH₃)₃ | H | Ph |
| 1222. | H | H | CD₂C(CH₃)₃ | CD₃ | Ph |
| 1223. | CD₃ | CD₃ | CD₂C(CH₃)₃ | H | Ph |
| 1224. | CD₃ | H | CD₂C(CH₃)₃ | CD₃ | Ph |
| 1225. | H | CD₃ | CD₂C(CH₃)₃ | CD₃ | Ph |
| 1226. | CD₃ | CD₃ | CD₂C(CH₃)₃ | CD₃ | Ph |
| 1227. | 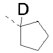 | H | H | H | Ph |
| 1228. | 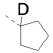 | CD₃ | H | CD₃ | Ph |
| 1229. | 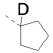 | H | CD₃ | H | Ph |
| 1230. | 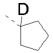 | H | H | CD₃ | Ph |
| 1231. | 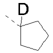 | CD₃ | CD₃ | H | Ph |
| 1232. | 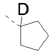 | CD₃ | H | CD₃ | Ph |
| 1233. | 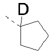 | H | CD₃ | CD₃ | Ph |
| 1234. | 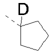 | CD₃ | CD₃ | CD₃ | Ph |
| 1235. | H | 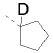 | H | H | Ph |
| 1236. | CD₃ | 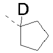 | H | CD₃ | Ph |
| 1237. | H | 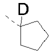 | CD₃ | H | Ph |
| 1238. | H | 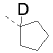 | H | CD₃ | Ph |
| 1239. | CD₃ | 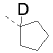 | CD₃ | H | Ph |
| 1240. | CD₃ | 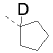 | H | CD₃ | Ph |
| 1241. | H | 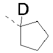 | CD₃ | CD₃ | Ph |
| 1242. | CD₃ | 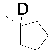 | CD₃ | CD₃ | Ph |
| 1243. | H | H | 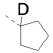 | H | Ph |
| 1244. | CD₃ | H | 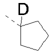 | H | Ph |
| 1245. | H | CD₃ | 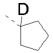 | H | Ph |
| 1246. | H | H | 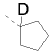 | CD₃ | Ph |
| 1247. | CD₃ | CD₃ | 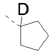 | H | Ph |
| 1248. | CD₃ | H | 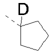 | CD₃ | Ph |
| 1249. | H | CD₃ | 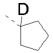 | CD₃ | Ph |
| 1250. | CD₃ | CD₃ | 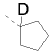 | CD₃ | Ph |
| 1251. | 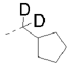 | H | H | H | Ph |
| 1252. | 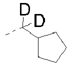 | CD₃ | H | CD₃ | Ph |
| 1253. | 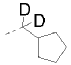 | H | CD₃ | H | Ph |
| 1254. | 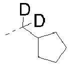 | H | H | CD₃ | Ph |
| 1255. | 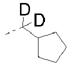 | CD₃ | CD₃ | H | Ph |
| 1256. | 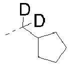 | CD₃ | H | CD₃ | Ph |
| 1257. | 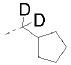 | H | CD₃ | CD₃ | Ph |
| 1258. | 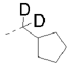 | CD₃ | CD₃ | CD₃ | Ph |
| 1259. | H | 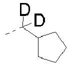 | H | H | Ph |
| 1260. | CH₃ | 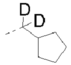 | H | CD₃ | Ph |
| 1261. | H | 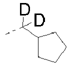 | CD₃ | H | Ph |
| 1262. | H | 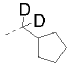 | H | CD₃ | Ph |
| 1263. | CD₃ | 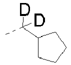 | CD₃ | H | Ph |
| 1264. | CD₃ | 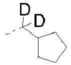 | H | CD₃ | Ph |
| 1265. | H | 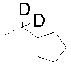 | CD₃ | CD₃ | Ph |
| 1266. | CH₃ | 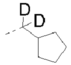 | CD₃ | CD₃ | Ph |
| 1267. | H | H | 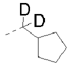 | H | Ph |
| 1268. | CD₃ | H | 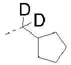 | H | Ph |
| 1269. | H | CD₃ | 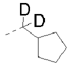 | H | Ph |
| 1270. | H | H | 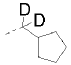 | CD₃ | Ph |
| 1271. | CD₃ | CD₃ | 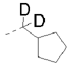 | H | Ph |
| 1272. | CD₃ | H | 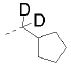 | CD₃ | Ph |
| 1273. | H | CD₃ | 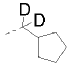 | CD₃ | Ph |
| 1274. | CD₃ | CD₃ | 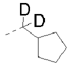 | CD₃ | Ph |
| 1275. | 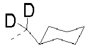 | H | H | H | Ph |
| 1276. | 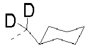 | CD₃ | H | CD₃ | Ph |
| 1277. | 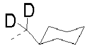 | H | CD₃ | H | Ph |
| 1278. | 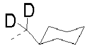 | H | H | CD₃ | Ph |
| 1279. | 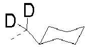 | CD₃ | CD₃ | H | Ph |
| 1280. | 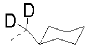 | CD₃ | H | CD₃ | Ph |
| 1281. | 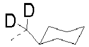 | H | CD₃ | CD₃ | Ph |
| 1282. | 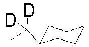 | CD₃ | CD₃ | CD₃ | Ph |
| 1283. | H | 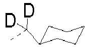 | H | H | Ph |
| 1284. | CD₃ | 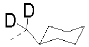 | H | CD₃ | Ph |
| 1285. | H | 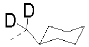 | CD₃ | H | Ph |
| 1286. | H | 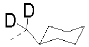 | H | CD₃ | Ph |
| 1287. | CD₃ | 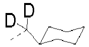 | CD₃ | H | Ph |
| 1288. | CD₃ | 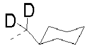 | H | CD₃ | Ph |
| 1289. | H | 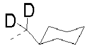 | CD₃ | CD₃ | Ph |
| 1290. | CD₃ | 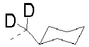 | CD₃ | CD₃ | Ph |
| 1291. | H | H | 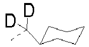 | H | Ph |
| 1292. | CD₃ | H | 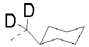 | H | Ph |
| 1293. | H | CD₃ | 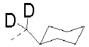 | H | Ph |
| 1294. | H | H | 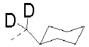 | CD₃ | Ph |
| 1295. | CD₃ | CD₃ | 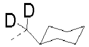 | H | Ph |
| 1296. | CD₃ | H | 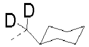 | CD₃ | Ph |
| 1297. | H | CD₃ | 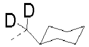 | CD₃ | Ph |
| 1298. | CD₃ | CD₃ | 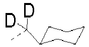 | CD₃ | Ph |
| 1299. | 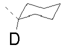 | H | H | H | Ph |
| 1300. | 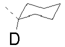 | CD₃ | H | CD₃ | Ph |
| 1301. | 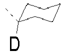 | H | CD₃ | H | Ph |
| 1302. | 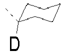 | H | H | CD₃ | Ph |
| 1303. | 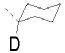 | CD₃ | CD₃ | H | Ph |
| 1304. | 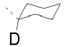 | CD₃ | H | CD₃ | Ph |
| 1305. | 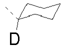 | H | CD₃ | CD₃ | Ph |
| 1306. | 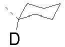 | CD₃ | CD₃ | CD₃ | Ph |
| 1307. | H | 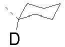 | H | H | Ph |
| 1308. | CD₃ | 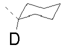 | H | CD₃ | Ph |
| 1309. | H | 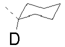 | CD₃ | H | Ph |
| 1310. | H | 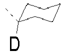 | H | CD₃ | Ph |
| 1311. | CD₃ | 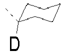 | CD₃ | H | Ph |
| 1312. | CD₃ | 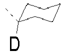 | H | CD₃ | Ph |
| 1313. | H | 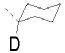 | CD₃ | CD₃ | Ph |
| 1314. | CD₃ | 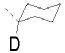 | CD₃ | CD₃ | Ph |
| 1315. | H | H | 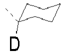 | H | Ph |
| 1316. | CD₃ | H | 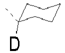 | H | Ph |
| 1317. | H | CD₃ | 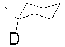 | H | Ph |
| 1318. | H | H | 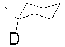 | CD₃ | Ph |
| 1319. | CD₃ | CD₃ | 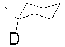 | H | Ph |
| 1320. | CD₃ | H | 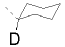 | CD₃ | Ph |
| 1321. | H | CD₃ | 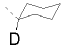 | CD₃ | Ph |
| 1322. | CD₃ | CD₃ | 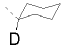 | CD₃ | Ph |
| 1323. | 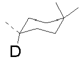 | H | H | H | Ph |
| 1324. | 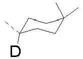 | CD₃ | H | CD₃ | Ph |
| 1325. | 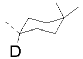 | H | CD₃ | H | Ph |
| 1326. | 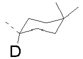 | H | H | CD₃ | Ph |
| 1327. | 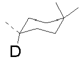 | CD₃ | CD₃ | H | Ph |
| 1328. | 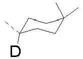 | CD₃ | H | CD₃ | Ph |
| 1329. | 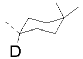 | H | CD₃ | CD₃ | Ph |
| 1330. | 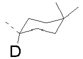 | CD₃ | CD₃ | CD₃ | Ph |
| 1331. | H | 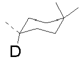 | H | H | Ph |
| 1332. | CD₃ | 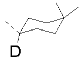 | H | CD₃ | Ph |
| 1333. | H | 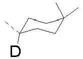 | CD₃ | H | Ph |
| 1334. | H | 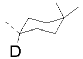 | H | CD₃ | Ph |
| 1335. | CD₃ | 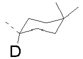 | CD₃ | H | Ph |
| 1336. | CD₃ | 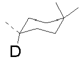 | H | CD₃ | Ph |
| 1337. | H | 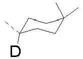 | CD₃ | CD₃ | Ph |
| 1338. | CD₃ | 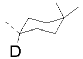 | CD₃ | CD₃ | Ph |
| 1339. | H | H | 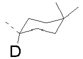 | H | Ph |
| 1340. | CD₃ | H | 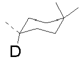 | H | Ph |
| 1341. | H | CD₃ | 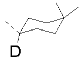 | H | Ph |
| 1342. | H | H | 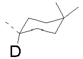 | CD₃ | Ph |
| 1343. | CD₃ | CD₃ | 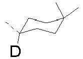 | H | Ph |
| 1344. | CD₃ | H | 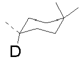 | CD₃ | Ph |
| 1345. | H | CD₃ | 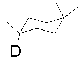 | CD₃ | Ph |
| 1346. | CD₃ | CD₃ | 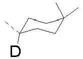 | CD₃ | Ph |
| 1347. | 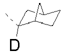 | H | H | H | Ph |
| 1348. | 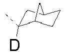 | CD₃ | H | CD₃ | Ph |
| 1349. | 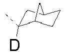 | H | CD₃ | H | Ph |
| 1350. | 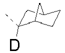 | H | H | CD₃ | Ph |
| 1351. | 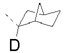 | CH₃ | CH₃ | H | Ph |
| 1352. | 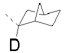 | CD₃ | H | CD₃ | Ph |
| 1353. | 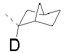 | H | CD₃ | CD₃ | Ph |
| 1354. | 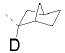 | CD₃ | CD₃ | CD₃ | Ph |
| 1355. | H | 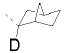 | H | H | Ph |
| 1356. | CD₃ | 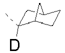 | H | CD₃ | Ph |
| 1357. | H | 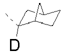 | CD₃ | H | Ph |
| 1358. | H | 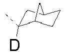 | H | CD₃ | Ph |
| 1359. | CD₃ | 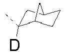 | CD₃ | H | Ph |
| 1360. | CD₃ | 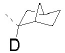 | H | CD₃ | Ph |
| 1361. | H | 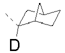 | CD₃ | CD₃ | Ph |
| 1362. | CD₃ | 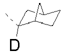 | CD₃ | CD₃ | Ph |
| 1363. | H | H | 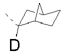 | H | Ph |
| 1364. | CD₃ | H | 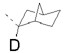 | H | Ph |
| 1365. | H | CD₃ | 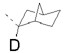 | H | Ph |
| 1366. | H | H | 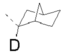 | CH₃ | Ph |
| 1367. | CD₃ | CD₃ | 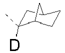 | H | Ph |
| 1368. | CD₃ | H | 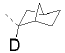 | CD₃ | Ph |
| 1369. | H | CD₃ | 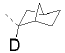 | CD₃ | Ph |
| 1370. | CD₃ | CD₃ | 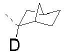 | CD₃ | Ph |
| 1371. | CD(CH₃)₂ | H | CD₂CH₃ | H | Ph |
| 1372. | CD(CH₃)₂ | H | CD(CH₃)₂ | H | Ph |
| 1373. | CD(CH₃)₂ | H | CD₂CH(CH₃)₂ | H | Ph |
| 1374. | CD(CH₃)₂ | H | C(CH₃)₃ | H | Ph |
| 1375. | CD(CH₃)₂ | H | CD₂C(CH₃)₃ | H | Ph |
| 1376. | CD(CH₃)₂ | H | 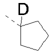 | H | Ph |
| 1377. | CD(CH₃)₂ | H | 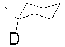 | H | Ph |
| 1378. | CD(CH₃)₂ | H | 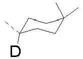 | H | Ph |
| 1379. | CD(CH₃)₂ | H | 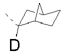 | H | Ph |
| 1380. | CD(CH₃)₂ | H | 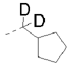 | H | Ph |
| 1381. | CD(CH₃)₂ | H | 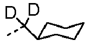 | H | Ph |
| 1382. | C(CH₃)₃ | H | CD₂CH₃ | H | Ph |
| 1383. | C(CH₃)₃ | H | CD(CH₃)₂ | H | Ph |
| 1384. | C(CH₃)₃ | H | CD₂CH(CH₃)₂ | H | Ph |
| 1385. | C(CH₃)₃ | H | C(CH₃)₃ | H | Ph |
| 1386. | C(CH₃)₃ | H | CD₂C(CH₃)₃ | H | Ph |
| 1387. | C(CH₃)₃ | H | 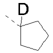 | H | Ph |
| 1388. | C(CH₃)₃ | H | 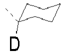 | H | Ph |
| 1389. | C(CH₃)₃ | H | 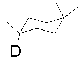 | H | Ph |
| 1390. | C(CH₃)₃ | H | 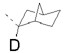 | H | Ph |
| 1391. | C(CH₃)₃ | H | 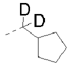 | H | Ph |
| 1392. | C(CH₃)₃ | H | 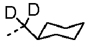 | H | Ph |
| 1393. | CD₂C(CH₃)₃ | H | CD₂CH₃ | H | Ph |
| 1394. | CD₂C(CH₃)₃ | H | CD(CH₃)₂ | H | Ph |
| 1395. | CD₂C(CH₃)₃ | H | CD₂CH(CH₃)₂ | H | Ph |
| 1396. | CD₂C(CH₃)₃ | H | C(CH₃)₃ | H | Ph |
| 1397. | CD₂C(CH₃)₃ | H | CD₂C(CH₃)₃ | H | Ph |
| 1398. | CD₂C(CH₃)₃ | H | 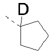 | H | Ph |
| 1399. | CD₂C(CH₃)₃ | H | 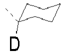 | H | Ph |
| 1400. | CD₂C(CH₃)₃ | H | 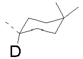 | H | Ph |
| 1401. | CD₂C(CH₃)₃ | H | 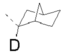 | H | Ph |
| 1402. | CD₂C(CH₃)₃ | H | 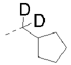 | H | Ph |
| 1403. | CD₂C(CH₃)₃ | H | 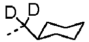 | H | Ph |
| 1404. | 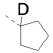 | H | CD₂CH₃ | H | Ph |
| 1405. | 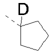 | H | CD(CH₃)₂ | H | Ph |
| 1406. | 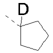 | H | CD₂CH(CH₃)₂ | H | Ph |
| 1407. | 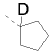 | H | C(CH₃)₃ | H | Ph |
| 1408. | 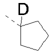 | H | CD₂C(CH₃)₃ | H | Ph |
| 1409. | 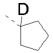 | H | 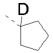 | H | Ph |
| 1410. | 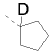 | H | 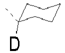 | H | Ph |
| 1411. | 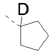 | H | 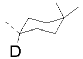 | H | Ph |
| 1412. | 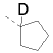 | H | 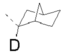 | H | Ph |
| 1413. | 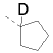 | H | 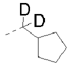 | H | Ph |
| 1414. | 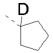 | H | 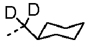 | H | Ph |
| 1415. | 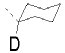 | H | CD₂CH₃ | H | Ph |
| 1416. | 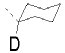 | H | CD(CH₃)₂ | H | Ph |
| 1417. | 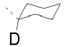 | H | CD₂CH(CH₃)₂ | H | Ph |
| 1418. | 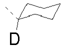 | H | C(CH₃)₃ | H | Ph |
| 1419. | 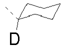 | H | CD₂C(CH₃)₃ | H | Ph |
| 1420. | 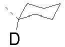 | H | 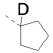 | H | Ph |
| 1421. | 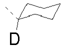 | H | 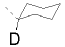 | H | Ph |
| 1422. | 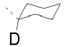 | H | 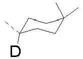 | H | Ph |
| 1423. | 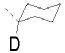 | H | 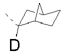 | H | Ph |
| 1424. | 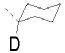 | H | 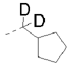 | H | Ph |
| 1425. | 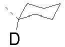 | H | 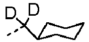 | H | Ph |
| 1426. | 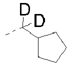 | H | CD₂CH₃ | H | Ph |
| 1427. | 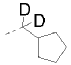 | H | CD(CH₃)₂ | H | Ph |
| 1428. | 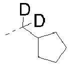 | H | CD₂CH(CH₃)₂ | H | Ph |
| 1429. | 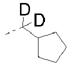 | H | C(CH₃)₃ | H | Ph |
| 1430. | 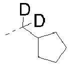 | H | CD₂C(CH₃)₃ | H | Ph |
| 1431. | 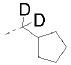 | H | 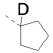 | H | Ph |
| 1432. | 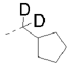 | H | 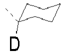 | H | Ph |
| 1433. | 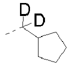 | H | 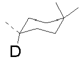 | H | Ph |
| 1434. | 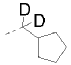 | H | 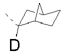 | H | Ph |
| 1435. | 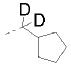 | H | 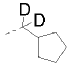 | H | Ph |
| 1436. | 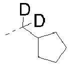 | H | 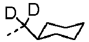 | H | Ph |
| 1437. | 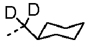 | H | CD₂CH₃ | H | Ph |
| 1438. | 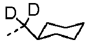 | H | CD(CH₃)₂ | H | Ph |
| 1439. | 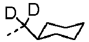 | H | CD₂CH(CH₃)₂ | H | Ph |
| 1440. | 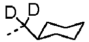 | H | C(CH₃)₃ | H | Ph |
| 1441. | 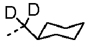 | H | CD₂C(CH₃)₃ | H | Ph |
| 1442. | 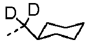 | H | 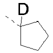 | H | Ph |
| 1443. | 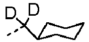 | H | 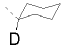 | H | Ph |
| 1444. | 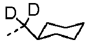 | H | 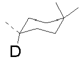 | H | Ph |
| 1445. | 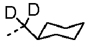 | H | 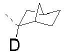 | H | Ph |
| 1446. | 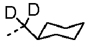 | H | 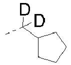 | H | Ph |
| 1447. | 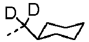 | H | 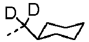 | H | Ph |
| 1448. | 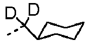 | H | CD₂CH₃ | H | Ph |
| 1449. | 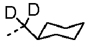 | H | CD(CH₃)₂ | H | Ph |
| 1450. | 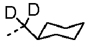 | H | CD₂CH(CH₃)₂ | H | Ph |
| 1451. | 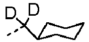 | H | C(CH₃)₃ | H | Ph |
| 1452. | 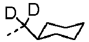 | H | CD₂C(CH₃)₃ | H | Ph |
| 1453. | 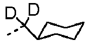 | H | 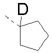 | H | Ph |
| 1454. | 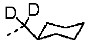 | H | 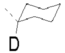 | H | Ph |
| 1455. | 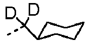 | H | 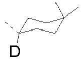 | H | Ph |
| 1456. | 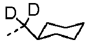 | H | 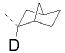 | H | Ph |
| 1457. | 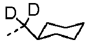 | H | 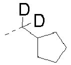 | H | Ph |
| 1458. | 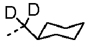 | H | 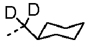 | H | Ph |
| 1459. | H | Ph | CD3 | H | H |
| 1460. | H | 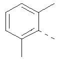 | CD3 | H | H |
| 1461. | H | 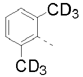 | CD3 | H | H |
| 1462. | H | 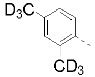 | CD3 | H | H |

8. Dispositif électroluminescent organique (OLED) comprenant :
une anode ;
une cathode ; et
une couche organique, disposée entre l'anode et la cathode, comprenant un composé selon l'une quelconque des revendications précédentes.

9. OLED selon la revendication 8, où la couche organique comprend en outre un hôte, où l'hôte comprend un thiophène benzo-fusionné ou furane benzo-fusionné contenant du triphénylène ;
où un quelconque substituant dans l'hôte est un substituant non fusionné choisi indépendamment dans le groupe constitué par CₙH₂ₙ₊₁, OCₙH₂ₙ₊₁, OAr₁, N(CₙH₂ₙ₊₁)₂, N(Ar₁)(Ar₂), CH=CH-CₙH₂ₙ₊₁, C≡CCₙH₂ₙ₊₁, Ar₁, Ar₁-Ar₂, et CₙH₂ₙ-Ar₁, ou l'hôte n'a aucune substitution ;
où n va de 1 à 10 ; et
où Ar₁ et Ar₂ sont chacun indépendamment choisis dans le groupe constitué par benzène, biphényle, naphtalène, triphénylène, carbazole, et leurs analogues hétéroaromatiques

10. OLED selon la revendication 8, où la couche organique comprend en outre un hôte, où l'hôte comprend au moins un groupe chimique choisi dans le groupe constitué par triphénylène, carbazole, dibenzothiophène, dibenzofurane, dibenzosélénophène, azatriphénylène, azacarbazole, aza-dibenzothiophène, aza-dibenzofurane, et aza-dibenzosélénophène ; ou l'hôte est choisi dans le groupe constitué par : 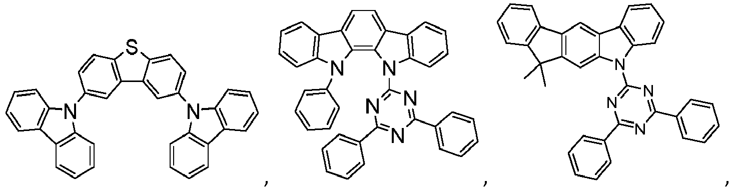 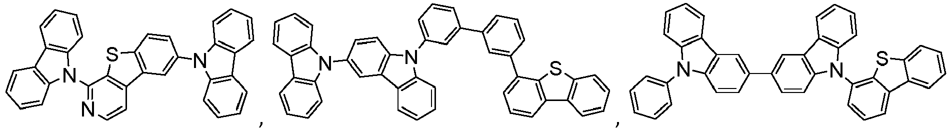 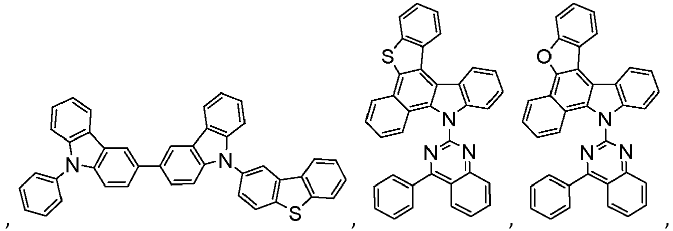 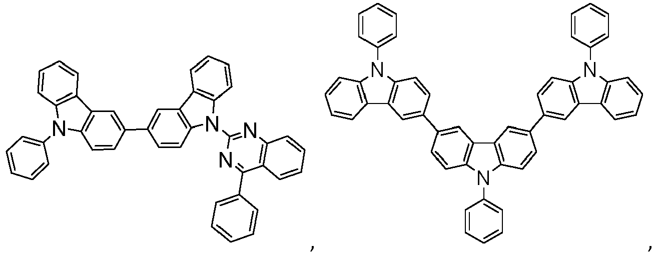 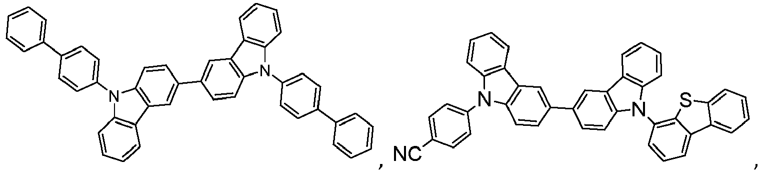 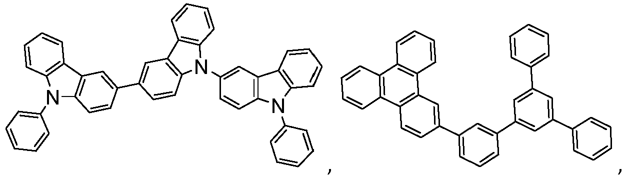 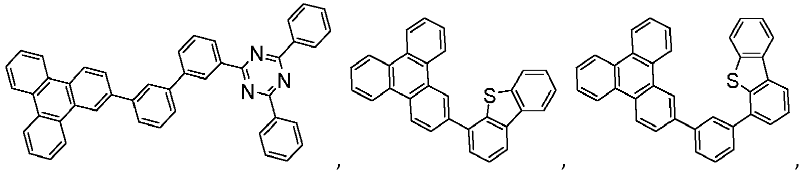 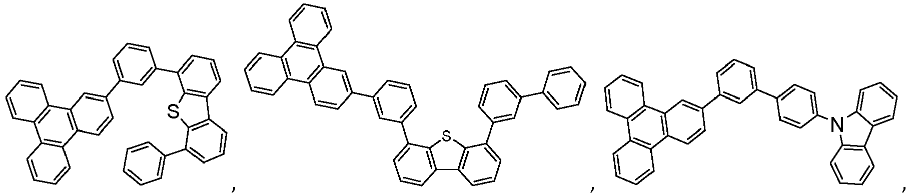 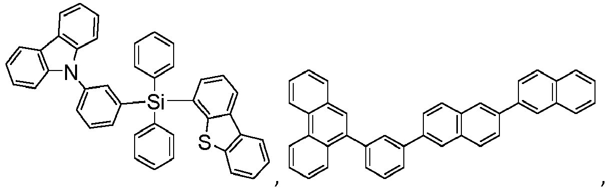 et leurs combinaisons ; ou
l'hôte comprend un complexe métallique.

11. Produit de consommation comprenant un dispositif électroluminescent organique (OLED) comprenant :
une anode ;
une cathode ; et
une couche organique, disposée entre l'anode et la cathode, comprenant un composé selon l'une quelconque des revendications 1 à 7.

12. Produit de consommation selon la revendication 11, où le produit de consommation est choisi dans le groupe constitué par un écran plat, un moniteur d'ordinateur, un moniteur médical, un téléviseur, un panneau d'affichage, une lumière pour l'éclairage d'intérieur ou d'extérieur et/ou la signalisation, un affichage tête haute, un affichage totalement ou partiellement transparent, un affichage souple, une imprimante laser, un téléphone, un téléphone cellulaire, une tablette, une phablette, un assistant numérique personnel (PDA), un dispositif à porter sur soi, un ordinateur portable, un appareil photo numérique, un caméscope, un viseur, un micro-écran d'une diagonale inférieure à 2 pouces, un écran 3D, un écran de réalité virtuelle ou de réalité augmentée, un véhicule, une paroi vidéo comprenant de multiples affichages juxtaposés, un écran de cinéma ou de stade, et une enseigne.
